# EUROPEAN PATENT SPECIFICATION

(11) **EP 4 657 329 B1**
(45) Date of publication and mention of the grant of the patent: **11.11.2026**
(21) Application number: 25209592.2
(22) Date of filing: 25.05.2023
(51) Int. Cl.: G06N 10/20, G06N 5/01, G06N 5/022, G06N 10/40, G06N 10/60

(54) **CONDENSED MATTER SIMULATIONS ON QUANTUM COMPUTERS**
SIMULATIONEN KONDENSIERTER MATERIEN AUF QUANTENCOMPUTERN
SIMULATIONS DE MATIÈRES CONDENSÉES SUR DES ORDINATEURS QUANTIQUES

(30) Priority: 27.05.2022 GB 202207893; 27.05.2022 GB 202207896; 27.05.2022 GB 202207899; 27.05.2022 GB 202207901
(43) Date of publication of application: 03.12.2025
(62) Document number(s) of the earlier application(s) in accordance with Art. 76 EPC: 23175487.0 / 4 283 534
(73) Proprietor: Phasecraft Limited, London Greater London W1T 4PW (GB)
(72) Inventor: MONTANARO, Ashley, London, W1T 4PW (GB); CUBITT, Toby, London, W1T 4PW (GB); FLYNN, Brian, London, W1T 4PW (GB); SHERIDAN, Evan, London, W1T 4PW (GB); GAMBETTA, Filippo, London, W1T 4PW (GB); KLASSEN, Joel, London, W1T 4PW (GB); SANTOS, Raul, London, W1T 4PW (GB); PIDDOCK, Stephen, London, W1T 4PW (GB)
(74) Representative: Mathys & Squire

(56) References cited:
- WO-A1-2021/160989
- US-A1- 2022 019 931
- LAURA CLINTON ET AL: "Towards near-term quantum simulation of materials", ARXIV.ORG, CORNELL UNIVERSITY LIBRARY, 201 OLIN LIBRARY CORNELL UNIVERSITY ITHACA, NY 14853, 30 May 2022 (2022-05-30), XP091235110

## Description

### FIELD OF THE INVENTION

The present application relates to methods and apparatuses for improved efficiency in quantum computation. In particular, the application relates to systems and methods for efficient simulation of condensed matter systems on quantum computers. Certain aspects of the disclosure relate specifically to systems and methods for schemes for efficiently encoding Hamiltonians describing condensed matter systems onto quantum computers; efficiently calculating fermionic swaps for improving performance of quantum operations on a quantum computer; and/or efficient identification of simultaneously measurable Majorana operators in an encoded Hamiltonian and the implementation of associated measurement strategies. Different aspects set out herein focus to varying degrees on these concepts.

### BACKGROUND OF THE INVENTION

The race to demonstrate useful applications of near term quantum computers is on, with quantum simulation being one of the most probable near term applications. Quantum simulation of complex materials allows one to understand their relevant properties in terms of chemical composition, pressure, temperature, voltages, etc. This understanding serves to predict macroscopic properties and permits the rational design of materials with novel characteristics. The capability of understanding and creating intended characteristics in chemicals and materials is crucial in the modern world and helps to guide the multi-billion dollar chemical industry.

The challenges faced by the rational design of properties in new materials are multiple across different length-scales. At the fundamental level, a poor efficient description of electron-electron interactions hinders the ability to make predictions in the strong-coupling regime, where many relevant technological applications are expected to appear.

A quantum processor (QP), sometimes referred to herein as a quantum computer, quantum information processor, etc., can simulate these correlated processes natively, by decomposing the quantum evolution into a sequence of elementary operations (quantum circuit), that are applied to a specified quantum state. The state obtained from this procedure is then queried by measuring relevant quantities. Crucially, the advantage of this approach over direct classical simulation of the state vector appears for large enough systems (in terms of qubits and quantum circuit complexity), where the exponential growth of the Hilbert space outpaces state-of-the-art supercomputer capabilities.

In the noisy intermediate-scale quantum (NISQ) era of quantum computers, two main challenges exist in order to accurately simulate quantum systems. First, the number of physical qubits *N*_{qu} is restricted (to this day the largest functioning quantum processors (QP) have *N*_{qu} ~ 100). Although different manufacturers project that this number will grow in the next decade, the second challenge of obtaining good enough gate fidelities remains. Both capabilities are critical to produce large quantum circuits where error mitigation techniques can handle the noisy outcomes to generate meaningful signals beyond classical capabilities. Further developments are needed for quantum error correction to become a feasible possibility, thus allowing arbitrarily deep circuits.

Access to a small number of qubits and limited gate fidelities constrains the type of algorithms that can be accurately implemented. In particular, these algorithms should optimize for the number of qubits available in a given system and required circuit depth of the algorithm in question in order to be successful. Simulation of materials is especially well suited to be tackled within this domain. Although the number of electrons in a large piece of material is of the order of Avogadro's number, the regularity of the lattice restricts the behaviour of electrons allowing one to concentrate the important degrees of freedom into a relevant active space, where the dominant mechanisms of interest lie, thus reducing the number of qubits needed to perform an accurate simulation.

The extensive effort to predict a material's properties in challenging regimes has also led to the development of embedding approaches like density matrix embedding theory (DMET) or dynamical mean field theory (DMFT), techniques that point to further reducing the relevant degrees of freedom that are studied, without sacrificing the physics.

The periodic structure of materials also usually offers a great deal of symmetries, that can be leveraged to generate a compact representation of the Hamiltonian, lowering the number of interactions and ultimately the cost of implementing a circuit based on that Hamiltonian. Symmetries can also be used to mitigate errors in the measured signals, as already demonstrated experimentally.

Materials systems also enjoy some useful properties. Band theory, i.e., the description in terms of single particle physics, is a well-defined limit which underpins the general success of Density Functional Theory (DFT). Although interaction terms can in principle greatly modify the single particle picture, having an efficiently computable state to initialize the system in the correct symmetry sector is useful for approaches like Variational Quantum Eigensolvers (VQE). Equally, using the single particle state as a starting point has already been shown to be useful for error mitigation. Here, by training on the data obtained in a noninteracting instance (or Fermionic Linear optics (FLO) circuit in quantum information language), a map between the data obtained in the QP and the exact values can be inferred and used to correct extracted data in the instances where classical simulations are not possible. Similar error mitigation approaches are plausible but have not been explored in chemical systems yet.

The description of electronic systems in digital quantum computers also presents particular challenges. While the most important components that describe the physics of materials are electrons, most of the digital quantum computers work with two-level systems that represent a qubit. In order to properly account for fermion statistics and the Pauli principle, an algebraic mapping between fermions and qubits is needed. A naive mapping using the Jordan-Wigner transform can increase the cost of a computation by a multiplicative factor that scales with the size of the system, outweighing the benefits of a local fermion Hamiltonian.

In addition, crystalline solids possess at least two natural bases for the single particle electrons, the band (Bloch) basis, which represents electrons in momentum space, and the Wannier basis, that represents them in real space. Each single particle basis affects differently the final cost of implementing a circuit, so one has to choose between these bases in a principled way.

WO 2021/160989 A1 (PHASECRAFT LTD [GB]) 19 August 2021 (2021-08-19) teaches a computer-implemented method of determining a control sequence for performing a quantum operation on a quantum information on a quantum information processor comprising a plurality of qubits. The quantum operation is characterised by a fermionic quantum operator for acting on local fermionic modes. The method comprises translating, using a fermion-to-qubit encoding, the fermionic quantum operator to a qubit operator for operating on the plurality of qubits, and determining from the qubit operator a control sequence for performing the quantum operation on the quantum information processor. Apparatuses and computer-readable media are also described therein.

The methods disclosed herein address some or all of the shortcomings of the field identified above.

### SUMMARY OF THE INVENTION

The various methods and systems described below each relate generally to the use of a hybrid quantum and classical computing system to best leverage their capabilities. Specifically, as noted above a quantum computer in principle represents an excellent native environment for modelling the quantum mechanical interactions in solids, but quantum computers have limitations in both noise tolerance and number of qubits (this is true both currently and is expected to remain so in at least the near-term). Rather than allowing the limitations to stifle the applicability, the partitioning of tasks in a carefully chosen manner allows the system as a whole to tackle problems which, on the face of things, appear to be intractable with current technology. This allows for a trade-off in which the bespoke processing capabilities of each subsystem (quantum and classical computation) is leveraged to bring its own unique properties to bear on the problem. In particular, the large-scale binary processing power available in classical computation is used to investigate certain tractable problems in fields like combinatorics, graph theory and connectivity measures, calculating matrices and tensors, etc. This classical calculation step enables the formation of relatively low depth and therefore noise tolerant quantum circuits. This in turn opens up access to simulating systems on a quantum computer which could not be simulated taking a naive approach.

The specific solutions set out herein directly use both the form of the system to be simulated and the operational parameters of the quantum computer as inputs to the process. These inputs are used to tailor the mathematical description of the system to the operational capabilities of the quantum computer. In this way, the methods can be thought of, in part, as providing a bridge between a complex system to be simulated on the one hand and a limited capacity and robustness in the otherwise seemingly ideal environment for simulations of quantum systems. The system to be simulated feeds in to the methods performed as described herein not just in the relatively trivial sense of setting the parameters of the problem to be solved (i.e. setting out what a valid simulation would look like), but also in the sense that the connectivity and interrelationships between the modes are used in assessing the core parts of the system which needs to be modelled (and conversely which parts may be simplified or approximated with minimal loss to accuracy).

Similarly, the operational parameters of the quantum computing system are used in the classical computation aspects because it is important to understand the informational capacity of the quantum computer and its noise tolerance in order to ensure that there are reasonable prospects of being able to complete the simulation. As one example, in adapting the original problem to the quantum encoding, it is important to understand the number of qubits available for use in information processing. In addition, the simulation procedure will require a particular circuit depth (i.e. number of consecutive gate manipulations required to run the full algorithm) which depends on the encoding chosen. The noise tolerance (i.e. robustness, coherence, etc.) of the quantum processing substrate on which the calculations are to be performed plays a strong role in determining the maximum circuit depth which can reasonably be expected to be enacted. These considerations feed directly into the classical calculations performed to enable the overall system to operate effectively. As an example the classical calculations in reducing the input problem to a calculable one are performed with an eye on the circuit depth and encoding complexity available for the quantum simulation steps. In some examples, certain systems to be simulated on given quantum hardware may benefit from performing more calculations overall, but in such a way that the encoding requires a lower overall circuit depth. Another important aspect of a quantum computing hardware platform is the connectivity of its qubits. For example, platforms based on superconducting qubits usually allow for quantum gates to act on adjacent qubits in a planar graph topology. This motivates a representation of a materials system on the quantum computer that respects this topology as far as possible. In some ion trap architectures, qubits are arranged in groups where any pair of qubits within each group can interact easily, whereas long-range interactions between groups are more challenging. This motivates a representation that minimises the number of these long-range interactions.

Each of the contributions set out below can be thought of in a variety of ways. For example, although phrased generally as methods or systems for simulating, calculating, compiling, improving efficiency, etc., these may equally be thought of as being one or more of:
- A method of preparing control signals for operating a quantum computer to improve, and in some cases optimise, utilisation of the resources of the quantum computer. Or a method of control of a quantum computer to achieve these goals.
- A method of controlling a quantum computer in which encodings and qubit manipulations are selected by virtue of the steps of the methods set out below.
- A hybrid quantum-classical process and/or system for performing a simulation, by way of enacting the methods set out below.
- A method for preparing an encoding scheme for a quantum computer of a given noise level and number of computational qubits.
- A method of developing an encoding scheme having an overall (or average) circuit depth below a threshold for encoding onto a quantum computer having a known number of calculation qubits.
- A method of developing an encoding scheme, the scheme requiring fewer than a threshold number of qubits for encoding onto a quantum computer having a known level of noise tolerance.
- A method of efficiently performing calculations from a set of calculations efficiently, in view of the number of qubits and/or the noise tolerance of the quantum computer on which the set of calculations is to be performed.

There are a number of fundamental assumptions about the features of the specific quantum computing hardware which motivate the design choices in the methods set out in this application. The methods below are directly based on the features in order that the advantages of using these methods can be realised.

Unlike classical computing hardware, which can usually be assumed to be sufficiently error-free (and in which error correction is commonly employed) that it performs according to an abstract computational model, near-term quantum computing hardware is affected by significant errors and noise, such that its performance is intimately tied to the underlying physics of the quantum hardware on which the calculations are performed. This physics plays an integral role in the design of new computing methods such as those set out herein.

The following methods, assume that the dominant contributing factor to the accumulation of errors in performing computation on quantum devices is the gate count and circuit depth of the computation, in particular counts/depths given in terms of gate operations between multiple qubits. This is generally true of existing quantum computing devices and is a major motivation for constructing quantum circuits which have reduced gate overheads.

Other aspects which may affect the performance of a given piece of hardware include performing some specific subroutine, which turns out to be unexpectedly costly, or where the run time of a given process (which we typically seek to reduce via improved algorithmic efficiency) is unusually and unexpectedly long. In such cases the specific choice of encoding, or swap network routine described here may help a little, but adaptations to the encodings may be preferred to mitigate errors in the device.

The methods set out herein are directly focussed on minimizing circuit depth in addition to gate count. Circuit depth can reflect how badly errors can be allowed to propagate through the computation, and also gives a measure of the effect of errors due to idling qubits -- something that gate count does not capture. This again is motivated by how noise functions on the physical hardware.

Building on the assumption about error accumulation and increased runtime due to increased circuit depth, a second assumption is that there is an increased cost in terms of gate count and circuit depth involved in constructing circuits for unitary operations generated by Pauli operators acting on a large number of qubits. This will depend on the native gate set of the quantum computer. For example in a superconducting qubit architecture the native gate set is typically constrained to 1 and 2 qubit gates, and thus a unitary generated by a Pauli operator acting on many qubits will need to be decomposed into a sequence of many 2 qubit gates. However, other devices might have access to native interactions over many qubits, in which case the gate count of the circuit decomposition of a unitary operator generated by a large Pauli acting on these qubits may not be very deep. In such cases, the native gates available on a given piece of hardware factor neatly into the algorithms below, which can be optimised in response to the native hardware gates available, i.e. placing less weight on decomposing gates into two qubit gates when higher numbers of qubits are operable on by a single native gate in a given hardware.

Finally, in the case of the simultaneous measurement routine, there is an assumption that, although any pair of commuting observables are in principle simultaneously measurable, in practice certain pairs are more easily measured simultaneously than others. In this case it is assumed that the circuit cost of simultaneously measuring commuting Pauli operators which differ by a small number of qubits is less than the cost of simultaneously measuring a pair of Paulis which differ on many qubits. This comes from assumptions about native gate sets outlined above, and also about the specific ways in which measurement occurs on the device.

Under these realistic assumptions about the practicalities of running algorithms on near term quantum computers, the methods set out below provide a real advantage over known methods because they directly address likely causes of inaccuracy and provide executable algorithms which improve the likelihood that meaningful and accurate results are obtained.

Aspects of the invention are set out in the appended independent claims and preferable features are set out in the dependent claims.

Described herein is an unclaimed method of simulating at least a subset of interactions between modes in a fermionic system on a quantum information processor having N or fewer qubits. The method comprising the steps of: identifying an active space and associated degrees of freedom within the active space, the active space corresponding to a plurality of modes in the fermionic system between which the subset of interactions operates; constructing an effective Hamiltonian describing the degrees of freedom within the active space of the fermionic system; providing the effective Hamiltonian in a localised representation whereby an interactivity graph of the Hamiltonian in the localised representation comprises clusters of modes in which a first cluster and a second cluster are candidate connected clusters if there exists at least one edge in the interactivity graph between a mode in the first cluster and a mode in the second cluster and wherein a set of connected clusters is selected from the set of candidate connected clusters to provide an encoding scheme for the modes of the Hamiltonian on the qubits of the quantum information processor; calculating quadratic interaction matrix coefficients between pairs of modes of the localised Hamiltonian and Coulomb tensor coefficients representing interactions between quartets of modes of the localised Hamiltonian; encoding the modes of the localised Hamiltonian onto the qubits of the quantum information processor; implementing qubit interactions between the qubits, the qubit interactions corresponding to interactions between modes of the localised Hamiltonian; and measuring the state of the qubits thereby to extract a simulation of the active space of the effective Hamiltonian.

This can be thought of generally as taking a Hamiltonian which is to be investigated and adapting it to a suitable representation for encoding on a quantum information processor for investigating the system described by the Hamiltonian. In particular, the active space is identified, and a localised representation is provided. By considering the interactivity graph of this localised representation, clusters can be identified which indicate the density of interaction of certain of the modes with one another. This indicates the relative importance of the various interactions within the active space. From here, the various Hamiltonian terms (such as kinetic energy, potential energy, and interaction energy terms) can be calculated, and the modes and interactions can be encoded on a quantum computer for further calculation, simulation, analysis, etc.

This process can be thought of as using the high resource availability of a classical computer to identify core symmetries and relationships between the modes of the Hamiltonian to be simulated on a quantum computer. With these parameters in hand, the encoding of the system onto the quantum computer can be approached. As noted above, current and near-term quantum computers have limited resources available in terms of compute resources and noise tolerance, and it is usually necessary to simplify the problem to be simulated on the quantum computer in some way. By identifying the important interrelations in the system to be simulated, the most important features of that system can be preserved, and the less important features approximated. This initial step allows the problem to be simplified without losing the core properties. In addition, the limitations of the quantum computer are fed into the problem by setting thresholds in terms of the number of qubits required by the encoding being limited to the number available and the circuit depth of the encoding, which is limited by the noise tolerance of the computer. In addition, certain aspects of the connectivity of qubits within the quantum computer can be leveraged in that a more efficient algorithm is obtained if this connectivity matches the pattern of interactions between the modes of the Hamiltonian.

This represents an efficient division of labour between the classical computer, which is used in the analysis of the system and formation of a specific efficient encoding to represent a given system, and the quantum computer which is then able to efficiently perform a simulation of a system which appears on the face of it to be too complex to accurately simulate given the available resources.

Note that in some cases the input Hamiltonian may already be expressed in a suitably localised format, while in others, the Hamiltonian may need to be converted into a different format, to provide the degree of localisation set out above. Localisation in this example may include, e.g., exploring the active space in a plurality of single particle bases (e.g. Bloch-wave single particle basis, Wannier single particle electron basis, etc.) for the fermions and selecting the single particle basis which results in the most local Hamiltonian.

Of particular note is the use of the interactivity graph. The identification of clustering within the structure of the Hamiltonian allows the leveraging of the above notion of locality and leads in turn to an expression for the system which is amenable to implementing in a quantum circuit which has a circuit depth which scales sub-linearly with the system size for a suitable choice of encoding, as discussed elsewhere herein. In particularly advantageous examples the circuit depth may be fixed irrespective of the system size. This tailors the initial starting Hamiltonian to the limitations of the quantum information processor and opens up modelling of complex quantum systems on an appropriate hardware. In particular the noise/fidelity limitations of quantum computers mean that increases in circuit depth quickly lead to circuits which are not practically implementable on current quantum computers. Since these problems are not expected to be overcome in the near future, it is extremely beneficial to decouple (or at least weaken the dependence between) the circuit depth from the system size if simulations are to become practical.

A working assumption is that (in quantum computers without full fault tolerance), the error of implementing a single 2-qubit gate can accumulate when the gates are done in series. This is why it is preferable to have a layer of gates that is as shallow as possible. In light of this, a method to simulate a system where the layer depth scales with the size of the system is undesirable. An innovation in the present document is that this adverse effect is reduced or eliminated, so any system size can be simulated with an improved (in some cases fixed) circuit depth.

As a specific example discussed in more detail herein, the localised representation may include a further restriction in a periodic system to a motif Hamiltonian. "Motif Hamiltonians" as used herein are those which are restricted to a central unit cell of the localised Hamiltonian and having interactions between modes of the localised Hamiltonian restricted to interactions which include the central unit cell at least once and one or more of the nearest neighbouring unit cells of order n. That is, the motif Hamiltonian is one which leverages the periodic nature of the lattice to cast the interactions in terms of interactions between any given unit cell and nearest neighbours out to a user-selected distance. The motif simplifies the calculations because the system can be tiled using the motif at constant calculation depth irrespective of system size. The specific distance being selected based on parameters such as the complexity of system capable of being simulated on the expected hardware, the level of detail needed, the interactions of interest, and so forth. This format of restricted, motif, Hamiltonian leverages translation invariance to simplify the calculation, and thereby assist in decoupling the circuit depth for simulating such a system from the size of the system (since the symmetries allow for the motif to represent the whole system).

The limitation can include for example ignoring hopping matrix coefficients corresponding to an interaction over a distance larger than a first distance threshold value; and/or ignoring Coulomb tensor coefficients corresponding to an interaction over a distance larger than a second distance threshold value. That is, limiting the interactions to those within a certain distance (in terms of unit cells of the periodic lattice) from the central cell.

In other words, although the focus is on constructing the motif Hamiltonian, a system of any size is modelled, ultimately restricted to what can be fit on the quantum computer. The motif allows this without increasing the circuit depth. As an example, if M gates in a layer of depth D are needed to model all the interactions in the motif, a layer of depth D would still be needed to model any system size in the optimal case (and will at least scale sub-linearly with system size in most cases) for a single time step. Of course larger systems require more gates to completely model, but the additional gates can be implemented in parallel, thus not increasing the error that may appear by doing gates in series in a greater number of layers.

In whichever manner this limitation is implemented (various other specific details are set out elsewhere), the overall goal is to prepare a system which is sufficiently local to use all of the tools set out generally in this document.

The concept of an "active space" as used in this document, is used in the sense in common use in the art, specifically meaning the region of the energy spectrum of a system which is important for answering the questions of interest of the system. While this may differ markedly depending on the questions being asked (e.g. low temperature electron transport questions lead to considering different parts to questions about the melting point of the material), it is well-understood how to identify the active space in response to a specific question being asked. In order to successfully answer the desired questions, the method focussed on modes and interactions which express the relevant information. The degrees of freedom within the active space are therefore those which capture the phenomenon being investigated.

In general, the terms "matrix element(s)", "tensor element(s)" and "interaction(s) between the modes" are used somewhat interchangeably. The tensors and matrices that capture the set of interactions are populated with coefficients which describe the relative strength of a given interaction. Specifically, the entry in a matrix which is at the intersection of a given row and column (or the intersection of a larger number of lines in higher dimensional tensors) indicates the strength of interaction between the modes corresponding to that row and that column. Thus, the encoding of the interactions as interactions between the qubits maps the interactions in the Hamiltonian to a set of operators which are applied to qubits. Typically the interactions therefore manifest as a series of quantum circuit gates which are applied to the qubits on which the Hamiltonian is encoded.

Optionally, the method further comprises filtering the quadratic interaction matrix elements corresponding to kinetic and potential terms and Coulomb tensor coefficients to form a filtered localised Hamiltonian by ignoring: kinetic and potential matrix coefficients having a magnitude below a first interaction threshold value; and/or Coulomb tensor coefficients having a magnitude below a second interaction threshold value; and/or the encoding step includes encoding the modes of the filtered localised Hamiltonian onto the qubits of the quantum information processor. The quadratic interaction matrix is sometimes referred to as the hopping matrix elsewhere in this document.

Optionally, the first and second interaction thresholds are selected to reduce a number of interaction terms between modes addressed by matrix and/or tensor elements in the filtered localised Hamiltonian to contain inter-cluster interactions that represent a user-specified percentage p of the overall interactions, and that do not contain interactions between modes in clusters separated by more than a user-specified threshold distance k in the interactivity graph. In other words interactions which operate over a long range are selectively excised from the system in favour of shorter range interactions. Since the Hamiltonian is already a localised one, the longer range interactions are usually able to be preferentially culled. In some cases, the thresholds focus on modes which are close together at the expense of filtering out consideration of modes which are less close together in the interactivity graph.

Optionally, each of the interaction thresholds and the threshold distance, k, are selected to reduce the number of interaction terms between modes in distant clusters according to the distance between modes in the filtered Hamiltonian in an iteration subroutine, in which: one or more of the thresholds and the parameters p and k are set at a respective value; the number of interaction terms and the distance of the modes within an interaction term in the resulting filtered Hamiltonian is calculated; where the number of interactions between modes in clusters at a distance k in the filtered Hamiltonian is larger than p, one or more new threshold values is selected and the number interaction terms re-calculated; and where the number interactions in the filtered Hamiltonian is smaller than or equal to p and each interaction occurs between modes at a distance smaller of equal than k, the iteration subroutine ends. By iterating in this way, the method is able to gradually reduce the complexity of the Hamiltonian being simulated until it is capable of being run on the expected complexity of hardware available. Note that this procedure allows the method to be adapted to any complexity of hardware available by setting the thresholds and parameters appropriately.

Optionally, the value of the interaction thresholds are set at a value no lower than the largest magnitude of a Coulomb tensor or quadratic interaction matrix coefficient corresponding to an interaction strength not present in interactions within a distance k. This feature improves the filtering by examining whether interactions have been retained in the filtered Hamiltonian have an interaction strength (i.e. relative magnitude of the corresponding matrix/tensor coefficient) which is weaker than interaction strengths which have already been culled by virtue of distance or considerations from the connectivity of the interactivity graph. In cases where such weaker interaction strengths remain, it is reasonable to filter them out anyway, since they are less important in some sense than interactions which have already been discarded. This therefore further represents an additional manner of reducing the complexity of the system to be simulated without unduly sacrificing accuracy.

In this example, the idea of distance means that in any instance, more distant interactions (ones between physically distant regions of the system) are sacrificed in favour of those which operate over a shorter range.

Optionally, providing the effective Hamiltonian in a localised representation includes using the localised representation to construct a cluster k-local Hamiltonian, the cluster k-local Hamiltonian having all interactions between modes that are members of different clusters within a distance k. This definition of a "cluster k-local Hamiltonian" leads to a consideration of only interactions within a distance k of a cell. In periodic cases this is justified by translation invariance, while in atomic/molecular orbitals there is a natural basis of atoms in the molecule and distance has again a well-defined meaning

Optionally, the quadratic interaction matrix and Coulomb tensor coefficients are calculated using classical integration techniques, optionally using Monte Carlo integration. Classical integration techniques are well-studied and are efficiently and consistently implementable with good accuracy.

Optionally, the localised representation is selected from a plurality of single particle bases including atomic orbitals, molecular orbitals, Wannier functions, and the Bloch basis. Localisation may mean confining interactions to those which are close to specific lattice sites where there is a regular lattice, or it may mean individual atoms in atomic/molecular situations, for example. It can be beneficial to make use of the most local representation available in any given circumstance because this can provide confidence in truncating the system at particular distances.

Optionally, the localised representation is selected such that: an energy gap exists between energy levels of the system in the region of the active space and other energy levels outside of the natural energy levels of the system, not in the active space; and either systems having time reversal symmetry; or systems not having time reversal symmetry but having a vanishing Chern number. These criteria (when satisfied) open up the possibility of using maximally localised Wannier functions, thereby ensuring that the basis is as local as possible.

Optionally, the energy levels to be considered in the system include: bands in the active space of periodic systems; or the highest occupied molecular orbital (HOMO) and/or the lowest unoccupied molecular orbital (LUMO) in atomic or molecular systems. These energies represent natural energy levels to at which analyse the system and are a natural selection for the active space.

Optionally, density functional theory is used to explore the plurality of single particle bases and the results used to determine which of the single particle bases results in the most local Hamiltonian. This is a well-studied approach which allows for a reliable assessment of the optimal basis to use for a given system.

Optionally, the exploration is performed in a region around: the Fermi energy in periodic systems; or the energy of the highest occupied molecular orbital (HOMO) in atomic or molecular systems; this energy corresponding to the active space in each of the single particle bases.

Optionally, the calculation of the quadratic interaction matrix coefficients and the Coulomb tensor includes a simplification based on one or more of: the hermiticity of the quadratic interaction matrix and/or the Coulomb tensor; and/or the swap symmetry of the Coulomb tensor; and/or the quadratic interaction matrix and/or the Coulomb tensor being real-valued. Recognising and using these symmetries allows for a simplification of the system without undue loss of detail.

Optionally, the encoding step uses the interactivity graph of the Hamiltonian to identify clustering in the modes of the Hamiltonian.

Optionally, vertices of the interactivity graph are uniquely associated with the modes of the Hamiltonian, and edges of the interactivity graph connect every pair of vertices whose associated pair of modes are involved in an interaction together.

Optionally, disjoint clusters of modes are determined in the interactivity graph and pairs of connected clusters are selected from a set of candidate pairs of connected clusters, wherein a first cluster and a second cluster are a candidate pair of connected clusters if there exists at least one edge in the interactivity graph between a mode in the first cluster and a mode in the second cluster; and wherein the encoding step includes defining a plurality of fermionic operators for encoding as qubit operators, the fermionic operators including: at least one edge operator for each pair of connected clusters; a set of fermionic edge operators between modes of the same cluster; and a fermionic vertex operator for every mode.

Optionally the fermionic edge operators have the form *E*_{[*R*,*i*],[*R',j*]}, for every pair of connected clusters *R,R'*, between modes *i* and *j*, wherein *i* is any mode in *R* and *j* is any mode in *R'*; the fermionic edge operators have the form *E*_{[*R,i*],[*R,j*]} between modes *i,j* in the same cluster *R* such that for any pair of modes *i,j* in *R*, there exists a sequence of modes *i, l, m, n..., o, j* such that *Eᵢₗ, Eₗₘ, Eₘₙ* ... *Eₒⱼ*; the fermionic vertex operators have the form *Vⱼ* for every mode *j*; and wherein *Eⱼₖ*: *= -iγⱼγₖ*, *Vⱼ*: *= -iγⱼγ̅ⱼ*, ${γ}_{j} : = {w}_{j} + {w}_{j}^{†}$, and ${\overline{γ}}_{j} : = \left({w}_{j}-{w}_{j}^{†}\right) / i$, wherein *wⱼ* and ${w}_{j}^{†}$ are fermionic annihilation and creation operators and the edge operators satisfy a composition relation *Eₕₖ = iEₕⱼEⱼₖ*, and *j* and *k* are multi-indices [*j,k*]: *=* [*R, m*].

Optionally, each of the plurality of fermionic edge and vertex operators are encoded as corresponding qubit operators acting on qubits of the quantum information processor, such that all the anti-commutation and commutation relations between the fermionic operators are preserved between their corresponding qubit operators and that the square of any fermionic edge or vertex operator is equal to the square of its corresponding qubit operator.

Optionally, the method, further includes simulating at least one fermionic interaction on the quantum information processor by enacting unitary qubit operations generated by the qubit operators on the qubits of the quantum information processor.

Optionally, the encoding step includes a Jordan-Wigner transform to map fermionic creation and annihilation operators to Pauli strings comprising Pauli X, Y and Z operators. It will be appreciated that the developments of the encoding step allow the advantages of the encoding aspects of this disclosure to be applied to the simulation. Consequently, the advantages set out in detail below apply in this context too.

Optionally, the method further comprises implementing fermionic swap operations on the Pauli strings to reduce the weight of a quantum circuit comprising the Pauli strings.

Optionally, the fermionic swap operations are calculated by: receiving a graph comprising vertices and edges, the vertices of the graph being associated with Hamiltonian modes wherein the edges define a set of available vertex swaps; receiving a plurality of interactions of the Hamiltonian modes based on the Coulomb tensor and the quadratic interaction matrix, each interaction comprising at least two vertices of the graph; and determining a swap layer for the quantum circuit based on the graph and the interactions between the Hamiltonian modes.

Optionally, determining a swap layer includes: (i) determining a graph cost of the graph, wherein the graph cost is based on distances between the vertices within the interactions on the graph; (ii) determining, for each available vertex swap, a swapped graph cost of a swapped graph, wherein the swapped graph is the graph modified according to the each available vertex swap; (iii) adding a best available vertex swap to the swap layer, the best available vertex swap being the available vertex swap associated with a lowest swapped graph cost; and (iv) updating the graph according to the best available vertex swap and updating the set of available vertex swaps to remove available vertex swaps containing vertices in the best available vertex swap.

Optionally, the method further comprises iterating the step of determining a swap layer until there are no more available vertex swaps and/or until the swapped graph costs associated with the available vertex swaps are not less than the swapped graph cost of the updated graph following the last vertex swap added to the swap layer and/or none of the available swaps reduce the distance of at least one interaction.

Optionally, the method further comprises determining an interaction layer for the quantum circuit by adding interactions whose vertices can be split into one or more pairs of vertices that are connected by edges after the swap layer to the interaction layer; adding a layer of quantum swap operations to the quantum circuit for swapping qubits or swapping labels of qubits of the quantum information processor corresponding to the vertex swaps in the swap layer; and adding a subsequent layer of quantum operations to the quantum circuit for interacting qubits of the quantum information processor corresponding to the interactions in the interaction layer. It will be appreciated that the developments of the swap network steps allow the advantages of the swap network aspects of this disclosure to be applied to the simulation. Consequently, the advantages set out in detail below apply in this context too.

Optionally, the measurement step includes: encoding the Hamiltonian in terms of a set of Majorana operators on a set of qubits, {α, β, γ, δ ...} of the quantum information processor; identifying a subset of the Majorana operators having M members, each member corresponding to an interaction which is to be measured between modes in the Hamiltonian; identifying at least one sub-subset of Majorana operators within the subset which can be simultaneously measured; and simultaneously measuring the Majorana operators in each sub-subset in a series of sequential measurements until all Majorana operators in the subset have been measured.

Optionally, the method further includes: allocating a portion of the qubits into a subset of data qubits and optionally allocating a separate subset of the qubits into ancilla qubits, and fixing an ordering of the data qubits; and writing the Majorana operators in terms of products of quadratic Majorana operators; and writing the quadratic Majorana operators in terms of products of two Pauli strings which operate on the data qubits and which optionally also operate on one or more ancilla qubits, where each Pauli string on the data qubits comprises one or more Pauli operators X, Y or Z, each Pauli operator operating on a specific qubit in the array of qubits.

Optionally, each Pauli string of length 1 consists of one Z; and wherein each Pauli string of length two or more has ends Aᵢ and Bⱼ selected from the set {X,Y} and wherein indices of the set {i, j, k, I...} denote specific qubits in the array of qubits {α, β, γ, δ...} on which the ends of the string operate.

Optionally, identifying at least one sub-subset of Majorana operators includes identifying at least a first quadratic Majorana operator acting on data qubits i ≤ j and a second quadratic Majorana operator acting on data qubits k ≤ l, and in which in the first and second Majorana operators are simultaneously measurable if any one of the following non-crossing criteria are met: $j < k ;$ or $l < i ;$ or $i < k \leq l < j ;$ or $k < i \leq j < l ;$ or
i = j and k = l; or
i = k and j = l and A and B are selected such that the ends of the Pauli strings representing the first and second Majorana operators are each selected from either the set {XX,YY} or the set {XY,YX}; and wherein the Majorana operators also commute qubitwise on the ancilla qubits.

Optionally, quartic Majorana operators are defined as a product of two quadratic Majorana operators written as Pauli strings operating on disjoint data qubits, and wherein the method includes: as part of the identifying step, identifying a plurality of quartic Majorana operators which can be measured simultaneously by identifying quartic Majorana operators in which all pairs of the distinct quadratic Majorana operators which form part of the quartic Majorana operators satisfy at least one non-crossing criterion. It will be appreciated that the developments of the measurement step allow the advantages of the measurement aspects of this disclosure to be applied to the simulation. Consequently, the advantages set out in detail below apply in this context too.

Optionally, implementing qubit interactions includes applying a time evolution operation to the encoded localised Hamiltonian. This is one example of allowing the system to evolve once encoded, in order to simulate the system and extract meaningful information from the output of the quantum computer.

Also disclosed herein is an unclaimed computer-implemented method of efficiently simulating a fermionic system on a quantum information processor, comprising: receiving a list of interactions between fermionic modes, m; determining an interactivity graph of the modes, wherein vertices of the interactivity graph are uniquely associated with the modes, and edges of the interactivity graph connect every pair of vertices whose associated pair of modes are involved in an interaction together; determining disjoint clusters of modes and selecting pairs of connected clusters from a set of pairs of candidate connected clusters, wherein a first cluster and a second cluster are a candidate pair of connected clusters if there exists at least one edge in the interactivity graph between a mode in the first cluster and a mode in the second cluster; defining a plurality of fermionic operators for encoding as qubit operators, comprising: at least one fermionic edge operator *E*_{[**R**,*i*],[**R**',*j*]} for every pair of connected clusters, **R, R',** between modes i and *j,* wherein *i* is any mode in **R** and *j* is any mode in **R';** fermionic edge operators *E*_{[**R**,*p*],[***R***,*q*]} between modes *p, q* in the same cluster **R** such that for any pair of modes *i,j* in **R,** there exists a sequence of modes *i, l, m, n ..., o, j* such that *Eᵢₗ, Eₗₘ, Eₘₙ* ... *Eₒⱼ*; and, fermionic vertex operators *Vⱼ* for every mode *j,* wherein *Eⱼₖ* : *= -iγⱼγₖ*, *Vⱼ* : *= -iγⱼjγ̅ⱼ*, ${γ}_{j} : = {w}_{j} + {w}_{j}^{†}$, and ${\overline{γ}}_{j} : = \left({w}_{j}-{w}_{j}^{†}\right) / i$, wherein *wⱼ* and ${w}_{j}^{†}$ are fermionic annihilation and creation operators and the edge operators satisfy a composition relation *Eₕₖ = iEₕⱼEⱼₖ*, *and j* and *k* are multi-indices *j, k*: = [**R**, *m*]; encoding each of the plurality of fermionic edge and vertex operators as corresponding qubit operators acting on qubits of the quantum information processor, such that all the anti-commutation and commutation relations between the fermionic operators are preserved between their corresponding qubit operators and that the square of any fermionic edge or vertex operator is equal to the square of its corresponding qubit operator; and, simulating at least one fermionic interaction on the quantum information processor by enacting unitary qubit operations generated by the qubit operators on the qubits of the quantum information processor. This process can be thought of in terms of using the connectivity and interrelationships between the modes of the system to be simulated to inform the encoding scheme on the quantum computer. In particular, the set of operators for encoding onto the quantum computer is selected to reflect the connectivity/interrelationships of the system to be studied. In addition, the connectivity of the qubits on the quantum computer informs the choice of operators for encoding. For example, if simulating a 3d material system using a quantum computer whose qubits have the connectivity of a 2d lattice, one may choose to collapse the 3d interaction pattern to a 2d encoding, at the cost of increasing the number of fermionic swap operations required in the simulation protocol. As another example, if using a quantum computer consisting of multiple small ion traps with all-to-all connectivity, connected to each other via long-range links, one may choose an encoding where clusters are contained within the small ion traps and long-range links are used only for interactions between clusters. This leads to the encoded state of the quantum computer reflecting the symmetries of the system under consideration and allows the quantum computer to efficiently simulate the system under consideration.

The process leverages the large computational resources of a classical computer to identify and capture the symmetries and interrelationships between the modes of the system to be simulated. The results of this complex calculation feeds directly into the control signals provided to the quantum computer, thereby to enable improved calculations on the quantum computer. In particular this ensures that the limited resources currently available are best utilised for the system being investigated.

By clustering the modes involved in the list of interactions, determining pairs of connected clusters, and defining fermionic operators acting between modes in the clusters and between pairs of connected clusters in this way, a set of fermionic operators may be provided for mapping to qubit operators which advantageously may take advantage of swap network protocols for simulating interactions between modes in the same cluster (which are preferably have denser interactivity than with modes outside the cluster) while the (preferably sparser) connectivity between clusters can be handled by a particular choice of fermion-to-qubit encoding. The fermionic interactions may thus be more efficiently simulated by a sequence of unitary qubit operations on the qubits of the quantum computer. The unitary qubit operators for simulating the interactions may correspond to fermionic unitary interactions generated by the plurality of fermionic edge and vertex operators, where that correspondence may be determined, preferably uniquely determined, by the encoding. Encoding the plurality of fermionic edge and vertex operators as corresponding qubit operators preferably involves encoding as qubit operators that act on a small number of qubits (i.e. the corresponding qubit operators are low weight). The unitary qubit operation may comprise one or more fermionic swap operations, whereby the fermionic swap operations may transform the fermionic unitary operations which are not generated by a small number of the plurality of the fermionic edge and vertex operators into operations which may be generated as such thereby since the plurality of fermionic edge and vertex operators may be encoded as qubit operators acting on a small number of qubit, the unitary qubit operations may thus be implemented on the quantum computer via a low depth quantum circuit and so provide an efficient quantum simulation.

Clusters in a pair of connected clusters may be described as having a connection between them. Clusters and their connections may be represented graphically, for example, with a vertex representing a cluster and an edge representing the connection between a pair of connected clusters. Fermionic edge and vertex operators may similarly be represented graphically with modes associated with a vertex operators being a vertex of the graph, and modes acted on by a fermionic edge operator having an edge between them. Preferably there is only one fermionic edge operator between each pair of connected clusters.

Preferably, determining disjoint clusters of modes is in dependence on one or more properties of the list of interactions between fermionic modes, preferably wherein the one or more properties relate to the physics of the fermionic system to be simulated.

Advantageously, the modes may thus be clustered such that the clustering may reflect the underlying structure and/or physics of the interactions and/or of the system to be simulated, for example, such that clusters correspond to modes which interact frequently with each other or with a large number of other modes in the cluster thereby such that the simulation of these interactions may be made more efficient, for example, by leveraging swap networks to simulate those interactions occurring between modes within the cluster.

Preferably a cluster of modes comprises modes which are more densely connected with each other in the interactivity graph than with modes outside the cluster.

This may advantageously increase the benefit of clustering since most interactions to be simulated may be handled efficiently using swap networks within clusters. In an example, the modes within each cluster may have all-to-all interactivity and each mode within a cluster may have an edge in the interactivity graph connecting it to just one corresponding mode in clusters to which it is connected.

In an example, the density, D, of a graph may be defined in terms of a ratio of a function of the number of edges present to the number of possible edges, for example. *D =* 2*E*/(*V*² *- V*), where E is the number of edges and V is the number of vertices. In an example, modes in a cluster may be more densely connected with each other than with the modes outside of the cluster if the density of the subgraph of the interactivity graph consisting of edges and vertices within the cluster is greater than the density of the whole graph. It will be appreciated that alternative measures of density and methods of comparing density are similarly applicable.

Preferably, the list of interactions is derived from a fermionic Hamiltonian.

Advantageously, the method may thus be applied to simulating physical systems governed by a particular Hamiltonian, for example, using a variational quantum eigensolver (VQE), trotterization steps, time-dynamics simulation (TDS), etc. The list of interactions may correspond to some or all of the interactions in the fermionic Hamiltonian.

Optionally, the modes are clustered in dependence on one or more properties of the fermionic Hamiltonian.

Advantageously, the properties of the fermionic Hamiltonian may be used to inform the clustering and thereby the encoding and simulating in order to tailor these to the specific Hamiltonian of interest in order to obtain lower circuit depths for simulating the interactions. In this way, the structure of the Hamiltonian is preserved in the interactivity graph, thereby allowing this structure to be exploited to improve efficiency in other stages of the encoding procedure.

Optionally, at least one property relates to a symmetry of the fermionic Hamiltonian, preferably wherein the clusters and the pairs of connected clusters are determined such that they retain the symmetry of the fermionic Hamiltonian.

Advantageously, the clustering may therefore closely reflect the structure of the Hamiltonian to be simulated, this may be particularly advantageous in the simulation of materials which may have a highly regular and/or symmetrical lattice structure.

Preferably, the clusters and the connections between the pairs of connected clusters are representable as a regular lattice.

Advantageously, the structure of the clusters may thus be easily representable and the encoding, particularly of fermionic edge operators acting between clusters, may be based on a regular fermion-to-qubit encoding which may reflect the underlying physical structure of the system to be simulated.

Optionally, the clusters are indexed by a cartesian coordinate and pairs of connected clusters only involve clusters within a prescribed cartesian neighbourhood of each other.

Advantageously, the structure of the clusters may thus be easily representable and the encoding, particularly of fermionic edge operators acting between clusters, may be based on regular local fermion-to-qubit encodings which may reflect the underlying physical structure of the system to be simulated and/or the quantum information processor on which it will be simulated.

Optionally, selecting pairs of connected clusters comprises selecting pairs of the candidate connected clusters having at least a threshold number of edges between them in the interactivity graph.

Advantageously, this may provide a simple method for determining which clusters are useful to connect in the encoding. For candidate connected clusters having only very few connection, it may not be advantageous to provide fermionic edge operators for encoding as qubit operators since simulation of such interactions may be rare or unimportant and may be handled in any case by the structure of the fermion-to-qubit encoding, for example, by indirect connections via intermediate clusters.

In an example, the threshold number of edges is one and accordingly all the candidate pairs of connected clusters are selected.

Optionally, each cluster is in no more than a threshold number of pairs of connected clusters.

By keeping the degree of connectivity between the clusters below a threshold it may make it easier to design particular encodings. In general, it may be desirable to minimize the degree of connectivity of the clusters while maximising the number of pairs of candidate clusters that are selected.

In an illustrative example, the clusters and the connections between the pairs of connected clusters are represented as a 2D nearest neighbour lattice with clusters as lattice sites and edges between the pairs of connected clusters. In this case, no cluster is in more than 4 connected pairs, i.e., each cluster has at most "degree" 4.

Optionally, encoding each of the plurality of fermionic edge and vertex operators as corresponding qubit operators comprises selecting a fermion-to-qubit encoding from a plurality of valid encodings.

There may be a number of possible valid fermion to qubit encoding that preserve the necessary relations between the plurality of fermionic operators. The plurality of valid encodings may be pre-determined, preferably algorithmically.

Optionally, the fermion-to-qubit encoding is selected based on one or more criteria.

This may allow a fermion-to-qubit encoding which is particularly suitable to the system to be simulated, or the kind of simulation, to be selected. In general, this may allow a fermion-to-qubit encoding to be selected that is optimal for the particular simulation task.

Optionally, at least one criterion is related to a weight of the qubit operators of the fermion-to-qubit encoding.

Advantageously, this may allow an encoding to be selected which permits a lower depth quantum circuit to be used in the simulations.

Optionally, at least one criterion is a related to one or more of: a weight of a highest weight qubit operator; a total weight of the qubit operators; a number of qubits in the quantum information processor; an average weight of the qubit operators; an arrangement of the qubits in the quantum information processor; a set of available quantum operations in the quantum information processor.

Advantageously, the fermion-to-qubit encoding may thus be tailored to the hardware (i.e. the quantum information processor) on which the simulation is to run, in line with the considerations discussed above, for example.

Preferably, the fermionic edge operators, *E*_{[**R**,*p*],[**R**,*q*]}, between modes within each cluster **R** form a linear sequence *E*_{[**R**,1],[**R**,2]}*E*_{[**R**,3],[**R**,4]} ··· *E*_{[**R***,nR*}-1],[**R***,n_{R}*], wherein [1, 2, ... *n*_{R}] is a linear ordering of every mode in the cluster, wherein the number of modes in the cluster is *n*_{R}.

Fermionic edge operators formed in such a way may be particularly suitable for the use of fermionic swap networks.

Alternatively, the fermionic edge operators between modes within each cluster **R** may form more than one linear sequence. This alternative may be particular advantageous where the structure of interactions between modes in a cluster permit means that certain interactions between modes within a cluster are absent due to a symmetry.

Preferably, the fermionic operators, *E*_{[**R**,*i*],[**R**',*j*]}, between connected clusters **R**, **R'** act on modes at the ends of the linear sequence, such that *i* = 1 or *n*_{R} and *j* = 1 or *n*_{R'}.

Advantageously, this may allow the linear orderings to be concatenated with those on neighbouring clusters.

Preferably, the fermionic edge operators, *E*_{[**R**,*i*],[**R**,*j*]}, between modes within each cluster are encoded as qubit operators in the same way as in a Jordan-Wigner transform having an identical linear ordering of modes.

This may be a particularly simple way of encoding the fermionic edge operators as qubit operators. Advantageously, the inventors have shown that the Jordan-Wigner transform combined with swap networks may yield optimal quantum circuit depths.

Optionally, each mode, [**R**,*j*], is associated with one data qubit of the quantum information processor such that the data qubits are also indexed by [**R**,*j*] and the fermionic edge operators, *E*_{[**R**,*p*],[**R**,*q*]}, between modes within each cluster are encoded as the qubit operators: *E̅*_{[**R**,*j*],[**R**,*j*+1]} = *X*_{[**R**,*j*]} *Y*_{[**R**,*j*+1]}, wherein *X* and *Y* are Pauli *X* and *Y* operators.

Advantageously, these qubit operators are low weight (weight 2) and so such encodings may yield low depth quantum circuits.

Optionally, each mode, [**R**,*j*], is associated with one data qubit of the quantum information processor such that the data qubits are also indexed by [**R**,*j*] and the fermionic vertex operators are encoded as the qubit operators: *V̅*_{[**R***,j*]} = *Z*_{[**R**,*j*]}, wherein *Z* is a Pauli *Z* operator.

Advantageously, these qubit operators are low weight (weight 1) and so such encodings may yield low depth quantum circuits.

Optionally, the clusters and their connections are representable as a square lattice and the index **R:** = [*a, b*] indexes the cluster's position in the square lattice up to a uniform coordinate translation; each mode [**R**,*j*] is associated with one data qubit of the quantum information processor such that the data qubits are also indexed by [**R**,*j*] and wherein [**R**,*m*] is the end of the linear ordering within the cluster and [**R**,*n*] is the start of the linear ordering within the cluster ancilla qubits are associated with those faces of the square lattice defined by edges connecting lattice positions [*a, b*], [*a* + 1, *b*]*,* [a*, b +* 1] and [*a +* 1, *b* + 1] where *a* + *b* is even, such that there is one ancilla qubit associated with each alternate face in a checkerboard pattern; and the fermionic edge operators *E*_{[***R***,*i*],[***R***',*j*]} between connected clusters are encoded as the qubit operators *E̅*_{[***R***,*i*],[***R**'*,*j*]} as follows:
if a is even: ${\overline{E}}_{\left[\left[a, b\right], m\right] , \left[\left[a,b+1\right], n\right]} = {X}_{\left[\left[a, b\right], m\right]} {Y}_{\left[\left[a,b+1\right], n\right]} {X}_{ancilla} ;$ ${\overline{E}}_{\left[\left[a, b\right], n\right] , \left[\left[a,b-1\right], m\right]} = {Y}_{\left[\left[a, b\right], n\right]} {\overline{X}}_{\left[\left[a,b-1\right], m\right]} {\overline{X}}_{ancilla} ;$ if *a* is odd then: ${\overline{E}}_{\left[\left[a, b\right], n\right] , \left[\left[a,b+1\right], m\right]} = {Y}_{\left[\left[a, b\right], n\right]} {X}_{\left[\left[a,b+1\right], m\right]} {X}_{ancilla} ;$ ${\overline{E}}_{\left[\left[a, b\right], m\right] , \left[\left[a,b-1\right], n\right]} = {X}_{\left[\left[a, b\right], m\right]} {Y}_{\left[\left[a,b-1\right], n\right]} {X}_{ancilla} ;$ if *b* is even then: ${\overline{E}}_{\left[\left[a, b\right], n\right] , \left[\left[a-1,b\right], m\right]} = {Y}_{\left[\left[a, b\right], n\right]} {X}_{\left[\left[a-1,b\right], m\right]} {Y}_{ancilla} ;$ ${\overline{E}}_{\left[\left[a, b\right], m\right] , \left[\left[a+1,b\right], n\right]} = - {X}_{\left[\left[a, b\right], m\right]} {Y}_{\left[\left[a+1,b\right], n\right]} {Y}_{ancilla} ;$ and
if *b* is odd then: ${\overline{E}}_{\left[\left[a, b\right], n\right] , \left[\left[a-1,b\right], m\right]} = - {X}_{\left[\left[a, b\right], m\right]} {Y}_{\left[\left[a-1,b\right], n\right]} {Y}_{ancilla} ;$ ${\overline{E}}_{\left[\left[a, b\right], m\right] , \left[\left[a+1,b\right], n\right]} = {Y}_{\left[\left[a, b\right], n\right]} {X}_{\left[\left[a+1,b\right], m\right]} {Y}_{ancilla} ,$ wherein *X, Y* and *Z* are Pauli operators, and wherein the ancilla qubit in each of the qubit operators *E̅*_{[[*a,b*]*,m*],[[*a',b*']*,n*]} is that associated with the alternate face incident on the edge of the lattice connecting vertices [[*a*, *b*], *m*] and [[*a', b*']*, n*].

Advantageously, this fermion-to-qubit encoding results in low-weight qubit operators (at most weight 3) for each of the plurality of fermionic edge and vertex operators. This may yield particularly efficient quantum circuits for simulating the interactions. The encoding also has a simple local two dimensional structure which may be particularly amenable to simulating systems having a similar structure and/or simulating on a quantum information processors whose qubits are laid out in a similar structure.

Optionally, the clusters and their connections are representable as a cubic lattice and the cluster index **R**: = [*a, b, c*] indexes the cluster's position in the cubic lattice up to a uniform coordinate translation; one data qubit of the quantum information processor is associated with each mode [**R**,*j*] such that the data qubits are also indexed by [**R**,*j*] and wherein [**R**,*m*] is the end of the linear ordering within the cluster and [**R**,*n*] is the start of the linear ordering within the cluster; ancilla qubits are associated with those faces of the cubic lattice defined by edges connecting lattice positions: [*a, b, c*]*,* [*a +* 1, *b, c*]*,* [*a, b +* 1, *c*] and [*a* + 1, *b* + 1, *c*] where *a* + *b* is even and for every fixed c, [*a, b, c*], [*a +* 1, *b, c*], [*a, b, c +* 1] and [*a +* 1, *b, c +* 1] where *a* + *c* is even and for every fixed b, and [*a, b, c*], [*a, b +* 1, *c*], [*a, b, c +* 1] and [*a, b +* 1, *c* + 1] where *b + c* is even and for every fixed a, such that there is one ancilla qubit associated with each alternate face in a checkerboard pattern on the square lattice defined by any cross-section of the cubic lattice at a fixed *a*, *b* or *c*; and the fermionic edge operators *E*_{[***R***,*i*],[***R***',*j*]} between connected clusters are encoded as the qubit operators *E̅*_{[***R***,*i*],[***R**'*,*j*]} as follows:
if *a + c* is even then: ${\overline{E}}_{\left[\left[a, b, c\right], m\right] , \left[\left[a,b+1,c\right], n\right]} = {X}_{\left[\left[a, b, c\right], m\right]} {Y}_{\left[\left[a,b+1,c\right], n\right]} {Y}_{ancilla} {Y}_{ancilla} ;$ ${\overline{E}}_{{}_{\left[\left[a, b, c\right], n\right] , \left[\left[a,b-1,c\right], m\right]}} = {Y}_{\left[\left[a, b, c\right], n\right]} {X}_{\left[\left[a,b-1,c\right], m\right]} {Y}_{ancilla} {Y}_{ancilla} ;$
if *a + c* is odd then: ${\overline{E}}_{\left[\left[a, b, c\right], n\right] , \left[\left[a,b+1,c\right], m\right]} = {Y}_{\left[\left[a, b, c\right], n\right]} {X}_{\left[\left[a,b+1,c\right], m\right]} {Y}_{ancilla} {Y}_{ancilla} ;$ ${\overline{E}}_{\left[\left[a, b, c\right], m\right] , \left[\left[a,b-1,c\right], n\right]} = {X}_{\left[\left[a, b, c\right], m\right]} {Y}_{\left[\left[a,b-1,c\right], n\right]} {Y}_{ancilla} {Y}_{ancilla} ;$
if *a + b* is even then: ${\overline{E}}_{\left[\left[a, b, c\right], m\right] , \left[\left[a,b,c+1\right], n\right]} = {X}_{\left[\left[a, b, c\right], m\right]} {Y}_{\left[\left[a,b,c+1\right], n\right]} {Z}_{ancilla} {Z}_{ancilla} ;$ ${\overline{E}}_{\left[\left[a, b, c\right], n\right] , \left[\left[a,b,c-1\right], m\right]} = {Y}_{\left[\left[a, b, c\right], n\right]} {X}_{\left[\left[a,b,c-1\right], m\right]} {Z}_{ancilla} {Z}_{ancilla} ;$
if *a + b* is odd then: ${\overline{E}}_{\left[\left[a, b, c\right], n\right] , \left[\left[a,b,c+1\right], m\right]} = {Y}_{\left[\left[a, b, c\right], n\right]} {X}_{\left[\left[a,b,c+1\right], m\right]} {Z}_{ancilla} {Z}_{ancilla} ;$ ${\overline{E}}_{\left[\left[a, b, c\right], m\right] , \left[\left[a,b,c-1\right], n\right]} = {\overline{X}}_{\left[\left[a, b, c\right], m\right]} {\overline{Y}}_{\left[\left[a,b,c-1\right], n\right]} {\overline{Z}}_{ancilla} {\overline{Z}}_{ancilla} ;$
if *b + c* is even then: ${\overline{E}}_{{}_{\left[\left[a, b, c\right], n\right] , \left[\left[a-1,b,c\right], m\right]}} = {Y}_{\left[\left[a, b, c\right], n\right]} {X}_{\left[\left[a-1,b,c\right], m\right]} {X}_{ancilla} {X}_{ancilla} ;$ ${E}_{\left[\left[a, b, c\right], m\right] , \left[\left[a+1,b,c\right], n\right]} = {X}_{\left[\left[a, b, c\right], m\right]} {Y}_{\left[\left[a+1,b,c\right], n\right]} {X}_{ancilla} {X}_{ancilla} ;$ and
if *b* + *c* is odd then: ${\overline{E}}_{\left[\left[a, b, c\right], n\right] , \left[\left[a-1,b,c\right], m\right]} = {X}_{\left[\left[a, b, c\right], m\right]} {Y}_{\left[\left[a-1,b,c\right], n\right]} {X}_{ancilla} {X}_{ancilla} ;$ ${\overline{E}}_{\left[\left[a, b, c\right], m\right] , \left[\left[a+1,b,c\right], n\right]} = {Y}_{\left[\left[a, b, c\right], n\right]} {X}_{\left[\left[a+1,b,c\right], m\right]} {X}_{ancilla} {X}_{ancilla} ,$
wherein *X, Y* and *Z* are Pauli operators, and wherein *X, Y* and *Z* are Pauli operators, and wherein the ancilla qubits in each of the qubit operators *E̅*_{[[***a,b,c***]*,m*],[[***a',b',c**'*]*,n*]} are those arranged on the faces incident on the edge of the lattice connecting vertices [[*a, b, c*], *m*] and [[*a', b', c'*]*, n*].

Advantageously, this fermion-to-qubit encoding results in low-weight qubit operators (at most weight 4) for each of the plurality of fermionic edge and vertex operators. This may yield particularly efficient quantum circuits for simulating the interactions. The encoding also has a simple local three dimensional structure which may be particularly amenable to simulating systems having a similar structure and/or simulating on a quantum information processors whose qubits are laid out in a similar structure.

It will be understood that that a coordinate system [*a, b*] or [*a, b, c*] *etc.* may be uniformly translated without loss of generality, i.e. where, for example, statements such as "*a + b* is even" is merely a convenient convention for describing the relative structure of elements in a coordinate system. The skilled person would understand, for example, that relabelling *a* to *a* + 1 would entail that statements such as "*a* + *b* is even" would be replaced by "*a* + *b* is odd" *etc*.

Preferably, the unitary qubit operations correspond to a fermionic unitary operation generated by products of the fermionic edge and vertex operators.

Preferably, simulating at least one fermionic interaction comprises: determining one or more fermionic unitary operations generated by products of a number of fermionic edge and/or vertex operators; and determining a fermionic swap network to reduce the number of fermionic edge and vertex operators, thereby to reduce the weight of the corresponding unitary qubit operators.

Advantageously, a fermionic unitary operation which may correspond to a product of fermionic edge and/or vertex operators which would otherwise result in a high weight qubit operator may be transformed into one which has a low weight representation.

Preferably, fermionic swap networks protocols acting on disjoint modes are implementable by the quantum information processor in parallel.

Advantageously, this decreases the run-time of the simulation. This may be particularly advantageous for non-fault tolerant quantum information processors in which qubits may have relatively short coherence times.

Optionally, the qubits of the quantum information processor comprise physical qubits.

Simulations may thus be run on noisy intermediate scale (NISQ) quantum information processors without fault-tolerance. This low depth circuits for simulations of fermionic systems provided by the present invention may be particularly advantageous as they permit such simulations to be run on near-term quantum computers with tens or hundreds of qubits.

Optionally, the qubits of the quantum information processor comprise logical qubits.

The simulations may thus be run on an error-correcting and/or fault tolerant quantum information processor wherein logical qubits are made up of a plurality of physical qubits and may be operated on by logical qubit operations.

Optionally, the graph is a hypergraph, the vertices of the hypergraph corresponding to the modes, and hyperedges connecting vertices which correspond to modes between which an interaction exists in the Hamiltonian, and wherein determining the clusters of modes comprises: identifying sets of vertices of the hypergraph for which at least a threshold number of hyperedges between the vertices in the set are present.

This may provide a particularly simple method of determining clusters of modes such that highly interactive modes are clustered together.

Also disclosed herein is a method of compiling a quantum circuit comprising swap layers and interaction layers for performing quantum operations on a quantum information processor. The method is defined by claim 1.

Advantageously, constructing a swap layer in this way may allow as many interactions as possible to be performed on the subsequent interaction layer and may reduce the overall number of swaps required thereby to allow for a quantum circuit of low depth to be compiled. The distances may be examples of internal distance functions of the interactions. The graph cost may be an example of a total distance function, based on the internal distance functions. In an example, the graph costs may be an Lp norm.

An important innovation here has been to identify that a trade-off can be made between the quantum compute resources involved in adding swap operations prior to performing the calculation and/or measurement operations for a process, when compared with performing the operations without any swaps. It may be helpful to think of this as optimising the computational parameters by using simple swap operations (which are reasonably low-depth) to simplify the time-dynamics simulation and measurement operators (which are generally higher depth and depend strongly on the "distance" spanned by the operator). The operational parameters of the quantum computer can be used to inform this process, as the noise level in the quantum computer will affect the circuit depth/complexity which can reasonably be expected to run with a desired level of accuracy and reliability. In addition, certain quantum hardware platforms have varying costs for varying operations - for example, a swap operation may be a different cost to simulating time-dynamics for a small time. This in turn informs the process in the sense that where the native (i.e. un-swapped) gate arrangement for a calculation or measurement exceeds a particular depth or complexity threshold, it will be beneficial to simplify the procedure using swaps. In general for simulation of complex systems envisaged herein, there will almost always be calculations or measurements which will benefit from including a swap procedure to reduce the depth/complexity of the calculation or measurement.

It is once more a beneficial division of labour to leverage the high throughput capabilities of classical computing to identify available swaps for a given simulation and calculate the changes in overall cost in doing so. Once these resource-intensive calculations have been completed, the simulation itself can proceed in the quantum computational environment at improved efficiency, thereby leveraging the bespoke properties of the quantum computer for performing simulations of the quantum system to be investigated.

Preferably, the vertices are associated with modes of a fermionic Hamiltonian and the plurality of interactions are interactions of modes in the fermionic Hamiltonian, preferably wherein the edges of the graph connect fermionic modes which are efficiently swappable by a fermionic swap operation.

Advantageously, this allows building up of a quantum circuit to simulate the interaction in a fermionic Hamiltonian which has a low depth, this may allow such simulations to be performed, for example, on small and/or noisy quantum information processors or to improve the performance of such simulations on quantum information processors in general.

Optionally, the graph is an encoding graph of a fermion to qubit encoding.

Encoding fermionic operators as qubit operators may lead to qubit operators which are high weight, by swapping modes of an encoding graph of a fermion-to-qubit encoding such that modes which are interacting are made closer (or, for example, adjacent) in the encoding graph the weight of the qubit operators for simulating that interaction may be reduced.

Preferably, the vertices are associated with qubits and the edges connect qubits which are swappable by a qubit swap operation or a fermionic swap operation.

Advantageously, the method may be used to reduce the circuit depth for simulating fermionic interactions on qubits and/or for simulating or compiling any quantum circuit with or to another quantum circuit comprising swap layers and interaction layers.

Optionally, step (b) further comprises: determining a vertex list of all vertices involved in the plurality of interactions; determining a Steiner tree, wherein the Steiner tree is a tree in the graph that connects the vertices in the vertex list; and determining whether the Steiner tree has fewer vertices than the graph and, if so, replacing the graph with the Steiner tree.

This may further improve the efficiency of the method by reducing the size of the graph for which the graph cost is determined.

Preferably, the distances are computed based on a minimum path length between vertices, more preferably between pairs of vertices within interactions.

Advantageously, the distances are thus closely related to the number of swaps required to make vertices in an interaction adjacent and so the minimising a graph cost based on such distances is a good heuristic for minimising the number of swaps which need be implemented.

Preferably, the graph cost is based on a sum of a function of the distances, preferably the sum being in terms of the distances of all the interactions.

This may provide a graph cost which characterises the overall cost of performing the interactions on the graph.

Preferably, determining the graph cost comprises calculating: (Σ*_{T}d*(*T*)*^{p}*)^{1/*p*} , wherein *T* is the interaction, *d*(*T*) is the distance of the interaction on the graph, the sum is over all of the interactions and 0 < *p* ≤ 1, preferably wherein 0.25 *< p* < 0.75, more preferably wherein *p* = 0.5. Optionally, *d*(*T*) is defined as the minimum, over all possible splits of the modes in the interaction *T* into pairs of the distance within the encoding graph between those modes.

Advantageously, the graph cost calculated in such a fashion may place greater weight on bringing terms with low distance closer together and has been found to produce particularly efficient layers of swap and interactions layers. Choosing *p* = 0.5 has been found empirically by the inventors to produce good results.

Optionally, distances are computed based on a function of indices of the quantum systems associated with the vertices, preferably wherein the indices are Majorana indices.

This is particularly useful in realistic use cases of simulating quantum systems, such as systems where two Majorana indices reside on each (fermionic) mode associated with the vertices of the graph. The distance may then account for quartic interactions of modes consisting, for example, of four Majorana indices which may require, for example that two mode-pairs are adjacent simultaneously for an interaction to be performed.

Preferably, at least one of the plurality of interactions is a quadratic interaction comprising a pair of vertices of the graph. Quadratic interactions are common features of interacting quantum systems, so this provides a method applicable to a wide range of systems which may be usefully simulated.

Preferably, at least one of the plurality of interactions is a quartic interaction comprising a quartet of vertices of the graph.

Quartic interactions are common features of interacting quantum systems, so this provides a method applicable to a wide range of systems which may be usefully simulated.

Preferably, the quartic interaction comprising four vertices is split into two pairs of vertices.

Quartic interactions may be dealt with simply in an analogous way to quadratic interactions.

Preferably, the distance of a quartic interaction is based on the sum of the distance of each pair of vertices.

This simple method of calculating the distance of a quartic interaction may be sufficient in many cases, and thus quadratic and quartic interactions may be dealt with in a simple and similar way. The distance between certain pairs in the quartic interaction may not be important in many useful scenarios, for example, fermionic quartic interactions encoded as qubit operations on qubit may benefit from strings of Pauli operators cancelling which obviates the need to consider the distance between certain pairs.

Preferably, steps (c)-(e) are iterated to determine a plurality of interleaved swap layers and interaction layers until each of the plurality of interactions has been included in at least one interaction layer.

This may provide for a quantum circuit to simulate all of the interactions which is optimised for low circuit depth.

Optionally, the quantum operations are native quantum operations of the quantum information processor.

This may be particularly advantageous in providing a circuit to simulate the interactions which can be implemented directly on the quantum information processor.

Optionally, the quantum operations are two-qubit quantum gates.

This may provide a simple circuit suitable for implementing on a wide range of quantum information processors.

Preferably, the quantum swap operations comprise fermionic swap operations and/or qubit swap operations.

This may be particularly suitable for simulating fermionic quantum systems on qubits.

Optionally, the vertices of the graph are associated with qubits of the quantum information processor, and the edges of the graph are associated with qubits of the quantum information processor which are configured to interact with each other.

This may be particularly advantageous for compiling a quantum circuit suitable for implementing on a particular layout of qubits in a quantum information processor.

Optionally, the method may further comprise: determining after step (e) whether the graph is semi-Eulerian, and if the graph is semi-Eulerian: (m) determining further swap and interaction layers of the quantum circuit by: (i) forming a new graph from the Euler path edges of the graph; (ii) adding vertex swaps corresponding to odd-indexed edges of the new graph to an odd swap layer; (iii) adding the ones of the plurality of interactions whose vertices are connected by edges after the swap layer to an odd interaction layer; (iv) updating the new graph according to the vertex swaps of step (m)(ii); (iv) adding vertex swaps corresponding to even-indexed edges of the new graph to an even swap layer; (v) adding the ones of the plurality of interactions whose vertices are connected by edges after the swap layer to an even interaction layer; (vi) updating the new graph according to the vertex swaps of step (m)(v); (vii) iterating steps (m)(ii)-(vi) until each of the plurality of interactions has been included in at least one odd or even interaction layer; (n) adding further layers of quantum swap operations to the quantum circuit for swapping qubits or swapping labels of qubits of the quantum information processor corresponding to the vertex swaps in the odd and even swap layers; and (o) interleaving the further layers of quantum swap operations in the quantum circuit with further layers of quantum operations for interacting qubits of the quantum information processor corresponding to the interactions in the corresponding odd and even interaction layers.

Advantageously, this may permit a chain swap network protocol to be used where appropriate to reduce the computational cost of determining the swap and interaction layers.

Preferably, the plurality of interactions comprise quadratic interactions involving two vertices of the graph and quartic interactions involving four vertices of the graph, and the method further comprises: before step (c), determining whether the graph is semi-Eulerian, and if the graph is semi-Eulerian: (x) determining swap and interaction layers for the quantum circuit by: (i) forming a new graph from the Euler path edges of the graph; (ii) adding vertex swaps corresponding to odd-indexed edges of the new graph to an odd swap layer; (iii) adding the ones of the plurality of interactions whose vertices are connected by edges after the odd swap layer to an odd interaction layer; (iv) updating the graph according to the vertex swaps of step (x)(ii); (v) adding vertex swaps corresponding to even-indexed edges of the new graph to an even swap layer; (vi) adding the ones of the plurality of interactions whose vertices are connected by edges after the swap layer to an even interaction layer; (vii) updating the graph according to the vertex swaps of step (x)(v); (viii) iterating steps (x)(ii)-(vii) until each of the plurality of quadratic interactions has been included in at least one odd or even interaction layer, wherein, step (c) follows step (x) for those quartic interactions not present in at least one odd or even interaction layer; (y) adding layers of quantum swap operations to the quantum circuit for swapping qubits or swapping labels of qubits of the quantum information processor corresponding to the vertex swaps in the odd and even swap layers; and (z) interleaving the layers of quantum swap operations in the quantum circuit with layers of quantum operations for interacting qubits of the quantum information processor corresponding to the interactions in the corresponding odd and even interaction layers.

Advantageously, the chain swap network may thus be used to determine the swap and interactions layers to perform the quadratic interactions at low computation cost, while the quartic interactions may be handled by consideration of the graph cost, thereby to determine with lower computational cost a set of interleaved swap and interactions layers for compiling the quantum circuit.

Preferably, the method further comprises: performing the quantum circuit on the quantum information processor.

Advantageously, the low depth quantum circuit compiled by the above method may then provide faster and more reliable results of calculation run on the quantum information processor.

Also disclosed herein is an unclaimed method of improving the efficiency of a quantum computational measurement of a set of quadratic Majorana operators describing a Hamiltonian encoded on a set of qubits, {α, β, γ, δ ...} of a quantum computer, the method comprising: identifying a subset of the Majorana operators having M members, each member corresponding to an interaction which is to be measured between modes in the Hamiltonian; allocating a portion of the qubits into a subset of data qubits and optionally allocating a separate subset of the qubits into ancilla qubits, and fixing an ordering of the data qubits; writing the Majorana operators in terms of products of two Pauli strings which operate on the data qubits and which optionally also operate on one or more ancilla qubits, where each Pauli string on the data qubits comprises one or more Pauli operators X, Y or Z, each Pauli operator operating on a specific qubit in the array of qubits, and each Pauli string of length 1 consisting of one Z, and each Pauli string of length two or more having ends Aᵢ and Bⱼ selected from the set {X,Y} and wherein indices of the set {i, j, k, I...} denote specific qubits in the array of qubits {α, β, γ, δ...} on which the ends of the string operate; and identifying at least one sub-subset of Majorana operators within the subset which can be simultaneously measured, the sub-subset of Majorana operators including at least a first Majorana operator acting on data qubits i ≤ j and a second Majorana operator acting on data qubits k ≤ l, and in which in the first and second Majorana operators are non-crossing; wherein a pair of Majorana operators are defined as non-crossing if any one of the following non-crossing criteria are met: $j < k ;$ or $l < i ;$ or $i < k \leq l < j ;$ or $k < i \leq j < l ;$ or
i = j and k = l; or
i = k and j = l and A and B are selected such that the ends of the Pauli strings representing the first and second Majorana operators are each selected from either the set {XX,YY} or the set {XY,YX}; and wherein the Majorana operators also commute qubitwise on the ancilla qubits; and simultaneously measuring the Majorana operators in each sub-subset in a series of sequential measurements until all Majorana operators in the subset have been measured.

This method provides a protocol for reliably and efficiently identifying those operators which can be measured simultaneously and proceeding to implement the identified measurements simultaneously. This allows for improvements in the overall simulation procedure because the measurement step can be implemented in fewer rounds than with previous methods. In some cases, the above method provides the smallest possible number of measurement rounds for a given set of operators to be measured by leveraging this simultaneous measurement protocol.

Since classical computers are able to handle complex problems in the field of combinatorial mathematics, leveraging their high computational throughput to break down a problem such as this into computable subunits on a quantum computer. It is not apparent *a priori* that the use of graph theory and combinatorial mathematics would be of such use in this context. By noting the resource availability on the quantum computer, the much higher computational power of the classical system is leveraged to provide vastly improved quantum computational resource efficiency when making the measurements. This is because allowed simultaneous measurements of the strings are identified classically, but implemented on the quantum system meaning that fewer measurement rounds are required, thereby improving the overall protocol. This process provides a balance between having few measurement rounds and having low-depth measurement circuits. This directly utilises the parameters of the quantum computer in the sense that having few measurement rounds is desirable, especially on quantum computers with a slow clock speed, because it directly translates into the time required for the protocol; whereas having low-depth measurement circuits is desirable for quantum computers with low-fidelity gates because it directly translates into the level of errors affecting the measurement results. Therefore, the balance provided by the present protocol is particularly beneficial for quantum computers with both relatively slow clock speeds, and relatively low gate fidelities. Broadly, the use of Majorana operators allows non-crossing criteria to be discussed without fixing the measurement format in advance. This method therefore defines a non-crossing condition, which in turn allows terms which satisfy that condition to be measured simultaneously. The subset of Majorana operators within the set may be all of the quadratic operators within the set, or it may be only a subset, for example a subset of particular interest or for modelling a particular aspect of the system, answering a specific question about the modelled system, etc.

The method begins with the assumption that a set of operators to be measured has been provided, deduced, calculated, etc. in line with the protocols discussed generally herein. The form of the operators is fixed by the encoding of an underlying physical Hamiltonian (also discussed elsewhere herein) that is used. The current method takes this situation as an input and assesses how best to measure the operators. That is to say that there is no freedom to choose the form of the operators, e.g. selection of the form of the operators to ensure that a given set of operators is non-crossing and so can be measured simultaneously is not possible in this method.

The form of the Majorana operators in terms of products of two Pauli strings may therefore take different forms depending on the specific encoding scheme used. In particular where a Pauli string includes no ancilla qubits, the string has the form A... Z..B, i.e. a string of one or more Z operators separating two end operators each selected from the set {X,Y}. In other words, A and B collectively form ends of a string of the form X...X; X...Y; Y...X; or Y...Y. Where one or more ancilla qubits are present in the Pauli string, the encoding scheme will determine the form of the operator. Specific examples of this are set out elsewhere herein. In some cases there may even be zero Zs separating A and B. It is also possible for A and B to act on the same qubit, in which case the resulting operator is effectively just a single Z (because X*Y = Z, up to a constant, the imaginary number *i* in this case). In summary, each Pauli string can act nontrivially on an arbitrary number of qubits, from 1 (in which case it looks like Z), to 2 (in which case it looks like XX, XY, YX or YY), or more.

Note that the M operators correspond to a set of M interactions in the Hamiltonian. This correspondence ties the Majorana operators to the physical system being simulated (expressed in the Hamiltonian). In other words the correspondence represents a mapping between the simulated physical system (the Hamiltonian) and a physical state of a real system (ultimately the qubits of the quantum computer).

The method uses a single pair of operators as the basic block. This is advantageous as the most basic core of the measurement is the concept of non-crossing operations, which can be defined clearly in terms of pairs of Pauli strings according to the above criteria. Of course, more complex assessments can be made to widen the applicability of this concept, as set out in detail below.

Note that the assignment of labels to modes is a free choice, so long as the labels are consistently used throughout the process. For example the labelling could be chosen to maximise efficiency in other parts of the quantum simulation algorithm, by choosing an ordering such that the strings of Pauli operators have low weight (few non-identity parts). This would correspond to mapping a notion of locality in the original operator into a Jordan-Wigner ordering. It is often desirable for modes which are close physically (in the simulated model underlying the Hamiltonian) to be close within the mode index ordering because most interactions are between modes which are physically close, so this means that most interactions will be low weight, thereby tailoring the simulation protocol to the anticipated parameters of the quantum computer.

Optionally, the identifying step identifies additional Majorana operators which are all mutually non-crossing, meaning that any pair of Majorana operators selected from the set of first, second and all additional Majorana operators satisfies at least one of the non-crossing criteria. As will be apparent, the non-crossing criteria help to identify whether any pair of operators can be simultaneously measured, so performing a check that each possible pair within a set satisfies at least one of the non-crossing criteria means that the full set can be simultaneously measured. This allows for measurement rounds to be constructed which have an arbitrarily large number of measurements in them, subject only to the criterion that each measurement is mutually non-crossing with the other measurements.

Optionally the split into subsets of mutually non-crossing Majorana operators is identified using a graph colouring algorithm to identify sets of simultaneously measurable Majorana operators. The inventors have found that the process for identifying groups of non-crossing operators is mathematically equivalent to the procedures for understanding graph colouring (i.e. how many colours are needed to uniquely colour the edges of a graph such that no two edges of the same colour terminate at the same vertex). The skilled person will recognise that this is a well-studied problem in graph theory, and consequently the use of graph colouring in this context allows the findings of graph theory to be applied to this situation.

The method may further include measurements of quartic Majorana operators. In the context of the present invention, quartic Majorana operators are defined as a product of two quadratic Majorana operators written as Pauli strings operating on disjoint data qubits. To measure a quartic operator of this form, the method includes as part of the identifying step, identifying a plurality of quartic Majorana operators which can be measured simultaneously by identifying quartic Majorana operators in which all pairs of the distinct quadratic Majorana operators which form part of the quartic Majorana operators satisfy at least one non-crossing criterion. This specifies that all pairs of quadratic operators making up the two quartic operators satisfy at least one of the non-crossing constraints set out above. That is, if the first operator is AB and the second one is CD, the pairs (A,C), (A,D), (B,C), (B,D) must each satisfy at least one non-crossing constraint. This process advantageously extends the measurement protocol from quadratic terms to quartic terms in a Hamiltonian describing the system. Optionally, the method further includes performing the measurement and iterating on a set of all quartic Majorana operators which are to be measured until all quartic Majorana operators in the set have been measured.

Optionally, the set of all quartic Majorana operators which are to be measured is described by a set of matchings constructed such that each possible quadruple of modes {i,j,k,l} acted on by the Majorana operators appears in a matching from the set of matchings as the union of the pairs:
{i,j} and {k,l}; or
{i,k} and {j,l}; or
{i,l} and {j,k}.

As used herein and in particular in the context of measurement, "matching" is used in the specific sense of the graph theory meaning. This may be defined loosely as "a choice of a set of edges in the graph for which no edges in the set share any vertices". Thus at a high level this defines the subsets which need to be identified within the set of operators to complete the desired measurements.

Optionally, the graph colouring algorithm includes a non-crossing protocol in which: all possible pairs in a set of size M are identified into a set of M matchings {L₁, L₂,.. L_{M}}, such that the *p*^{th} matching Lₚ includes all pairs of modes {q, p-q modulo M}, for all q. Since the set of size M has a direct correspondence with the M operators to be measured, this provides a clear method for logically identifying the sets of operators which can be measured in a single measurement cycle (corresponding to a matching), and hence allows all the pairs in the full set of M operators to be measured in a series of simultaneous measurements. This in turn provides a reduction in the number of measurement cycles required to measure each pair in the set.

Optionally, the graph colouring algorithm includes: dividing the subset of M modes into blocks of size 2ⁿ where n is an integer between 1 and log₂(M); for each value of n: dividing each block into two sub-blocks and using the non-crossing protocol to identify all possible pairs in each sub-block in a set of non-crossing matchings within each sub-block; and extending the matchings from the first sub-block to the second sub-block to identify all quadruples having a first pair in the first sub-block and a second pair in the second sub-block. This step is equivalent to finding an edge colouring of the complete bipartite graph, and thereby allows various aspects of graph theory to advantageously be applied to the solution.

Optionally the graph colouring algorithm further includes: dividing the subset of M modes into blocks of size 2ⁿ where n is an integer between 1 and [log₂(M)-1]; for each value of n: generating a first list of matchings which covers each pair in a list of labels {1,2,...,M·2⁻ⁿ} indexing each individual block of size 2ⁿ ; using the pairs in each matching {{a₁,b₁}, {a₂,b₂}...} as indices to form, in parallel a first block, Bₐᵢ, and a second block, B_{bi}, for all i, thereby identifying each possible pairing of blocks of size 2ⁿ; for each first and second block so identified, splitting the first block into first and second sub-blocks and splitting the second block into third and fourth sub-blocks; using the non-crossing protocol to generate a non-crossing second list of matchings which includes all pairs with an element in one of the first and second sub-blocks and another element in one of the third and fourth sub-blocks; for each matching from the second list of matchings, extending that matching to cover each pair in the other of the first and second sub-blocks and the other of the third and fourth sub-blocks from those which were used to form that matching, thereby to provide a list of matchings which covers all quadruples having either: an element in the first block, and three elements in the second block, the elements in the second block including at least one element in each of the third and fourth sub-blocks; or three elements in the first block, and one element in the second block, the elements in the first block including at least one element in each of the first and second sub-blocks. These features provide a method for identifying all quadruples of a particular form, which is a useful step in identifying the components in a quartic operator which can be measured simultaneously.

Optionally, the set of quartic Majorana operators to be measured includes M' operators which only act non-trivially on three of the M modes, corresponding to Pauli string measurements of the form: ${X}_{i} \left({\prod }_{i < j < k} {Z}_{j}\right) {Y}_{k} {Z}_{l} or {Y}_{i} \left({\prod }_{i < j < k} {Z}_{j}\right) {X}_{k} {Z}_{l}$
for *i < k* and *l* ∉{*i,k*}
in which {*i, j, k, l}* are indices denoting qubits in the qubit array and wherein the non-crossing protocol is used to identify a set of non-crossing matchings in which all possible pairs in the set of size M' occur in at least one matching; and wherein for each matching a set of log₂(M'/2) measurement settings is provided such that the v^{th} measurement setting measures the u^{th} pair in the matching in: the {XY, YX, ZZ} basis if the v^{th} bit of the binary representation of u is 0; or the {ZI, IZ} basis if the v^{th} bit of the binary representation of u is 1. This procedure allows the identification of a special class of operators, those which operate non-trivially on only three modes. Having identified these operators, the non-crossing criteria described herein are applied in the usual manner discussed elsewhere to identify a set of matchings which covers all pairs in the set.

Once this has happened, it is important to perform the measurements of each pair in a couplet of pairs in a different basis. This is achieved in the procedure set out above by selecting a measurement basis for each pair in each matching (referred to generally as a measurement setting) in a logical and consistent manner. Note that the actual ordering of the pairs within a matching is arbitrary - so long as the same ordering is used throughout, the above method will result in a logical route to stepping through each pair in turn. Likewise, the use of a binary representation for the pair number to determine the measurement basis results in each pair in a couplet of pairs being measured in a different measurement basis, thereby satisfying the conditions above. The ordering of the measurement settings is also arbitrary so long as the same ordering is used throughout. The skilled person will note that there are other protocols which achieve this in different, but equivalent ways. For example, the protocol above would work equally well by swapping 0 and 1 (so that the {XY, YX, ZZ} basis is used if the v^{th} bit of the binary representation of u is 1; or the {ZI, IZ} basis is used if the v^{th} bit of the binary representation of u is 0).

Optionally, measurement includes measuring the pair of qubits at the endpoints of the operator in the basis where {XX, YY, ZZ} are diagonal where the endpoints of the Pauli string are XX or YY, or measuring the pair of qubits at the endpoints of the operator in the basis where {XY, YX, ZZ} are diagonal where the endpoints of the Pauli string are XY or YX. Optionally all data qubits other than the endpoint qubits are measured in the Z basis, and all ancilla qubits are measured in a basis determined by the qubitwise commutativity constraint. This provides a measurement in a suitable basis, specifically adapted to the string type being measured.

Optionally, the encoding of the Hamiltonian uses an interactivity graph to identify clustering in the modes of the Hamiltonian. Once more the use of an interactivity graph allows for an alternate viewpoint of the system. This not only allows densely connected parts of the Hamiltonian to be identified, but also opens up various theorems from the field of graph theory to be applied to the system to assist in analysing the systems being modelled.

Optionally, vertices of the interactivity graph are uniquely associated with the modes of the Hamiltonian, and edges of the interactivity graph connect every pair of vertices whose associated pair of modes are involved in an interaction together; and wherein identifying clustering includes determining disjoint clusters of modes, wherein a cluster of modes comprises modes which are more densely connected with each other in the interactivity graph than with modes outside the cluster, and determining connected clusters, wherein a first cluster of modes is connected to a second cluster of modes if there exists at least one edge in the interactivity graph between a mode in the first cluster and a mode in the second cluster.

Optionally the encoding step includes defining a plurality of fermionic operators for encoding as qubit operators, the fermionic operators including: at least one edge operator for each pair of connected clusters; a set of fermionic edge operators between modes of the same cluster; and a fermionic vertex operator for every mode.

Optionally the fermionic edge operators have the form *E*_{[*R,i*],[*R*',*j*]}, for every pair of connected clusters *R,R'*, between modes *i* and *j*, wherein *i* is any mode in *R* and *j* is any mode in *R'*; the fermionic edge operators have the form *E*_{[*R,i*],*[R,j*]} between modes *i,j* in the same cluster *R* such that for any pair of modes *i,j* in *R*, there exists a sequence of modes *i, l, m, n..., o, j* such that *Eᵢₗ, Eₗₘ, Eₘₙ* ... *Eₒⱼ* ; the fermionic vertex operators have the form *Vⱼ* for every mode *j*; and wherein *Eⱼₖ*: *= -iγⱼγₖ*, *Vⱼ*: *= -iγⱼγ̅ⱼ*, ${γ}_{j} : = {w}_{j} + {w}_{j}^{†}$, and ${\overline{γ}}_{j} : \left({w}_{j}-{w}_{j}^{†}\right) / i$, wherein *wⱼ* and ${w}_{j}^{†}$ are fermionic annihilation and creation operators and the edge operators satisfy a composition relation *Eₕₖ = iEₕⱼEⱼₖ, and j* and *k* are multi-indices *j, k*: *=* [**R**,*m*].

Optionally each of the plurality of fermionic edge and vertex operators are encoded as corresponding qubit operators acting on qubits of the quantum information processor, such that all the anti-commutation and commutation relations between the fermionic operators are preserved between their corresponding qubit operators and that the square of any fermionic edge or vertex operator is equal to the square of its corresponding qubit operator.

Optionally, the method further includes simulating at least one fermionic interaction on the quantum information processor by enacting unitary qubit operations generated by the qubit operators on the qubits of the quantum information processor.

It will be appreciated that these developments of the encoding step allow the advantages of the encoding aspects of this disclosure to be applied to the simulation. Consequently, the advantages set out in detail above and below apply in this context too.

Also disclosed herein is an unclaimed control apparatus for a quantum information processor, the apparatus configured to improve the efficiency of a quantum computational measurement of a set of Majorana operators describing a Hamiltonian encoded on an array of qubits, the apparatus comprising: a processor configured to perform the steps of any one of the methods discussed above.

Optionally, the apparatus further comprises a quantum information processor including the array of qubits.

Optionally, the apparatus is further configured to compile a quantum circuit for performing quantum operations on a quantum information processor,

Also disclosed herein is an unclaimed non-transient computer readable medium comprising instructions which cause a computer to enact the method steps set out above.

Where the discussion above focusses on qubits, it will be understood that instead of the two-level quantum systems implied by qubits, a multi-level quantum system more generally referred to as qudits could be used. Of course, the mathematical processing, specific forms of encoding and measurement, etc. will need to be adapted should multi-level qudits be used instead, but the principles set out herein are generally applicable to such systems, albeit incorporating the necessary alternative mathematical adaptations. A natural situation in which the use of qudits may be advantageous would be where the local dimension is sufficiently large to encode an entire site; in this case, all operations within a site would reduce to local operations acting on each qudit. If the local dimension is not this large, each qudit could be used to encode some, but not all, fermionic modes within each site. In either case this would reduce the complexity of the overall quantum circuit, in terms of the number of qudit operations needed.

### BRIEF DESCRIPTION OF THE FIGURES

Methods and systems are now described by way of example only, in relation to the Figures, in which:
Figure 1 shows a schematic of the overall strategy employed herein, and illustrates the relationships between an example for implementing the advantages of described herein;
Figure 2 shows a Simple Orthorhombic Bravais lattice, with its lattice vectors;
Figure 3 shows a direct and reciprocal lattice of a 2D square Bravais lattice;
Figure 4 shows another view of the reciprocal lattice of a 2D square Bravais lattice, illustrating the interaction of the reciprocal lattice with system size;
Figure 5 shows a workflow of a typical Density Functional Theory calculation with a Wannierisation protocol illustrating the steps required to transform from a plane-wave basis set to a maximally localised one;
Figure 6(a) shows electrons in the system filling the lowest single particle energy levels;
Figure 6(b) shows an example of an active space represented by the states in a shaded area;
Figure 7 shows four valence Wannier functions of Silicon;
Figure 8 shows a schematic for hybrid fermion to qubit mapping for a 2d material;
Figure 9 shows the form of the edge (*Eᵢⱼ*) and vertex (*Vᵢ*) operators associated with the diagram in Figure 8;
Figure 10 shows a stabilizer of the hybrid encoding;
Figure 11 illustrates a collapsing of a 3d model into a 2d model;
Figure 12 shows a conversion between 3D compact encoding and 3D hybrid encoding;
Figure 13 shows the edge and vertex operators of the 3d hybrid encoding of Figure 12;
Figure 14 shows the quantum circuit for implementing *e*^{*iθZ*^{⊗*k*}} in the case *k* = 4;
Figure 15 shows sets of *M* matchings that contain all pairs for *M* = 5 and *M* = 6;
Figure 16 shows an example swap network for a five-mode linear system;
Figure 17 shows a distance minimising swap network;
Figure 18 shows an illustration of how the common site decomposition on a unit cell translates to the full system for nearest neighbour interactions on the 2D hybrid encoding;
Figure 19 shows an illustration of how the common site decomposition on a unit cell translates to the full system for nearest neighbour interactions on the 3D hybrid encoding;
Figure 20 shows a connectivity graph of a single unit cell and the different types of interactions in the Hamiltonian and their map into Pauli monomials;
Figure 21 shows a bar chart of the data presented in Figure 23A;
Figure 22 shows a swap network rearranging the mode configurations, specifically part (a) shows a starting configuration, part (b) shows the configuration after swaps {(0,1), (2,3)}, and part (c) shows the configuration after a further swap (0,3);
Figure 23A shows a circuit decomposition to implement all the terms of the Hamiltonian Eq. (121) once along with the circuit notation used;
Figure 23B shows a circuit implementing the unitaries generated by all the terms in the Hamiltonian and a diagram for the fermionic-swap gate;
Figure 23C shows JW ordering across a 2d lattice and low weight Pauli operators for the intracell processes using extra ancilla qubits;
Figure 24 shows the structural unit cell of SrVO₃ and the ground state electronic band structure as predicted using Density Functional Theory (DFT);
Figure 25 shows fatbands projections on the DFT electronic band structure for SrVO₃ using projectors corresponding to (a) V-d *e_{g}* orbitals, (b) V-d t_{2*g*} orbitals and (c) O-p orbitals;
Figure 26 shows two choices of active space for the Wannierisation protocol;
Figure 27 shows the spread of each Wannier function for the subspaces consisting of 3 V-d t_{2*g*} states and (b) 3 V-d t_{2*g*} states with an additional 9 O-p states, as illustrated in Fig. 26. The corresponding MLWFs for the (c) small and (d) large subspaces, which use an isosurface value of 0.325;
Figure 28 shows a unit cell and motif for SrVO₃;
Figure 29 shows the electronic band structure for SrVO₃;
Figure 30 shows the number of non-equivalent Coulomb tensor coefficients for each site structure that need to be computed under various conditions;
Figure 31 shows an analysis of a circuit breakdown for SrVO₃;
Figure 32 shows circuit costings for simulations of other materials;
Figure 33 shows: a band structure for the face centred cubic (FCC) lattice, with zero and non-zero potentials, and the integration contour for the Riesz projector.

### DETAILED DESCRIPTION

### Introduction

In this work we take advantage of the interplay between single particle basis, locality, symmetries, fermion encoding, fermionic swap networks and measurement to develop novel and efficient algorithms for simulating materials systems. In particular, these four aspects are developed in detail below, each of which contributes to an improved efficiency (in terms of both time and resource usage) of implementation of simulation algorithms for condensed matter systems. In fact, any system which can be described by a Hamiltonian can be simulated using the methods set out herein. This approach achieves a speed up of several orders of magnitude over naive methods in a cost model that assumes all-to-all connectivity and cost 1 for each 2-qubit gate. Selected results appear in Table 1, where we compare the circuit depth obtained by our methods with a previous general method that does not use the structure of the Hamiltonian see "Baseline for qubit requirements and gate depth of materials" section below. The materials analysed here represent a selection of systems where different underlying mechanisms are expected to be relevant for their behaviour. This set of four materials spans a minimal but wide structural, chemical and technological range. Strontium vanadate (SrVO₃) is a strongly correlated material that serves as a benchmark for post-DFT methods, Gallium arsenide (GaAs) is a fairly well-understood material with many technological applications. Likewise, silicon (Si) is the cornerstone material used in modern electronics and also important in many applications, such as solar technology. Recently, Hydrogen disulfide gas (H₃S) has been found to host a high superconducting transition temperature *T_{c}* at high pressures, which could be described with conventional BCS theory. Finally, Lithium copper oxide (Li₂CuO₂) is a material used in advanced lithium-ion battery technology.

**Table 1: Summary of resources needed to implement a single VQE layer that simulates the Hamiltonian of a material. Previous method refers to previous estimates without considering the structure present in the Hamiltonian. These estimates do not account for initial state preparation. For further details, see section 7.3.**

| Material | Applications | Method | Bands | Qubits | Depth |
|---|---|---|---|---|---|
| SrVO₃ | Batteries; Solar cells | previous | 22 | 1188 | 2 × 10⁹ |
| | | this work | 3 | 180 | 731 |
| GaAs | Semiconductors; Transistors; Solar cells; Spintronics | previous | 36 | 9000 | 9.6 × 10¹¹ |
| | | this work | 4 | 1120 | 4935 |
| Si | Semiconductors; Solar cells | previous | 8 | 2000 | 9.6 x 10⁹ |
| | | this work | 4 | 1120 | 5244 |
| H₃S | Superconductors | previous | 12 | 3000 | 3.3 × 10¹⁰ |
| | | this work | 7 | 1870 | 2824 |
| Li₂CuO₂ | High-capacity battery cathodes | previous | 26 | 2340 | 1.6 × 10¹⁰ |
| | | this work | 11 | 1024 | 7994 |

### Baseline for qubit requirements and gate depth of materials

Here, we briefly give a naive estimate of the resources (i.e., qubit number and circuit depths) required to simulate a material on a quantum computer using general existing methods and without taking advantage of the tailored approach we exploited in the main text.

We consider a material with periodic boundary conditions, discrete translational symmetry, and lattice volume *V* (i.e., with a total of *V* unit cells). In the spirit of the Born-Oppenheimer approximation, we assume a stationary atomic configuration and we are interested in simulating the electronic degrees of freedom of the system. For the sake of simplicity, we may choose to describe the material in the Bloch basis introduced in Section 3. In analogy with the procedure described in Section 3.5.1, we assume that we are able to identify a set of active bands where the relevant physics takes place. In this case we are concerned with the Hamiltonian restricted to the m modes indexed by those bands. These m bands are determined by identifying the last occupied atomic orbital for each atom in the material and then including all occupied orbitals for each atom. Accounting for spin, the total number of active fermionic modes is *m = 2Vb,* where *b* is the number of bands.

One may represent the fermionic system on the qubits of a quantum computer using the Jordan-Wigner (JW) transform in accordance with some prechosen linear ordering of the fermionic modes. This requires one qubit per mode. We denote by *H'* the Hamiltonian expressed as a sum of Pauli operators on the qubit system corresponding to the JW transform of *H*.

We now wish to estimate the circuit depth of a potential quantum algorithm for such a representation. As a benchmark we consider the circuit depth of the following unitary circuit: $U = {\prod }_{j} exp \left({iα}_{j}{H}_{j}^{′}\right)$ where we are free to choose the ordering of the product. Circuits of this type appear as subroutines in both VQE (under a Hamiltonian variational ansatz) and time dynamic simulation (TDS). In both cases, these subroutines are repeated multiple times, introducing an additional multiplicative overhead to the circuit depth, which we will not detail here.

A consequence of choosing the JWtransform is that many of the terms in *H'* operate on a large number of qubits. In particular, fermionic operations corresponding to interactions between fermionic modes far from each other in the aforementioned linear ordering precipitate costly circuit decompositions of individual exp(*iαⱼH'ⱼ*) terms.

We consider two previously known methods of implementing the desired interactions. The first is simply to implement the terms in *H'* in sequence, via the logarithmic-depth circuit for computing parities described in Section 5.1. Each term can be implemented in depth at most: $\left⌈{log}_{2}m\right⌉ - 1$ given that we are allowed all-to-all interactions, leading to an overall depth of at most: $T \left(\left⌈{log}_{2}m\right⌉-1\right)$ for a Hamiltonian with T terms. Note that it may be possible to reduce the complexity somewhat by implementing some of these terms in parallel and using the fact that many of the terms act nontrivially on fewer than m qubits; we do not explore these further here.

The second method (discussed in Guang Hao Low, Nathan Wiebe, Natalie M. Klco, and Yuan Su. Swap networks for quantum computation, 2019) allows all quartic interactions to be implemented in quantum circuit depth approximately ***O***(*m*³). More precisely, assuming that each quartic term requires 2-qubit depth 3 (as used in Section 5.1), a lower bound on the overall 2-qubit gate depth is approximately $0.76 {m}^{3.06} + \frac{12 T}{m}$ where we estimate the total cost by summing the cost of swap layers from Fig, 7E of the above citation (taking the fit up to 400 qubits) and make the optimistic assumption that the *T* terms can be optimally parallelised in between the swap layers, such that we implement *m*/4 of them at each layer, each with 2-qubit gate depth 3.

It remains to compute the total number of terms *T*. We will assume for simplicity that there are only quartic terms, because in practice quadratic terms can likely be implemented at a lower-order cost during the course of the algorithm to implement the quartic terms.

In terms of the complex fermion creation and annihilation operators ${f}_{k , b , σ}^{†}$ and *f_{k,b,σ}*, the quartic interactions in the Bloch basis are (see, e.g., second term in (26)): ${H}_{int} = {\sum }_{{k}_{i} , {b}_{i}} {V}_{{b}_{1} {b}_{2} {b}_{3} {b}_{4}}^{{k}_{1} {k}_{2} {k}_{3} {k}_{4}} {\sum }_{σ} {f}_{{k}_{1} , {b}_{1} , σ}^{†} {f}_{{k}_{2} , {b}_{2} , σ ′}^{†} {f}_{{k}_{3} , {b}_{3} , σ ′} {f}_{{k}_{4} , {b}_{4} , σ}$ where ***k**ᵢ* are Bloch momenta, *bᵢ* are band indices and σ is the spin. Here δ_{k1+k2;k3+k4} enforces explicitly the Bloch momentum conservation (up to lattice vectors). To ease the count, it is useful to write *Hᵢₙₜ* in terms of singlet and triplet scattering terms (valid in presence of time reversal symmetry): ${H}_{int} = {\sum }_{{α}_{i}} {δ}_{{k}_{1} + {k}_{2} + {k}_{3} + {k}_{4}} \left({V}_{{α}_{1} {α}_{2} {α}_{3} {α}_{4}}^{+}{ψ}_{S}^{+}\left({α}_{1}, {α}_{2}\right){ψ}_{S}\left({α}_{3}, {α}_{4}\right)+{V}_{{α}_{1} {α}_{2} {α}_{3} {α}_{4}}^{-}{\sum }_{a = 0 , ↑ , ↓} {ψ}_{a}^{†} \left({α}_{1}, {α}_{2}\right) {ψ}_{a} \left({α}_{3}, {α}_{4}\right)\right) ,$ where we have defined the super-index *αᵢ =* (***k**ᵢ*; *bⱼ*) that can take *Vb* different values and ${V}_{{α}_{1} {α}_{2} {α}_{3} {α}_{4}}^{\pm } ≡ \frac{1}{2} \left({V}_{{b}_{1} {b}_{2} {b}_{3} {b}_{4}}^{{k}_{1} {k}_{2} {k}_{3} {k}_{4}}\pm {V}_{{b}_{1} {b}_{2} {b}_{4} {b}_{3}}^{{k}_{1} {k}_{2} {k}_{3} {k}_{4}}\right)$ . The singlet and triplet operators are: ${ψ}_{S} \left({α}_{1}, {α}_{2}\right) = \frac{1}{\sqrt{2}} \left({f}_{{k}_{1} , {b}_{1} , ↑}{f}_{{k}_{2} , {b}_{2} , ↓}-{f}_{{k}_{1} , {b}_{1} , ↓}{f}_{{k}_{2} , {b}_{2} , ↑}\right) ,$ ${ψ}_{0} \left({α}_{1}, {α}_{2}\right) = \frac{1}{\sqrt{2}} \left({f}_{{k}_{1} , {b}_{1} , ↑}{f}_{{k}_{2} , {b}_{2} , ↓}-{f}_{{k}_{1} , {b}_{1} , ↓}{f}_{{k}_{2} , {b}_{2} , ↑}\right) ,$ ${ψ}_{σ} \left({α}_{1}, {α}_{2}\right) = {f}_{{k}_{1} , {b}_{1} , σ} {f}_{{k}_{2} , {b}_{2} , σ}$

For the singlet operator above, we can choose $\left(\begin{matrix}Vb \\ 2\end{matrix}\right)$ values for the pair of indices α₁ and α₂ that give a different operator plus *Vb* choices when α₁ = α₂. On the other hand, for any of the triplet operators one can only choose $\left(\begin{matrix}Vb \\ 2\end{matrix}\right)$ values of the pair (α₁, α₂) that generate a different operator. Note that ψₐ(α, α) = 0.

Then, the overall bound is given by: $T = \frac{1}{V} \left[{\left[\left(\begin{matrix}Vb \\ 2\end{matrix}\right)+Vb\right]}^{2}+3{\left(\begin{matrix}Vb \\ 2\end{matrix}\right)}^{2}\right] = {V}^{3} {b}^{4} - {V}^{2} {b}^{3} + {Vb}^{2}$

Here, the reduction by a factor of *V* is due to lattice momentum conservation. Additional symmetries of the Hamiltonian may introduce more savings in the number of terms (with the size of the savings being proportional to the size of the symmetry), but few are likely to be as large as the lattice translation symmetry.

Using the fact that a Hamiltonian with *T* terms can be implemented with an overall depth of at most $T \left(\left⌈{log}_{2}m\right⌉-1\right)$ and the lower bound on overall 2-qubit gate depths given above, we can derive two upper bounds on the quantum circuit depth. In terms of *V* and *b*, they take the forms $U {B}_{1} = \left({V}^{3}{b}^{4}-{V}^{2}{b}^{3}+{Vb}^{2}\right) \left⌈lo{g}_{2}\left(Vb\right)\right⌉$ ${UB}_{2} = 6.34 {\left(Vb\right)}^{3.06} + 6 \left({V}^{2}{b}^{3}-{Vb}^{2}+b\right)$ respectively.

We can also put a crude lower bound on the quantum circuit complexity of any method based on the JW transform. If we have *T* quartic terms and *m* qubits, we can implement at most *m*/4 terms at each step. Assuming again that each quartic term requires 2-qubit depth 3, we require 2-qubit gate depth of at least 12*T*/*m*, or in terms of *V* and *b*, at least $LB = 6 \left({V}^{2}{b}^{3}-{Vb}^{2}+b\right)$

In order to these compare naive estimates with the results reported in the, in Table 1 above we considered a system consisting of *V =* 33 unit cells for SrVO₃ and *V =* 5³ for the rest of the materials and reported the better of the two upper bounds in each case.

### Design Strategy

The NISQ era is characterised by quantum computers operating without fault tolerance. This means that the implementable quantum circuits that are possible have a depth which is fixed by the error level present in the device. This situation makes the construction of compact circuits for simulation crucial, as it can be the difference between being able to obtain meaningful results (in circuits whose depth is such that the accumulated error can be mitigated) or just random noise.

One of the earlier applications within the NISQ era is expected to be quantum simulation, where classical approaches are limited by the growth in the size of Hilbert space. In this context, we aim to find a minimal representation Hamiltonians amenable to quantum simulations with near term devices.

The construction of compact circuits for quantum simulation of materials depends on two critical components: the physical instance being simulated, and an efficient decomposition of the physical information into layers of quantum gates. Our design strategy tackles these aspects in tandem.

The present application is directed to systems and methods for addressing the shortcomings of contemporary and near-term quantum computation systems. In particular, it is highly desirable to leverage the power of quantum computing to tackle the technical problem of simulating atomic, chemical, condensed matter, and other material systems. The methods set out herein provide various approaches to assist in tackling this problem. For example, the initial parts of the project address how to recast Hamiltonians of interest into a format which is more amenable to simulation on current or near term hardware. This is achieved in part by leveraging symmetries where these exist, and by simplifying the least important terms in the Hamiltonian. However, crucially this process is guided by the eventual goal of quantum computation. This informs not only when the Hamiltonian is "simple enough" (in a general sense) to be encodable on a specific piece of hardware, but more importantly also the uses the concept of circuit depth to inform the format of the Hamiltonian. In particular, the choices are guided in such a way as to avoid the eventual circuit depth scaling in an impractical way with the size of the system being simulated. In this way, the methods and systems bring a wide range of physical materials within range of effective and accurate simulation on quantum hardware. It almost goes without saying that the benefit of being able to assess the behaviour of materials without needing to undergo the expensive and time consuming process of synthesis is highly sought after and is expected to spur great developments across a spectrum of fields depending on novel input materials to overcome the technical challenges of each field.

This construction distils an initial high-level description of a material (e.g. lattice structure, symmetries, atomic constituents) into a Hamiltonian in terms of Majorana modes that is local and translational invariant. These characteristics inform the subsequent analysis and are crucial to achieve compact quantum circuits. Once the circuits have been constructed and their cost analysed, the physical choices that minimise the circuit depth without sacrificing the physical information will be selected.

The components of this construction can be separated into four modules:
- Classical computation of relevant degrees of freedom (DoF)
- Choice of single particle basis for these DoFs that localises the electron wavefunction minimising its extent.
- Classical computation to bound the number of matrix elements of the Hamiltonian to be evaluated
- Classical computation of the filtered matrix elements.

Described below is a method of simulating at least a subset of interactions between modes in a fermionic system on a quantum information processor having N or fewer qubits. The method begins by identifying an active space and associated degrees of freedom within the active space, the active space corresponding to a plurality of modes in the fermionic system between which the subset of interactions operates. Next, an effective Hamiltonian is constructed describing the degrees of freedom within the active space of the fermionic system. The effective Hamiltonian is then provided in a localised representation whereby an interactivity graph of the Hamiltonian in the localised representation comprises clusters of modes in which a first cluster and a second cluster are candidate connected clusters if there exists at least one edge in the interactivity graph between a mode in the first cluster and a mode in the second cluster and wherein a set of connected clusters is selected from the set of candidate connected clusters to provide an encoding scheme for the modes of the Hamiltonian on the qubits of the quantum information processor.

Following this quadratic interaction matrix coefficients between pairs of modes of the localised Hamiltonian and coulomb tensor coefficients representing interactions between quartets of modes of the localised Hamiltonian are calculated and the modes of the localised Hamiltonian are encoded onto the qubits of the quantum information processor. Qubit interactions are then implemented between the qubits, the qubit interactions corresponding to interactions between modes of the localised Hamiltonian; and measuring the state of the qubits thereby to extract a simulation of the active space of the effective Hamiltonian.

This can be thought of generally as taking a Hamiltonian which is to be investigated and adapting it to a suitable representation for encoding on a quantum information processor for investigating the system described by the Hamiltonian. In particular, the active space is identified and a localised representation is provided. By considering the interactivity graph of this localised representation, clusters can be identified which indicate the density of interaction of certain of the modes with one another. This indicates the relative importance of the various interactions within the active space. From here, the various Hamiltonian terms (such as kinetic energy, potential energy, and interaction energy terms) can be calculated and the modes and interactions can be encoded on a quantum computer for further calculation, simulation, analysis, etc.

Note that in some cases the input Hamiltonian may already be expressed in a suitably localised format, while in others, the Hamiltonian may need to be converted into a different format, to provide the degree of localisation set out above. Localisation in this example may include, e.g., exploring the active space in a plurality of single particle bases (e.g. Bloch-wave single particle basis, Wannier single particle electron basis, etc.) for the fermions and selecting the single particle basis which results in the most local Hamiltonian.

The concept of an interactivity graph is discussed in more detail below, but in short the identification of clustering within the structure of the Hamiltonian allows the leveraging of symmetries. This leads in turn to an expression of the system which is amenable to implementing in a quantum circuit which has a circuit depth which scales sub-linearly with the system size for a suitable choice of encoding, as discussed elsewhere herein. In particularly advantageous examples the circuit depth may be fixed irrespective of the system size. This tailors the initial starting Hamiltonian to the limitations of the quantum information processor and opens up modelling of complex quantum systems on an appropriate hardware. In particular the noise/fidelity limitations of quantum computers means that increases in circuit depth quickly leads to circuits which are not practically implementable on current quantum computers. Since these problems are not expected to be overcome in the near future, it is extremely beneficial to decouple (or at least weaken the dependence between) the circuit depth from the system size if simulations are to become practical.

In what follows, specific examples of this general principle are set out. However, the skilled person will recognise that the general principles set out herein are applicable in a much wider context with little or no adaptation required.

The first step is to identify the relevant degrees of freedom (DoF) of the phenomena under investigation. This is not a sharp (or even well defined) procedure, but instead it depends on the nature of the question being asked. For example, for a given material, different physical processes are involved in the study of electric transport at low temperatures, versus the melting behaviour at high temperatures. At a high level, this approach consists of choosing a so called active space, commonly discussed in chemistry and materials science. This active space can be seen as a distillation of the relevant DoF at a certain energy scale. Once the relevant DoF in the active space have been identified, their dynamics are constructed. These dynamics are governed by an effective Hamiltonian that describes their interactions.

After this Hamiltonian has been obtained, a map between the physical and the logical DoF is required. Abstractly, this procedure maps interactions between the original degrees of freedom to qubit operations. In particular for fermions, the interplay between the structure of the Hamiltonian interactions and the fermionic encoding plays an important role in the ability to create compact circuits. At the end of this step a collection of Pauli operators is derived, comprising the qubit Hamiltonian *H_{Q}*.

Finally, the protocol of implementing all the terms in the qubit Hamiltonian is computed. Here the general approach that we use has the same structure as Trotterization of the evolution operator exp(*iH_{Q}t*). The structure of this step is indicative of the cost of finding a ground state via the variational quantum eigensolver (VQE) approach (in particular under the Hamiltonian variational ansatz), or time dynamics. This produces the circuit for a single Trotter step (a single layer of VQE). Finally, we determine the measurement protocol that produces the minimum measurement overhead.

Clearly, the decisions at each stage trickle down into the final cost of implementing all the qubit operators present in *H_{Q}* through a quantum circuit. Based on this, we adopt a multi-tiered strategy for minimizing the cost of the quantum circuit, that we describe below in the context of materials simulations.

For the physics-based construction of the Hamiltonian of a material, we adopt the Born-Oppenheimer approximation, and concentrate on the quantum description of the electron DoF, including the nuclei as a classical background potential. While this approach is general enough to be used in chemistry and materials science, we note that including the quantum mechanical DoF of the nucleus is also possible within this framework. In materials, the existence of the periodic ionic potential is a distinctive feature of the system, which sets them apart from molecules. We use density functional theory (DFT) to do a low level exploration of the active space in materials, defined as an energy window around the Fermi level (in periodic systems). Using this window, that contains the relevant DoF, we construct an effective Hamiltonian by computing classically its matrix elements. Other examples of suitable exploration spaces include the energy of the highest occupied molecular orbital (HOMO) in atomic or molecular systems. Here it can be seen that bands in the active space of periodic systems or the highest occupied molecular orbital (HOMO) and/or the lowest unoccupied molecular orbital (LUMO) in atomic or molecular systems are appropriate regions in which to investigate the material. These energies represent natural energy levels at which to analyse the system and are therefore a natural selection for the active space.

The problem of properly computing these matrix elements is ambiguous, for at least two reasons. An unavoidable problem that appears once an active space is used, is that the electrons outside the active space renormalise the interactions that the electrons in the active space feel with the nucleus. To fully characterise that renormalisation, the solution of the many-body interacting problem has to be found, which is what we are trying to do in the first place. The second reason is that any realisation of DFT is in itself an approximation, as the exchange correlation functional is unknown. Both problems are known in the community and are handled in a plethora of different ways.

We study two natural single-particle bases for the electrons in periodic systems, the Bloch basis, and the Wannier basis. In addition, atomic and molecular orbitals may be used on non-periodic systems. The bands kept in the active space become modes in the unit cell, and the size of the material determines the number of unit cells. Due to the locality in real space achieved by the Wannier basis, a smart selection of bands allows one to construct a local Hamiltonian in real space, where the Coulomb interactions are localised, and the hopping range of electrons between unit cells does not scale with the system size. We select the single particle basis that generates the most local Hamiltonian. Localisation may mean confining interactions to those which are close to specific lattice sites where there is a regular lattice, or it may mean individual atoms in atomic/molecular situations, for example. It can be beneficial to make use of the most local representation available in any given circumstance because this can provide confidence in truncating the system at particular distances. This local Hamiltonian defines a motif that can be used to tile a system of any size without increasing the depth of the layer needed to implement the motif. Finally, the Hamiltonian is fed through a compiler to produce a circuit. We iterate among different choices to find the instance of lower circuit cost.

A motif is a specific example of a restriction of a general (periodic) Hamiltonian. "Motif Hamiltonians" as used herein are those which are restricted to a central unit cell of the localised Hamiltonian and having interactions between modes of the localised Hamiltonian restricted to interactions which include the central unit cell at least once and one or more of the nearest neighbouring unit cells of order n. That is, the motif Hamiltonian is one which leverages the periodic nature of the lattice to cast the interactions in terms of interactions between any given unit cell and nearest neighbours out to a user-selected distance. The motif simplifies the calculations because the system can be tiled using the motif at constant calculation depth irrespective of system size. The specific distance being selected based on parameters such as the complexity of system capable of being simulated on the expected hardware, the level of detail needed, the interactions of interest, and so forth. This format of restricted, motif, Hamiltonian leverages translation invariance to simplify the calculation, and thereby assist in decoupling the circuit depth for simulating such a system from the size of the system (since the symmetries allow for the motif to represent the whole system).

The limitation can include for example ignoring hopping matrix coefficients corresponding to an interaction over a distance larger than a first distance threshold value; and/or ignoring Coulomb tensor coefficients corresponding to an interaction over a distance larger than a second distance threshold value. That is, limiting the interactions to those within a certain distance (in terms of unit cells of the periodic lattice) from the central cell.

In other words, although the focus is on constructing the motif Hamiltonian, a system of any size is modelled, ultimately restricted to what can be fit on the quantum computer. The motif allows this without increasing the circuit depth. As an example, if M gates in a layer of depth D are needed to model all the interactions in the motif, a layer of depth D would still be needed to model any system size in the optimal case (and will at least scale sub-linearly with system size in most cases) for a single time step. Of course, larger systems require more gates to completely model, but the additional gates can be implemented in parallel, thus not increasing the error that may appear by doing gates in series in a greater number of layers.

To leverage the locality of the fermion Hamiltonians obtained, we introduce a novel fermionic encoding that works using the local structure of Coulomb interactions and hopping, by hybridizing two fermion encodings: the Jordan-Wigner (JW) transform within a unit cell (where the majority of the electron-electron interactions are present), and the compact encoding between unit cells, where fewer interactions have to be considered, following from the locality of the fermion Hamiltonian. This comes with the cost of needing extra ancillary qubits. In order to deal with the existence of large weight operators along the JW line, we introduce an algorithm based on the use of fermionic swap operations. These operations, by relabelling the fermion modes, can bring closer operators along the JW line and minimise their weight. This construction can be expanded to span structures different than single unit cells, depending on the connectivity graph of the Hamiltonian in question.

In a cost model where all-to-all interactions are allowed, arbitrary 2-qubit gates are cost 1 each, and 1-qubit gates are free, we do an in-depth analysis of the cost of implementing the most general terms allowed by symmetry, and the cost of performing fermionic swaps to bring modes to an adjacent ordering within the JW string.

Finally, we analyse the cost of executing a full VQE layer, i.e. Π*ₖ e*^{*i*θ*ₖHₖ*}, where *H_{Q}* = Σ*ₖHₖ* on a Hamiltonian written from a fermion representation in both the Bloch and Wannier bases, with different fermion encodings. We also calculate the cost of doing measurements in the different scenarios.

The filtering discussed above may include filtering the quadratic interaction matrix elements corresponding to kinetic and potential terms and coulomb tensor coefficients to form a filtered localised Hamiltonian. The filtered localised Hamiltonian may ignore kinetic and potential matrix coefficients having a magnitude below a first interaction threshold value; and/or coulomb tensor coefficients having a magnitude below a second interaction threshold value. The quadratic interaction matrix is sometimes referred to as the hopping matrix elsewhere in this document.

The first and second interaction thresholds may be selected to reduce a number of interaction terms between modes addressed by matrix and/or tensor elements in the filtered localised Hamiltonian to contain inter-cluster interactions that represent a user-specified percentage p of the overall interactions. These may further be filtered so as to not contain interactions between modes in clusters separated by more than a user-specified threshold distance k in the interactivity graph. In other words interactions which operate over a long range are selectively excised from the system in favour of shorter range interactions. Since the Hamiltonian is already a localised one, the longer range interactions are usually able to be preferentially culled. In some cases, the thresholds focus on modes which are close together at the expense of filtering out consideration of modes which are less close together in the interactivity graph.

Each of the interaction thresholds and the threshold distance, k, may be selected to reduce the number of interaction terms between modes in distant clusters according to the distance between modes in the filtered Hamiltonian in an iteration subroutine. The sub-routine includes setting one or more of the thresholds and the parameters p and k at a respective value, and then calculating the number of interaction terms and the distance of the modes within an interaction term in the resulting filtered Hamiltonian. Where the number of interactions between modes in clusters at a distance k in the filtered Hamiltonian is larger than p, one or more new threshold values is selected and the number interaction terms re-calculated. On the other hand where the number interactions in the filtered Hamiltonian is smaller than or equal to p and each interaction occurs between modes at a distance smaller of equal than k, the iteration subroutine ends. By iterating in this way, the method is able to gradually reduce the complexity of the Hamiltonian being simulated until it is capable of being run on the expected complexity of hardware available. Note that this procedure allows the method to be adapted to any complexity of hardware available by setting the thresholds and parameters appropriately.

The value of the interaction thresholds may be set (initially or indeed fixedly) at a value no lower than the largest magnitude of a coulomb tensor or quadratic interaction matrix coefficient corresponding to an interaction strength not present in interactions within a distance k. This feature improves the filtering by examining whether interactions have been retained in the filtered Hamiltonian have an interaction strength (i.e. relative magnitude of the corresponding matrix/tensor coefficient) which is weaker than interaction strengths which have already been culled by virtue of distance or considerations from the connectivity of the interactivity graph. In cases where such weaker interaction strengths remain, it is reasonable to filter them out anyway, since they are less important in some sense than interactions which have already been discarded. This therefore further represents an additional manner of reducing the complexity of the system to be simulated without unduly sacrificing accuracy.

In this example, the idea of distance means that in any instance, more distant interactions (ones between physically distant regions of the system) are sacrificed in favour of those which operate over a shorter range.

As a further example, providing the effective Hamiltonian in a localised representation includes using the localised representation to construct a cluster k-local Hamiltonian, the cluster k-local Hamiltonian having all interactions between modes that are members of different clusters within a distance k. This definition of a "cluster k-local Hamiltonian" leads to a consideration of only interactions within a distance k of a cell. In periodic cases this is justified by translation invariance, while in atomic/molecular orbitals there is a natural basis of atoms in the molecule and distance has again a well-defined meaning.

In its current implementation, our construction uses a DFT approach to reduce the relevant degrees of freedom considered in the system. Once this has been achieved by selecting particular bands, we construct Wannier functions. Those are used to compute matrix elements. There are two type of matrix elements corresponding to quadratic (hopping matrix coefficients) and quartic terms (Coulomb tensor coefficients). The overall classical cost is dominated by the quartic terms corresponding to the Coulomb interaction. We develop a complete approach for computing those interactions efficiently, as described below.

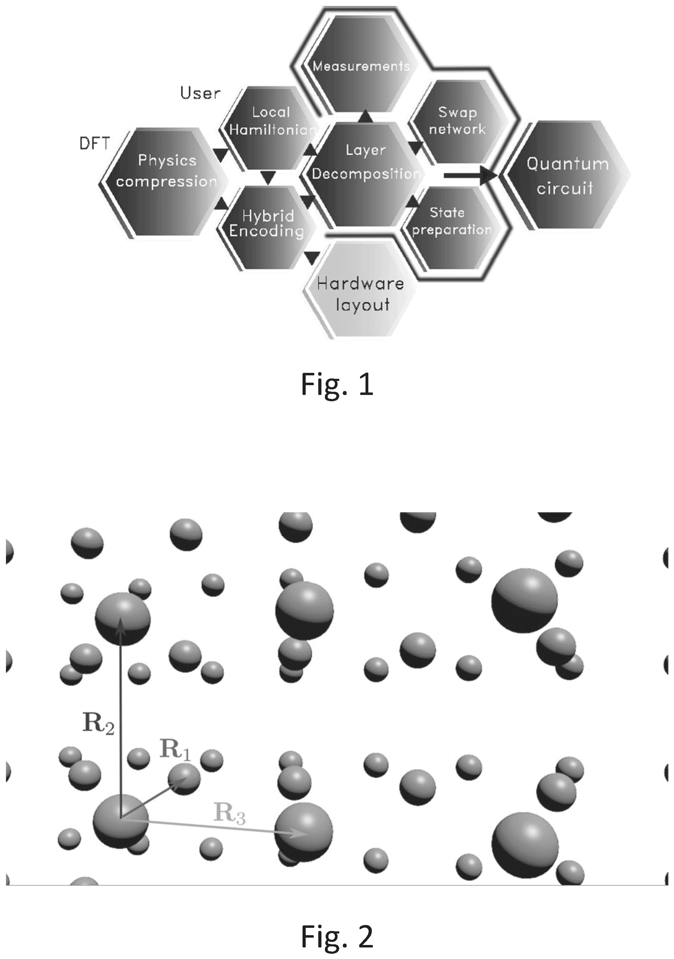

We construct a tool that is able to perform the necessary decompositions into layers of a given Hamiltonian data input. This allows us to study in detail different materials and model Hamiltonians, to understand their cost complexity, and to find a full decomposition into quantum circuits. The summary of the design strategy to optimize over circuit cost is shown in Fig. 1, which summarises the overall strategy developed in this work to minimize circuit depth in the simulation of materials. Starting from a low level calculation based on DFT, we perform a compression of the physical information into relevant degrees of freedom. The locality of the interactions and the hardware layout determine the structure of the hybrid encoding. In order to minimize the circuit depth, the layer decomposition module constructs nearly optimal swap networks, state preparation layers and a measurement protocol. These elements constitute the quantum circuit that implements a layer of either VQE or TDS.

A self-contained exposition of the physics behind the construction of Hamiltonians is presented in section 3. The role of symmetries, Wannier and Bloch functions and efficient techniques to construct the matrix elements are discussed there.

In section 4 we introduce the hybrid encoding and discuss its use in the context of materials' simulation, where it represents a natural fermion-to-qubit mapping. In section 5 we first concentrate on the quantum algorithm (VQE) itself and then discuss the decomposition of operators in terms of gates, initial state preparation, time evolution according to the material's Hamiltonian, and measurement protocols. Combining these ideas, in section 6 we discuss the design of our circuit compiler, which we go on to use in section 7 to analyse the cost of running a single layer of VQE or a single Trotter step for TDS, in examples of increasing complexity.

### Effective description of the Hamiltonian

The full simulation of a physical system comprises infinitely many DoF, which makes it infeasible. This has never been a problem in domains where the relevant energy scale of the problem is restricted to a finite range. In this situation, the DoF at that scale are the ones that mostly contribute to the physical phenomena in question. For everyday applications, where most of the processes are controlled by the behaviour of the electron DoF in atoms, the Hamiltonian $\begin{matrix}H = {\sum }_{σ} \int d r \left[\frac{{ℏ}^{2}}{2 m}{\left|∇{\hat{ψ}}_{σ}\left(r\right)\right|}^{2}+{U}^{˜}\left(r\right){\hat{ψ}}_{σ}^{†}\left(r\right){\hat{ψ}}_{σ}\left(r\right)\right] \\ + \frac{1}{2} {\sum }_{σ , σ ′} \int d r \int d r ′ {\hat{ψ}}_{σ}^{†} \left(r\right) {\hat{ψ}}_{σ ′}^{†} \left(r′\right) V \left(\left|r-r′\right|\right) {\hat{ψ}}_{σ ′} \left(r′\right) {\hat{ψ}}_{σ} \left(r\right)\end{matrix}$ (1) describes all the possible non-relativistic physical systems in the absence of external magnetic fields. Here ${\hat{ψ}}_{σ}^{†} \left(r\right) \left({\hat{ψ}}_{σ}\left(r\right)\right)$ is an operator that creates (destroys) an electron at position *r* of spin *σ*. For the sake of notational simplicity, in what follows we will omit the hat when denoting operators. Here, *V*(|***r** - **r***'|) is the distance-dependent repulsive potential between electrons. To derive explicit formulas, in what follows we will consider the screened Coulomb potential *V*(|***r** - **r***'|) = *qₑ*(4*πε*₀)^{*-*1}*e*^{*-µ*|*r-r'*|}/|***r*** - ***r*'**|, with *µ* being the inverse screening length, but our results hold for any positive definite, central, and spin-independent potential. The constants ℏ, *m*, *qₑ* and *ε*₀, are the Planck's constant, the electron mass, and charge, and the vacuum permittivity of space respectively.

The full Hamiltonian includes the lattice ions. The mass of the ions is much larger than the mass of the electrons, so a good approximation is to consider the ions frozen. The lattice of frozen ions then acts as an external potential on the electrons. This approach has found success outside typical everyday experimental phenomena, from the prediction of the optimal structural configuration of the rare earth hydrides used in high pressure room temperature superconductors to understanding the role of Li-ion migration in conventional batteries.

The infinitude of different phenomena that we observe is in part due to the structure of the potential *Ũ*(*r*), which characterises the Coulomb potential produced by the positively charged nucleus of the atoms in the system.

In materials, the external potential created by the ions in the lattice heavily influences the electrons. Assuming a block of material invariant under lattice translations **R***ₙ*, the external potential satisfies *Ũ*(*r + Rₙ*) *= Ũ*(*r*). A usual way of parameterising it is ${U}^{˜} \left(r\right) = \frac{{q}_{e}}{4 {πϵ}_{0}} {\sum }_{I} \frac{{Z}_{I}}{\left|r-{r}_{I}\right|}$ (2) where *Z_{I}* is the charge of the ions and ***r**_{I}* is their position.

Starting from this scenario, in this section we discuss how the reduction of the Hamiltonian in Eq. (1) (which from now on we assume to be representing a block of material, and thus lattice periodic) is performed, leading to a Hamiltonian over finitely many degrees of freedom and with an interaction structure that makes it amenable to simulation using shorter quantum circuits. As quantum simulation brings different communities together, we present a self-contained discussion, revising familiar concepts to condensed matter physicists and materials scientists, but which may be not completely familiar to other communities.

### 3.1 General characteristics of fermion Hamiltonians

### 3.1.1 Structure of two and four fermion integrals

In this section we examine the general properties of the two and four fermion integrals occurring in the Hamiltonian of a system of spinful and charged fermions interacting via a Coulomb-like two-body interaction *V*(|***r** - **r***'|).

We can expand the electron operator *ψ̂_{σ}*(***r***) that appears in Eq. (1) in a basis of single-particle wavefunctions {ϕ_{λ}(***r***)} as ${\hat{ψ}}_{σ} \left(r\right) = {\sum }_{λ} {ϕ}_{λ} \left(r\right) {c}_{λ , σ}$ (3) where *λ* represents the collection of all the particles' quantum numbers but the spin and *c_{λ,σ}* is the annihilation operator for a fermion in the state *λ*, *σ*. In terms of the latter, Eq. (1) becomes $H = {\sum }_{σ} {\sum }_{{λ}_{1} , {λ}_{2}} {t}_{{λ}_{1} {λ}_{2}} {c}_{{λ}_{1} , σ}^{†} {c}_{{λ}_{2} , σ} + {\sum }_{σ , σ ′} {\sum }_{{λ}_{1} , {λ}_{2} , {λ}_{3} , {λ}_{4}} {V}_{{λ}_{1} {λ}_{2} {λ}_{3} {λ}_{4}} {c}_{{λ}_{1} , σ}^{†} {c}_{{λ}_{2} , σ ′}^{†} {c}_{{λ}_{3} , σ ′} {c}_{{λ}_{4} , σ} .$ (4)

Here, the hopping matrix is defined as ${t}_{{λ}_{1} {λ}_{2}} = \int d r {ϕ}_{{λ}_{1}}^{∗} \left(r\right) \left[-\frac{{ℏ}^{2} {∇}^{2}}{2 m}+{U}^{˜}\left(r\right)\right] {ϕ}_{{λ}_{2}} \left(r\right)$ (5) while the Coulomb tensor (CT) is ${V}_{{λ}_{1} {λ}_{2} {λ}_{3} {λ}_{4}} = \frac{1}{2} \int d r \int d r ′ {ϕ}_{{λ}_{1}}^{∗} \left(r\right) {ϕ}_{{λ}_{2}}^{∗} \left(r′\right) V \left(\left|r-r′\right|\right) {ϕ}_{{λ}_{3}} \left(r′\right) {ϕ}_{{λ}_{4}} \left(r\right) .$ (6)

In particular, both the hopping matrix and the CT are Hermitian, i.e., ${t}_{{λ}_{1} {λ}_{2}} = {t}_{{λ}_{2} {λ}_{1}}^{∗}$ and ${V}_{{λ}_{1} {λ}_{2} {λ}_{3} {λ}_{4}} = {V}_{{λ}_{4} {λ}_{3} {λ}_{2} {λ}_{1}}^{∗}$ , where *a** denotes the complex conjugate of *a*. From Eq. (6) it immediately follows that the Coulomb tensor obeys the index-swap symmetry *V*_{λ₁λ₂λ₃λ₄} = *V*_{λ₂λ₁λ₄λ₃}.

In systems with strong spin-orbit coupling, a more general single particle spinor wavefunction φλ,σ(r) is possible. We do not consider this case here.

### 3.1.2 Cauchy-Schwarz inequality for the Coulomb tensor

Exploiting the fact that *V*(|***r** - **r***'|) is a real positive definite function, one can rewrite Eq. (6) in terms of an inner product. In particular, the latter can be defined in two possible ways. The first one is: ${V}_{{λ}_{1} {λ}_{2} {λ}_{3} {λ}_{4}} ≡ {\left〈{ρ}_{{λ}_{1} {λ}_{2}}, {ρ}_{{λ}_{4} {λ}_{3}}\right〉}_{1} = \frac{1}{2} \int d r \int d r ′ V \left(\left|r-r′\right|\right) {ρ}_{{λ}_{1} {λ}_{2}}^{∗} \left(r,r′\right) {ρ}_{{λ}_{4} {λ}_{3}} \left(r,r′\right)$ (7) where ρ_{λ*ᵢ*λ*ⱼ*}(*r*, *r'*) ≡ ϕ*_{λⁱ}*(*r*)ϕ_{λ*ⱼ*}(*r'*). Hence, the following inequality between the elements of the Coulomb tensor follows from the Cauchy-Schwarz inequality applied to Eq. (7) ${\left|{V}_{{λ}_{1} {λ}_{2} {λ}_{3} {λ}_{4}}\right|}^{2} \leq {V}_{{λ}_{1} {λ}_{2} {λ}_{2} {λ}_{1}} {V}_{{λ}_{4} {λ}_{3} {λ}_{3} {λ}_{4}}$ (8)

On the other hand, another well-defined inner product can be introduced as ${V}_{{λ}_{1} {λ}_{2} {λ}_{3} {λ}_{4}} ≡ {\left〈{ρ}_{{λ}_{1} {λ}_{4}}^{′}, {ρ}_{{λ}_{2} {λ}_{3}}^{′}\right〉}_{2} = \frac{1}{2} \int dr \int dr ′ V \left(\left|r-r′\right|\right) {ρ}_{{λ}_{1} {λ}_{4}}^{′ ∗} \left(r\right) {ρ}_{{λ}_{3} {λ}_{2}}^{′} \left(r′\right)$ (9)

Where ${ρ}_{{λ}_{i} {λ}_{j}}^{′} \left(r\right) ≡ {ϕ}_{{λ}_{i}} \left(r\right) {ϕ}_{{λ}_{j}}^{∗} \left(r\right)$. Similarly to the previous case, the Cauchy-Schwarz inequality associated with this inner product implies the following relation between the Coulomb tensor elements: ${\left|{V}_{{λ}_{1} {λ}_{2} {λ}_{3} {λ}_{4}}\right|}^{2} \leq {V}_{{λ}_{1} {λ}_{4} {λ}_{1} {λ}_{4}} {V}_{{λ}_{3} {λ}_{2} {λ}_{3} {λ}_{2}}$ (10)

Eq. (8) and Eq. (10) can be exploited to obtain bounds on the CT coefficients, allowing to truncate the elements smaller than a given threshold without having to directly compute them. This is usually very useful in reducing the classical computation needed to determine a quantum Hamiltonian.

### 3.2 Momentum-space single-particle bases

In this and the following sections we will introduce some of the most common single-particle bases to study condensed matter systems.

As we will be discussing different bases for the same Hamiltonian, to avoid confusion, especially when these Hamiltonians are mapped into qubit operators, we will explicitly add a superscript to a Hamiltonian in a particular basis, each of which will be defined below, so we will have
*H^{P}*: Hamiltonian (1) in the plane wave single particle electron basis. The second quantized creation (annihilation) operators of momentum *k* and spin *σ* in this context are denoted by ${c}_{k , σ}^{†} \left({c}_{k , σ}\right)$. Choosing a lattice of discrete translations, the total momentum *k* can always be decomposed in the lattice momentum *k* and reciprocal lattice vector **G** as **k** = **k + G.**
*H^{B}:* Hamiltonian (1) in the Bloch-wave single particle electron basis. The creation (annihilation) operators are ${f}_{k , n , σ}^{†} \left({f}_{k , n , σ}\right)$, with **k** the lattice momentum, *n* the band index and *σ* the spin.
*H^{W}:* Hamiltonian (1) in the Wannier single particle electron basis. The creation (annihilation) operators of band *n* and spin *σ* are ${w}_{R , n , σ}^{†} \left({w}_{R , n , σ}\right)$, where **R** is the lattice vector.

All single particle basis operators (called generically *Aⱼ*) satisfy the equal time commutation relations $\left\{{A}_{i}, {A}_{j}^{†}\right\} = {δ}_{ij}$.

We begin with momentum-space bases, which fully exploit the translational invariance of crystalline solids.

In a material, atoms are arranged in a periodic structure (e.g., the simple orthorhombic Bravais lattice of Fig. 2) which is spanned by the lattice vectors **R***ₐ*, *a* = 1, 2, 3. The lattice points correspond to $R = {n}_{1} {R}_{1} + {n}_{2} {R}_{2} + {n}_{3} {R}_{3}$ (11) where ${n}_{a} ∈ ℤ$. The lattice vector **R***ₐ* has length *Rₐ*. Translations *T***_{R}** along these lattice vectors leave the Hamiltonian *H* invariant. Consequently, we can block diagonalize the Hamiltonian, and each block will correspond to a different eigenvalue of the translation operator. The Bloch Theorem allows us to find the simultaneous eigenfunctions of *T***_{R}** and *H*.

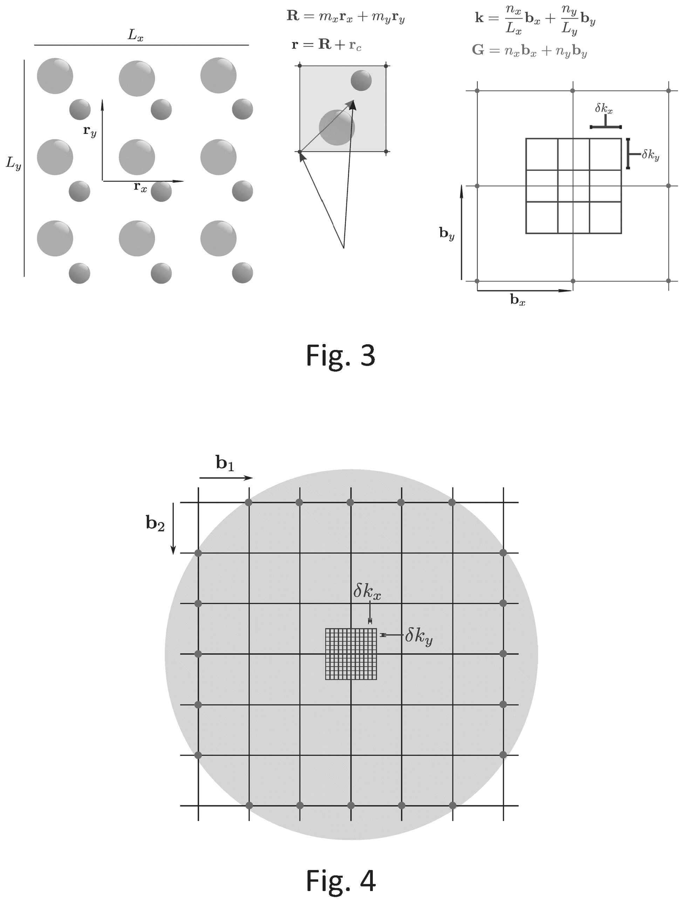

Clearly the translation operator *T* forms an abelian group, satisfying with *T***₀** = 1. As *T* should be represented by a unitary operator, in its diagonal basis it acts on the single particle wavefunctions as ${T}_{R} ϕ \left(r\right) ≡ ϕ \left(r+R\right) = {e}^{i k ⋅ R} ϕ \left(r\right)$ (12) where the vector **k** is called the crystal momentum. Note that the crystal momentum does not coincide with the momentum of the particle. The latter can be obtained from its group velocity according to ${v}_{n} \left(k\right) = \frac{1}{ℏ} {∇}_{k} {E}_{n} \left(k\right)$, where *Eₙ*(**k**) is the energy of *n*th band. In a periodic system with linear size *Lₐ = NₐRₐ* in each lattice vector direction, the periodic boundary conditions (Born-von Karman boundary conditions) ψ(*r* + *NₐRₐ*) *=* ψ(*r*) imply the quantization of the crystal momentum as $k = \frac{{n}_{1}}{{N}_{1}} {b}_{1} + \frac{{n}_{2}}{{N}_{2}} {b}_{2} + \frac{{n}_{3}}{{N}_{3}} {b}_{3} , where the reciprocal lattice vectors {b}_{j} satisfy {b}_{i} ⋅ {R}_{j} = 2 {πδ}_{ij}$ (13) and *nₐ* ∈ [0, *Nₐ* - 1]. The eigenstates of the translation operator can then be labelled by the triplet *n*₁, *n*₂, *n*₃, corresponding to a total of *N = N*₁*N*₂*N*₃ states. The total volume of the crystal is *V_{c}* = *N*|**R**₁ · (**R**₂ × **R**₃)|. The volume of the unit cell is Ω = |**R**₁ · (**R**₂ × **R**₃)|. The relation between direct and reciprocal lattice is shown in Fig. 3. Here the left figure illustrates a square Bravais lattice with two atoms per unit cell. The lattice vectors are ***r**ₓ* and ***r**_{y}* and the size of the system is *Lₓ* and *L_{y}*. In the middle figure, it is shown that every position r in the material can be decomposed in the position of the cell R and a position inside the cell ***r**_{c}*. Finally, the right figure shows the reciprocal lattice (larger grid) is unbounded while the finer, smaller k-mesh represents the different lattice momentum states **k.** The system size determines the number of k points and does not affect the reciprocal lattice;
Using Eq. (12), we can define ${ϕ}_{k} \left(r\right) = {e}^{i k ⋅ r} \left[{e}^{- i k ⋅ r}{ϕ}_{k}\left(r\right)\right] = {e}^{i k ⋅ r} {u}_{k} \left(r\right)$ (14) with *u***ₖ**(**r** + **R**) = *u***ₖ**(**r**) a lattice periodic function. The single electron wavefunction ϕ**ₖ**(**r**) = *e*^{*i***k·r**}*u***ₖ**(**r**) is called a Bloch wave. Since *u***ₖ**(**r**) is a lattice periodic function, it may be useful to expand it in Fourier series as ${u}_{k} \left(r\right) = {\sum }_{G} {u}_{k , G} {e}^{i G ⋅ r}$ (15) where G is a reciprocal lattice vector **G** = *m*₁**b**₁ + *m*₂**b**₂ + *m*₃**b**₃, with ${m}_{i} ∈ ℤ$, and to write the Bloch wave as: ${ϕ}_{k} \left(r\right) = {\sum }_{G} {u}_{k , G} {e}^{i \left(k+G\right) ⋅ r}$ (16)

### 3.2.1 Plane wave basis

A particularly simple choice for the functions *u***ₖ**(**r**) is *u***ₖ**(**r**) = *N*⁻¹Σ*_{R} δ* (**r** - **R**), with *δ*(**R**) the Dirac delta function. This choice implies that all the Fourier coefficients *u***_{k,G}** in Eq. (16) are set to 1 and, therefore, it corresponds to expanding the Bloch wave *ϕ***ₖ**(**r**) in the plane wave basis {e^{ik·r}}. The electron operator takes the form ${ψ}_{σ} \left(r\right) = \frac{1}{\sqrt{{V}_{c}}} {\sum }_{k , G} {e}^{i \left(k+G\right) ⋅ r} {c}_{k + G , σ}$ (17) where *c*_{**k+G**,*σ*} is the annihilation operator of an electron with momentum k + G and spin *σ.* An advantage of this basis is that plane waves for different momenta are orthogonal. The Hamiltonian Eq. (1) in term of modes is ${H}^{P} = {\sum }_{k , G , G ′ , σ} {h}_{k , G - G ′} {c}_{k + G , σ}^{†} {c}_{k + G ′ , σ} + {\sum }_{\begin{matrix}k , k ′ , p \\ G , G ′ , σ , σ ′\end{matrix}} {V}_{p} {c}_{k + G + p , σ}^{†} {c}_{k ′ + G ′ - p , , σ ′}^{†} {c}_{k ′ + G ′ , σ ′} {c}_{k + G , σ}$ (18) where ${h}_{k , G - G ′} = \left[\frac{{\left|ℏ\left(k+G\right)\right|}^{2}}{2 m}{δ}_{G , G ′}+{U}_{G - G ′}\right]$*, Vₚ* = 1/(2*V_{c}*)∫ *d***r***e*^{*-ip·***r**}*V*(|**r**|)*,* and p = p + P, with p = k + **k'** and P = G + **G'**,, is the total momentum. *U***_{G}** is the Fourier component of the external lattice potential at reciprocal lattice vector G ${U}^{˜} \left(r\right) = {\sum }_{G} {e}^{i G ⋅ r} {U}_{G} \to {U}_{G} = \frac{1}{Ω} {\int }_{uc} d r {e}^{- i G ⋅ r} {U}^{˜} \left(r\right)$ (19) where the integral is over the unit cell. Using Eq. (2), we find ${U}_{G} = \frac{{q}_{e}}{{ϵ}_{0} Ω} {\sum }_{a} {Z}_{a} \frac{{e}^{i {r}_{a} ⋅ G}}{{\left|G\right|}^{2}} , for G \neq 0 \left({U}_{0}=0\right)$ (20) where the sum runs over the positions **r***ₐ* of the atoms in the unit cell.

### 3.2.2 Bloch wave basis

Going back to the Hamiltonian of Eq. (18), in the non-interacting limit we see that the lattice momentum **k** enters as a parameter, ${H}_{0} = {\sum }_{k , G , G ′ , σ} \left[\frac{{\left|ℏ\left(k+G\right)\right|}^{2}}{2 m}{δ}_{G , G ′}+{U}_{G - G ′}\right] {c}_{k + G , σ}^{†} {c}_{k + G ′ , σ}$ (21)

This implies that we can decompose the Hamiltonian in different crystal momentum blocks as *H* = Σₖ *H*₀ (**k**) and solve an independent Schrödinger equation for each of them, ${H}_{0} \left(k\right) \left|{Ψ}_{n}\left(k\right)\right〉 = {ϵ}_{n} \left(k\right) \left|{Ψ}_{n}\left(k\right)\right〉$ (22) with |*Ψₙ*(**k**)〉 being a two-component spinor state. It is useful to define a particular zone of **k** values called the Brillouin zone, which corresponds to the Wigner-Seltz cell construction in reciprocal space, i.e. the locus of points k in reciprocal space which is closer to **G** = 0. The eigenvalues *εₙ*(**k**) define the energy bands of the system.

The expansion of the non-interacting Hamiltonian in the basis defined by the momentum block eigenstates of Eq. (22), can be obtained by diagonalising *h*_{**k**,**G-G'**} in Eq. (18), ${H}_{0} \left(k\right) ≡ {\sum }_{G , G ′ , σ} {h}_{k , G - G ′} {c}_{k , G , σ}^{†} {c}_{k , G ′ , σ} = {\sum }_{n , σ} {ϵ}_{n} \left(k\right) {f}_{k , n , σ}^{†} {f}_{k , n , σ}$ (23) where *f*_{**k***,n,σ*} = Σ**_{G}**S_{*n*,**G**} (**k**, *σ*)*c*_{**k***,***G***,σ*} is the band fermion annihilation operator. Here *S*_{*n*,**G**}(**k**, *σ*) is the unitary matrix that diagonalises *h*, i.e., *h*_{**k**,**G-G'**} = Σ*ₙ* (*S*^{†})_{**G***,n*} (k, *σ*)*εₙ*(**k**)*S*_{*n*,**G'**}(**k***, σ*). The index n here denotes the band and takes the same number of values as the reciprocal lattice vectors G, i.e., $\left|n\right| = 8 {G}_{max}^{3}$ in *D* = 3 dimensions.

For a system with νₑₗ electrons per unit cell (i.e., corresponding to a total of νₑₗ × *N*₁*N*₂*N*₃ electrons), the system will have νₑₗ occupied bands, as each band can accommodate *N*₁*N*₂*N*₃ states, which is the number of different lattice momentum values in the Brillouin zone (note that νₑₗ can be a rational number, in which case there are $\left⌊{ν}_{el}\right⌋$ fully occupied bands and the last band $\left⌈{ν}_{el}\right⌉$ is partially occupied).

In real space, the non-interacting Hamiltonian corresponding to each momentum block is ${H}_{0} \left(k\right) = \frac{{ℏ}^{2}}{2 m} {\left(k-i∇\right)}^{2} + {U}^{˜} \left(r\right)$ . The spin components of its eigenstates coincide with the periodic functions *u*_{**k**,*n*,*σ*}(**r**) introduced in Eq. (14), i.e., ${H}_{0} \left(k\right) {u}_{k , n , σ} \left(r\right) = {ϵ}_{n} \left(k\right) {u}_{k , n , σ} \left(r\right)$ (24) with the boundary condition *u*_{**k**+**G**,*n*,*σ*}(**r**) = *e*^{*-i***G**·**r**}*u*_{**k***,n,σ*}(**r**). Note that the functions *u*_{**k**,*n*,*σ*}(**r**) are defined within the unit cell via *u*_{**k**,*n*,*σ*}(**r**) = *u*_{**k**,*n*,*σ*}(**r***_{c}* + R) = *u*_{**k**,*n*,*σ*}(**r***_{c}*), where **R** is a lattice vector and **r***_{c}* is a vector with domain in the unit cell. By expanding *u*_{**k**,*n*,*σ*}(**r**) in Eq. (14) in Fourier series one can verify that ${u}_{k , n , σ} \left(r\right) = {\sum }_{G} {e}^{i G ⋅ r} {S}_{n , G} \left(k, σ\right) .$ (25)

In the language of Section 3.1, what we have done so far corresponds to expanding the electron operator on a Bloch wave basis (also called band fermion basis), ${ϕ}_{k , n , σ} \left(r\right) = {e}^{i k ⋅ r} {u}_{k , n , σ} \left(r\right) / \sqrt{{V}_{c}}$. In this basis, the full Hamiltonian is ${H}^{B} = {\sum }_{k , n , σ} {ϵ}_{n} \left(k\right) {f}_{k , n , σ}^{†} {f}_{k , n , σ} + {\sum }_{σ , σ ′} {\sum }_{\begin{matrix}{n}_{1} , {n}_{2} , {n}_{3} , {n}_{4} \\ k , q , k ′\end{matrix}} {V}_{{n}_{1} {n}_{2} {n}_{3} {n}_{4}}^{\left(k,k′,q\right)} {f}_{k + q , {n}_{1} , σ}^{†} {f}_{k ′ - q , {n}_{2} , σ ′}^{†} {f}_{k ′ , {n}_{3} , σ ′} {f}_{k , {n}_{4} , σ}$ (26) with the matrix element ${V}_{{n}_{1} {n}_{2} {n}_{3} {n}_{4}}^{\left(k,k′,q\right)} = {\sum }_{G , K , G ′} {V}_{q + K} {S}_{{n}_{1} , G + K} \left(k+q,σ\right) {S}_{{n}_{2} , G ′ - K} \left(k′-q,σ′\right) {S}_{{n}_{3} , G ′}^{∗} \left(k′,σ′\right) {S}_{{n}_{4} , G}^{∗} \left(k, σ\right) .$ (27)

### 3.3 Real-space single-particle basis: Wannier functions

In Eq. (26), the quadratic part of the Hamiltonian is diagonal, but the electron-electron interaction is highly non-local. In real space, on the other hand, the electron-electron interaction is diagonal, but the kinetic term is not. We look for a representation where both terms are not diagonal with respect to the single particle basis, but as local (in real space) as possible. One very convenient way to achieve this goal is obtained by considering Wannier functions as the single-particle basis. The fermion operators associated with the latter are defined as ${w}_{R , n , σ} = {\sum }_{k , m} {e}^{i k ⋅ R} {U}_{mn}^{∗} \left(k\right) {f}_{k , m , σ} \to {f}_{k , m , σ} = \frac{1}{N} {\sum }_{R , n} {e}^{- i k ⋅ R} {U}_{mn} \left(k\right) {w}_{R , n , σ} ,$ (28) where *Uₘₙ*(**k**) is a unitary transformation representing the gauge freedom in the definition of the Bloch waves. In this basis, the Hamiltonian becomes $\begin{matrix}{H}^{W} = {\sum }_{σ} {\sum }_{\begin{matrix}m , n \\ {R}_{1} , {R}_{2}\end{matrix}} T {\left({R}_{1}-{R}_{2}\right)}_{mn} {w}_{{R}_{1} , m , σ}^{†} {w}_{{R}_{2} , n , σ} \\ + {\sum }_{σ , σ ′} {\sum }_{\begin{matrix}s , l , m , n \\ {R}_{1} , {R}_{2} , {R}_{3} , {R}_{4}\end{matrix}} {{V}^{˜}}_{slmn}^{\left({R}_{1}{R}_{2},{R}_{3},{R}_{4}\right)} {w}_{{R}_{1} , s , σ}^{†} {w}_{{R}_{2} , l , σ ′}^{†} , {w}_{{R}_{3} , m , σ ′} {w}_{{R}_{4} , n , σ}\end{matrix}$ (29) with the matrix elements $T {\left(R\right)}_{mn} = \frac{1}{{N}^{2}} {\sum }_{k} {e}^{i k ⋅ R} {\left[U\left(k\right)ϵ\left(k\right){U}^{†}\left(k\right)\right]}_{nm}$ (30) ${{V}^{˜}}_{slmn}^{\left({R}_{1}, {R}_{2}, {R}_{3}, {R}_{4}\right)} = \frac{1}{{N}^{4}} {\sum }_{\begin{matrix}{n}_{1} {n}_{2} {n}_{3} {n}_{4} \\ k , q , k ′\end{matrix}} {V}_{{n}_{1} {n}_{2} {n}_{3} {n}_{4}}^{\left(k,k′,q\right)} {U}_{{n}_{1} s}^{∗} \left(k+q\right) {U}_{{n}_{2} l}^{∗} \left(k-q\right) {U}_{{n}_{3} m} \left(k′\right) {U}_{{n}_{4} n} \left(k\right)$ (31) $\times {e}^{ik ⋅ \left({R}_{1}-{R}_{4}\right)} {e}^{iq ⋅ \left({R}_{1}-{R}_{2}\right)} {e}^{ik ′ ⋅ \left({R}_{2}-{R}_{3}\right)}$

Defining the Wannier functions ${W}_{s , σ}^{R} \left(r\right) = {W}_{s , σ}^{0} \left(r-R\right) = {\sum }_{k , n} {e}^{- ik ⋅ R} {U}_{ns} \left(k\right) {u}_{k , n , σ} \left(r\right) {e}^{ik ⋅ r}$, we can express the matrix elements of the hopping matrix and the electron-electron interaction as $T {\left({R}_{1}-{R}_{2}\right)}_{mn} = \int d r {W}_{m , σ}^{{R}_{1} ∗} \left(r\right) \left[-\frac{{ℏ}^{2} {∇}^{2}}{2 m}+{U}^{˜}\left(r\right)\right] {W}_{n , σ}^{{R}_{2}} \left(r\right)$ (32a) ${{V}^{˜}}_{slmn}^{\left({R}_{1}, {R}_{2}, {R}_{3}, {R}_{4}\right)} = \frac{1}{2} \int dr \int dr ′ {W}_{s , σ}^{{R}_{1} ∗} \left(r\right) {W}_{l , σ ′}^{{R}_{2} ∗} \left(r′\right) V \left(\left|r-r′\right|\right) {W}_{m , σ ′}^{{R}_{3}} \left(r′\right) {W}_{n , σ}^{{R}_{4}} \left(r\right) .$ (32b)

Since the Coulomb tensor coefficients ${{V}^{˜}}_{slmn}^{\left({R}_{1}, {R}_{2}, {R}_{3}, {R}_{4}\right)}$ involves integrals over the real space, if the Wannier functions ${W}_{s , σ}^{R} \left(r\right)$ are localized around **R,** then the coefficients will decay fast for distant cells in the lattice. From the definition of the Wannier functions we have ${W}_{s , σ}^{0} \left(r\right) ≡ {\sum }_{k} {v}_{k , s , σ} \left(r\right) {e}^{ik ⋅ r}$, where *v*_{**k**,*s*,*σ*}(**r**) are quasi-Bloch functions. This relation tells us that the quasi-Bloch functions and the Wannier functions are related by a Fourier transform. As discussed in below, we can then use the analyticity of the quasi-Bloch functions *v*_{**k**,*s*,*σ*}(**r**) as a function of the crystal momentum **k** to show that maximally localized Wannier functions (MLWFs) can be obtained if the following conditions are satisfied:
The system has a vanishing Chern number. This condition is automatically satisfied in systems with time-reversal symmetry, as in this case the Chern number is zero. Note that systems without time-reversal symmetry can still have a vanishing Chern number.

An energy gap exists between the bands in the active space (see below) and the rest. Note that a system satisfying this condition does not necessarily represent an insulator, as the Fermi energy can lie within an active space which is separated from the rest of the bands.

Therefore the localised representation may advantageously be selected in those systems where an energy gap exists between energy levels of the system in the region of the active space and other energy levels outside of the natural energy levels of the system, not in the active space. In addition, and either systems having time reversal symmetry or systems not having time reversal symmetry but having a vanishing Chern number, or systems having a natural separation of energy scales without considering interactions. These criteria (when satisfied) open up the possibility of using maximally localised Wannier functions, thereby ensuring that the basis is as local as possible.

### Exponentially localized Wannier functions

Here we derive the two conditions for the existence of maximally localized Wannier functions. Recalling the definition of the Wannier functions in Section 3.3, we have ${W}_{s , σ}^{0} \left(r\right) = {\sum }_{k , n} {u}_{k , n , σ} \left(r\right) {U}_{ns} \left(k\right) {e}^{- ik ⋅ r} ≡ {\sum }_{k} {v}_{k , s , σ} \left(r\right) {e}^{- ik ⋅ r} ,$ (133) where *v*_{**k**,*s*,*σ*}(**r**) are quasi-Bloch functions. We can use the analyticity of the quasi-Bloch functions *v*_{**k**,*s*,*σ*}(**r**) as a function of the crystal momentum **k** to show that the Wannier functions are localized, using the following result:
Theorem 1 (Cloizeaux): Let *f*(**k**) be a function of the n -dimensional complex vector **k = k' + ik"** defined in the *n* -torus with periods **b***ⱼ* (*j* = 1, ... , *n*), i.e., *f*(**k** + **b***ᵢ*) = f(**k**). If f(**k**) is an analytic function of **k** in a strip defined by |**k"**| < *A*, then:
*f*(**k**) can be expanded in a convergent Fourier series in this domain $f \left(k\right) = {\sum }_{R} {e}^{i k ⋅ R} g \left(R\right) ,$ (134) where **R** = Σ*ⱼ nⱼ* **r***ⱼ* is a reciprocal lattice vector to **k** satisfying **b***ⱼ* · **r***ₗ* = 2*πδⱼₗ,* and the Fourier coefficients *g*(**R**) satisfy lim_{|**R**|→∞}*e*^{*b*|**R**|}*g*(**R**) = 0 for any *b* < *A.*

Conversely, if the Fourier coefficients have this asymptotic behaviour, the series converges and is analytic in the region |**k"**| < *A.*

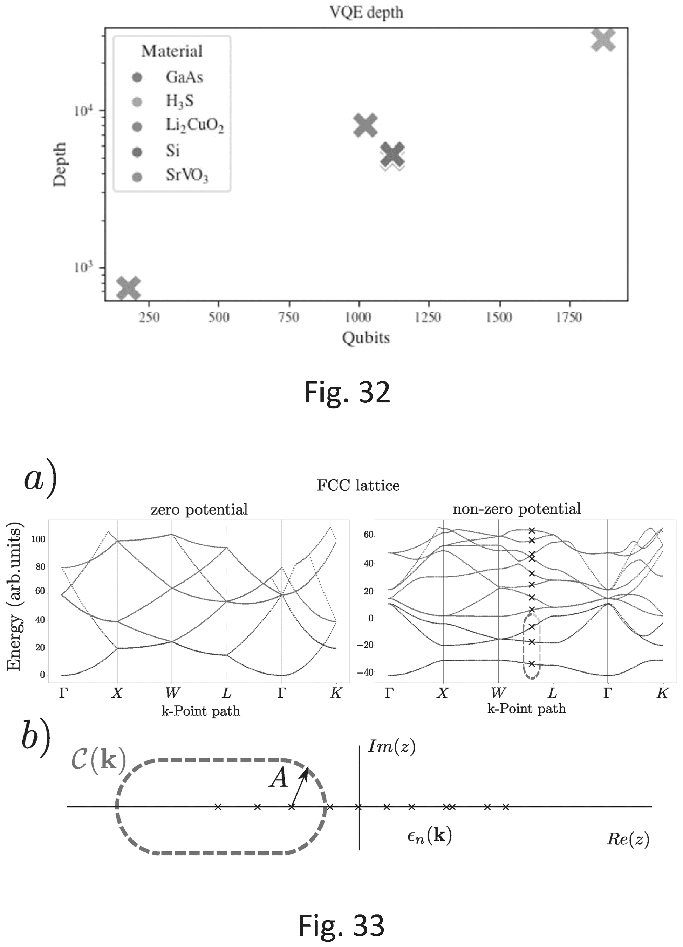

Clearly, if we can show that *v*_{**k**,*s*,*σ*}(**r**) is indeed an analytic function of the crystal momentum, then 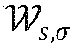 (**r**) will be exponentially localized as a function of **R.** The quasi-Bloch functions *v*_{**k**,*s*,*σ*}(**r**) are associated with the single-particle energies, which are analytic except for points where the bands are degenerate. In that case, the energy surface in the complex plane has a branch-cut. We can define the projector onto the bands considered as 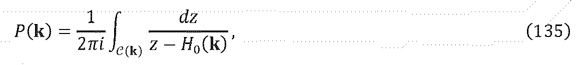 where the contour 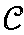 (**k**) encloses the bands in the active space. See Fig. 33, which shows: (a) left: Band structure for face centred cubic (FCC) lattice, in the empty lattice approximation (*U***_{G}** = 0). The three bottom bands are highly degenerate for many values of the crystal momentum. (a) right: Bands structure for FCC lattice, with ${U}_{G} = 100 {\sum }_{a} \frac{{e}^{{ir}_{a} ⋅ G}}{G}$, where the sum runs over the atoms in the unit cell. We observe that the bands split at high symmetry points, and a gap (for each **k**) develops between the three lower bands and the upper energy bands. Considering each band as the real cross-section of a complex eigenenergy parameterized by **k = k' + ik",** we can define a projector onto the lower three bands by using the Riesz projector defined in Eq. (135).(b): The integration contour for the Riesz projector. The width of the strip in in the imaginary direction where the projector is analytic is determined by the gap *A* between the active bands and the rest.

The gap *A* between the last band considered and the first band outside the active space determines the decay of the exponential localization of the Wannier functions. It has been shown that if the sum of Chern numbers on the bands belonging to the active space is zero, then the quasi-Bloch functions exist. The Chern number of a group of bands is defined as ${C}_{l} = \frac{i}{2 π} {\sum }_{i < j} {\int }_{{Θ}_{l}} {B}^{ij} \left(k\right) {dk}_{i} ∧ {dk}_{j} ,$ (136) where the integration is performed in the Brillouin zone. The Berry connection *B^{ij}*(**k**) characterizes the change of frame between different points in the Brillouin zone. This connection is given by ${B}^{ij} \left(k\right) = Tr \left(P\left(k\right)\left[\frac{\partial P \left(k\right)}{\partial {k}_{i}}, \frac{\partial P \left(k\right)}{\partial {k}_{j}}\right]\right) .$ (137)

Therefore, the two following conditions are sufficient to ensure the existence of localized Wannier functions:
Vanishing Chern numbers. It is sufficient to have a system with Time Reversal (TR) symmetry, as in systems with TR symmetry the Chern number is zero. Note that systems without TR symmetry can still have vanishing Chern number.

Large gap between the bands in the active space: Note that this does not necessarily represent an insulator, as the Fermi energy can lie within the active space, which is separated from the rest of the bands.

In this case, both the non-interacting and the electron-electron interaction terms of the Hamiltonian in the Wannier basis of Eq. (29) contain only local terms. Moreover, MLWFs are always real. This fact, combined with the general hermiticity requirement for the hopping matrix *T*(**R**)*ₘₙ* = *T*(-**R**)*ₙₘ* (see Eq. (46) below), implies $T {\left(R\right)}_{mn} = T {\left(-R\right)}_{nm} .$ (33)

As we discussed in previous sections, in order to obtain the Bloch and Wannier functions in an actual material it is necessary to obtain the eigenstates of the system electronic gas moving in the ionic potential *Ũ*(**r**), which is completely determined by just knowing the position of the ions. This requires solving a system of *N* Schrodinger equations for each possible value of the wavevector **k** (see Eq. (24)), a task which is classically unfeasible for most common materials. However, this procedure is generally unnecessarily complex as there are many electrons that are strongly bound to the ions (core electrons) which, if the processes involved are not very energetic, will not participate in the chemistry of the system. Therefore, the properties of a material can be effectively determined by studying the motion of the outermost electrons in a modified ionic potential (pseudo-potential) which combines the original ionic potential with the screening effects of the core electrons. An efficient way of dealing with this approach, which has been developed to maturity in the last century, is density functional theory.

Below we discuss how to obtain Bloch and Wannier functions within the framework of density functional theory and how to select the relevant degrees of freedom for the description of the system.

### 3.4 Using DFT to choose degrees of freedom.

Density Functional Theory (DFT) is a highly efficient, accurate and flexible method for simulating atomic systems. It has enjoyed decades of success for simulating the ground state properties of numerous quantum systems at the atomic scale across the entire periodic table for translationally invariant systems.

In this work, we use DFT to generate single particle Kohn-Sham states (described below) which then are used to select an active space of bands where the relevant processes appear. Once this active space has been chosen, we generate Maximally localised Wannier functions (MLWFs) for the construction of second quantised many body Hamiltonians.

DFT formally states that there exists an exact mapping between the external potential of a many body system and its ground state density *n*₀(**r**), whereby the nondegenerate ground-state wavefunction is a unique functional of the ground-state density, i.e. ${Ψ}_{0} \left({r}_{1},{r}_{2},…,{r}_{N}\right) = Ψ \left[{n}_{0}\left(r\right)\right] .$ (34)

An important ground-state property is its energy, and Hohenberg and Kohn additionally proved that it is minimal if the electron density is the ground-state electron density, $E \left[{n}_{0}\left(r\right)\right] \leq E \left[n\left(r\right)\right] ,$ (35) where n(r) is density of the system. Kohn and Sham subsequently showed how to map the fully interacting many body problem onto a single-particle problem, i.e., $\left[\frac{{ℏ}^{2}}{2 m}{∇}^{2}+{{U}^{˜}}_{eff}\left(r\right)\right] {ϕ}_{i} \left(r\right) = {ϵ}_{i} {ϕ}_{i} \left(r\right) ,$ (36) where *Ũ*_{eff}(**r**) is the effective Kohn-Sham potential, *εᵢ* are the single-particle Kohn-Sham eigenvalues and {*ϕᵢ*(**r**)} are the Kohn-Sham states; fictitious orbitals (not formally related to any physical electron state) such that they must obey the following constraint, ${n}_{0} \left(r\right) = {\sum }_{i = 1}^{occ} {\left|{ϕ}_{i}\left(r\right)\right|}^{2} ,$ (37) where *n*₀(**r**) is the ground state density. This constraint fixes the electron occupation in the system.

While DFT is in principle an ab initio method, i.e. requiring only the lattice structure of the system, practically it necessitates the choice of (i) a basis for the fictitious single particle Kohn-Sham states {*ϕᵢ*(**r**)} and (ii) a parameterized Kohn-Sham exchange correlation functional. In this work, for the DFT exploration we exclusively consider plane-wave basis sets, as implemented in Quantum Espresso, which are subsequently transformed into real-space MLWFs using Wannier90. We note that it is also possible to solve the Kohn-Sham equation exclusively in the real space basis, using the so-called "all-electron" methods, of which the Linear Muffin Tin Orbital (LMTO) formulations are particularly common. We now summarise some of the main features of employing a plane-wave basis code, choosing the appropriate exchange correlation functional and truncation of the Hilbert space using MLWFs.

### 3.5 Kohn-Sham eigenstates in the plane-wave basis

Bloch's theorem in periodic systems can be applied to the solution of the full Hamiltonian of any system that can be written in the plane-wave basis. Similarly, so can the Kohn-Sham equations. In the plane-wave basis-set the Hilbert space is truncated by considering only a finite number of reciprocal lattice vectors **G.** This is motivated by the fact that the kinetic energy is an unbounded operator that depends on the length of the reciprocal lattice vector, so a maximum energy sets a maximum value for the norm of G as $\frac{{ℏ}^{2}}{2 m} {\left|G\right|}^{2} = {E}_{max}$. After diagonalization of the single particle Hamiltonian, only a finite number of bands below and above the Fermi energy are retained. Moreover, as a consequence of Bloch's theorem, there is a natural partition of the degrees of freedom using the reciprocal lattice vectors. this is illustrated in Fig. 4 - the black grid corresponds to the reciprocal lattice **G** = *n*₁**b**₁ + *n*₂**b**₂, and it is unbounded ( ${n}_{a} ∈ ℤ$). The small, fine lattice represents the different lattice momentum states **k.** Increasing the system size leads to a finer reciprocal lattice, without affecting the black lattice. The red dots represent the maximum value of **G** inside a cut-off region depicted by the grey circle; While the size of the system under study defines the number of inequivalent **k** points as seen in Eq. (13); the number of different reciprocal lattice vectors is unbounded.

The following cut-off is defined, $\frac{{ℏ}^{2}}{2 m} {\left|G\right|}^{2} \leq {E}_{cut} ,$ (38) which defines the total number of plane-waves used in the DFT calculation. Fewer plane waves can be used by replacing the core level Kohn-Sham states by an effective potential, famously known as the pseudopotential. It is this crucial observation, i.e. that the core electrons do not participate in low energy, chemically relevant, excitations like their valence counterparts, that enables the success of the plane-wave method. Otherwise, the valence electron wavefunctions require impractically large number of Fourier components to remain orthogonal to all states within the core region, which are chemically inert. Thus, 'freezing' the core-states into an overall effective potential lifts this constraint and allows the valence electrons to be efficiently represented with far fewer Fourier components, without any nodes inside the core regions. Practically, smaller matrices have to be diagonalized when solving Eq. (36), due to the reduced basis size. Pseudopotentials for atoms are constructed by solving for all eigenvalues of their atomic wavefunction, fitting them to pseudo wavefunctions and generating the corresponding atomic pseudopotential. The constructed pseudopotential must reproduce the atomic properties of the element, i.e. the scattering properties of the ionic potential, and agree with its true wavefunction outside of a cut-off radius away from the core. Moreover, it should be transferrable to a variety of chemical environments. For the materials used in this work, we use pseudopotentials from the pre-generated ONCVPSP set.

As a result, the actual value for the kinetic energy cut-off *E*_{cut} is usually chosen such that it corresponds to the minimum energy where the convergence of the total ground state energy does not change with respect to a specific tolerance, typically 1 meV per atom. In a material like Silicon, a value used in DFT calculations is *E_{c}* ~ 200 eV. Using Eq. (38) this translates into ${G}_{max} = \frac{2 π}{a} {N}_{max}$ with *N*ₘₐₓ ~ 5. Depending on the pseudopotential used and the material under consideration, the total ground state energy converges for larger cut-off energies. A cut off energy of 800 eV implies a doubling of the value of *N*ₘₐₓ from 5 to 10. From the perspective of the Kohn-Sham approach to DFT, in reciprocal space, the Kohn-Sham equations in second quantization are given by, *H^{KS}*(**k**)*ϕ*_{**k***,n*}(**r**) = *ε***ₖ***_{,n}ϕ*_{**k***,n*}(**r**), with ${H}^{KS} \left(k\right) = {\sum }_{k , G , G ′} \left[\frac{{ℏ}^{2} {\left|k+G\right|}^{2}}{2 m}{δ}_{G , G ′}+{U}_{G - G ′}^{eff}\right] {f}_{k + G}^{†} {f}_{k + G ′}$ (39) where the effective ${U}_{G - G ′}^{eff}$ is the potential containing the exchange-correlation functional.

Additionally, before the optimal truncation of the active space occurs, the force on the ions created by the electronic charge of the electrons must be minimised. So far, in the spirit of the Born-Oppenheimer approximation, we have neglected the dynamics of the ions. In particular, their positions {**R***_{I}*} enter the Kohn-Sham equations of Eq. (36) as parameters, while their motion occurs on potential energy surfaces which are determined by the eigenvalues *εᵢ*({**R***_{I}*}) of the electronic problem. At equilibrium, denoting by *ε*₀({**R***_{I}*}) the ground-state energy of the electronic system, the minimization of the force acting on ion *I* requires that ${F}_{I} = \frac{\partial E \left(R\right)}{\partial {R}_{I}} < δ , ∀ I ,$ (40) i.e., the ions' equilibrium positions are obtained from the minimization of *ε*₀({**R***_{I}*}) which is a function of 3*N* variables, and *δ* is the threshold value on the force all ions must satisfy.

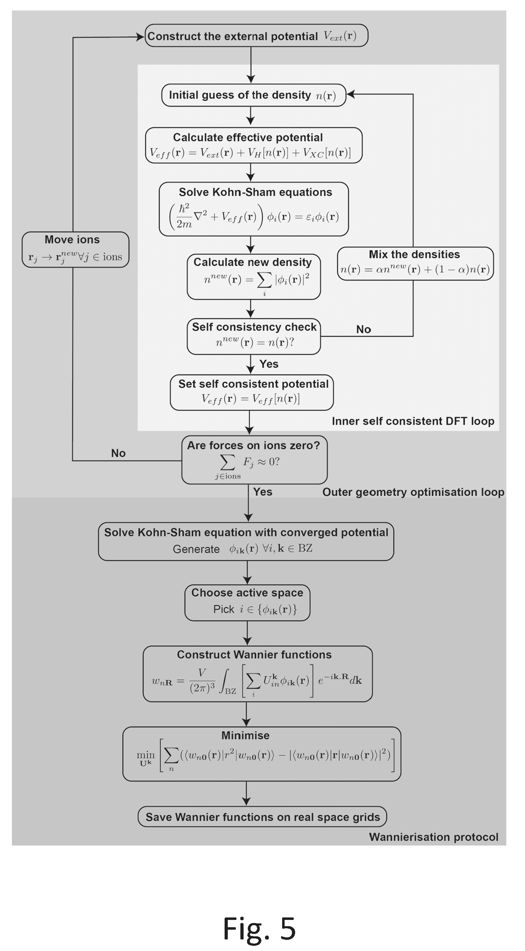

In the upper part of Fig. 5 a workflow of a typical Density Functional Theory calculation is shown highlighting the inner electronic self-consistency loop and outer structural optimisation loop. We supplement this procedure with a Wannierisation protocol in the lower portion illustrating the steps required to transform from a plane-wave basis set to a maximally localised one. This illustrates the typical workflow of a self-consistent DFT calculation, from calculating the external potential until self-consistency is achieved in the electronic density and geometry.

Using DFT, the single particle Bloch states are replaced by the corresponding Kohn-Sham orbitals.

### 3.5.1 Truncation into an active space

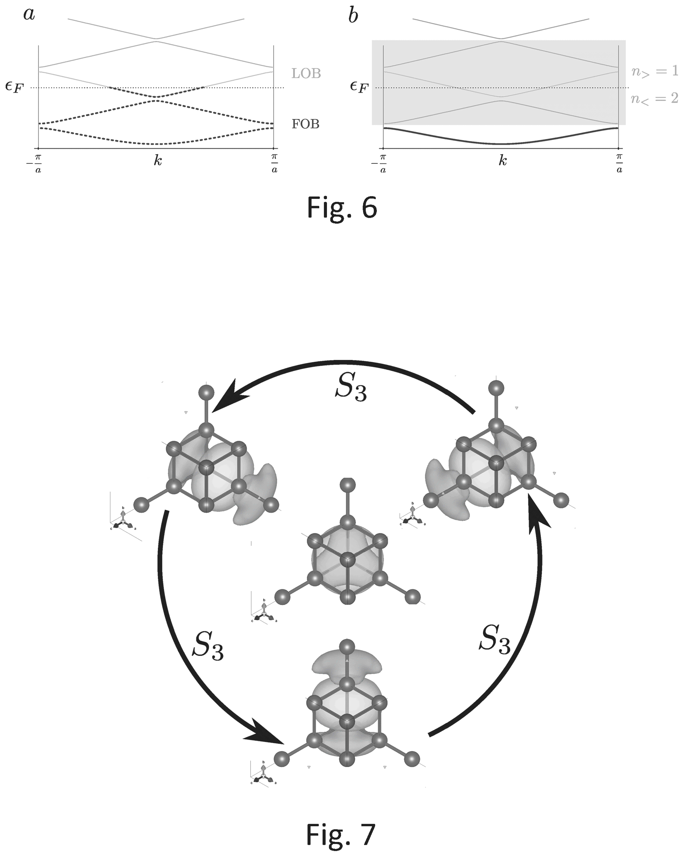

To further reduce the Hilbert space, we can truncate the Kohn-Sham eigenstates into a minimal representation within an active space of chemical interest. One such definition is to consider just the states around the last occupied band, as illustrated in Fig. 6, which illustrates that the number of electrons in the system defines the Fermi energy *ε_{F}*. In the non-interacting picture, the fermions fill the lowest single particle energy levels, shown here as bands in the Brillouin zone, for a one dimensional system. The dashed line represents a set of fermions occupying that particular energy level. In the figure, the lowest two bands are fully occupied bands (FOB), while the last occupied band (LOB) is partially occupied;

Figure 6(b) shows that, instead of considering all the bands, we can define an active space, where the electrons can reorganize due to interaction effects. This active space is represented here by the states in the shaded area, around the LOB. In this example, the number of bands below and including the LOB is *n*_{<} = 2, while the number of bands above the LOB is *n*_{>} = 1;

Fixing the number of bands above the last occupied one to be n, and the number of bands below the last occupied one and including it to be *n*_{<}, the dimension of the reduced Hilbert space 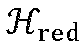 for a three dimensional material is $Dim \left({H}_{red}\right) ∼ O \left({e}^{\left({n}_{>}+{n}_{<}\right) {N}_{1} {N}_{2} {N}_{3} H \left(x\right)}\right)$ (41) with $x = \frac{{n}_{<} - 1 + {ν}_{el} - \left⌊{ν}_{el}\right⌋}{{n}_{>} + {n}_{<}}$ and *H*(*x*) = *-xlnx* - (1 - *x*)ln(1 - *x*). In addition to knowing the dimension of the Hilbert Space, the orbital character of the individual quantum states is required for the chemical interpretation of the possible physical processes that can occur between these states. Once the relevant Kohn-Sham orbitals have been selected, this represents the basis of the fermion operator in the active space. In contrast, to generate Wannier functions, further classical computation has to be performed.

A crucial step to generating MLWFs is to provide an initial set of sensible projectors that reflect the orbital character of the Kohn-Sham plane-wave eigenstates. To achieve this, a local projection operator ${\hat{P}}_{I}^{N}$ is used, which projects onto the subspace *N* = {*α, l, m*}, where *α* is the principal quantum number, *l* is the azimuthal quantum number and *m* the magnetic spin quantum number centred at ion *I* - these are the quantum numbers associated with the eigenstates of the angular momentum operator, and here are used as a basis for interpretability of the Kohn-Sham orbitals in terms of atomic or molecular orbitals. Assuming a paramagnetic spin system, the local projection is given by, ${\hat{P}}_{I}^{N} = \left|{Y}_{I}^{N}\right〉 \left〈{Y}_{I}^{N}\right| ,$ (42) where ${Y}_{I}^{N}$ is the spherical harmonic centred at the centre of ion *I* and in the subspace *N*. Therefore, for the Kohn-Sham eigenpair (*εₙₖ, ϕₙₖ*), the projected weight ${p}_{nk}^{N}$ is defined as, $\begin{matrix}{p}_{nk}^{N} = \left〈{ϕ}_{nk}\right| {\hat{P}}^{N} \left|{ϕ}_{nk}\right〉 , & \left(43\right) \\ = \left〈{ϕ}_{nk}\right| {Y}_{I}^{N} \left〈\left.{Y}_{I}^{N}\right|{ϕ}_{nk}\right〉 , & \left(44\right) \\ = {\left|\left〈{ϕ}_{nk}\left|{Y}_{I}^{N}\right.\right〉\right|}^{2} & \left(45\right)\end{matrix}$

Subsequently, each Kohn-Sham eigenpair generates a set of weighted projections $\left\{\left({ε}_{nk}, {ϕ}_{nk}, {p}_{nk}^{N}\right)\right\}$ at each ion site *I* for the chosen subspace *N.* Typically, for a given subspace, this weight is overlaid at each point in the band-structure as a colour gradient and highlights the orbital character of all the Kohn-Sham eigenpairs in the chosen subspace. For example, *N* = {2,2,0} determines the 3*d*_{*z*₂} subspace, given by the spherical harmonic ${Y}_{I}^{2 , 2 , 0}$ centred at ion *I*. In Quantum Espresso, the axes of the spherical harmonics is orientated so that it aligns with the Cartesian axes.

Finally, MLWFs are then generated with the Wannier90 code. The lower half of Fig. 5 summarises the protocol for producing MLWFs after the DFT calculation has been run, which takes as input the Kohn-Sham eigenstates and outputs Wannier functions on a real spaced grid.

As discussed in this section, the ion potential defines the single particle states in the Bloch and Wannier functions, and those in turn determine the structure of the Hamiltonian. It is possible to extract more information about the structure of the Hamiltonian by general guiding principles based on symmetry. These symmetries constraint the form of the operators appearing in the Hamiltonian, thus reducing the number of terms that has to be implemented in a circuit. They are also important because they impose relations between the fermion integrals that allow to reduce the number of classical computation required to determine the Hamiltonian. In the next sections we discuss the structure of the fermion integrals in the presence of the generic symmetries of lattice inversion, time reversal and crystal symmetries, with respect to different single particle states.

### 3.6 General constraints and symmetry properties of the fermion integrals

The single particle wavefunctions determine the symmetry properties of the second-quantized Hamiltonian. For generic real space wavefunctions, the symmetry properties are discussed below. After that, we discuss in this section two important generic symmetries in the Bloch and Wannier basis respectively, inversion (3.6.2) and time reversal symmetry (3.6.3).

### 3.6.1 General constrains and symmetry properties of the fermion integrals for general real single-particle wavefunctions

The hopping matrix and Coulomb tensor of a general many-body system satisfy the following identities (see Eqs 5, 6): ${t}_{{λ}_{1} {λ}_{2}} = {t}_{{λ}_{2} {λ}_{1}}^{∗} \left(hermiticity\right) ,$ (46) ${V}_{{λ}_{1} {λ}_{2} {λ}_{3} {λ}_{4}} = {V}_{{λ}_{2} {λ}_{1} {λ}_{4} {λ}_{3}} \left(swap symmetry\right) ,$ (47) ${V}_{{λ}_{1} {λ}_{2} {λ}_{3} {λ}_{4}} = {V}_{{λ}_{4} {λ}_{3} {λ}_{2} {λ}_{1}}^{∗} \left(hermiticity\right) ,$ (48) ${V}_{{λ}_{1} {λ}_{2} {λ}_{3} {λ}_{4}} = {V}_{{λ}_{3} {λ}_{4} {λ}_{1} {λ}_{2}}^{∗} \left(hermiticity+swap\right) ,$ (49) for single-particle bases with real wavefunctions {*ϕ_{λ}*(**r**)} (see Section 3.3) the above relations simplify to ${t}_{{λ}_{1} {λ}_{2}} = {t}_{{λ}_{2} {λ}_{1}} ,$ (50) $\begin{matrix}{V}_{{λ}_{1} {λ}_{2} {λ}_{3} {λ}_{4}} = {V}_{{λ}_{4} {λ}_{3} {λ}_{2} {λ}_{1}} = {V}_{{λ}_{2} {λ}_{1} {λ}_{4} {λ}_{3}} = {V}_{{λ}_{4} {λ}_{2} {λ}_{3} {λ}_{1}} = {V}_{{V}_{{λ}_{1} {λ}_{3} {λ}_{2} {λ}_{4}}} \\ = {V}_{{λ}_{3} {λ}_{4} {λ}_{1} {λ}_{2}} = {V}_{{λ}_{3} {λ}_{1} {λ}_{4} {λ}_{2}} = {V}_{{λ}_{2} {λ}_{4} {λ}_{1} {λ}_{3}} .\end{matrix}$ (51)

In particular, the latter set of equivalences has been obtained by combining the hermiticity and swap symmetry of the Coulomb tensor with the additional symmetry *V*_{*λ*₁*λ*₂*λ*₃*λ*₄} = *V*_{*λ*₄*λ*₃*λ*₂*λ*₁} = *V*_{*λ*₁*λ*₃*λ*₂*λ*₄} arising from Eq. (6) for real wavefunctions and it can be exploited to significantly reduce the number of independent Coulomb tensor coefficients one has to directly compute.

After the single particle basis has been picked and thus the second quantized Hamiltonian is fixed, it will have a form like Eq. (4). To pass into a qubit Hamiltonian, as we will discuss in Section 4, it is useful to group together the single-particle quantum numbers and the spin in a single label *ξᵢ* = (*λᵢ, σᵢ*). Introducing the spin-dependent hopping matrix 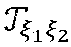 and Coulomb tensor 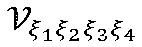 we can re-write Eq. (4) as $H = {\sum }_{{ξ}_{1} , {ξ}_{2}} {T}_{{ξ}_{1} {ξ}_{2}} {c}_{{ξ}_{1}}^{†} {c}_{{ξ}_{2}} + {\sum }_{{ξ}_{1} , {ξ}_{2} , {ξ}_{3} , {ξ}_{4}} {V}_{{ξ}_{1} {ξ}_{2} {ξ}_{3} {ξ}_{4}} {c}_{{ξ}_{1}}^{†} {c}_{{ξ}_{2}}^{†} {c}_{{ξ}_{3}} {c}_{{ξ}_{4}} .$ (52)

Here the spinful hopping matrix is ${T}_{{ξ}_{1} {ξ}_{2}} = \left\{\begin{matrix}{t}_{{λ}_{1} {λ}_{2}} & if {σ}_{1} = {σ}_{2} \\ 0 & otherwise\end{matrix}\right.$ (53) while the spinful Coulomb tensor is ${V}_{{ξ}_{1} {ξ}_{2} {ξ}_{3} {ξ}_{4}} = \left\{\begin{matrix}{V}_{{λ}_{1} {λ}_{2} {λ}_{3} {λ}_{4}}^{s} & if {σ}_{1} = {σ}_{2} = {σ}_{3} = {σ}_{4} \\ \frac{1}{2} {V}_{{λ}_{1} {λ}_{2} {λ}_{3} {λ}_{4}} & if {σ}_{1} = {σ}_{4} and {σ}_{2} = {σ}_{3} \left({σ}_{1}\neq {σ}_{2}\right) \\ - \frac{1}{2} {V}_{{λ}_{2} {λ}_{1} {λ}_{3} {λ}_{4}} & if {σ}_{1} = {σ}_{3} and {σ}_{2} = {σ}_{4} \left({σ}_{1}\neq {σ}_{2}\right) \\ 0 & otherwise\end{matrix}\right. ,$ (54) with ${V}_{{λ}_{1} {λ}_{2} {λ}_{3} {λ}_{4}}^{s} = \left({V}_{{λ}_{1} {λ}_{2} {λ}_{3} {λ}_{4}}-{V}_{{λ}_{2} {λ}_{1} {λ}_{3} {λ}_{4}}\right) / 2$.The spinful Coulomb tensor 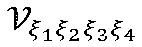 is hermitian, ${V}_{{ξ}_{1} {ξ}_{2} {ξ}_{3} {ξ}_{4}} = {V}_{{ξ}_{4} {ξ}_{3} {ξ}_{2} {ξ}_{1}}^{∗}$ , and anti-symmetric ${V}_{{ξ}_{1} {ξ}_{2} {ξ}_{3} {ξ}_{4}} = - {V}_{{ξ}_{2} {ξ}_{1} {ξ}_{3} {ξ}_{4}} = - {V}_{{ξ}_{1} {ξ}_{2} {ξ}_{4} {ξ}_{3}} = {V}_{{ξ}_{2} {ξ}_{1} {ξ}_{4} {ξ}_{3}} .$ (55)

Note that for the case *σ*₁ = *σ*₄ and *σ*₂ = *σ*₃ 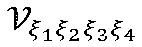 obeys the same identities in Eq. (51) as *V*_{*λ*₁*λ*₂*λ*₃*λ*₄}*.* In this latter case, by exploiting Eq. (51) and Eq. (55), one can show that 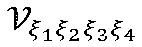 also satisfies the following Jacobi identity: ${V}_{{ξ}_{1} {ξ}_{2} {ξ}_{3} {ξ}_{4}} + {V}_{{ξ}_{1} {ξ}_{3} {ξ}_{4} {ξ}_{2}} + {V}_{{ξ}_{1} {ξ}_{4} {ξ}_{2} {ξ}_{3}} = 0 if {σ}_{1} = {σ}_{4} and {σ}_{2} = {σ}_{3} .$ (56)

### 3.6.2 Inversion symmetry

Inversion symmetry 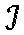 transforms space and momentum variables according to r → -r and k → -k, respectively. In a crystal with inversion symmetry the external potential satisfies *Ũ*(**r**) = *Ũ*(-**r**).

Bloch basis: under inversion, a Bloch wavefunction *ϕ*_{**k***,n,σ*}(**r**) transforms as ${ϕ}_{k , n , σ} \left(r\right) \to {Jϕ}_{k , n , σ} \left(r\right) = {ϕ}_{k , n , σ} \left(-r\right) = {ϕ}_{- k , n , σ} \left(r\right) .$ (57)

Recalling that in Bloch basis the hopping matrix is *hₘₙ*(**k***,* k') = *εₘ*(**k**)*δ***_{k,k'}***δₘₙ*, with ${ϵ}_{m} \left(k\right) = \int d r {ϕ}_{k , m , σ}^{∗} \left(r\right) \left[-\frac{{ℏ}^{2} {∇}^{2}}{2 m}+{U}^{˜}\left(r\right)\right] {ϕ}_{k , m , σ} \left(r\right) ,$ (58) in a crystal with inversion symmetry one finds ${ϵ}_{m} \left(k\right) = {ϵ}_{m} \left(-k\right) .$ (59)

Since the electron-electron interaction potential *V*(|**r** - **r'**|) is always invariant under inversion, one also obtains ${V}_{{n}_{1} {n}_{2} {n}_{3} {n}_{4}}^{\left(k,k′,q\right)} = {V}_{{n}_{1} {n}_{2} {n}_{3} {n}_{4}}^{\left(-k,-k′,-q\right)} .$ (60)

Wannier basis: under inversion with respect to R = **0**, a Wannier function ${W}_{m , σ}^{R} \left(r\right)$ transforms as ${W}_{m , σ}^{R} \left(r\right) \to {JW}_{m , σ}^{R} \left(r\right) = {W}_{m , σ}^{- R} \left(-r\right) .$ (61)

First, we note that if the unitary transformation entering the definition of the Wannier basis in Eq. (28) is trivial, i.e., *Uₘₙ*(**k**) *= δₘₙ,* Eq. (30) reduces to $T {\left(R\right)}_{mn} = \frac{1}{{N}^{2}} {\sum }_{k} {e}^{i k ⋅ R} {ϵ}_{n} \left(k\right) {δ}_{mn} .$ (62)

If the crystal has inversion symmetry, from Eq. (59) we have *εₙ*(**k**) = *εₙ*(-**k**) and, therefore, $T {\left(R\right)}_{mn} = T {\left(-R\right)}_{mn} = T {\left(R\right)}_{nm} , ∀ m , n ,$ (63) where in the last step we used Eq. (33). Unfortunately, for MLWFs the unitary matrix *Uₘₙ*(**k**) is usually more complicated and the relation above does not hold in general.

A more general identity can be obtained if the Wannier functions transform under inversion as ${JW}_{m , σ}^{R} \left(r\right) = {W}_{m , σ}^{- R} \left(-r\right) = {\sum }_{m ′} {P}_{mm ′}^{π} {W}_{m ′ , σ}^{- R} \left(r\right)$, with *P^{π}* the generalized permutation matrix corresponding to a permutation *π* acting on the orbital indices, with ${P}_{mm ′}^{π} = {η}_{m} = \pm 1$ for m' = *π*(*m*) and ${P}_{mm ′}^{π} = 0$ otherwise. Since usually Wannier functions retain the main features of the corresponding atomic orbitals, this a quite common situation. In this case, in a crystal with inversion symmetry, one obtains $T {\left(R\right)}_{mn} = {\sum }_{m ′ , n ′} {P}_{mm ′}^{π} {P}_{nn ′}^{π} T {\left(R\right)}_{m ′ n ′} = {η}_{m} {η}_{n} T {\left(R\right)}_{π \left(m\right) π \left(n\right)} ,$ (64) from which one can see that $T {\left(R\right)}_{mn} = 0 if \left(π\left(m\right),π\left(n\right)\right) = \left(m, n\right) and {η}_{m} {η}_{n} = - 1 .$ (65)

The identity above can be generalized by noting that for **R** = **0** we have *T*(**0**)*ₘₙ* = *T*(**0**)*ₙₘ* and hence the two orbital configurations (*m*, *n*) and (*n*, *m*) are equivalent in the computation of the hopping matrix. We can then introduce the set of the orbital configurations equivalent to (*m,n*) as [(*m*, *n*)]⁰ = {(*m*, *n*), (*n*, *m*)} and [(*m*, *n*)]***^{R}*** = {*m*, *n*} for **R** ≠ 0. Using this fact, we finally obtain $T {\left(R\right)}_{mn} = 0 if \left(π\left(m\right),π\left(n\right)\right) ∈ {\left[\left(m, n\right)\right]}^{R} and {η}_{m} {η}_{n} = - 1 .$ (66)

On the other hand, the electron-electron interaction potential V(|r - **r'**|) is always invariant under inversion. In cases with Wannier functions transforming as ${JW}_{m , σ}^{R} \left(r\right) = {W}_{m , σ}^{- R} \left(-r\right) = {\sum }_{m ′} {P}_{mm ′}^{π} {W}_{m ′ , σ}^{- R} \left(r\right)$ under inversion, one obtains ${{V}^{˜}}_{s , l , m , n}^{\left({R}_{1}, {R}_{2}, {R}_{3}, {R}_{4}\right)} = 0 if \left(π\left(s\right),π\left(l\right),π\left(m\right),π\left(n\right)\right) ∈ {\left[\left(s, l, m, n\right)\right]}^{{R}_{1} {R}_{2} {R}_{3} {R}_{4}} and {η}_{s} {η}_{l} {η}_{m} {η}_{n} = - 1 .$ (67)

Here, [(s, *l*, *m*, *n*)]^{**R**₁**R**₂**R**₃**R**₄} is the set of equivalent orbital configurations according to Eq. (51). See the "Coulomb tensor coefficients" section below for details. The equation above is particularly useful since it allows one to determine a number of coefficients of the Coulomb tensor which are identically zero without the need to compute them.

### Hamiltonian coefficients pipeline

In this section we describe the pipeline to generate the hopping matrix (HM) and Coulomb tensor (CT) coefficients for an arbitrary material in the Wannier function basis. The following assumptions are made: 1) real Wannier functions, 2) non-magnetic material (i.e., equivalent spin sectors), 3) n - order nearest-neighbor electron-electron interactions.

### Full Hamiltonian of an electronic system on a lattice

We consider a system of electrons whose wavefunctions are localized around the N sites of a translationally invariant (Bravais) lattice 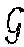 . Working within the Born-Oppenheimer approximation, we assume that its electronic problem has been restricted to an active space spanned by M Wannier functions (WFs) ${W}_{i , σ}^{P} \left(r\right)$ per site, with *P* ∈ 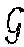 , *i* ∈ {1, ... , *M*} labeling the various modes/orbitals, and σ ∈ {↑ , ↓} the spin quantum number. By choosing a coordinate system with origin *O*, we can assign to each point *P* ∈ 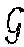 a vector ${R}_{P} = {n}_{1}^{P} {R}_{1} + {n}_{2}^{P} {R}_{2} + {n}_{2}^{P} {R}_{3} ∈ B$, with **R***ₐ*, *a* = 1,2,3 the primitive vectors of 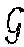 and $B = \left\{\left.R={n}_{1}{R}_{1}+{n}_{2}{R}_{2}+{n}_{3}{R}_{3}\right|{n}_{a}∈ℤ,a=1,2,3\right\}$ the set of all possible translations on 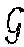 . Hence, **R***_{O}* = **0** and ${W}_{i , σ}^{P} \left(r\right) = {W}_{i , σ} \left(r-{R}_{P}\right)$.

The full Hamiltonian for the most general electronic system on the lattice 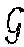 is $H = {H}_{0} + {H}_{int} ,$ (140) with quadratic/free and quartic/interaction contributions given by ${H}_{0} = {\sum }_{{σ}_{1} , {σ}_{2}} {\sum }_{A , B} {\sum }_{i , j} {t}_{\left(A, i, {σ}_{1}\right) , \left(B, j, {σ}_{2}\right)} {w}_{A , i , {σ}_{1}}^{†} {w}_{B , j , {σ}_{2}} ,$ (141a) ${H}_{int} = {\sum }_{{σ}_{1} , {σ}_{2} , {σ}_{3} , {σ}_{4}} {\sum }_{A , B , C , D} {\sum }_{i , j , k , l} {V}_{\left(A, i, {σ}_{1}\right) , \left(B, j, {σ}_{2}\right) , \left(C, k, {σ}_{3}\right) , \left(D, l, {σ}_{4}\right)} {w}_{A , i , {σ}_{1}}^{†} {w}_{B , j , {σ}_{2}}^{†} {w}_{C , k , {σ}_{3}} {w}_{D , l , {σ}_{4}} ,$ (141b) with *σ*₁, *σ*₂, *σ*₃, *σ*₄ ∈ {↓, ↑}, *A, B, C, D* ∈ 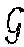 *,* and *i, j, k, l* ∈ {1, ... , *M*}. Here, ${w}_{A , i , σ}^{\left(†\right)}$ destroys (creates) an electron at site A with mode i and spin *σ.* Finally, *t* and V denote the spinful hopping matrix and the Coulomb tensor, respectively.

In what follows we will make the following assumptions:
Non-magnetic material (NMM) approximation: we will consider materials without spin-orbit coupling and in the absence of magnetic fields. In this case, the spin up and spin down sectors are completely equivalent. From here on, we will therefore omit the spin index in the WFs, i.e. ${W}_{i , σ}^{P} \left(r\right) ≡ {W}_{i}^{P} \left(r\right)$. Note that this assumption can be relaxed by generalizing Eq. (142) and Eq. (145) below.

Real Wannier functions: we will assume that the WFs ${W}_{i , σ}^{P} \left(r\right)$ are real. This is always true if maximally localized Wannier functions can be built (see the "Exponentially localized Wannier functions" section above).

Nearest-neighbour (NN) approximation: in calculating the HM and the CT coefficients, we will consider a nearest-neighbour (NN) approximation up to order *n.* Thanks to the localization properties of the MLWFs this is a reasonable approximation for a wide range of materials. By looking at a lattice site *P* ∈ 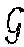 we group all the other sites of the lattice in ascending order of Euclidean distances from *P,* namely 0 = *d*₀ < *d*₁ < *d*₂ *<* ··· *< dₙ.* All the sites of the lattice having the same distance *dₙ* from *P* represent the nearest neighbors of order *n* of *P.* Then, in the NN approximation of order *n* we compute only those HM (CT) coefficients involving lattice sites *A* and *B* (*A, B, C, D*) which are NN of order ≤ n with respect to each other, i.e., such that |*P*₁ - *P*₂| ≤ *dₙ,* ∀*P*₁, *P*₂ ∈ *A, B* (∀*P*₁, *P*₂ ∈ *A, B, C, D*) and set ${t}_{ij}^{AB} = 0 \left({V}_{ijkl}^{ABCD}=0\right)$ otherwise. Here, |...| denotes the Euclidean distance between two lattice sites. In particular, we introduce the general notation ${N}_{G ′}^{n} = \left\{\left.P∈G\right|\left|P-P′\right|\leq {d}_{n},∀P′∈G′\right\}$*,* with 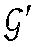 ⊆ 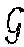 , and ${N}_{G ′}^{n} = dim \left({N}_{G ′}^{n}\right)$, to denote the set of sites of 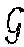 which are NNs of order ≤ n with respect to all the sites of 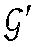 and their total number, respectively.

Within these approximations, we have that the coefficients of the spinful HM in Eq. (141) are defined as ${t}_{\left(A, i, {σ}_{1}\right) , \left(B, j, {σ}_{2}\right)} = \left\{\begin{matrix}{T}_{ij}^{AB} & if {σ}_{1} = {σ}_{2} \\ 0 & otherwise\end{matrix}\right. ,$ (142) where the bare HM coefficients are given by ${T}_{ij}^{AB} = \int d r {W}_{i} \left(r-{R}_{A}\right) {H}_{sp} {W}_{j} \left(r-{R}_{B}\right) .$ (143)

In what follows we will omit this specification and we will implicitly assume that all the HM and CT coefficients but the spinful ones are bare coefficients.

Here, *H*ₛₚ = -ℏ²∇²/(2*m*) + *Ũ*_{eff}(**r**) is the single particle Hamiltonian, with *U*_{eff} the effective Kohn-Sham potential (implicitly) derived within Density Functional Theory (see Section 3.4). Thanks to the translational invariance of the lattice, all the HM coefficients can be obtained from the core ones, which are defined by setting *A* = *O* in the equation above, ${T}_{ij}^{OB} = \int d r {W}_{i} \left(r\right) {H}_{sp} {W}_{j} \left(r-{R}_{B}\right) .$ (144)

The coefficients of the spinful CT in Eq. (141), *V*_{(*A,i,σ*₁),(*B,j,σ*₂),(*C,k,σ*₃),(*D,l,σ*₄)}, are defined in terms of the bare CT coefficients, ${V}_{ijkl}^{ABCD}$*,* as ${V}_{\left(A, i, {σ}_{1}\right) , \left(B, j, {σ}_{2}\right) , \left(C, k, {σ}_{3}\right) , \left(D, l, {σ}_{4}\right)} = \left\{\begin{matrix}{V}_{ijkl}^{s , ABCD} & if {σ}_{1} = {σ}_{2} = {σ}_{3} = {σ}_{4} \\ \frac{1}{2} {V}_{ijkl}^{ABCD} & if {σ}_{1} = {σ}_{3} and {σ}_{2} = {σ}_{4} \left({σ}_{1}\neq {σ}_{2}\right) \\ - \frac{1}{2} {V}_{jikl}^{BACD} & if {σ}_{1} = {σ}_{4} and {σ}_{2} = {σ}_{3} \left({σ}_{1}\neq {σ}_{2}\right) \\ 0 & otherwise\end{matrix}\right. ,$ (145) **with** ${V}_{ijkl}^{s , ABCD} = \left({V}_{ijkl}^{ABCD}-{V}_{jikl}^{BACD}\right) / 2$*.* In turn, the CT coefficients can be obtained as ${V}_{ijkl}^{ABCD} = \frac{1}{2} \int dr \int dr ′ {W}_{i} \left(r-{R}_{A}\right) {W}_{j} \left(r′-{R}_{B}\right) V \left(\left|r-r′\right|\right) {W}_{k} \left(r′-{R}_{C}\right) {W}_{l} \left(r-{R}_{D}\right) ,$ (146) with *Ṽ*(|**r** - **r'**|) the (screened) Coulomb potential. Note that, by exploiting the translational invariance of the lattice, we can set *A* = *O* and get the core CT coefficients ${C}_{ijkl}^{OBCD} ≡ {V}_{ijkl}^{OBCD} = \frac{1}{2} \int d r \int d r ′ {W}_{i} \left(r\right) {W}_{j} \left(r′-{R}_{B}\right) V \left(\left|r-r′\right|\right) {W}_{k} \left(r′-{R}_{C}\right) {W}_{l} \left(r-{R}_{D}\right) .$ (147)

These coefficients can be computed via Monte Carlo (MC) integration and the full CT can then be retrieved from the core coefficients thanks to the lattice translational invariance (see below). Classical integration techniques (such as Monte Carlo) are well-studied and are efficiently and consistently implementable with good accuracy.

### Cauchy-Schwarz inequality

To reduce the number of CT coefficients to be computed, we will exploit a Cauchy-Schwarz (CS) inequality between the coefficients themselves. This is obtained by re-writing Eq. (146) as an inner product, ${V}_{ijkl}^{ABCD} = \left〈{ρ}_{il}^{AD}, {ρ}_{kj}^{CB}\right〉 ≡ \frac{1}{2} \int d r \int d r ′ V \left(\left|r-r′\right|\right) {ρ}_{il}^{AD} \left(r\right) {ρ}_{kj}^{CB} \left(r′\right) ,$ (148) with ${ρ}_{ij}^{AB} \left(r\right) ≡ {W}_{i} \left(r-{R}_{A}\right) {W}_{j} \left(r-{R}_{B}\right)$. Since *V*(|**r** - **r'**|) is always a positive definite kernel, it can be shown that the inner product we have just introduced is well-defined and that the following CS inequality holds ${\left|{V}_{ijkl}^{ABCD}\right|}^{2} \leq {V}_{iill}^{AADD} {V}_{kkjj}^{CCBB} .$ (149)

In what follows, we will exploit this inequality to determine which coefficients of the CT need to be computed via MC integration.

### Symmetry properties of the Coulomb tensor.

For the sake of simplicity we now introduce the composite indices *λᵢ* grouping together the site and orbital indices (i.e., *λ*₁ = (*A, i*), etc.). From Eq. (146), by exploiting the hermiticty of the CT, *V*_{*λ*₁*λ*₂*λ*₃*λ*₄} = *V*_{*λ*₄}*_{λ3}λ₂λ*₁, the swap symmetry *V*_{*λ*₁*λ*₂*λ*₃*λ*₄} = *V*_{*λ*₂*λ*₁*λ*₄*λ*₃}*,* and the reality of the Wannier functions, one can derive the following identities (see also Section 3.6.1) ${V}_{{λ}_{1} {λ}_{2} {λ}_{3} {λ}_{4}} = {V}_{{λ}_{4} {λ}_{3} {λ}_{2} {λ}_{1}} = {V}_{{λ}_{2} {λ}_{1} {λ}_{4} {λ}_{3}} = {V}_{{λ}_{4} {λ}_{2} {λ}_{3} {λ}_{1}} = {V}_{{λ}_{1} {λ}_{3} {λ}_{2} {λ}_{4}} = {V}_{{λ}_{3} {λ}_{4} {λ}_{1} {λ}_{2}} = {V}_{{λ}_{3} {λ}_{1} {λ}_{4} {λ}_{2}} = {V}_{{λ}_{2} {λ}_{4} {λ}_{1} {λ}_{3}} ,$ (150) which can be exploited to further reduce the number of CT coefficients we have to compute.

Recognising and using the various symmetries allows for a reduction of the number of CT coefficients to be computed without undue loss of detail.

### Majorana Hamiltonian

To obtain the system Hamiltonian in the Majorana basis, we first map the composite site-orbital-spin indices of Eq. (141), (*A, i ,σ*₁), (*B, j, σ*₂), (*C, k, σ*₃), (*D, l, σ*₄), to the single indices *α, β, γ, δ* ∈ {1,...,2*MN*} and re-write Eq. (141) as ${H}_{0} = {\sum }_{α , β} {t}_{αβ} {w}_{α}^{†} {w}_{β} ,$ (151a) ${H}_{int} = {\sum }_{α , β , γ , δ} {V}_{αβγδ} {w}_{α}^{†} {w}_{β}^{†} {w}_{γ} {w}_{δ} .$ (151b)

We then introduce the Majorana basis operators as ${w}_{α} = \frac{1}{2} \left({γ}_{α}+i{\overline{γ}}_{α}\right)$ and ${w}_{α}^{†} = \frac{1}{2} \left({γ}_{α}-i{\overline{γ}}_{α}\right)$. After some algebra, the full Hamiltonian reads ${H}_{M} = {\sum }_{k ∈ {\left\{0, 1\right\}}^{4 MN}} {α}_{k} {\prod }_{j} {γ}_{j}^{{k}_{2 j}} {\overline{γ}}_{j}^{{k}_{2 j + 1}} , \left|k\right| ∈ \left\{2, 4\right\}$ (152)

### Motif Hamiltonian pipeline

As noted above, the method may include the use of a motif Hamiltonian to simplify the analysis by leveraging the symmetries inherent in the translation invariance of periodic systems. The procedure for using this innovation is set out in the following.

In what follows we will describe the stages of the pipeline to obtain the full Hamiltonian of Eq. (140) for a minimal system, which we refer to as motif of order n, consisting of a central unit cell (as defined by WANNIER90) interacting with the nearest neighbouring unit cells of order n. Note that, thanks to translational invariance of the lattice, we need to include in the motif Hamiltonian only those hopping and interaction terms involving the central unit cell at least once. This implies that onsite interactions, and inter- and intra-cell hoppings involving exclusively nearest neighbouring cells are excluded. The

Hamiltonian of a lattice can then be obtained from the motif one by exploiting translation invariance. The motif Hamiltonian is hence given by ${H}^{m} = {H}_{0}^{m} + {H}_{int}^{m}$, with ${H}_{0}^{m} = {\sum }_{{σ}_{1} , {σ}_{2}} {\sum }_{B} {\sum }_{i , j} \left[{t}_{\left(O, i, {σ}_{1}\right) , \left(B, j, {σ}_{2}\right)}^{m}{w}_{O , i , {σ}_{1}}^{†}{w}_{B , j , {σ}_{2}}+{t}_{\left(B, j, {σ}_{2}\right) , \left(O, i, {σ}_{1}\right)}^{m}{w}_{B , j , {σ}_{2}}^{†}{w}_{O , i , {σ}_{1}}\right] ,$ (153a) ${H}_{int}^{m} = {\sum }_{{σ}_{1} , {σ}_{2} , {σ}_{3} , {σ}_{4}} {\sum }_{B , C , D} {\sum }_{i , j , k , l} \left[\begin{matrix}{V}_{\left(O, i, {σ}_{1}\right) , \left(B, j, {σ}_{2}\right) , \left(C, k, {σ}_{3}\right) , \left(D, l, {σ}_{4}\right)}^{m} {w}_{O , i , {σ}_{1}}^{†} {w}_{B , j , {σ}_{2}}^{†} {w}_{C , k , {σ}_{3}} {w}_{D , l , {σ}_{4}} \\ + {V}_{\left(B, j, {σ}_{2}\right) , \left(O, i, {σ}_{1}\right) , \left(C, k, {σ}_{3}\right) , \left(D, l, {σ}_{4}\right)}^{m} {w}_{B , j , {σ}_{2}}^{†} {w}_{O , i , {σ}_{1}}^{†} {w}_{C , k , {σ}_{3}} {w}_{D , l , {σ}_{4}} \\ + {V}_{\left(B, j, {σ}_{2}\right) , \left(C, k, {σ}_{3}\right) , \left(O, i, {σ}_{1}\right) , \left(D, l, {σ}_{4}\right)}^{m} {w}_{B , j , {σ}_{2}}^{†} {w}_{C , k , {σ}_{3}}^{†} {w}_{O , i , {σ}_{1}} {w}_{D , l , {σ}_{4}} \\ + {V}_{\left(B, j, {σ}_{2}\right) , \left(C, k, {σ}_{3}\right) , \left(D, l, {σ}_{4}\right) , \left(O, i, {σ}_{1}\right)}^{m} {w}_{B , j , {σ}_{2}}^{†} {w}_{C , k , {σ}_{3}}^{†} {w}_{D , l , {σ}_{4}} {w}_{O , i , {σ}_{1}}\end{matrix}\right] ,$ (153b) with $B , C , D ∈ {N}_{O}^{n}$. Here, ${t}_{\left(A, i, {σ}_{1}\right) , \left(B, j, {σ}_{2}\right)}^{m}$ and ${V}_{\left(A, i, {σ}_{1}\right) , \left(B, j, {σ}_{2}\right) , \left(C, k, {σ}_{3}\right) , \left(D, l, {σ}_{4}\right)}^{m}$ are defined as in Eq. (142) and Eq. (145), respectively, with $A , B , C , D ∈ {N}_{\left\{O, A, B, C, D\right\}}^{n}$.

In what follows, we will always operate within the real Wannier functions, NMM, and n -order NN approximations described in the "Full Hamiltonian of an electronic system on a lattice" section above.

### Hopping matrix coefficients

### Stage H1: core HM coefficients.

In the first stage, the core HM coefficients ${T}_{ij}^{OB}$ with *B* ∈ 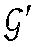 introduced in Eq. (144) are read from the output of DFT/Wannier90 calculations. Here, 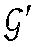 is determined by DFT/Wannier90 data.

### Stage H2: filtered core HM coefficients.

In the second stage, to reduce the complexity of the problem, we assume that the relevant properties of the system are determined by the largest HM coefficients only. Hence, in the second state of the pipeline we filter the coefficients of the HM according to a threshold *t*₀. The core HM coefficients ${T}_{ij}^{OB}$ are first restricted to NNs of order *n*₀, i.e., for lattice sites $B ∈ {N}_{\left\{O\right\}}^{{n}_{0}}$. To determine *n*₀, we compare the exact bands *εᵢ*(**k**) with the ones obtained from the filtered order *n*₀ NN HM, ${{ε}^{˜}}_{i}^{\left({n}_{0}\right)} \left(k\right)$. The latter are given by the eigenvalues of the matrices $h {\left(k\right)}_{ij} {\sum }_{B ∈ {N}_{0}^{{n}_{0}}} {e}^{i k ⋅ R} {{T}^{˜}}_{ij}^{OB}$ with filtered HM coefficients ${{T}^{˜}}_{ij}^{OB} = \left\{\begin{matrix}{T}_{ij}^{OB} & if \left|{T}_{ij}^{OB}\right| \geq {t}_{0} \\ 0 & otherwise\end{matrix}\right.$ (154) and threshold ${t}_{0} = max \left|{T}_{mn}^{OB}\right|$, ∀*m*,*n* and $∀ B ∉ {N}_{\left\{O\right\}}^{{n}_{0}}$ (i.e., *t*₀ is given by the largest absolute value of the HM coefficients which are higher order neighbors with respect to *O*). In what follows, an overlying tilde will always be used to denote filtered quantities. To make the comparison quantitative we introduce the following measure of distance between bands $d \left(n\right) = {max}_{i , k} \left|{ε}_{i}\left(k\right)-{{ε}^{˜}}_{i}^{\left(n\right)}\left(k\right)\right|$ and we determine *n*₀ as the minimum integer such that *d*(*n*₀) < *η_{ε}* with *η_{ε}* a pre-determined threshold (for instance, in the main text we set *η_{ε}* = 0.5 eV) for values of **k** sampled from a regular grid in the Brillouin zone.

### Stage H3: motif HM coefficients.

In the third stage, the filtered motif HM coefficients ${{T}^{˜}}_{ij}^{OB}$ and ${{T}^{˜}}_{ij}^{BO}$ with $B ∈ {N}_{\left\{O\right\}}^{{n}_{0}}$ [as defined in Eq. (153a)] are obtained via ${{T}^{˜}}_{ij}^{BO} = {{T}^{˜}}_{ji}^{OB} .$ (155)

### Stage H4: spinful motif HM coefficients.

In the fourth stage, the spinful motif HM coefficients *t̃*_{(*A,i,σ*₁),(*B,j,σ*₂)} with $A , B ∈ {N}_{\left\{O\right\}}^{n}$ are obtained via Eq. (142), ${{t}^{˜}}_{\left(A, i, {σ}_{1}\right) , \left(B, j, {σ}_{2}\right)} = \left\{\begin{matrix}{{T}^{˜}}_{ij}^{AB} & if {σ}_{1} = {σ}_{2} \\ 0 & otherwise\end{matrix}\right. .$ (156)

### (optional) Stage H4b: spinful lattice HM coefficients.

In this optional stage, all the filtered spinful HM coefficients over the lattice 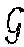 are obtained from Eq. (156) by exploiting the translational invariance: ${{t}^{˜}}_{\left(A′,i,{σ}_{1}\right) , \left(B′,j,{σ}_{2}\right)} = {{t}^{˜}}_{\left(O, i, {σ}_{1}\right) , \left(B, j, {σ}_{2}\right)} with P ′ = P + R , ∀ R ∈ B .$ (157)

### Stage H5: single-index HM coefficients.

In the fifth and final stage, the composite indices *(A, i, σ*₁) and (*B, j, σ*₂) are mapped to the single indices *α, β* ∈ {1, ... ,2*MN*}, respectively. The filtered spinful HM coefficients can thus be written as filtered single-index HM coefficients, *t̃_{αβ}*.

### Coulomb tensor coefficients

The scope of this part of the pipeline is to compute via MC integration the Coulomb integrals defined in Eq. (146) for a motif of order *n*ᵢₙₜ. Since these are 6 -dimensional their evaluation is costly and it is therefore essential to evaluate the smallest possible number of integrals. To do so, we will take advantage of the Cauchy-Schwarz inequality introduced in Eq. (149) and of the symmetry properties of the CT of Eq. (150).

### Stage CT1: fundamental CT coefficients.

In the first stage of the pipeline, we compute via MC integration the fundamental terms required to apply the CS inequality of Eq. (149), denoted by ${F}_{iill}^{OODD}$*.* These are defined as ${F}_{iill}^{OODD} = \left\{\begin{matrix}{V}_{iill}^{OOOO} & ∀ i , l \geq i \\ {V}_{iill}^{OODD} & ∀ i , l and ∀ C ∈ {N}_{\left\{O\right\}}^{n} \ \left\{O\right\}\end{matrix}.\right.$ (158)

To reduce the number of Coulomb integrals to be computed we assume that only the CT coefficients with the largest absolute value determine the properties of the system. Thanks to the localization properties of the MLWFs, this is a reasonable assumption for all the materials we considered in the main draft. Importantly, due to Eq. (149), the CT coefficient with the largest absolute value will be one of the coefficients introduced in Eq. (158). Hence, we can fix a threshold as ${t}_{int} = {τ}_{int} \times max \left(\left|{F}_{iill}^{OODD}\right|\right)$ with, e.g., *τ*ᵢₙₜ ~ 10⁻², and defined the filtered fundamental CT coefficients as ${{F}^{˜}}_{i}^{OODD} = \left\{\begin{matrix}{F}_{iill}^{OODD} & if \left|{F}_{ill}^{OODD}\right| \geq {t}_{int} \\ 0 & otherwise\end{matrix}.\right.$ (159)

### Stage CT2: filtered unique CT coefficients.

In the second stage, we exploit Eq. (149) to compute via MC integration only those unique CT coefficients, defined as ${U}_{ijkl}^{OBCD} = {V}_{ijkl}^{OBCD}$, ∀(*O, B, C, D*) ∈ 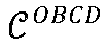 and *V*(*i, j, k, l*) ∈ 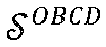 *,* such that ${{F}^{˜}}_{iill}^{OODD} {{F}^{˜}}_{kkjj}^{OO \left(B-C\right) \left(B-C\right)} \geq {t}_{int}$. Here, 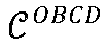 and 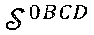 denote the minimal set of lattice sites and the unique (i.e., non-equivalent according to the symmetry properties of the CT outlined in Eq. (150)) orbital configurations required in the evaluation of terms with site structure (*O, B, C, D*), respectively. In particular, the latter is defined as the quotient set of all the possible orbital configurations M induced by the equivalence relation *ε^{OBCD} ,* i.e., 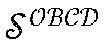 = 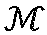 / 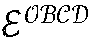 = {[(*i, j, k, l*)]*^{OBCD}*|(*i, j, k, l*) ∈ *M*}, with [(*i, j, k, l*)]*^{OBCD}* the equivalence class of (*i, j, k, l*) with respect to *ε^{OBCD}.* Here, 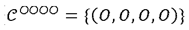 and ${\left[\left(i, j, k, l\right)\right]}^{oooo} = \left\{\left(i, j, k, l\right), \left(l, k, j, i\right), \left(j, i, l, k\right), \left(l, j, k, i\right), \left(i, k, j, l\right), \left(k, l, i, j\right), \left(k, i, l, j\right), \left(j, l, i, k\right)\right\} .$ 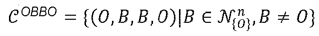 and ${\left[\left(i, j, k, l\right)\right]}^{OBBO} = \left\{\left(i, j, k, l\right), \left(l, j, k, i\right), \left(i, k, j, l\right), \left(l, k, j, i\right)\right\} .$ 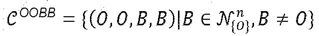 and ${\left[\left(i, j, k, l\right)\right]}^{OOBB} = \left\{\left(i, j, k, l\right), \left(j, i, l, k\right)\right\} .$ 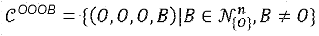 and ${\left[\left(i, j, k, l\right)\right]}^{OOOB} = \left\{\left(i, j, k, l\right), \left(i, k, j, l\right)\right\} .$ 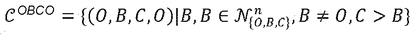 and ${\left[\left(i, j, k, l\right)\right]}^{OBCO} = \left\{\left(i, j, k, l\right), \left(l, j, k, i\right)\right\} .$

Note that coefficients with *C < B* can be retrieved via ${V}_{ijkl}^{OBCO} = {V}_{ikjl}^{OCBO}$*.* 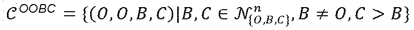 and

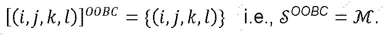

Note that coefficients with C *< B* can be retrieved via ${V}_{ijkl}^{OOBC} = {V}_{jilk}^{OOCB}$*.* 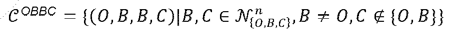 and ${\left[\left(i, j, k, l\right)\right]}^{OBBC} = \left\{\left(i, j, k, l\right), \left(i, k, j, l\right)\right\} .$ 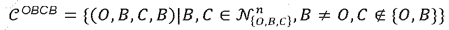 and 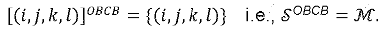 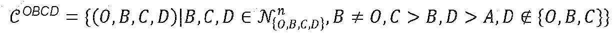 and

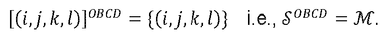

Note that coefficients with *C < B* can be retrieved via ${V}_{ijkl}^{OBCD} = {V}_{ikjl}^{OCBD}$.

It can be shown that the choices above allow us to minimize the number of CT coefficients to be computed. Finally, the filtered unique coefficients are introduced as ${{U}^{˜}}_{i}^{OBCD} = \left\{\begin{matrix}{U}_{iill}^{OBCD} & if \left|{U}_{ill}^{OBCD}\right| \geq {t}_{int} \\ 0 & otherwise\end{matrix}.\right.$ (160)

### Stage CT3: filtered motif CT coefficients.

In the third stage, the filtered motif CT coefficients associated with the coefficients in Eq. (153), ${V}_{ijkl}^{m , ABCD}$*,* $∀ A , B , C , D ∈ {N}_{\left\{O, A, B, C, D\right\}}^{n}$ and ∀(*i, j, k, l*) ∈ 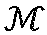 , are obtained from the filtered unique ones. First, by exploiting the equivalence classes introduced in the previous stage, we can obtain the coefficients ${{V}^{˜}}_{ijkl}^{m , OBCD}$*,* ∀(*O, B, C, D*) ∈ 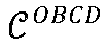 and ∀(*i, j, k, l*) ∈ 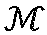 . The latter can then be extended to any $A , B , C , D ∈ {N}_{\left\{O, A, B, C, D\right\}}^{n}$ (and at least one among *A, B, C, D* equals to *O*) via the following identities ${V}_{ijkl}^{OBBO} = {V}_{jilk}^{BOOB} ,$ ${V}_{ijkl}^{OOBB} = {V}_{ikjl}^{OBOB} = {V}_{ljki}^{BOBO} = {V}_{lkji}^{BBOO} ,$ ${V}_{ijkl}^{OOOB} = {V}_{jilk}^{OOBO} = {V}_{jlik}^{OBOO} = {V}_{ljki}^{BOOO} ,$ ${V}_{ijkl}^{OBCO} = {V}_{jilk}^{BOOC} ,$ ${V}_{ijkl}^{OOBC} = {V}_{ikjl}^{OBOC} = {V}_{lkji}^{CBOO} = {V}_{ljkl}^{COBO} ,$ ${V}_{ijkl}^{OBBC} = {V}_{ljki}^{CBBO} = {V}_{jilk}^{BOCB} = {V}_{jlik}^{BCOB} ,$ ${V}_{ijkl}^{OBCB} = {V}_{ljki}^{BBCO} = {V}_{ikjl}^{OCBB} = {V}_{lkji}^{BCBO} = {V}_{jilk}^{BOBC} = {V}_{jlik}^{BBOC} = {V}_{kilj}^{COBB} = {V}_{klij}^{CBOB} ,$ ${V}_{ijkl}^{OBCD} = {V}_{jlik}^{BDOC} = {V}_{jilk}^{BODC} = {V}_{ljki}^{DBCO} .$

### Stage CT4: spinful motif CT coefficients.

The filtered spinful motif CT coefficients of Eq. (153b), ${{V}^{˜}}_{\left(A, i, {σ}_{1}\right) , \left(B, j, {σ}_{2}\right) , \left(C, k, {σ}_{3}\right) , \left(D, l, {σ}_{4}\right)}^{m}$ with $A , B , C , D ∈ {N}_{\left\{O, A, B, C, D\right\}}^{n}$ and (*i, j, k, l*) *∈* 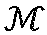 , can be obtained via Eq. (145) as ${{V}^{˜}}_{\left(A, i, {σ}_{1}\right) , \left(B, j, {σ}_{2}\right) , \left(C, k, {σ}_{3}\right) , \left(D, l, {σ}_{4}\right)}^{m} = \left\{\begin{matrix}{{V}^{˜}}_{ijkl}^{m , s , ABCD} & if {σ}_{1} = {σ}_{2} = {σ}_{3} = {σ}_{4} \\ \frac{1}{2} {{V}^{˜}}_{ijkl}^{m , ABCD} & if {σ}_{1} = {σ}_{3} and {σ}_{2} = {σ}_{4} \left({σ}_{1}\neq {σ}_{2}\right) \\ - \frac{1}{2} {{V}^{˜}}_{jikl}^{m , BACD} & if {σ}_{1} = {σ}_{4} and {σ}_{2} = {σ}_{3} \left({σ}_{1}\neq {σ}_{2}\right) \\ 0 & otherwise\end{matrix}\right. ,$ (161) with ${{V}^{˜}}_{ijkl}^{m , s , ABCD} = \left({{V}^{˜}}_{ijkl}^{m , ABCD}-{{V}^{˜}}_{jikl}^{m , BACD}\right) / 2 .$

### (optional) Stage CT4b: spinful lattice CT coefficients.

In this optional stage, all the filtered spinful coefficients over the lattice 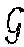 are obtained from motif coefficients by exploiting the translational invariance of the lattice: ${{V}^{˜}}_{\left(A′,i,{σ}_{1}\right) , \left(B′,j,{σ}_{2}\right) , \left(C′,k,{σ}_{3}\right) , \left(D′,l,{σ}_{4}\right)} = {{V}^{˜}}_{\left(A, i, {σ}_{1}\right) , \left(B, j, {σ}_{2}\right) , \left(C, k, {σ}_{3}\right) , \left(D, l, {σ}_{4}\right)}^{m} ,$ with *P' = P* + R, $∀ P ∈ {N}_{\left\{O, A, B, C, D\right\}}^{n}$ and ∀**R** ∈ 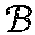 .

### Stage CT5: consistently filtered CT coefficients.

The NN approximation of order *n*ᵢₙₜ we performed in the previous stages is not guaranteed to be consistent, i.e., there may be CT coefficients corresponding to a higher order NN approximation whose absolute value is actually larger than the threshold *t*ᵢₙₜ. To avoid such a situation and obtain a consistent approximation of the CT, we can
repeat the procedure above for *n*ᵢₙₜ + 1 using the same value of *t*ᵢₙₜ;
set a new threshold *t'*ᵢₙₜ as the largest of the absolute values of the coefficients of the CT obtained within the *n*ᵢₙₜ + 1 NN order approximation which are not contained in the CT of order *n*ᵢₙₜ.
filter the CT of order *n*ᵢₙₜ with the new threshold *t'*ᵢₙₜ.

In principle, to be certain that the approximation of the CT is consistent, one should repeat the procedure above for all NN orders > *n*ᵢₙₜ. However, taking into account the localization of the MLWFs and due the growing computational cost, in this work we limited our analysis to the case with *n*ᵢₙₜ + 1 only.

The composite indices (*A, i, σ*₁), (*B, j, σ*₂), (*C, k, σ*₃), (*D, l, σ*₄) are mapped to the single indices α, β, γ, δ ∈ {1, ... ,2*MN*}, respectively. The filtered spinful CT coefficients can thus be written as filtered single-index CT coefficients, ${{V}^{˜}}_{αβγδ}^{m}$.

### Single-index HM and CT coefficients

Finally, to obtain the single-index Hamiltonian introduced in Eq. (151), we map the composite site-mode-spin triplet index (*Aᵢ*, *i*, *σᵢ*) to a single index α*ᵢ* ∈ {1, ... ,2*MÑ*}. Here, ${N}^{˜} = max \left({N}_{O}^{{n}_{0}}, {N}_{O}^{{n}_{int}}\right)$*.* In terms of the single indices, the filtered spinful motif HM and CT coefficients can be written as *t̃_{αβ}* and ${{V}^{˜}}_{αβγδ}^{m}$*,* respectively. Usually, we have ${N}_{O}^{{n}_{0}} > {N}_{O}^{{n}_{int}}$ and, therefore, all the CT coefficients with single indices corresponding to sites of ${N}_{O}^{{n}_{0}}$ not included in ${N}_{O}^{{n}_{int}}$ are set to zero.

### 3.6.3 Time-reversal symmetry

Under time-reversal symmetry 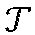 momentum and spin variables transform according to **k** → -**k** and **s** → -s , with **s** = **σ**/2 and **σ** = (*σₓ, σ_{y}, σ_{z}*). Time-reversal symmetry is represented by an anti-unitary operator. One common choice is 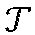 *= e^{-iπσ_{y}}K,* with *K* denoting the complex conjugation operator and the unitary operator *e^{-iπσ_{y}}* performing a *π* - rotation of the spin around the *y* -axis. If the crystal possesses time-reversal symmetry, the external potential *Ũ*(**r**) is spin-independent and the electronic bands are doubly degenerate. This is always the case for a non-relativistic system (e.g., with no spin-orbit coupling) and in the absence of an external magnetic field. Since both these assumptions have been made in Section 3, the general Hamiltonians in Eq. (1) and Eq. (4) already take into account the consequences of time-reversal invariance. Hence, in this section we will also examine which are the consequences of time-reversal symmetry in the case with a spin-dependent external potential *Ũ*_{*σ*₁*σ*₂}(**r**), which represent a generalization of what we considered in Section 3. In this case, the quadratic part of Eq. (4) should be modified as follows, ${H}_{0} = {\sum }_{{σ}_{1} , {σ}_{2}} {\sum }_{{λ}_{1} , {λ}_{2}} {t}_{{λ}_{1} , {λ}_{2}}^{{σ}_{1} , {σ}_{2}} {c}_{{λ}_{1} , {σ}_{1}}^{†} {c}_{{λ}_{2} , {σ}_{2}} ,$ (68) with ${t}_{{λ}_{1} , {λ}_{2}}^{{σ}_{1} , {σ}_{2}} = \int d r {ϕ}_{{λ}_{1} , {σ}_{1}}^{∗} \left(r\right) \left[-\frac{{ℏ}^{2} {∇}^{2}}{2 m}+{{U}^{˜}}_{{σ}_{1} {σ}_{2}}\left(r\right)\right] {ϕ}_{{λ}_{2} , {σ}_{2}} \left(r\right) .$ (69)

Bloch basis: under time-reversal a Bloch wavefunction *ϕ*_{**k***,n,σ*}(**r**) transforms as ${ϕ}_{k , n , ↑} \left(r\right) \to {ϕ}_{- k , n , ↓} \left(r\right) = {ϕ}_{k , n , ↓} \left(-r\right) and {ϕ}_{k , n , ↓} \left(r\right) \to - {ϕ}_{- k , n , ↑} \left(r\right) = - {ϕ}_{k , n , ↑} \left(-r\right) .$ (70)

If the external potential *Ũ*(**r**) is spin-independent, the hopping matrix coefficients ${h}_{mn}^{σ , σ ′} \left(k,k′\right) = {ϵ}_{m} \left(k\right) {δ}_{k , k ′} {δ}_{m , n} {δ}_{σ , σ ′}$ satisfy the identity ${ϵ}_{m} \left(k\right) = {ϵ}_{m} \left(-k\right) ,$ (71) while for the Coulomb tensor coefficients one finds ${V}_{{n}_{1} {n}_{2} {n}_{3} {n}_{4}}^{\left(k,k′,q\right)} = {V}_{{n}_{1} {n}_{2} {n}_{3} {n}_{4}}^{\left(-k,-k′,-q\right)} .$ (72)

Note that the above equations are the same as the one we obtained for a system with inversion symmetry.

On the other hand, in the presence of a spin-dependent but time-reversal invariant external potential *Ũ*_{↑}(**r**) = *Ũ*_{↓}(**r**), one finds ${h}_{m , n}^{σ , σ ′} \left(k,k′\right) = {ϵ}_{m}^{σ , σ ′} \left(k\right) {δ}_{k , k ′} {δ}_{m , n}$*,* with ${ϵ}_{m}^{σ , σ ′} \left(k\right) ∈ ℝ$ and ${ϵ}_{m}^{↑ , ↑} \left(k\right) = {ϵ}_{m}^{↓ , ↓} \left(-k\right) and {ϵ}_{m}^{↑ , ↓} \left(k\right) = - {ϵ}_{m}^{↓ , ↑} \left(-k\right) = - {ϵ}_{m}^{↑ , ↓} \left(-k\right) .$ (73)

If, in addition, the crystal also possesses inversion symmetry, the above equation becomes ${ϵ}_{m}^{↑ , ↑} \left(k\right) = {ϵ}_{m}^{↓ , ↓} \left(k\right) and {ϵ}_{m}^{↑ , ↓} \left(k\right) = - {ϵ}_{m}^{↑ , ↓} \left(k\right) = 0 .$ (74)

Wannier basis: under time-reversal a Wannier function ${W}_{n , σ}^{R} \left(r\right)$ transforms as ${W}_{n , ↑}^{R} \left(r\right) \to {W}_{n , ↓}^{R} \left(r\right) and {W}_{n , ↓}^{R} \left(r\right) \to - {W}_{n , ↑}^{R} \left(r\right) .$ (75)

If the external potential *Ũ*(**r**) is spin-independent, time-reversal invariance does not lead to any further relation for the hopping matrix and Coulomb tensor coefficients.

On the other hand, in the presence of a spin-dependent and time-reversal invariant external potential *Ũ*_{↑}(**r**) = *Ũ*_{↓}(**r**), one obtains $T {\left(R\right)}_{mn}^{↑ , ↑} = T {\left(R\right)}_{mn}^{↓ , ↓} T {\left(R\right)}_{mn}^{↑ , ↓} = T {\left(R\right)}_{mn}^{↓ , ↑} .$ (76) where we have used the reality of the matrices *T*(*R*), that follows from the reality of the Wannier functions. For more general single particle functions, further relations between the complex conjugated elements of the tensors can be equally found. Finally, from the last identity and hermiticity of the Hamiltonian it follows that $T {\left(0\right)}_{mm}^{↑ , ↓} = 0$.

### 3.7 Crystal symmetries

A Hamiltonian *H* invariant under a symmetry group G (eg. crystal symmetries, inversion, discrete rotations, etc), satisfies particular selection rules that determine the type of operators allowed in the Hamiltonian. In this section we discuss the general strategy to determine those rules for a general discrete group. Leveraging those constraints allows to reduce the number of classical computations (computations of overlap integrals) and, more importantly, reduces the number of gates needed to implement the Hamiltonian by constraining the allowed operators in *H.*

Let's consider the electron-electron interaction term in Eq. (4). The single particle wavefunctions used to span the Hilbert space form a basis that can be chosen to transform under a definite representation of the symmetry of the Hamiltonian. In this case, a symmetry operation *g* ∈ *G*, with representation ${D}_{{λ}_{i} {λ}_{i} ′}^{\left(μ\right)} \left(g\right)$ (which can always be chosen to be some irreducible representation *µ*), satisfies ${\sum }_{{λ}_{1}^{′} {λ}_{2}^{′} {λ}_{3}^{′} {λ}_{4}^{′}} {D}_{{λ}_{1} {λ}_{1}^{′}}^{† \left({μ}_{1}\right)} \left(g\right) {D}_{{λ}_{2} {λ}_{2}^{′}}^{† \left({μ}_{2}\right)} \left(g\right) {D}_{{λ}_{3} {λ}_{3}^{′}}^{\left({μ}_{3}\right)} \left(g\right) {D}_{{λ}_{4} {λ}_{4}^{′}}^{\left({μ}_{4}\right)} \left(g\right) {V}_{{λ}_{1}^{′} {λ}_{2}^{′} {λ}_{3}^{′} {λ}_{4}^{′}} = {V}_{{λ}_{1} {λ}_{2} {λ}_{3} {λ}_{4}} .$ (77)

For simplicity we assume that the symmetries discussed here are unitary. The equation above means in particular that the tensor product of different representations involved in a particular element of the interaction tensor should contain the trivial representation, that does not transform under the symmetry. In general, the tensor product of representations can be decomposed into the direct sum of irreducible representations (irreps) as ${D}^{\left({μ}_{1}\times {μ}_{2}\right)} \left(g\right) = {⊕}_{ν} {c}_{ν} \left({μ}_{1}, {μ}_{2}\right) {D}^{\left(ν\right)} \left(g\right) ,$ (78) where *cᵥ*(*µ*₁, *µ*₂) is the number of times that the irrep v appears in the tensor product of irreps *µ*₁ and *µ*₂. Using this equation repeatedly and taking the trace (i.e., *χ*^{(*µ*)}(*g*) = Tr (*D*^{(*µ*)}(*g*))) we find the relation between the characters *χ*^{***(*µ*₁×*µ*₂)}(*g*)*χ*^{(*µ*₃×*µ*₄)}(*g*) *=* Σ*_{vv'ρ} cᵥ* (*µ*₁, *µ*₂)*c_{v'}*(*µ*_{3,} *µ*₄)*χ*^{***(*v*)}(*g*)*χ*^{(*v'*)}(*g*). In this product the number of times that the trivial representation e appears can be computed using the orthogonality relation of the characters ${c}_{e} \left(ν,ν′\right) = \frac{1}{\left|G\right|} {\sum }_{g} {χ}^{∗ \left(ν\right)} \left(g\right) {χ}^{\left(ν′\right)} \left(g\right) = {δ}_{νν ′}$*,* where |*G*| is the dimension of *G* . This means that the nonzero components of the Coulomb tensor can be decomposed as *D*^{†(*µ*₁×*µ*₂})(*g*)*D*^{(*µ*₃×*µ*₄)}(*g*) = ⊕*ᵥcᵥ*(*µ*₁*, µ*₂)*cᵥ*(*µ*_{3,} *µ*₄)*D*^{(*e*)}(*g*).

Starting from the definition of the Coulomb tensor ${V}_{{λ}_{1} {λ}_{2} {λ}_{3} {λ}_{4}}^{{μ}_{1} {μ}_{2} {μ}_{3} {μ}_{4}} = \int drdr ′ {ϕ}_{{λ}_{1}}^{∗ \left({μ}_{1}\right)} \left(r\right) {ϕ}_{{λ}_{2}}^{∗ \left({μ}_{2}\right)} \left(r′\right) V \left(\left|r-r′\right|\right) {ϕ}_{{λ}_{3}}^{\left({μ}_{3}\right)} \left(r′\right) {ϕ}_{{λ}_{4}}^{\left({μ}_{4}\right)} \left(r\right) ,$ (79) where with a slight abuse of notation we use the label and the representation under which the single particle wavefunction ${ϕ}_{{λ}_{i}}^{\left({μ}_{i}\right)} \left(r\right)$ transforms as indices for the tensor, we can decompose it into irreps to find ${V}_{{λ}_{1} {λ}_{2} {λ}_{3} {λ}_{4}}^{{μ}_{1} {μ}_{2} {μ}_{3} {μ}_{4}} = {C}_{{λ}_{1} {λ}_{2} , s}^{∗ {μ}_{1} {μ}_{2} , ν} {C}_{{λ}_{3} {λ}_{4} , s ′}^{{μ}_{3} {μ}_{4} , ν} \int drdr ′ {Ψ}_{s}^{∗ \left(ν\right)} \left(r,r′\right) V \left(\left|r-r′\right|\right) {Ψ}_{s ′}^{\left(ν\right)} \left(r′,r\right) .$ (80)

The three-leg tensor ${C}_{{λ}_{1} {λ}_{2} , s}^{{μ}_{1} {μ}_{2} , ν}$ (a Clebsch-Gordan coefficient of the group *G*) transforms the tensor product of basis in the *µ*₁ and *µ*₂ irreps into a new basis transforming in the v irrep. They can be computed via the relation $\frac{1}{\left|G\right|} {\sum }_{g} {D}_{{λ}_{1} {λ}_{2}}^{\left({μ}_{1}\right)} \left(g\right) {D}_{{λ}_{3} {λ}_{4}}^{\left({μ}_{2}\right)} \left(g\right) {D}_{ss ′}^{\left(ν\right)} \left(g\right) = \left(\frac{1}{\sqrt{{n}_{ν}}}{C}_{{λ}_{1} {λ}_{3} , s}^{{μ}_{1} {μ}_{2} , ν}\right) {\left(\frac{1}{\sqrt{{n}_{ν}}}{C}_{{λ}_{2} {λ}_{4} , s ′}^{{μ}_{1} {μ}_{2} , ν}\right)}^{∗}$ (81) where *nᵥ* is the dimension of the irrep v and |*G*| is the number of elements in G. Fixing *λ*₁ = *λ*₂, *λ*₃ = *λ*₄, and s = s' we have $\frac{1}{\left|G\right|} {{\sum }_{g} {D}_{{λ}_{1} {λ}_{1}}^{\left({μ}_{1}\right)} \left(g\right) {D}_{{λ}_{3} {λ}_{3}}^{\left({μ}_{2}\right)} \left(g\right) {D}_{ss}^{\left(ν\right)} \left(g\right) = \left|\frac{1}{\sqrt{{n}_{ν}}}{C}_{{λ}_{1} {λ}_{3} , s}^{{μ}_{1} {μ}_{2} , ν}\right|}^{2} ,$ (82) which allows us to look for the set of labels where the Clebsch-Gordan coefficient does not vanish. Together with Eq. (80), this determines the selection rules, and can be used to find the set of allowed labels (i.e., the ones corresponding to non-vanishing terms) in an interaction term.

Example: ${ℤ}_{m}$ group.

The different irreps of the cyclic group are all one dimensional and they are parameterised by ${D}^{\left(μ\right)} \left({g}^{n}\right) = {e}^{i \frac{2 π}{m} μn}$ *,* with *µ* = 0 ... *m* - 1 and *n* = 0 ... *m* - 1. Equation (82) becomes $\frac{1}{m} {\sum }_{n = 0}^{m - 1} {e}^{i \frac{2 π}{m} \left({μ}_{1}+{μ}_{2}+ν\right) n} = {δ}_{{μ}_{1} + {μ}_{2} + ν} = {\left|{C}^{{μ}_{1} {μ}_{2} , ν}\right|}^{2}$ (83) from where we find the selection rule *µ*₁ + *µ*₂ + *µ*₃ + *µ*₄ = 0. Let's apply this to one of the many symmetries of Silicon. The lattice vectors (in Å) are *a* = (-2.7,0,2.7), *b* = (0,2.7,2.7) and *c* = (-2.7,2.7,0). Starting with four valence WFs, each one aligned with one of the four axis of a Silicon tetrahedron, $\begin{matrix}{W}_{1}^{Si} : a + b - 3 c \to axis 1 , & {W}_{2}^{Si} : - 3 a + b + c \to axis 2 , \\ {W}_{3}^{Si} : a - 3 b + c \to axis 3 , & {W}_{4}^{Si} : a + b + c \to axis 4 ,\end{matrix}$ (84) a ${ℤ}_{3}$ rotation around each of these axes is a symmetry of the crystal (we consider only these symmetries for simplicity of exposition, recalling that the full space group of Silicon is m3m). We call *Sⱼ* the operator associated with a rotation by 2*π*/3 around an axis *j*. In Fig. 7 four valence Wannier functions of Silicon; Each of these is aligned with respect to the axes 1 through 4 of Eq. (84). A ${ℤ}_{3}$ rotation around one of the axis maps the Wannier functions into themselves. The transformation matrix together with the invariance of the Hamiltonian determines the selection rules.
the transformation generated by *S*₄ is shown. These transformations permute the WFs in the basis ${\left[{W}_{1}^{Si}, {W}_{2}^{Si}, {W}_{3}^{Si}, {W}_{4}^{Si}\right]}^{T}$*.* Focusing on *S*₄, we can find a basis where the action of the symmetry is diagonal, i.e., ${S}_{4} {{W}^{˜}}_{a} {S}_{4}^{†} = {ω}^{a} {{W}^{˜}}_{a}$*,* with $ω = {e}^{\frac{2 πi}{3}}$*.* This basis consists of ${{W}^{˜}}_{4} = {W}_{4}^{Si}$ and $\left[\begin{matrix}{{W}^{˜}}_{0} \\ {{W}^{˜}}_{1} \\ {{W}^{˜}}_{2}\end{matrix}\right] = \frac{1}{\sqrt{3}} \left[\begin{matrix}1 & 1 & 1 \\ 1 & ω & {ω}^{2} \\ 1 & {ω}^{2} & ω\end{matrix}\right] \left[\begin{matrix}{W}_{1}^{Si} \\ {W}_{2}^{Si} \\ {W}_{3}^{Si}\end{matrix}\right] .$ (85)

The selection rule of Eq. (83) applies now for the symmetry ${ℤ}_{3}$ and is nothing more than the condition that the overall phase that the Coulomb term in the *W̃* basis acquires under *S*₄ is zero, fixing the product of functions in Eq. (79) to have the form *W̃ₐW̃_{b}W̃_{c}W̃_{d}* with *a + b + c + d =* 0 mod 3.

### Example: Octahedral metal centre.

As a further example of how symmetry could help in reducing the number of Coulomb tensor coefficients one has to compute, we now consider a cluster consisting of a transition metal atom (e.g., Manganese (Mn)) surrounded by six Oxygen (O) atoms. This structure is typical of many transition metal oxides and perovskites.

In our analysis, we employ renormalized Hydrogen-like atomic orbitals. The main reason for that is that they are simpler than Wannier functions and they feature the same symmetry properties. They are defined as ${ψ}_{nlm} \left({Z}_{eff}; r\right) = {R}_{nl} \left({Z}_{eff}; r\right) {X}_{l}^{m} \left(r\right) ,$ (86) with *n, l*, *m* the standard principal, angular, and magnetic quantum numbers, Z_{eff} the effective nuclear charge, ${X}_{l}^{m} \left(r\right)$ cubic spherical harmonics, and ${R}_{nl} \left({Z}_{eff}; r\right) = \sqrt{{\left(\frac{{Z}_{eff}}{n}\right)}^{3} \frac{\left(n-l-1\right) !}{2 n \left(n+l\right) !}} {e}^{- \frac{{Z}_{{eff}^{r}}}{2 n}} {\left(\frac{{Z}_{eff} r}{n}\right)}^{l} {L}_{n - l - 1}^{2 l + 1} \left(\frac{{Z}_{eff} r}{n}\right)$ (87) the radial wavefunction. Here, lengths are measured in units of *a*₀/2, with *a*₀ the Born radius, and ${L}_{n - l + 1}^{2 l + 1} \left(z\right)$ is the generalized Laguerre polynomial of degree *n* - *l* + 1.

In what follows we will assume that the largest contribution to the Coulomb tensor is due to the 5 d orbitals centred at the transitional metal, *d_{xy}, d_{xz}, d_{xz}, d*_{*x*²*-y*²}*, d*_{*z*²}*,* whose corresponding wavefunction are denoted as *Wₐ*(**r**) with *a* = 1,...,5, respectively. We are interested in calculating the Coulomb tensor coefficients in the central unit cell ${V}_{abcd} = \int d r d r ′ {W}_{a} \left(r\right) {W}_{b} \left(r′\right) V \left(\left|r-r′\right|\right) {W}_{c} \left(r′\right) {W}_{d} \left(r\right) .$ (88)

In doing that, symmetry properties can be exploited to determine a priori which elements of *V* are vanishing. Here, we take into account the reflection symmetry along the *x,* y, and *z* axes, and *π*/2 rotations around the *z* - axis. The corresponding operators are denoted by 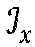 *,* 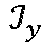 *,* 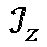 *,* and 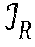 *,* respectively. Their action on the orbitals *Wₐ*(**r**) is ${J}_{μ} {W}_{a} \left(r\right) = {\sum }_{a ′} {P}_{aa ′}^{{π}_{μ}} {W}_{a ′} \left(r\right)$*,* with *µ* = {*x*, *y*, *z, R*} and *P^{π_{µ}}* a generalized permutation matrix corresponding to the permutation of the wavefunction indices *π_{µ}*, with ${P}_{aa ′}^{{π}_{μ}} = {η}_{a}^{μ} = \pm 1$ if *a'* = *π_{µ}*(*a*) and ${P}_{aa ′}^{{π}_{μ}} = 0$ otherwise. Exploiting the fact that *V*(|**r** - **r'**|) is invariant under the operations associated with 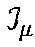 , we can identify which elements of the Coulomb tensor should be zero.

In particular, *V_{abcd}* = 0 if (*π_{µ}*(*a*), *π_{µ}*(*b*), *π_{µ}*(*c*), *π_{µ}*(*d*)) ∈ [(*i, j, k, l*)] and ${η}_{a}^{μ} {η}_{b}^{μ} {η}_{c}^{μ} {η}_{d}^{μ} = - 1$. Here, [(*i, j, k, l*)] is the set of all the configurations equivalent to (*a, b, c, d*) according to Eq. (51). As shown in Table 2, exploiting inversion and rotational symmetries allows us to significantly reduce the number of independent coefficients to be computed.

**Table 2: Number of independent Coulomb tensor coefficients to be computed for a transition metal cluster with 5 d orbitals.**

| No symmetry | Inversion | Inversion + Rotation |
|---|---|---|
| 325 | 157 | 129 |

So far we have discussed the construction of effective Hamiltonians starting from a material and reducing it to generate a Hamiltonian with the same general characteristics as the starting system (with the same symmetries, and of the same size in terms of unit cells). Another approach is to appeal to effective descriptions of physical systems, where a portion of the system is considered in a different footing than the rest. If one subsystem is small compared with the other, it is possible to replace the larger portion by an effective description in terms of a bath. This procedure is actually exact in the limit of lattices with infinite connectivity. At the end of this procedure, a Hamiltonian that looks formally like Eq. (4) is obtained. The tools that we develop in the rest of the sections work equally well for these systems. In the next section we review these model Hamiltonians for materials.

### 3.8 Summary

Electrons in solids can behave in completely unexpected ways, depending on the ions in the solid and the interactions between electrons. Using a classically cheap zeroth order description based on DFT, it is possible to isolate the relevant degrees of freedom that participate in a given phenomenon. From this description, we can construct a distilled Hamiltonian that contains the most important interactions and hopping terms within modes in the active space. A further compression is possible due to the structure of materials, where the thermodynamic number of degrees of freedom is encapsulated in a separation between bath and impurity modes in embedded approaches. Both strategies generate ultimately a Hamiltonian in a restricted set of modes. This effective Hamiltonian is constraint by the symmetries of the system, and these can be used to effectively construct it, reducing the classical cost of computation, but also limiting the possible interaction terms possible, thus also reducing the complexity of the quantum circuits that implement the interactions. In this compression is where the physics of the system is encoded.

In the following sections, we discuss in detail how to create a quantum circuit that implements the different terms of an effective Hamiltonian, with the goal of performing VQE or TDS. To achieve that, it is crucial to have an efficient way of representing fermionic degrees of freedom in terms of qubits.

### Qubit representation

In order to represent a fermionic system on a quantum computer, a mapping (also known as an encoding) must be specified between the fermionic Hilbert space, and the multi-qubit Hilbert space of the quantum computer. Such a mapping is most conveniently specified by a correspondence between fermionic operators and qubit operators. There are many design schemes available for such mappings, with significant room for variation in the details of their implementation. The most commonly used mapping is the Jordan-Wigner (JW) transform, which maps fermionic creation ( ${c}_{i}^{†}$) and annihilation (*cᵢ*) operators to string-like qubit operators: ${c}_{i}^{†} ↔ \frac{1}{2} \left({\prod }_{j < i} {Z}_{j}\right) \left({X}_{i}+{iY}_{i}\right) , {c}_{i} ↔ \frac{1}{2} \left({\prod }_{j < i} {Z}_{j}\right) \left({X}_{i}-{iY}_{i}\right) .$ (96)

The choice of mapping can have important consequences for the circuit depth and memory cost of quantum algorithms such as TDS and VQE. Furthermore the way in which the mapping choice influences these costs will depend strongly on the structure of the given Hamiltonian, as well as the available hardware connectivity. Thus it is not obvious what the correct choice of mapping should be in general.

In the case of simulating physical systems, it is generally best to use a mapping which specifically maps the interactions present in the Hamiltonian of the system to low weight operators (i.e. operators that act non-trivially in just a small subset of the qubits, without scaling with the size of the system). The JW transform is not well equipped to do this in general. An example of a mapping which is better suited to this, and that we will make use of in this work is the Compact Encoding. Unfortunately, in cases where there is a high degree of interaction between modes in the Hamiltonian, it is simply not possible to map all interactions to low weight operators, regardless of the choice of mapping. In lieu of low weight representations, a swap-network protocol may be employed, wherein fermionic modes are dynamically re-ordered throughout the algorithm, such that each interaction admits a low weight representation at some point in the protocol. Such a swap-network amortizes the cost of performing high-weight interactions, at the expense of having to actively re-order the fermionic modes in the mapping. This amortization can be very powerful, in particular when there are many interactions amongst a subset of modes; indeed in the case where we want to implement all-to-all quadratic interactions it can be shown - under weak algorithmic assumptions - that swap network methods in conjunction with the Jordan-Wigner mapping can yield essentially optimal circuit depths (see the "Optimality of the Jordan-Wigner transform and swap networks" section below). More details about the swap-network protocol will be discussed in Sections 5.3 and 6.1.

In the case of simulating materials, a fermionic mode basis can often be chosen such that interactions amongst nearby modes are very dense, while interactions between distant modes are sparse, such as in a maximally localized Wanier basis. In this case there is a need for both the localized operator support afforded by local fermionic encodings, and the amortization afforded by swap network protocols. The former to leverage the feature that most interactions are clustered in a localized region and are short range, and the latter to address the fact that within those regions there are a high number of interactions. However, to date uses of fermionic swap networks have been considered exclusively in conjunction with the JW transform, which does not yield local operator representations.

Yet in principle they may be used in conjunction with any fermion to qubit mapping, as the act of reordering fermionic modes admits a representation purely in terms of the fermionic algebra. Furthermore, in the case where a subset of modes have a high degree of interactivity, swap network protocols may be applied to this subset in isolation. This allows us to leverage the optimality of the swap network protocol for highly dense sets of (all-to-all) interactions, restricted to this subset where it is relevant. This suggests that a hybrid strategy may be ideal, wherein clusters of highly interacting modes are handled by a swap network protocol, while any sparse connectivity is handled by a specific choice of mapping.

Thus, we propose a specific family of fermionic encodings, built on the compact encoding, which are particularly well suited to this purpose. The innovation here is three-fold:
- The insight that fermionic swap networks may be applied to any fermionic encoding, and that currently no local encodings are being leveraged to this end.
- That this is particularly useful in the context of material simulations where localized structure is present.
- A specific proposal for a fermionic encoding which is ideally suited to the synthesis of these ideas.

With this in mind, and for the purposes of comparison, we focus our attention on two basis choices for the material Hamiltonian: the band basis Hamiltonian (Eq. 26) and the Wannier basis Hamiltonian (Eq. 29).

### Description of the Specific Encoding

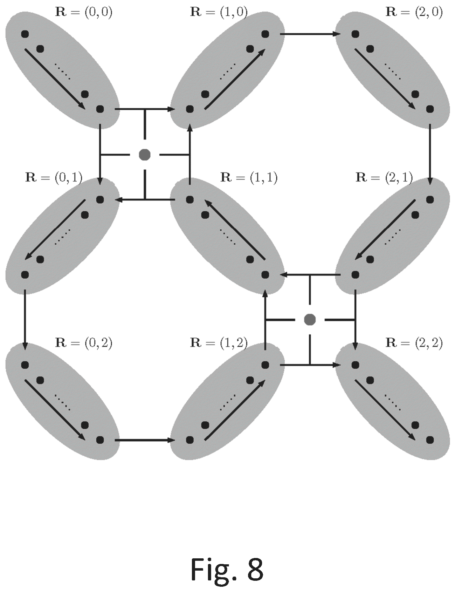

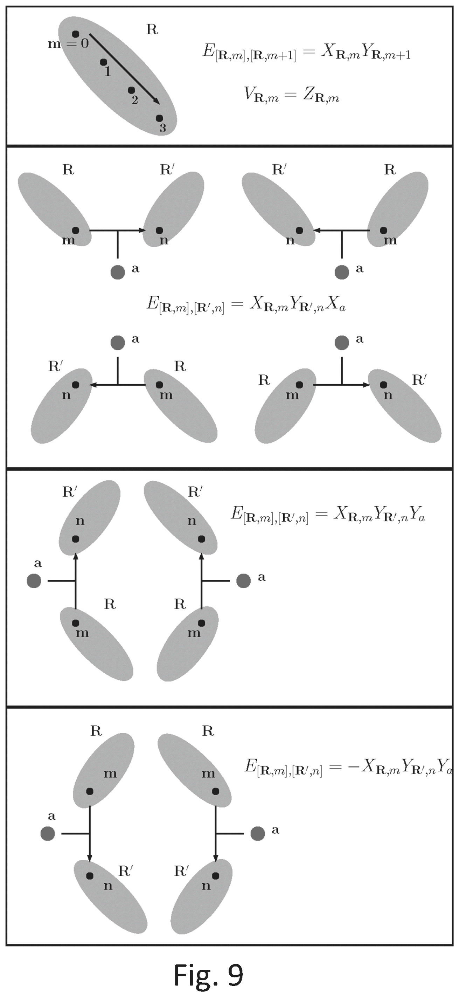

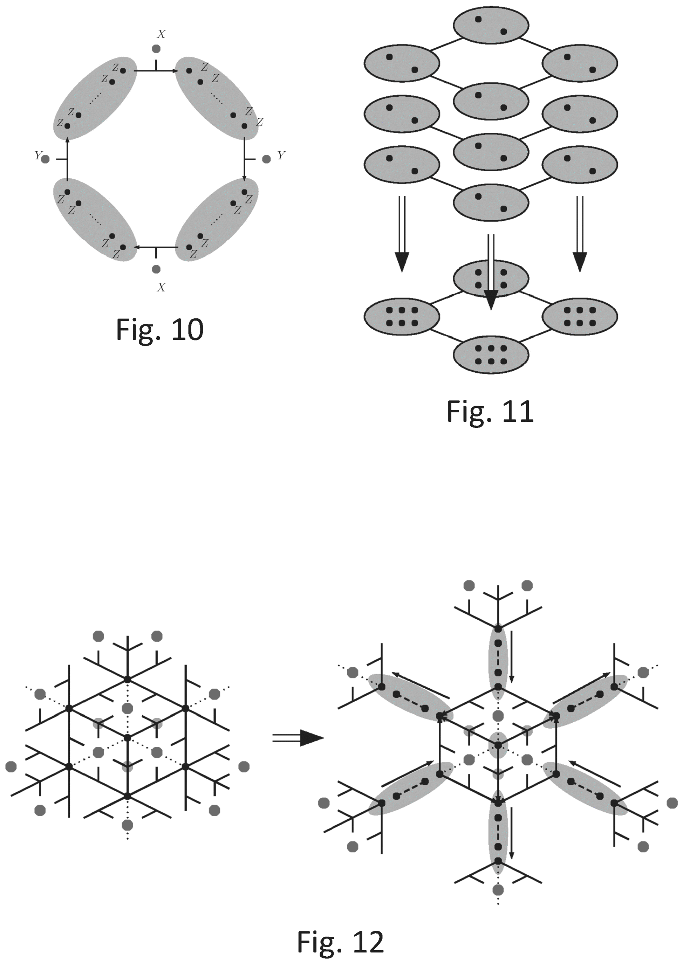

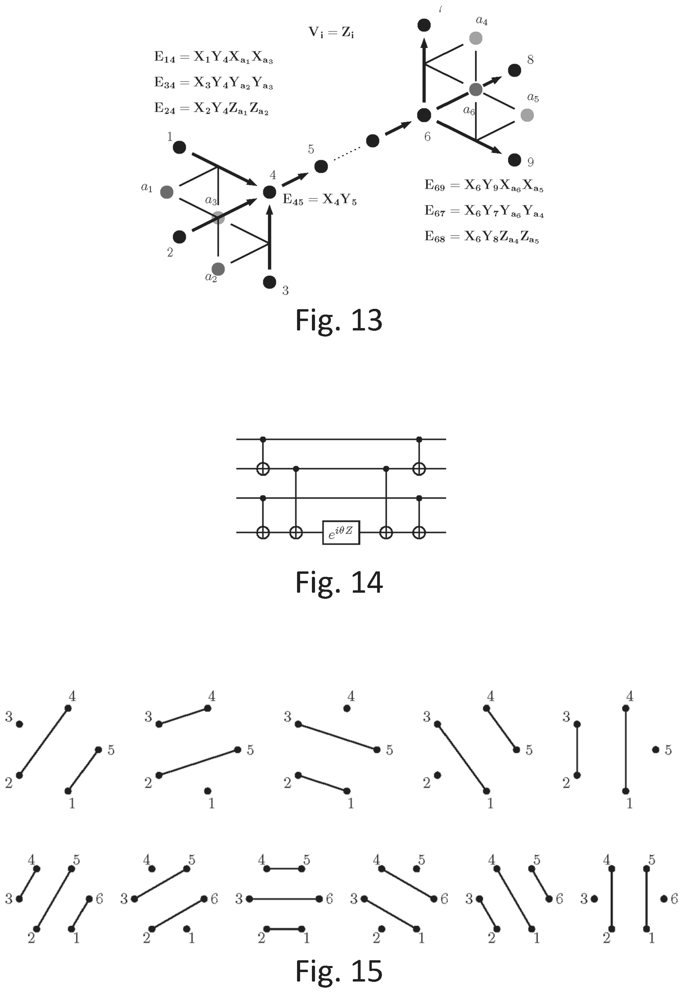

The specific encoding we propose for hybridizing swap networks and local encodings is a modified version of the 2d square and 3d cubic compact encodings described in Refs I and II. Those encodings represent an individual mode at each vertex of a square or cubic lattice. The modification is to replace that individual mode by a "site" containing a chain of modes stretching between what were previously overlapping corners of square faces/cubic cells. This is illustrated in figure 8 in the 2d case and figure 12 in the 3d case. The particular operator representations are given in figures 9 and 13.

The intended use case is for the collection of modes organized along one of these strings - often concatenated with one of its neighbouring strings - to undergo a localized swap network protocol. Since the swap networks are localized to subsets of sites, these protocols may be applied in parallel on disjoint sites across the system. By associating all the densely interacting modes together on each chain, the swap network protocol can amortize their cost, and it can be applied across neighbouring sites because the encoding yields low weight representations for some interactions between those sites.

### Generalizations

In principle the insight that the fermionic encoding may be used in conjunction with swap networks to yield a hybrid advantage need not be restricted to being deployed on the specific encoding that we propose here. One motivation for considering a different design of the encoding may be that the material has a different local geometry other than the rectilinear geometry of the square and cubic lattice, such as if the material has specific crystalline point symmetries that one wishes to leverage - for example in the case of a hexagonal point symmetry Jordan Wigner strings may be inserted into the hexagonal compact encoding in a similar fashion to how they have been inserted into the square compact encoding. Another motivation for considering a different design might be that the dense short range interactions might have additional structure, for example particular interactions may be absent due to a symmetry. In this case one might consider inserting some other encoding structure other than a single JW string. For example in the case where hopping interactions between spin sectors do not exist, it may be useful to consider inserting two strings instead of one. It is important to note that when constructing fermionic encodings, there are specific design constraints that must be satisfied in order to preserve certain algebraic relations. Thus generalizing in this way is not entirely trivial.

As important as the appropriate format for bringing materials simulations into the realms in which they are accessible by current and near term quantum computation hardware is the manner in which that Hamiltonian is encoded. The encoding schemes discussed below work towards this goal by providing guidance on encoding the specific Hamiltonian derived in the manner set out above, in such a way that the careful choice of format is preserved and carries through into low weight quantum circuits. This in turn allows the simulation to proceed at a high level of accuracy and reliability.

Finally the use case for this kind of hybridized approach need not be restricted to materials. Any fermionic system which exhibits some kind of local structure could take advantage of this approach. For example in the simulation of quantum field theories.

**Therefore,** the generalised method of efficiently simulating a fermionic system on a quantum information processor discussed herein includes: receiving a list of interactions between fermionic modes, *m;* determining an interactivity graph of the modes, wherein vertices of the interactivity graph are uniquely associated with the modes, and edges of the interactivity graph connect every pair of vertices whose associated pair of modes are involved in an interaction together; determining disjoint clusters of modes and selecting pairs of connected clusters from a set of pairs of candidate connected clusters, wherein a first cluster and a second cluster are a candidate pair of connected clusters if there exists at least one edge in the interactivity graph between a mode in the first cluster and a mode in the second cluster; defining a plurality of fermionic operators for encoding as qubit operators, comprising: at least one fermionic edge operator *E*_{[**R**,*i*],[**R'**,*j*]} for every pair of connected clusters, **R**, **R**', between modes i and*j*, wherein *i* is any mode in **R** and *j* is any mode in R'; fermionic edge operators *E*_{[**R**,*p*],[**R**,*q*]} between modes *p, q* in the same cluster **R** such that for any pair of modes *i,j* in **R**, there exists a sequence of modes *i, l*, m, n ..., *o,j* such that *Eᵢₗ, Eₗₘ, Eₘₙ* ... *Eₒⱼ*; and, fermionic vertex operators *Vⱼ* for every mode *j,* wherein *Eⱼₖ* : = *-iγⱼγₖ, Vⱼ* : = *-iγⱼγ̅ⱼ,* ${γ}_{j} : = {w}_{j} + {w}_{j}^{†}$, and ${\overline{γ}}_{j} : = \left({w}_{j}-{w}_{j}^{†}\right) / i$, wherein *wⱼ* and ${w}_{j}^{†}$ are fermionic annihilation and creation operators and the edge operators satisfy a composition relation *Eₕₖ = iEₕⱼEⱼₖ, and j* and *k* are multi-indices *j, k:* = [**R**, *m*]; encoding each of the plurality of fermionic edge and vertex operators as corresponding qubit operators acting on qubits of the quantum information processor, such that all the anti-commutation and commutation relations between the fermionic operators are preserved between their corresponding qubit operators and that the square of any fermionic edge or vertex operator is equal to the square of its corresponding qubit operator; and, simulating at least one fermionic interaction on the quantum information processor by enacting unitary qubit operations generated by the qubit operators on the qubits of the quantum information processor.

By clustering the modes involved in the list of interactions, determining pairs of connected clusters, and defining fermionic operators acting between modes in the clusters and between pairs of connected clusters in this way, a set of fermionic operators may be provided for mapping to qubit operators which advantageously may take advantage of swap network protocols for simulating interactions between modes in the same cluster (which are preferably have denser interactivity than with modes outside the cluster) while the (preferably sparser) connectivity between clusters can be handled by a particular choice of fermion-to-qubit encoding. The fermionic interactions may thus be more efficiently simulated by a sequence of unitary qubit operations on the qubits of the quantum computer. The unitary qubit operators for simulating the interactions may correspond to fermionic unitary interactions generated by the plurality of fermionic edge and vertex operators, where that correspondence may be determined, preferably uniquely determined, by the encoding. Encoding the plurality of fermionic edge and vertex operators as corresponding qubit operators preferably involves encoding as qubit operators that act on a small number of qubits (i.e. the corresponding qubit operators are low weight). The unitary qubit operation may comprise one or more fermionic swap operations, whereby the fermionic swap operations may transform the fermionic unitary operations which are not generated by a small number of the plurality of the fermionic edge and vertex operators into operations which may be generated as such thereby since the plurality of fermionic edge and vertex operators may be encoded as qubit operators acting on a small number of qubits, the unitary qubit operations may thus implemented on the quantum computer via a low depth quantum circuit and so provide an efficient quantum simulation.

The graph may be a hypergraph, the vertices of the hypergraph corresponding to the modes, and hyperedges connecting vertices which correspond to modes between which an interaction exists in the Hamiltonian. Determining the clusters of modes may comprise identifying sets of vertices of the hypergraph for which at least a threshold number of hyperedges between the vertices in the set are present. This may provide a particularly simple method of determining clusters of modes such that highly interactive modes are clustered together.

Clusters in a pair of connected clusters may be described as having a connection between them. Clusters and their connections may be represented graphically, for example, with a vertex representing a cluster and an edge representing the connection between a pair of connected clusters. Fermionic edge and vertex operators may similarly be represented graphically with modes associated with a vertex operators being a vertex of the graph, and modes acted on by a fermionic edge operator having an edge between them. Preferably there is only one fermionic edge operator between each pair of connected clusters.

Determining disjoint clusters of modes may be made in dependence on one or more properties of the list of interactions between fermionic modes, preferably wherein the one or more properties relate to the physics of the fermionic system to be simulated. Advantageously, the modes may thus be clustered such that the clustering may reflect the underlying structure and/or physics of the interactions and/or of the system to be simulated, for example, such that clusters correspond to modes which interact frequently with each other or with a large number of other modes in the cluster thereby such that the simulation of these interactions may be made more efficient, for example, by leveraging swap networks to simulate those interactions occurring between modes within the cluster.

A cluster of modes may be thought of in some cases as modes which are more densely connected with each other in the interactivity graph than with modes outside the cluster. This definition may advantageously increase the benefit of clustering since most interactions to be simulated may be handled efficiently using swap networks within clusters. In an example, the modes within each cluster may have all-to-all interactivity and each mode within a cluster may have an edge in the interactivity graph connecting it to just one corresponding mode in clusters to which it is connected.

In an example, the density, D, of a graph may be defined in terms of a ratio of a function of the number of edges present to the number of possible edges, for example. D = 2E/(V^2 -V), where E is the number of edges and V is the number of vertices. In an example, modes in a cluster may be more densely connected with each other than with the modes outside of the cluster if the density of the subgraph of the interactivity graph consisting of edges and vertices within the cluster is greater than the density of the whole graph. It will be appreciated that alternative measures of density and methods of comparing density are similarly applicable.

The list of interactions is derived from a fermionic Hamiltonian in some examples. Advantageously, the method may thus be applied to simulating physical systems governed by a particular Hamiltonian, for example, using a variational quantum eigensolver (VQE), trotterization steps, time-dynamics simulation (TDS) etc.. The list of interactions may correspond to some or all of the interactions in the fermionic Hamiltonian.

The modes are therefore clustered in dependence on one or more properties of the fermionic Hamiltonian in some examples. Advantageously, the properties of the fermionic Hamiltonian may be used to inform the clustering and thereby the encoding and simulating in order to tailor these to the specific Hamiltonian of interest in order to obtain lower circuit depths for simulating the interactions. In this way, the structure of the Hamiltonian is preserved in the interactivity graph, thereby allowing this structure to be exploited to improve efficiency in other stages of the encoding procedure.

At least one such property may relate to a symmetry of the fermionic Hamiltonian, preferably wherein the clusters and the pairs of connected clusters are determined such that they retain the symmetry of the fermionic Hamiltonian. Advantageously, the clustering may therefore closely reflect the structure of the Hamiltonian to be simulated, this may be particularly advantageous in the simulation of materials which may have a highly regular and/or symmetrical lattice structure.

The clusters and the connections between the pairs of connected clusters are representable as a regular lattice in some examples. Advantageously, the structure of the clusters may thus be easily representable and the encoding, particularly of fermionic edge operators acting between clusters, may be based on a regular fermion-to-qubit encoding which may reflect the underlying physical structure of the system to be simulated.

The clusters may further be indexed by a cartesian coordinate and pairs of connected clusters only involve clusters within a prescribed cartesian neighbourhood of each other. Advantageously, the structure of the clusters may thus be easily representable and the encoding, particularly of fermionic edge operators acting between clusters, may be based on regular local fermion-to-qubit encodings which may reflect the underlying physical structure of the system to be simulated and/or the quantum information processor on which it will be simulated.

Selecting pairs of connected clusters can include selecting pairs of the candidate connected clusters having at least a threshold number of edges between them in the interactivity graph. Advantageously, this may provide a simple method for determining which clusters are useful to connect in the encoding. For candidate connected clusters having only very few connections, it may not be advantageous to provide fermionic edge operators for encoding as qubit operators since simulation of such interactions may be rare or unimportant and may be handled in any case by the structure of the fermion-to-qubit encoding, for example, by indirect connections via intermediate clusters. In an example, the threshold number of edges is one and accordingly all the candidate pairs of connected clusters are selected.

Each cluster may be in no more than a threshold number of pairs of connected clusters. By keeping the degree of connectivity between the clusters below a threshold it may make it easier to design particular encodings. In general, it may be desirable to minimize the degree of connectivity of the clusters while maximising the number of pairs of candidate clusters that are selected.

In an illustrative example, the clusters and the connections between the pairs of connected clusters are represented as a 2D nearest neighbour lattice with clusters as lattice sites and edges between the pairs of connected clusters. In this case, no cluster is in more than 4 connected pairs, i.e., each cluster has at most "degree" 4.

### Optimality of the Jordan-Wigner transform and swap networks

Here we show that, perhaps surprisingly, if our goal is to implement time-evolution according to an arbitrary set of quadratic fermionic interactions (in an order of our choice), then a previously known algorithm combining the Jordan-Wigner transform and fermionic swap networks is close to optimal (in a particular sense). This algorithm has been proven optimal among swap network algorithms within the Jordan-Wigner transform; here, by contrast, we prove it is close to optimal among all algorithms (of a somewhat restricted form) within any encoding.

To achieve this, we consider the following setup:
We are given a fermionic Hamiltonian on n modes of the form $H = {\sum }_{j , k} {H}_{jk} = {\sum }_{j , k} {h}_{jk} \left({c}_{j}^{†}{c}_{k}+{c}_{k}^{†}{c}_{j}\right) .$ (138)

Our goal is to implement the unitary transformation $U = {\prod }_{j , k} {e}^{{iθ}_{jk} {H}_{jk}}$ (139) where we can take the product in an arbitrary order of our choice. This is sufficient to implement the Hamiltonian variational ansatz in VQE, for example.

Our goal is to minimise the 2-qubit gate depth required to implement this transformation. We assume that an arbitrary 2-qubit gate has unit cost.

We assume that each mode is associated with one or more qubits, such that at least one of these is a "data" qubit; and that to implement each interaction on 2 modes requires at least one 2-qubit gate across all the associated data qubits.

To implement this using the Jordan-Wigner transformation, we order the fermionic modes arbitrarily and associate each one with a qubit. We then use the swap network proposed by Kivlichan et al., which alternates between swapping pairs of adjacent modes starting at even and odd positions. We can combine time-evolution according to the corresponding terms in the Hamiltonian with these swap operations at no additional cost, as we are assuming that all 2-qubit operations are equivalent. After *n* layers of swap operations, all pairs of modes have interacted and the order is returned to the original order, albeit reversed (which can be dealt with by acting on the modes in reverse order in the next step of the algorithm, if desired). Therefore, the algorithm has 2-qubit gate depth *n.*

To obtain a corresponding lower bound, we observe that in the worst case, there are $\left(\begin{matrix}n \\ 2\end{matrix}\right)$ interactions to be implemented in total. At each step, at most $\left⌊n/2\right⌋$ interactions can be implemented, because each interaction involves at least one 2-qubit gate across the data qubits. (If there are more than n data qubits, this bound continues to hold, as we can select one per mode to produce the set on which we need to implement the interactions.) Therefore, in 2-qubit gate depth *k* we can implement at most $k \left⌊n/2\right⌋$ interactions. Implementing all the interactions then requires *k* ≥ *n* - 1 (if n is even) or *k* ≥ *n* (if *n* is odd).

### 4.1 Bloch basis mapping

The Bloch basis Hamiltonian is given by (see Eq. 26): ${H}^{B} = {\sum }_{k , n , σ} {ϵ}_{n} \left(k\right) {f}_{k , n , σ}^{†} {f}_{k , n , σ} + {\sum }_{σ , σ ′} {\sum }_{\begin{matrix}{n}_{1} , {n}_{2} , {n}_{3} , {n}_{4} \\ k , q , k ′\end{matrix}} {V}_{{n}_{1} {n}_{2} {n}_{3} {n}_{4}}^{\left(k,k′,q\right)} {f}_{k + q , {n}_{1} , σ}^{†} {f}_{k ′ - q , {n}_{2} , σ ′}^{†} {f}_{k ′ , {n}_{3} , σ ′} {f}_{k , {n}_{4} , σ}$ (97)

The quartic interactions in the band basis Hamiltonian have no specific local structure - there are effectively interactions between every mode. This suggests that the best choice of mapping is the JW transform, in conjunction with a swap-network protocol.

### 4.2 Wannier basis mapping

The Wannier basis Hamiltonian (see Eq. (29)) is given by: $\begin{matrix}{H}^{W} = {\sum }_{σ} {\sum }_{\begin{matrix}m , n \\ {R}_{1} , {R}_{2}\end{matrix}} T {\left({R}_{1}-{R}_{2}\right)}_{mn} {w}_{{R}_{1} , m , σ}^{†} {w}_{{R}_{2} , n , σ} & \left(98\right) \\ + {\sum }_{σ , σ ′} {\sum }_{\begin{matrix}s , l , m , n \\ {R}_{1} , {R}_{2} , {R}_{3} , {R}_{4}\end{matrix}} {{V}^{˜}}_{slmn}^{\left({R}_{1}{R}_{2},{R}_{3},{R}_{4}\right)} {w}_{{R}_{1} , s , σ}^{†} {w}_{{R}_{2} , l , σ ′}^{†} {w}_{{R}_{3} , m , σ ′} {w}_{{R}_{4} , n , σ} & \left(99\right)\end{matrix}$

In contrast to the band basis, the Wannier basis Hamiltonian has some local structure, interactions between modes indexed by **R**₁ and **R**₂ are suppressed as |***R***₁ - ***R***₂| increases. However in the case where |***R***₁ - ***R***₂| is small, for example nearest neighbour or on-site, interactions are strong, and in general all-to-all with respect to the band index. In this case we make use of a hybrid strategy. We map the system to an expanded compact encoding illustrated in Fig. 8 for 2d. In figure 8 a schematic for the hybrid fermion to qubit mapping for a 2d material is shown. Black dots correspond to both fermionic modes and their corresponding data qubit. Dots at the centre of the squares correspond to ancillary face qubits operating in the same fashion as in the square compact encoding. Grey balloons surround all fermionic modes assigned to a given site R. These modes are arranged in a line, with all interactions within the line taking the same form as in a JW transform with an identical linear ordering. Interactions between modes at the ends of neighbouring lines take the form of interactions between neighbouring modes in the compact encoding;

In this mapping, all modes sharing a common site index R are associated with a collection of qubits laid out in a Jordan-Wigner style string, and each string is connected to nearest-neighbouring strings using the compact encoding design. This encoding is most concisely expressed in terms of "edge" (*Eᵢⱼ*) and "vertex" (*Vᵢ*) operators, which are defined as: ${E}_{jk} : = - {iγ}_{j} {γ}_{k} {V}_{j} : = - {iγ}_{j} {\overline{γ}}_{j}$ (100) ${γ}_{j} : = {w}_{j} + {w}_{j}^{†} {\overline{γ}}_{j} : = \left({w}_{j}-{w}_{j}^{†}\right) / i$ (101) where here *j* (and *k*) is a multi-index over the site index R and mode index m. The edge and vertex operators are Hermitian, they anti-commute when they share an index, and commute otherwise. Furthermore, the edge operators satisfy an important composition relation: ${E}_{ik} = {iE}_{ij} {E}_{jk}$ (102)

The edge and vertex operators can be combined to synthesize any fermionic terms with an even number of creation and or annihilation operators, i.e. all observables that preserve parity super-selection - a fundamental requirement of any realistic Hamiltonian. For reference we include these decompositions for quadratic terms: ${w}_{i}^{†} {w}_{i} = \left(1-{V}_{i}\right) / 2 , {w}_{i}^{†} {w}_{j} = \frac{i}{4} \left(1-{V}_{i}\right) \left(1+{V}_{j}\right) {E}_{ij}$ (103) ${w}_{i} {w}_{j} = \frac{i}{4} \left(1+{V}_{i}\right) \left(1+{V}_{j}\right) {E}_{ij} , {w}_{i}^{†} {w}_{j}^{†} = \frac{i}{4} \left(1-{V}_{i}\right) \left(1-{V}_{j}\right) {E}_{ij}$ (104) ${w}_{i}^{†} {w}_{j} + {w}_{j}^{†} {w}_{i} = \frac{- i}{2} \left({E}_{ij}{V}_{j}+{V}_{i}{E}_{ij}\right)$ (105)

Quartic terms may be constructed from quadratic terms. However in this case there is a freedom in the choice of decomposition into edge operators thanks to Eq. (102). This freedom may be used to choose a decomposition with the smallest qubit representation.

The precise details of how the hybrid mapping specifies the edge and vertex operators are given in Fig. 9. In the mapping, only certain edge operators are specified. Any other edge operators must be constructed using relation (102). Thus interactions between modes distant from one another on the graph geometry will decompose into products of edge operators, yielding string-like Pauli representations similar to Jordan-Wigner strings. It is here where the swap-network protocol plays an important role.

This representation takes advantage of both the benefits of swap-network protocols in the context of all-to-all connectivity, which can be naturally applied to these Jordan-Wigner style strings, and the benefits of the local structure manifest between sites, through the compact encoding.

### 4.2.1 Stabilizers

Unlike the JW transform, the hybrid encoding represents fermionic states in a subspace of the multi-qubit Hilbert space. This subspace is best described as the code space of a stabilizer code. The generators of the stabilizer code are given by the ordered product of loops of edge operators around the octagonal faces in Figure 8, i.e. the faces with no ancillary qubit. An instance of one these generators is illustrated in Figure 10.

The fact that the fermionic system lives in a code space means that state preparation incurs an additional overhead compared to the JW transform. This is discussed further below. However, one benefit these stabilizers do supply is error detection. We will not discuss that in detail in this paper.

### 4.2.2 3d Layout

In most cases a realistic material will not be two dimensional but rather 3 dimensional. In this case there are two approaches one may take.

One approach is to collapse the 3d lattice of sites into a 2d lattice, with each site containing *m* * *L* modes, as illustrated in Figure 11. If the original 3d Hamiltonian has a nearest neighbour interaction structure, then the collapsed 2d counterpart will also have a nearest neighbour structure. The downside of this approach is that it increases the depth of the swap network protocol, since the number of modes on an individual site has increased. Additionally, it does not leverage the full sparsity of the Hamiltonian. The upside is that the qubits on superconducting devices are typically confined to a planar layout, and so this approach lends itself well to such devices.

The second approach is to employ a 3d generalization of the 2d compact encoding, to construct a 3d generalization of the hybrid encoding - illustrated in Figure 12. At the left of Figure 12, 3d compact encoding is shown converted to (right part of the image) 3d hybrid encoding. Black dots correspond to both fermionic modes and their corresponding data qubits, and red dots correspond to ancillary qubits. Red dots are positioned on the faces of the cubes. The basic principle remains the same, however in this case the edge operators connecting the different sites are weight 4 instead of weight 3. The details of this construction are given in Figure 13 showing the edge and vertex operators of the 3d hybrid encoding.

It can help to understand this process by considering the "sites" of the 3d material, each of which contains M modes. These modes would normally be assigned to each "site" (i.e. Jordan-Wigner, JW, chain) in the 3d hybrid encoding. Each "site" is labelled by a position (x,y,z) in the 3d material and 3d hybrid encoding. To map the 3d material into a 2d encoding instead, we use the 2d hybrid encoding which has sites (JW chains) labelled by (x,y). We assign all modes in a column of sites (x,y,0), (x,y,1), (x,y,2)... in the material to a single site (x,y) in the 2d hybrid encoding, thus the JW chains of the 2d hybrid encoding have to have M*L qubits instead of M, where L is the range of values the z parameter can take in the 3d material. Obviously we could also choose to collapse the x or y axis in this way instead of the z axis, in which case the process proceeds in a corresponding manner.

### VQE and TDS algorithms

We aim to find efficient quantum algorithms for two procedures, both relevant to simulating quantum systems on a quantum computer: the variational quantum eigensolver (VQE) for finding ground states of quantum systems, and time-dynamics simulation (TDS) for evolving an initial state in time. Both VQE and TDS are defined for a given quantum Hamiltonian *H,* which is split into terms, and they can be implemented by executing time-evolution according to each term. We often have some freedom in the order with which we time-evolve each term.

Fermionic swap networks provide a method to take advantage of this freedom in the case where *H* is a fermionic Hamiltonian, an important class of quantum systems. Encoding fermionic Hamiltonians on a quantum computer can lead to a relatively complex operator when represented as qubits, which can have terms which depend on many qubits (such as *X* ⊗ *Z* ⊗ *Z* ⊗ ... ⊗ *Z* ⊗ *X*). Time-evolving many terms of this form one after the other is inefficient. Fermionic swaps can simultaneously reduce the number of qubits on which many such terms depend, enabling them all to be implemented with a reduced quantum circuit depth overall.

Here we aim to use fermionic swap networks to find efficient quantum algorithms for simulating arbitrary, but specified, quantum systems (rather than either a general construction which works for all systems but is inefficient; or a construction which is efficient but carefully tuned for one particular system).

In this section we will find bounds on the complexity of implementing the variational quantum eigensolver (VQE) and time-dynamics simulation (TDS) algorithms for materials Hamiltonians. We begin by reviewing these algorithms before describing the details of how we implement and cost them for the systems of interest to us. We will use a simple model where all-to-all interactions are allowed, arbitrary 2-qubit gates are cost 1 each, and 1-qubit gates are free. Our goal is to minimise the overall circuit depth.

VQE is a method which aims to produce the ground state of a quantum Hamiltonian *H* via optimising over trial quantum circuits picked from some family ("ansatz") chosen based on advance knowledge that it may be able to represent the ground state effectively, and/or may be efficiently implementable on quantum hardware. Circuits from the ansatz have parameters which are optimised using a classical optimisation routine. This routine aims to minimise the energy with respect to *H* of the state produced by the quantum circuit. By the variational principle, if the ground state can be represented within the ansatz and is unique, minimising the energy will find it. In practice, the optimisation routine may find a local minimum rather than the global minimum. Once an approximation to the ground state has been produced, measurements can be performed to determine properties of interest.

Here we will use the Hamiltonian variational ansatz within the VQE framework. This ansatz can be used to find the ground state of a Hamiltonian *H* such that *H =* Σ_{*k*≥0} *Hₖ,* where the terms *Hₖ* correspond to nonzero Majorana monomials. We assume that we can write *H = H_{A}* + *H_{B},* where we have an efficient circuit for preparing the ground state of *H_{A},* and the time-evolution operations *e^{itHₖ}* can be implemented efficiently for all *k* and arbitrary times *t.* (For example, *Hₖ* may act non-trivially on only a small number of qubits.) Then we perform the following steps:
Prepare the ground state of *H_{A}.*

For each of *l* layers, implement the operation ${\prod }_{k} {e}^{{it}_{lk} {H}_{k}}$ for some parameters *tₗₖ,* to produce a state |ψ〉. Note that we will allow the ordering of the product to be arbitrary below, which can allow for more efficient algorithms.

Here we will compute the complexity of step 1, and of one layer of step 2. The terms *Hₖ* will correspond to the terms in equations (97) and (98), depending on whether we use the band or Wannier basis. In either case, all terms correspond to quadratic or quartic Majorana operators. We will also determine the number of measurements required to measure the energy of |ψ〉 with respect to the materials Hamiltonian. To gain a full understanding of the complexity of VQE, it is also necessary to understand how many layers are required, and how efficient the optimisation process is, which we will not consider here.

By contrast to VQE, the time-dynamics simulation (TDS) approach corresponds to implementing the unitary operation *e^{-itH}* for some *t*. Simulating time-dynamics of a quantum system is theoretically more straightforward than finding a ground state (BQP-complete in the worst case, rather than QMA-complete), yet may be more challenging in practice for near-term quantum computers. If an algorithm based on Trotterisation is used, TDS is very similar to implementing step 2 of the VQE algorithm. However, note that we have assumed in VQE that the time-evolution steps for each *Hₖ* can occur in arbitrary order, whereas we may want to fix a particular order for TDS.

We now discuss how each of the above steps is implemented. The algorithm is based on a set of basic operations, and we begin by calculating their quantum circuit complexity.

### 5.1 Gate decompositions of operations

There are three types of operations used in our algorithm: time-evolution according to Majorana operators, fermionic swaps and Givens rotations.

Time-evolution. Whichever fermionic encoding is used, each term will ultimately be represented on the quantum computer as a string of Pauli operators. As 1-qubit gates are free and all Pauli operators are equivalent up to unitary conjugation, implementing a term reduces to implementing the operation *e^{iθZ...Z},* acting on *k* ≥ 1 qubits, for arbitrary *θ*. This can be done in depth $2 \left⌈{log}_{2}k\right⌉ - 1$ via a circuit which uses a binary tree of CNOT operations to put the parity of the input state in the last qubit; performs a Z rotation on that qubit; and then performs the CNOT operations in reverse to uncompute the parity. We save depth 1 by combining the last two CNOTs and the Z rotation in one 2-qubit gate. See Figure 14 for an example for the case *k* = 4. Here, the three middle gates can be combined into one 2-qubit operation, given total cost (2-qubit gate depth) 3 in our model.

Note that we may have multiple commuting terms acting on the same qubits, which can lead to efficiency savings by implementing time-evolution according to these simultaneously. However, we do not consider this in our calculations.

Fermionic swaps. In the JW transform, fermionic swaps across adjacent modes are 2-qubit gates with cost 1. In the compact encoding, across most pairs of adjacent modes, the same holds. The exception is fermionic swaps across the split between sites, where an ancilla qubit is involved.

Here we can get an efficient decomposition as follows. Written in terms of Paulis, up to single-qubit unitary operations, a fermionic swap operation on the 3 qubits including the ancilla is of the form $exp \left(\pm i\frac{π}{4}\left({X}_{1}{X}_{2}+{Y}_{1}{Y}_{2}\right){P}_{A}\right)$ where *P_{A}* is a single-qubit Pauli operator, We can diagonalise this operator with a local unitary. For the remaining part, we can diagonalise *X*₁*X*₂ *+ Y*₁*Y*₂ with a 2-qubit gate, which turns out to be a Hadamard gate acting only on the odd parity subspace. The resulting operator is $I - \frac{1}{2} \left({Z}_{1}+{Z}_{2}\right)$, so implementing time-evolution according to this part requires 2-qubit depth 2. Including the basis change operations, the overall 2-qubit gate depth is then 4.

### Givens rotations.

A Givens rotation is a unitary operation which mixes pairs of fermionic operators in the following way: $\left(\begin{matrix}{G}_{ij} \left(θ, ϕ\right) {c}_{i}^{†} {G}_{ij}^{†} \left(θ, ϕ\right) \\ {G}_{ij} \left(θ, ϕ\right) {c}_{i}^{†} {G}_{ij}^{†} \left(θ, ϕ\right)\end{matrix}\right) = \left(\begin{matrix}cos \left(θ\right) & - {e}^{iϕ} sin \left(θ\right) \\ sin \left(θ\right) & {e}^{iϕ} cos \left(θ\right)\end{matrix}\right) \left(\begin{matrix}{c}_{i}^{†} \\ {c}_{j}^{†}\end{matrix}\right)$ (106)

Givens rotations are most easily defined in terms of fermionic edge and vertex operators, which may then be translated into qubit operations using the chosen mapping: ${G}_{ij} \left(θ, ϕ\right) = exp \left(-i\frac{ϕ}{2}{V}_{j}\right) exp \left(i\frac{θ}{2}\left[{E}_{ij}-{V}_{i}{V}_{j}{E}_{ij}\right]\right) ,$ (107)

In the JWtransform, when acting on adjacent modes this is a 2-qubit operation. In the compact encoding, it is usually a 2-qubit operation, except when acting across sites, when it is an operation of the form ${e}^{iθ \left({γ}_{i}{\overline{γ}}_{j}-{\overline{γ}}_{i}{γ}_{j}\right) / 2} = {e}^{- i \frac{ϕ}{2} {Z}_{2}} {e}^{i \frac{θ}{2} \left({X}_{1}{Y}_{2}-{Y}_{1}{X}_{2}\right) {P}_{A}}$ in 2D, and ${e}^{iθ \left({γ}_{i}{\overline{γ}}_{j}-{\overline{γ}}_{i}{γ}_{j}\right) / 2} = {e}^{- i \frac{ϕ}{2} {Z}_{2}} {e}^{i \frac{θ}{2} \left({X}_{1}{Y}_{2}-{Y}_{1}{X}_{2}\right) {P}_{A} {P}_{B}}$

By a similar argument to the fermionic swap operation, the 3-qubit operation can be implemented in 2-qubit gate depth 4. The 4-qubit operator can be implemented in 2-qubit gate depth 6.

### 5.2 State preparation

### 5.2.1 Fock states

The preparation of Fock states under the JW transform is straightforward, with each Fock state corresponding to a computational basis state i.e. $\left|{b}_{0},{b}_{1} … {b}_{m}\right〉 \to {⊗}_{i} \left|{b}_{i}\right〉 {b}_{i} ∈ \left\{0, 1\right\} .$

However, in the case of the hybrid compact encoding, the Fock state is encoded in a stabilizer code space, which necessitates a non-trivial state preparation procedure.

In the case of the 2D hybrid encoding, each stabilizer can be decomposed into a product of a classical parity check (product of *Z* operators) on the strings of data qubits *S_{D}* = *ZZZ* ... *ZZ,* coupled to a four qubit operator *S_{F} = XYXY* acting on the four face qubits. The set of stabilizers on the face qubits are identical to the stabilizers of the surface code. Thus if we wish to prepare a state where *S_{D}* = 1 for all data qubit stabilizers, such as the vacuum Fock state |0), then the algorithmic overhead of this state preparation is at most that of preparing a surface code state.

A given surface code state can be prepared either via a unitary circuit, or by measuring and correcting stabilizers. In the case of unitary preparation, a circuit of depth of 2 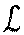 is required, where 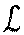 is the max side length of the surface code. In the case of the hybrid encoding 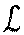 depends only on the number of sites {*N*₁, *N*₂, *N*₃}, and not on the mode number. More specifically, 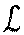 = max(*N*₁, *N*₂)/2 - assuming *N*₃ is collapsed into a single site, as described in 4.2.2.

If one has access to intermediate measurements and classically conditioned circuit operations, then it may be more convenient to use a measure and correct scheme of preparation. In the case of preparing a surface code state the measure and correct scheme works by measuring stabilizers and performing depth-1 Pauli corrections conditioned on the outcomes of the measurements. These corrections appear as Pauli strings between pairs of syndromes. However, in the case of preparing a Fock state, one need not prepare a surface code state, and may instead change the convention of the logical fermionic operations depending on the syndrome measurement. This gauge fixing saves having to actively perform the correction and is explained in more detail elsewhere in this document. An additional feature of encoding a fermionic Fock state is that the surface code stabilizers *S_{F}* can be measured without introducing any additional ancillary qubits. Instead one may employ one of the data qubits and measure in the Z basis. After correcting or gauging out the syndromes, the Fock state one will have prepared will depend on the syndrome produced, with a fermion occupying each data qubit which yielded -1 when measured in the Z basis.

Given an encoding of a vacuum Fock state |0〉, any other Fock state can be reached by applying a layer of single qubit Pauli operators (and vice-versa), in an analogous fashion to how any computational basis state can be reached from any other by a layer of single qubit X operators. To see this, we note that a product of Majoranas of the first kind (*γᵢ*) applied to a vacuum state yields a Fock state (up to appropriate sign from normal ordering) ${\prod }_{i} {γ}_{i} \left|0\right〉 = {\prod }_{i} {w}_{i}^{†} \left|0\right〉$ and any Fock state can be expressed this way. In the hybrid compact encoding, any product of Majoranas corresponds to a product of Pauli operators, which can be applied as a single layer of single qubit unitaries, each unitary being a single qubit Pauli.

The only caveat to the above discussion is that in some cases the hybrid compact encoding only represents even or odd parity Fock states. This happens when the encoding contains an even number of face qubits. In this case the parity operator Π*ᵢVᵢ* is in the set of stabilizers and odd products of Majoranas do not admit a representation. However one may freely fix a convention for the parity of the encoding by changing sign conventions for specific edge operators. So one may prepare any Fock state by fixing the correct edge operator sign convention, thus fixing the parity sector, and then proceeding as described above.

### 5.2.2 Fermionic Gaussian states

Another commonly prepared class of input fermionic states are the fermionic Gaussian states, which include Slater determinants. These states appear as the ground states of non-interacting fermionic Hamiltonians (those containing only quadratic terms) and also as ansatzes for ground states of interacting fermionic Hamiltonians in classical methods. As such they can often serve as good input states for quantum algorithms such as VQE.

The best known methods for preparing Gaussian states are designed for Jordan-Wigner representations of fermionic systems and involve sequences of Givens rotations 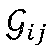 (*θ, ϕ*) : and Boguliubov transformations 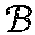 : $B : = {γ}_{F} {\prod }_{i \neq F} {V}_{i}$ (108) ${Bc}_{F} {B}^{†} = {c}_{F}^{†}$ (109) ${Bc}_{i} {B}^{†} = {c}_{i} i \neq F$ (110) where F is the index of the last mode in the choice of Jordan-Wigner ordering. As discussed earlier, there can be cases where the hybrid compact encoding does not admit a representation of single Majoranas, in which case Bogoliubov transformations of this kind are not possible to implement, however one may always choose a parity sector and then restrict to the class of transformations that preserve parity.

For the Jordan-Wigner transform, preparing Gaussian states requires circuit depth at most *Nm* - 1, using an algorithm of Jiang et al, where N is the number of sites and m is the number of modes per site. In the case of the 2D and 3D hybrid compact encoding the scaling of the depth of the circuit for preparing a Gaussian state cannot be much worse than that of the Jordan-Wigner transform, because one can always overlay a Jordan-Wigner ordering on the full hybrid compact encoding and perform the Givens rotations in accordance with the best known methods for the Jordan-Wigner transform. However, in this case the hybrid encoding introduces some overhead due to the higher Pauli weight of some of the edge operators - namely those with support on face qubits - and reduced opportunities for parallelization - namely when attempting to perform Givens rotations on two pairs of modes whose edge operators have support on a common qubit. The algorithm of Jiang et al acts on (at most) all consecutive modes at each step in an even-odd pattern. If we act on an even number of modes in total (as will always be the case if we consider spin) then at every other step, we only have 2-qubit gates. As shown, the depth of the step involving 3-qubit gates is 4 and involving 4-qubit gates is 6. To account for overlapping action on face qubits we have to stagger the Givens rotations on those edges. Therefore, the overall depth is at most $2 ∗ 4 \left⌈\left(M-1\right)/2\right⌉ + \left⌊\left(M-1\right)/2\right⌋ \approx 4.5 M$ for the 2D hybrid encoding and $2 ∗ 6 \left⌈\left(M-1\right)/2\right⌉ + \left⌊\left(M-1\right)/2\right⌋ \approx 6.5 M$ for the 3D hybrid encoding.

### 5.3 Time-evolution according to terms in materials Hamiltonians

For both the VQE and TDS algorithms, we need to implement time-evolution according to the quadratic part and the quartic part of the materials Hamiltonians *H_{B}, H_{W}.* To do this efficiently, we will use a protocol based on fermionic swap networks. These networks use layers of fermionic swap gates to rearrange the fermionic ordering and to enable terms to be implemented efficiently - for example, by moving modes to be adjacent in the JW transform. Here we apply swap networks to more general fermionic encodings than the JW transform, and the notion of efficiency we will use is to apply operations across modes which are adjacent in terms of the encoding graph. That is, we will swap modes (using fermionic swap operations on adjacent modes) with the intent of bringing modes across which we wish to perform some operation closer together.

Theoretical constructions of fermionic swap networks are known which implement all quadratic or quartic terms efficiently, in the sense that they reduce the quantum circuit depth by a factor scaling like the number of modes. That is, all quadratic terms on M modes can be implemented in quantum circuit depth *O*(*M*), and all quartic terms can be implemented in quantum circuit depth *O*(*M*³). However, here we will want to apply swap networks to specific materials Hamiltonians that do not include all terms. We are therefore led to an algorithmic approach to produce an efficient swap network protocol for a given Hamiltonian. We consider protocols that alternate between layers of the following form:
1. Fermionic swap gates across modes that are adjacent with respect to the graph of the fermionic encoding that we are using. For example, in the JW transform, swaps across qubits of the form (*i, i* + 1) would be allowed.
2. Time-evolution by all terms that are efficiently implementable given the current permutation of the graph of the fermionic encoding.

Note that following this structure gives a "greedy" protocol where we implement all terms that we are available at each step. One could also use a more incremental strategy where only some of these terms are implemented before the next layer of swaps.

We consider a term to be efficiently implementable if there is a split of the modes on which it acts into pairs such that all pairs are adjacent within the encoding graph. For the fermionic encodings we use, such terms correspond to low-weight Pauli operators. The aim is then to find a protocol using a small number of layers (corresponding to a good choice of positions for fermionic swap gates), as well as implementing the interactions within each layer efficiently. We can achieve both of these using computational techniques, which we summarise here, with a more detailed description in Section 6 below.

To find a good sequence of fermionic swap gates, we use a greedy protocol. At each layer, we look at the set of quartic interactions *T* which have not yet been implemented and define a distance function which measures the difficulty of implementing these interactions. Here we focus on *ℓₚ* distance functions of the form: $D = {\left({\sum }_{T} d {\left(T\right)}^{p}\right)}^{\frac{1}{p}} ,$ (111) where *d*(*T*) is the "distance" of the interaction on the graph, the sum is over all of the interactions and 0 < *p* ≤ 1, for example 0.25 *< p* < 0.75, or even approximately *p* = 0.5. Advantageously, the graph cost calculated in such a fashion may place greater weight on bringing terms with low distance closer together and has been found to produce particularly efficient layers of swap and interactions layers.

*d*(*T*) is defined as the minimum, over all splits of the modes into pairs, of the distance within the encoding graph of those modes. This is closely related to the number of swaps required to bring these modes together. Empirically, we found that choosing *p* = 0.5 seems to produce good results. We believe that this is because choosing *p* < 1 puts greater weight on bringing terms with low distance closer together.

We consider swapping each possible adjacent pair of modes in the interaction graph and compute the *D* function for each choice. If there exists a pair whose resulting *D* function is reduced, we then swap the pair which minimises *D* and mark this pair as used. We repeat this process until all modes have been used, or there is no choice of modes to swap that reduces *D.* A potential issue with this approach is that even in the first step, there may be no choice of pairs to swap that reduces *D.* We can handle this by adding a fallback step where a swap operation is chosen that at least reduces *d*(*T*) for some term *T.*

To implement all terms efficiently in step 2 above, we express this problem in terms of graph colouring. We define a graph whose vertices are terms that should be implemented in the current layer, and where two vertices are connected if the corresponding terms can be implemented simultaneously. Here we take the simple view that two terms can be implemented simultaneously if they act on disjoint sets of qubits. Then the minimal number of colours required to colour this graph such that no two adjacent vertices have the same colour is the same as the minimal number of sublayers required to implement all the terms.

As graph colouring is an NP-complete problem, we do not expect to be able to find the exact minimal number of sublayers for large numbers of terms and many qubits. (Empirically, it seems that exact graph colouring algorithms can be too slow even for some systems with around 10 modes.) However, we can use graph colouring heuristics to find an upper bound on the minimal number of layers efficiently. Here we use a greedy colouring algorithm with the DSATUR heuristic implemented in the NetworkX package.

As an additional optimisation, as the first step of our protocol we implement the swap network described herein, which enables all quadratic terms to be implemented using M layers of fermionic swaps, for a system with *M* modes. During this process, we can also implement some other terms, if they happen to become efficiently available. As we expect the overall complexity to be significantly greater than *M,* this is a lower-order cost that can reduce the number of terms used substantially. This optimisation can have two benefits: it significantly reduces the number of terms that need to be considered in the distance-minimising step, making finding the swap network protocol significantly more efficient; and it potentially leads to a more efficient quantum algorithm overall, in the case where there are many quadratic terms (so the network of is an efficient way of implementing them all).

Finally, we need to decompose the operations we apply in terms of elementary quantum gates. For this we use the costing procedure described in Section 5.1.

We now present a specific example of an encoding scheme to better illustrate the general principles. In general, each of the plurality of fermionic edge and vertex operators is encoding as a corresponding qubit operator. This process includes selecting a fermion-to-qubit encoding from a plurality of valid encodings. While a number of possible valid fermion to qubit encodings exist, all of which preserve the necessary relations between the plurality of fermionic operators, the selection can affect the complexity (i.e. depth) of the resulting quantum circuit. This in turn means that a well-chosen encoding scheme can be used to provide a highly efficient quantum circuit for a given system to be simulated.

The plurality of valid encodings from which to select may be pre-determined, for example, using algorithmic selection processes. In some examples, for example, the fermion-to-qubit encoding is selected based on one or more criteria (for example a criterion based on a weight of the qubit operators of the fermion-to-qubit encoding). This may allow a fermion-to-qubit encoding which is particularly suitable to the system to be simulated, or the kind of simulation, to be selected. In general, this may allow a fermion-to-qubit encoding to be selected that is optimal for the particular simulation task. As noted above, starting from a selection of appropriate encodings can allow an encoding to be selected from the set which permits a lower depth quantum circuit to be used in the simulations.

Other examples of criteria may include: a weight of a highest weight qubit operator; a total weight of the qubit operators; a number of qubits in the quantum information processor; an average weight of the qubit operators; an arrangement of the qubits in the quantum information processor; and/or a set of available quantum operations in the quantum information processor. This particular subset of criteria allows for the fermion-to-qubit encoding to be tailored to the hardware (i.e. the quantum information processor) on which the simulation is to run, in line with the considerations discussed above, for example.

The fermionic edge operators *E*_{[**R**,*p*],[**R**,*q*]}, between modes within each cluster **R** may form a linear sequence *E*_{[**R**,1],[**R**,2]}*E*_{[**R**,3],[**R**,4]} ... *E*_{[**R***,nR*}-1],[**R***,n_{R}*], wherein [1, 2, ... *n*_{R}] is a linear ordering of every mode in the cluster, wherein the number of modes in the cluster is *n*_{R}. Fermionic edge operators formed in such a way may be particularly suitable for the use of fermionic swap networks (discussed in detail below), meaning that they provide a useful framework within which to implement further advantageous features set out herein. Alternatively, the fermionic edge operators between modes within each cluster **R** may form more than one linear sequence. This alternative may be particularly advantageous where the structure of interactions between modes in a cluster means that certain interactions between modes within a cluster are absent due to a symmetry.

Similarly, the fermionic operators, *E*_{[**R**,*i*],[**R'**,*j*]}, between connected clusters **R,R'** may be arranged so that they act on modes at the ends of the linear sequence, such that *i* = 1 or *n*_{R} and *j* = 1 or *n*_{R'}. Advantageously, this may allow the linear orderings to be concatenated with those on neighbouring clusters.

In line with the above discussion, the fermionic edge operators, *E*_{[**R**,*i*],[**R**,*j*]}, between modes within each cluster may be encoded as qubit operators in the same way as in a Jordan-Wigner transform having an identical linear ordering of modes. This may be a particularly simple way of encoding the fermionic edge operators as qubit operators. Advantageously, and as will be apparent from the discussions elsewhere in this document, the Jordan-Wigner transform combined with swap networks may yield optimal quantum circuit depths.

Each mode, [**R**,*j*], may be associated with one data qubit of the quantum information processor such that the data qubits are also indexed by [**R**,*j*] and the fermionic edge operators, *E*_{[**R**,*p*],[**R**,*q*],} between modes within each cluster are encoded as the qubit operators: *E̅*_{[**R**,*j*],[**R**,*j*+1]} = *X*_{[**R**,*j*]} *Y*_{[**R**,*j*+1]}, wherein *X* and *Y* are Pauli *X* and *Y* operators. Advantageously, these qubit operators are low weight (weight 2) and so such encodings may yield low depth quantum circuits.

Similarly, each mode, [**R**,*j*], may be associated with one data qubit of the quantum information processor such that the data qubits are also indexed by [**R**,*j*] and the fermionic vertex operators are encoded as the qubit operators: *V̅*_{[**R***,j*]} = *Z*_{[**R**,*j*]}, wherein *Z* is a Pauli *Z* operator. Advantageously, these qubit operators are low weight (weight 1) and so such encodings may yield low depth quantum circuits.

To give a specific example, the clusters and their connections may be representable as a square lattice so that the index **R**: = [*a, b*] indexes the cluster's position in the square lattice up to a uniform coordinate translation. Each mode [**R**,*j*] in such a system is associated with one data qubit of the quantum information processor such that the data qubits are also indexed by [**R**,*j*] and wherein [**R**, *m*] is the end of the linear ordering within the cluster and [**R**,*n*] is the start of the linear ordering within the cluster. Ancilla qubits are associated with those faces of the square lattice defined by edges connecting lattice positions [*a, b*], [*a* + 1, *b*], [*a, b* + 1] and [*a* + 1, *b* + 1] where *a* + *b* is even, such that there is one ancilla qubit associated with each alternate face in a checkerboard pattern. The fermionic edge operators *E*_{[**R***,i*],[**R'***,j*]} between connected clusters are encoded as the qubit operators *E̅*_{[**R***,i*],[**R'***,j*]} in such a system as follows:
if a is even: ${\overline{E}}_{\left[\left[a, b\right], m\right] , \left[\left[a,b+1\right], n\right]} = {X}_{\left[\left[a, b\right], m\right]} {Y}_{\left[\left[a,b+1\right], n\right]} {X}_{ancilla} ;$ ${\overline{E}}_{\left[\left[a, b\right], n\right] , \left[\left[a,b-1\right], m\right]} = {Y}_{\left[\left[a, b\right], n\right]} {\overline{X}}_{\left[\left[a,b-1\right], m\right]} {\overline{X}}_{ancilla} ;$
if *a* is odd then: ${\overline{E}}_{\left[\left[a, b\right], n\right] , \left[\left[a,b+1\right], m\right]} = {Y}_{\left[\left[a, b\right], n\right]} {X}_{\left[\left[a,b+1\right], m\right]} {X}_{ancilla} ;$ ${\overline{E}}_{\left[\left[a, b\right], m\right] , \left[\left[a,b-1\right], n\right]} = {X}_{\left[\left[a, b\right], m\right]} {Y}_{\left[\left[a,b-1\right], n\right]} {X}_{ancilla} ;$
if *b* is even then: ${\overline{E}}_{\left[\left[a, b\right], n\right] , \left[\left[a-1,b\right], m\right]} = {Y}_{\left[\left[a, b\right], n\right]} {X}_{\left[\left[a-1,b\right], m\right]} {Y}_{ancilla} ;$ ${\overline{E}}_{\left[\left[a, b\right], m\right] , \left[\left[a+1,b\right], n\right]} = - {X}_{\left[\left[a, b\right], m\right]} {Y}_{\left[\left[a+1,b\right], n\right]} {Y}_{ancilla} ;$ and
if *b* is odd then: ${\overline{E}}_{\left[\left[a, b\right], n\right] , \left[\left[a-1,b\right], m\right]} = - {X}_{\left[\left[a, b\right], m\right]} {Y}_{\left[\left[a-1,b\right], n\right]} {Y}_{ancilla} ;$ ${\overline{E}}_{\left[\left[a, b\right], m\right] , \left[\left[a+1,b\right], n\right]} = {Y}_{\left[\left[a, b\right], n\right]} {X}_{\left[\left[a+1,b\right], m\right]} {Y}_{ancilla} ,$

As usual, *X,Y* and *Z* are Pauli operators, and the ancilla qubit in each of the qubit operators *E̅*_{[[*a,b*]*,m*]*,*[[*a',b'*]*,n*]} is that associated with the alternate face incident on the edge of the lattice connecting vertices [[*a*, *b*],*m*] and [[*a', b*'],*n*]. Advantageously, this fermion-to-qubit encoding results in low-weight qubit operators (at most weight 3) for each of the plurality of fermionic edge and vertex operators. This may yield particularly efficient quantum circuits for simulating the interactions. The encoding also has a simple local two dimensional structure which may be particularly amenable to simulating systems having a similar structure and/or simulating on a quantum information processors whose qubits are laid out in a similar structure.

In another example, the clusters and their connections are representable as a cubic lattice and the cluster index **R**: = [*a, b, c*] indexes the cluster's position in the cubic lattice up to a uniform coordinate translation. One data qubit of the quantum information processor is associated with each mode [**R**, *j*] such that the data qubits are also indexed by [R,j] and wherein [**R**, *m*] is the end of the linear ordering within the cluster and [**R**, *n*] is the start of the linear ordering within the cluster. Ancilla qubits are associated with those faces of the cubic lattice defined by edges connecting lattice positions: [*a, b, c*], [*a +* 1, *b, c*], [*a, b* + 1, *c*] and [*a +* 1, *b* + 1, *c*] where *a* + *b* is even and for every fixed c, [*a, b, c*], [*a +* 1, *b, c*], [*a, b, c +* 1] and [*a +* 1, *b, c +* 1] where *a* + *c* is even and for every fixed b, and [*a, b, c*], [*a, b +* 1, *c*], [*a, b, c +* 1] and [*a, b +* 1, *c +* 1] where *b + c* is even and for every fixed a, such that there is one ancilla qubit associated with each alternate face in a checkerboard pattern on the square lattice defined by any cross-section of the cubic lattice at a fixed *a, b* or *c*. The fermionic edge operators in this system *E*_{[**R***,i*],[**R'***,j*]} between connected clusters are encoded as the qubit operators *E̅*_{[***R**,i*],[***R'**,j*]} as follows:
if *a* + *c* is even then: ${\overline{E}}_{\left[\left[a, b, c\right], m\right] , \left[\left[a,b+1,c\right], n\right]} = {X}_{\left[\left[a, b, c\right], m\right]} {Y}_{\left[\left[a,b+1,c\right], n\right]} {Y}_{ancilla} {Y}_{ancilla} ;$ ${\overline{E}}_{{}_{\left[\left[a, b, c\right], n\right] , \left[\left[a,b-1,c\right], m\right]}} = {Y}_{\left[\left[a, b, c\right], n\right]} {X}_{\left[\left[a,b-1,c\right], m\right]} {Y}_{ancilla} {Y}_{ancilla} ;$
**if** *a + c* is odd then: ${\overline{E}}_{\left[\left[a, b, c\right], n\right] , \left[\left[a,b+1,c\right], m\right]} = {Y}_{\left[\left[a, b, c\right], n\right]} {X}_{\left[\left[a,b+1,c\right], m\right]} {Y}_{ancilla} {Y}_{ancilla} ;$ ${\overline{E}}_{\left[\left[a, b, c\right], m\right] , \left[\left[a,b-1,c\right], n\right]} = {X}_{\left[\left[a, b, c\right], m\right]} {Y}_{\left[\left[a,b-1,c\right], n\right]} {Y}_{ancilla} {Y}_{ancilla} ;$
**if** *a + b* is even then: ${\overline{E}}_{\left[\left[a, b, c\right], m\right] , \left[\left[a,b,c+1\right], n\right]} = {X}_{\left[\left[a, b, c\right], m\right]} {Y}_{\left[\left[a,b,c+1\right], n\right]} {Z}_{ancilla} {Z}_{ancilla} ;$ ${\overline{E}}_{\left[\left[a, b, c\right], n\right] , \left[\left[a,b,c-1\right], m\right]} = {Y}_{\left[\left[a, b, c\right], n\right]} {X}_{\left[\left[a,b,c-1\right], m\right]} {Z}_{ancilla} {Z}_{ancilla} ;$
**if** *a + b* is odd then: ${\overline{E}}_{\left[\left[a, b, c\right], n\right] , \left[\left[a,b,c+1\right], m\right]} = {Y}_{\left[\left[a, b, c\right], n\right]} {X}_{\left[\left[a,b,c+1\right], m\right]} {Z}_{ancilla} {Z}_{ancilla} ;$ ${\overline{E}}_{\left[\left[a, b, c\right], m\right] , \left[\left[a,b,c-1\right], n\right]} = {\overline{X}}_{\left[\left[a, b, c\right], m\right]} {\overline{Y}}_{\left[\left[a,b,c-1\right], n\right]} {\overline{Z}}_{ancilla} {\overline{Z}}_{ancilla} ;$
**if** *b* + *c* is even then: ${\overline{E}}_{\left[\left[a, b, c\right], n\right] , \left[\left[a-1,b,c\right], m\right]} = {Y}_{\left[\left[a, b, c\right], n\right]} {X}_{\left[\left[a-1,b,c\right], m\right]} {X}_{ancilla} {X}_{ancilla} ;$ ${E}_{\left[\left[a, b, c\right], m\right] , \left[\left[a+1,b,c\right], n\right]} = {X}_{\left[\left[a, b, c\right], m\right]} {Y}_{\left[\left[a+1,b,c\right], n\right]} {X}_{ancilla} {X}_{ancilla} ; and$
**if** *b* + *c* is odd then: ${\overline{E}}_{\left[\left[a, b, c\right], n\right] , \left[\left[a-1,b,c\right], m\right]} = {X}_{\left[\left[a, b, c\right], m\right]} {Y}_{\left[\left[a-1,b,c\right], n\right]} {X}_{ancilla} {X}_{ancilla} ;$ ${\overline{E}}_{\left[\left[a, b, c\right], m\right] , \left[\left[a+1,b,c\right], n\right]} = {Y}_{\left[\left[a, b, c\right], n\right]} {X}_{\left[\left[a+1,b,c\right], m\right]} {X}_{ancilla} {X}_{ancilla} ,$

Again, *X, Y* and Z are Pauli operators, and wherein *X, Y* and Z are Pauli operators, and the ancilla qubits in each of the qubit operators *E̅*_{[[***a,b,c***]*,m*],[[***a',b',c'***]*,n*]} are those arranged on the faces incident on the edge of the lattice connecting vertices [[*a, b, c*], *m*] and [[*a', b', c*'], *n*]. Advantageously, this fermion-to-qubit encoding results in low-weight qubit operators (at most weight 4) for each of the plurality of fermionic edge and vertex operators. This may yield particularly efficient quantum circuits for simulating the interactions. The encoding also has a simple local three dimensional structure which may be particularly amenable to simulating systems having a similar structure and/or simulating on a quantum information processors whose qubits are laid out in a similar structure. It will be understood that that a coordinate system [*a*, *b*] or [*a, b, c*] *etc.* may be uniformly translated without loss of generality, i.e. where, for example, statements such as "*a* + *b* is even" is merely a convenient convention for describing the relative structure of elements in a coordinate system. The skilled person would understand, for example, that relabelling *a to a* + 1 would entail that statements such as "*a* + *b* is even" would be replaced by "*a + b* is odd" etc.

In the above examples, the unitary qubit operations usually correspond to a fermionic unitary operation generated by products of the fermionic edge and vertex operators. Preferably, simulating at least one fermionic interaction in such a case comprises determining one or more fermionic unitary operations generated by products of a number of fermionic edge and/or vertex operators; and determining a fermionic swap network to reduce the number of fermionic edge and vertex operators. This reduces the weight of the corresponding unitary qubit operators. Advantageously, a fermionic unitary operation which may correspond to a product of fermionic edge and/or vertex operators which would otherwise result in a high weight qubit operator may be transformed into one which has a low weight representation.

Fermionic swap network protocols such as this acting on disjoint modes are usually implementable by the quantum information processor in parallel. Advantageously, this decreases the run-time of the simulation. This may be particularly advantageous for non-fault tolerant quantum information processors in which qubits may have relatively short coherence times.

The above discussion may involve implementing the method on qubits of the quantum information processor which comprise physical qubits. Simulations may thus be run on noisy intermediate scale (NISQ) quantum information processors without fault-tolerance. This low depth circuits for simulations of fermionic systems provided by the present invention may be particularly advantageous as they permit such simulations to be run on near-term quantum computers with tens or hundreds of qubits.

Equally, the qubits of the quantum information processor may comprise logical qubits. The simulations may thus be run on error-correcting and/or fault tolerant quantum information processor wherein logical qubits are made up of a plurality of physical qubits and may be operated on by logical qubit operations.

### 5.4 Measurements

The final step of a variational quantum algorithm is to measure the energy of the quantum state produced by the algorithm, with the goal being to minimise this. One may also wish to measure some other fermionic operator to extract a physical property of the state. A prominent example is measuring the energy of the quantum state with respect to some quantum Hamiltonian, which is used within the variational quantum eigensolver approach to find the ground state of that Hamiltonian.

Measuring a complicated fermionic operator can lead to significant overheads. Such an operator can be split into terms which are simpler to measure (for example, individual quadratic or quartic Majorana operators). Each of these terms can then be measured separately and their results summed together to produce an overall measurement result. However, this approach requires many preparations of the quantum state (measurement rounds), leading to a significant overhead for the overall quantum algorithm. The complexity of measurement can be reduced by grouping together terms that can be measured simultaneously. Yet simultaneously measuring a group of terms can itself require a complicated quantum circuit.

It will be appreciated that the careful choice of Hamiltonian and encoding to result in a low weight circuit is greatly boosted by enacting a measurement scheme which allows the output to also be extracted in as simple a manner as possible. This is because performing the measurement poorly, or inefficiently can lead to a longer running time, reduce the quality of the output, and reduce the accuracy of the simulation. Therefore the measurement methods set out below directly contribute to an improved simulation of the materials systems under consideration.

In this section we discuss how measurement can be achieved efficiently, in the rather general setting where one wishes to measure an arbitrary set of quadratic or quartic terms, expressed as Majorana operators. The approach can be seen as a middle ground between measuring in a local basis, which is easy to do but requires many measurement rounds, and measuring arbitrary commuting terms simultaneously, which requires a more challenging quantum circuit but fewer measurement rounds.

We will focus on operators expressed in the Jordan-Wigner transform. This also allows us to handle the case of the hybrid encoding with nearest-neighbour interactions between sites, because we can split terms into 4 groups (in 2D) or 6 groups (in 3D) that are only connected to nearest neighbours and locally look like Majorana operators in the Jordan-Wigner transform, with the exception of an ancilla qubit, which is always measured in the same basis.

Then a quadratic term corresponds to Pauli strings of the form *AZZ* ... *ZB,* where *A, B* ∈ {*X, Y*}, and the quartic case is products of two such strings on disjoint sets of qubits, or the product of a quadratic string and a Z operator elsewhere. In the two-string case, we can assume that we only need to measure terms containing an even number of *X'*s, since our Hamiltonian has time reversal symmetry.

This general method of a quantum computational measurement can be thought of as follows. Starting with of a set of quadratic Majorana operators describing a Hamiltonian encoded on a set of qubits, {α, β, γ, δ ...} of a quantum computer (i.e. achieved as set out above), the method begins by identifying a subset of the Majorana operators having M members, each member corresponding to an interaction which is to be measured between modes in the Hamiltonian. A portion of the qubits is/are allocated into a subset of data qubits (and in some cases a separate subset of the qubits are allocated into ancilla qubits), An ordering of the data qubits is fixed, and the Majorana operators are written in terms of products of two Pauli strings which operate on the data qubits (and which optionally also operate on one or more ancilla qubits, where present). Each Pauli string on the data qubits comprises one or more Pauli operators (X, Y or Z) where each Pauli operator operates on a specific qubit in the array of qubits. Each Pauli string of length 1 consists of one Z operator. Each Pauli string of length two or more has ends Aᵢ and Bⱼ selected from the set {X,Y}, where indices of the set {i, j, k, l...} denote specific qubits in the array of qubits {α, β, γ, δ...} on which the ends of the string operate.

The focus of the measurement part of this innovation focuses on the identification of at least one sub-subset of Majorana operators within the subset which can be simultaneously measured. This sub-subset of Majorana operators includes at least a first Majorana operator acting on data qubits i ≤ j and a second Majorana operator acting on data qubits k ≤ I, and is characterised such that the first and second Majorana operators are non-crossing. A full discussion of the concept of "non-crossing measurements" appears elsewhere in this paper, but in general a pair of Majorana operators are defined as non-crossing (i.e. can be measured simultaneously) if any one of the following non-crossing criteria are met:
- j < k; or
- l < i; or
- i < k ≤ l < j; or
- k < i ≤ j < l; or
- i = j and k = l; or
- i = k and j = I and A and B are selected such that the ends of the Pauli strings representing the first and second Majorana operators are each selected from either the set {XX,YY} or the set {XY,YX}.

Note that it is important that the Majorana operators also commute qubitwise on the ancilla qubits (where these are part of the qubit system - different encoding schemes may allow measurement to be performed without ancilla qubits being used as will be apparent from the discussion of encoding herein). Once this sub-subset has been identified, the method proceeds to simultaneously measure the Majorana operators in each sub-subset in a series of sequential measurements until all Majorana operators in the subset have been measured. Since the operators are known to be simultaneously measurable, this method provides a protocol for reliably and efficiently measuring each operator of interest in a small number of successive measurement rounds. This allows for improvements in the overall simulation procedure because the measurement step can be implemented in fewer rounds than with previous methods. In some cases, the above method provides the smallest possible number of measurement rounds for a given set of operators to be measured by leveraging this simultaneous measurement protocol. Broadly, the use of Majorana operators allows non-crossing criteria to be discussed without fixing the measurement format in advance. This method therefore defines a non-crossing condition, which in turn allows terms which qualify as non-crossing to be measured simultaneously.

The subset of Majorana operators within the set may be all of the quadratic operators within the set, or it may be only a proper subset, for example a subset of particular interest or for modelling a particular aspect of the system, answering a specific question about the modelled system, etc. The method begins with the assumption that a set of operators to be measured has been provided, deduced, calculated, etc. in line with the protocols discussed generally herein. The form of the operators is fixed by the encoding of an underlying physical Hamiltonian that is used. The current method takes this situation as an input and assesses how best to measure the operators. That is to say that there is no freedom to choose the form of the operators, e.g. selection of the form of the operators to ensure that a given set of operators is non-crossing and so can be measured simultaneously is not possible in this method.

The form of the Majorana operators in terms of products of two Pauli strings may therefore take different forms depending on the specific encoding scheme used. In particular where a Pauli string includes no ancilla qubits, the string has the form A...Z..B, i.e. a string of one or more Z operators separating two end operators each selected from the set {X,Y}. In other words, A and B collectively form ends of a string of the form X...X; X...Y; Y...X; or Y...Y. Where one or more ancilla qubits are present in the Pauli string, the encoding scheme will determine the form of the operator. Specific examples of this are set out elsewhere herein. In some cases there may even be zero Zs separating A and B. It is also possible for A and B to act on the same qubit, in which case the resulting operator is effectively just a single Z (because X*Y = Z, up to a constant, the imaginary number *i* in this case). In summary, each Pauli string can act nontrivially on an arbitrary number of qubits, from 1 (in which case it looks like Z), to 2 (in which case it looks like XX, XY, YX or YY), or more.

Note that the M operators correspond to a set of M interactions in the Hamiltonian. This correspondence ties the Majorana operators to the physical system being simulated (expressed in the Hamiltonian). In other words the correspondence represents a mapping between the simulated physical system (the Hamiltonian) and a physical state of a real system (ultimately the qubits of the quantum computer).

The method uses a single pair of operators as the basic block. This is advantageous as the most basic core of the measurement is the concept of non-crossing operations, which can be defined clearly in terms of pairs of Pauli strings according to the above criteria. Of course, more complex assessments can be made to widen the applicability of this concept, as set out in detail below.

Note that the assignment of labels to modes is a free choice, so long as the labels are consistently used throughout the process. For example the labelling could be chosen to maximise efficiency in other parts of the quantum simulation algorithm, by choosing an ordering such that the strings of Pauli operators have low weight (few non-identity parts). This would correspond to mapping a notion of locality in the original operator into a Jordan-Wigner ordering. It is often desirable for modes which are close physically (in the simulated model underlying the Hamiltonian) to be close within the mode index ordering because most interactions are between modes which are physically close, so this means that most interactions will be low weight, thereby tailoring the simulation protocol to the anticipated parameters of the quantum computer.

The identifying step may further identify additional Majorana operators which are all mutually non-crossing, meaning that any pair of Majorana operators selected from the set of first, second and all additional Majorana operators satisfies at least one of the non-crossing criteria. As will be apparent, the non-crossing criteria help to identify whether any pair of operators can be simultaneously measured, so performing a check that each possible pair within a set satisfies at least one of the non-crossing criteria means that the full set can be simultaneously measured. This allows for measurement rounds to be constructed which have an arbitrarily large number of measurements in them, subject only to the criterion that each measurement is mutually non-crossing with the other measurements.

The method may further include measurements of quartic Majorana operators. In the context of the present invention, quartic Majorana operators are defined as a product of two quadratic Majorana operators written as Pauli strings operating on disjoint data qubits. To measure a quartic operator of this form, the method includes as part of the identifying step, identifying a plurality of quartic Majorana operators which can be measured simultaneously by identifying quartic Majorana operators in which all pairs of the distinct quadratic Majorana operators which form part of the quartic Majorana operators satisfy at least one non-crossing criterion. This specifies that all pairs of quadratic operators making up the two quartic operators satisfy at least one of the non-crossing constraints set out above. That is, if the first operator is AB and the second one is CD, the pairs (A,C), (A,D), (B,C), (B,D) must each satisfy at least one non-crossing constraint. This process advantageously extends the measurement protocol from quadratic terms to quartic terms in a Hamiltonian describing the system. Optionally, the method further includes performing the measurement and iterating on a set of all quartic Majorana operators which are to be measured until all quartic Majorana operators in the set have been measured.

A naive measurement strategy would measure each term in sequence, using a number of measurements equal to the number of terms in the Hamiltonian, which can be at worst *Θ*(*M*⁴) measurements for a quartic Hamiltonian on M modes. Our goal here will be to do better by measuring multiple terms at a time. Minimising the number of rounds may not always give the strategy requiring the minimal number of measurements to achieve a certain level of accuracy, as this also depends on the variance of each measurement; however, this approach is a reasonable starting point. We also look for the measurements to be implemented using straightforward (ideally constant-depth) quantum circuits. To this end, we consider three types of measurement strategies:

### Measuring qubitwise commuting terms simultaneously (QWC).

These are Pauli terms which commute when restricted to individual qubits. This family of measurement strategies is easy to implement by measuring each qubit in the correct X/Y/Z basis, so requires only additional single-qubit gates. In the literature, this concept is sometimes called measuring in a tensor product basis (TPB).

(NC) Measuring a family of non-crossing terms simultaneously. As previously discussed, we say that a pair of distinct quadratic Majorana operators acting on modes i ≤ *j* and *k* ≤ *l* is non-crossing if either:
*j < k*, or *l < i*, or *i < k* ≤ *l < j*, or *k < i* ≤ *j < l*;
or *i* = *k*, *j* = *l*, and the endpoints of the two operators are picked from the set {*XX,YY*}, or the set {*XY*,*YX*}*.*

A pair of quartic Majorana operators is non-crossing if all of the pairs of distinct quadratic Majorana operators that they contain are non-crossing. We say that a set of Majorana operators is non-crossing if all pairs of distinct quadratic operators in it are non-crossing.

A set of Majorana operators can be measured simultaneously in a simple way if they are non-crossing. This is because *XX*, *YY* and *ZZ* commute and hence can be measured simultaneously (by a simple local transformation, corresponding to transforming to the Bell basis); the same is true for the set {*XY*, *YX*, *ZZ*}. So if all endpoints of all operators are either both contained within the Z-string of another Majorana operator, or avoid that operator completely, we can measure the terms simultaneously.

An NC measurement protocol on *M* modes gives rise to a non-crossing matching on the complete graph with *M* vertices (see Figure 15 for some examples), where we apply a 2-qubit unitary to the endpoints of each edge in the matching, and then measure in the computational basis. Such a protocol allows us to measure all the corresponding quadratic terms (and hence their products) simultaneously. Each matching is shown as a set of parallel lines on the circle. As used herein and in particular in the context of measurement, "matching" is used in the specific sense of the graph theory meaning. This may be defined loosely as "a choice of a set of edges in the graph for which no edges in the set share any vertices". Thus at a high level this defines the subsets which need to be identified within the set of operators to complete the desired measurements.

Explicitly, the protocol is as follows: to measure a set *S* of non-crossing quadratic Majorana operators, for each operator M ∈ *S*, measure the pair of qubits at the endpoints of iM either in the basis with respect to which {*XX,YY,ZZ*} are diagonal, or the basis in which {*XY,YX,ZZ*} are diagonal, depending on the endpoints. If *M* has just one endpoint, measure it in the *Z* basis. Any remaining qubits are measured in the Z basis. That is to say that measurement includes measuring the pair of qubits at the endpoints of the operator in the basis where {XX, YY, ZZ} are diagonal where the endpoints of the Pauli string are XX or YY, or measuring the pair of qubits at the endpoints of the operator in the basis where {XY, YX, ZZ} are diagonal where the endpoints of the Pauli string are XY or YX. Optionally all data qubits other than the endpoint qubits are measured in the Z basis, and all ancilla qubits are measured in a basis determined by the qubitwise commutativity constraint. This provides a measurement in a suitable basis, specifically adapted to the string type being measured.

This is a well-defined protocol, because by the non-crossing constraint, each qubit can be the endpoint of at most two distinct operators, which completely overlap and are jointly measurable. To show that it allows all of the operators in *S* to be measured, observe that the endpoints of each operator are measured in the correct basis, and the qubits between each endpoint are all measured in a basis that allows *ZZ* ...*Z* to be measured. This is because each qubit is either measured in the *Z* basis directly, if it is not the endpoint of a quadratic operator; or is one of a pair of qubits measured in an entangled basis allowing *ZZ* to be measured (by the non-crossing constraint).

(COM) Measuring a family of commuting operators simultaneously. This is the most general approach we will consider, so will require correspondingly fewer measurement rounds. However, the quantum circuits required to simultaneously diagonalise a set of measurement operators may be relatively difficult to implement (requiring depth *Θ*(*M*)).

Finding an efficient measurement procedure based on one of the above strategies corresponds to decomposing a set of Majorana operators into groups, such that each group only contains operators which are qubitwise commuting, non-crossing or commuting (respectively). The number of groups corresponds to the number of measurement settings. Since in the commuting and qubitwise commuting cases a group of operators can be simultaneously measured iff all pairwise combinations can be, this is then a graph colouring problem and can be solved computationally for any given set of operators. The non-crossing case is similar if we first choose a decomposition of each term into a particular product of quadratic terms. Each vertex corresponds to a term, and two vertices are connected by an edge when they are incompatible with respect to one of the above strategies (i.e. act incompatibly on the same qubit, cross, or anticommute). Compatible terms can be measured in the same round. The number of colours required then corresponds to the number of measurement rounds. Often in the literature the complement graph (where edges correspond to compatible operators) is considered in which case the graph colouring problem is equivalent to the problem of finding a minimum clique cover.

The graph colouring algorithm may include the implementation of a non-crossing protocol in which all possible pairs in a set of size M are identified into a set of M matchings {L₁, L₂,.. L_{M}}, such that the *p*^{th} matching Lₚ includes all pairs of modes {q, p-q modulo M}, for all q. This is shown schematically in Figure 15. Since the set of size M has a direct correspondence with the M operators to be measured, this provides a clear method for logically identifying the sets of operators which can be measured in a single measurement cycle (corresponding to a matching), and hence allows all the pairs in the full set of M operators to be measured in a series of simultaneous measurements. This in turn provides a reduction in the number of measurement cycles required to measure each pair in the set.

The graph colouring algorithm may further include dividing the subset of M modes into blocks of size 2ⁿ where n is an integer between 1 and log₂(M); for each value of n: dividing each block into two sub-blocks and using the non-crossing protocol to identify all possible pairs in each sub-block in a set of non-crossing matchings within each sub-block. the method continues by extending the matchings from the first sub-block to the second sub-block to identify all quadruples having a first pair in the first sub-block and a second pair in the second sub-block. This step is equivalent to finding an edge colouring of the

complete bipartite graph, and thereby allows various relevant aspects of graph theory to advantageously be applied to the solution.

The graph colouring approach can further include dividing the subset of M modes into blocks of size 2ⁿ where n is an integer between 1 and [log₂(M)-1]. For each value of n, the method then includes generating a first list of matchings which covers each pair in a list of labels {1,2,...,M·2⁻ⁿ} indexing each individual block of size 2ⁿ; using the pairs in each matching {{a₁,b₁}, {a₂,b₂}...} as indices to form, in parallel a first block, Bₐᵢ, and a second block, B_{bi}, for all i, thereby identifying each possible pairing of blocks of size 2ⁿ. For each first and second block so identified, the method proceeds by splitting the first block into first and second sub-blocks and splitting the second block into third and fourth sub-blocks. The non-crossing protocol (i.e. the methods described above for identifying non-crossing operators) is used to generate a non-crossing second list of matchings which includes all pairs with an element in one of the first and second sub-blocks and another element in one of the third and fourth sub-blocks. Then, for each matching from the second list of matchings, the method extends that matching to cover each pair in the other of the first and second sub-blocks and the other of the third and fourth sub-blocks from those which were used to form that matching, thereby to provide a list of matchings which covers all quadruples having either:
- an element in the first block, and three elements in the second block, the elements in the second block including at least one element in each of the third and fourth sub-blocks; or
- three elements in the first block, and one element in the second block, the elements in the first block including at least one element in each of the first and second sub-blocks.

These features provide a method for identifying all quadruples of a particular form, which is a useful step in identifying the components in a quartic operator which can be measured simultaneously.

### 5.4.1 Comparison of strategies

By restricting to measuring Majorana operators, here we obtain the advantage that the non-crossing condition defines joint measurability, via a simple (constant-depth) measurement strategy, without needing to fix the measurement in advance. This allows the problem of finding an efficient non-crossing strategy to be efficiently reduced to graph colouring, for which any desired approximate or exact algorithm can be used. This is because the inclusion of any term in a group uniquely specifies how the measurement of that term should be performed. By contrast, using more general Hamiltonians or measurement strategies, there does not seem to be such a unique specification and one seems to need to resort to a strategy such as trying each measurement operator in turn.

The identification of the split into subsets of mutually non-crossing Majorana operators using a graph colouring algorithm helps to identify sets of simultaneously measurable Majorana operators. The inventors have found that the process for identifying groups of non-crossing operators is mathematically equivalent to the procedures for understanding graph colouring (i.e. how many colours are needed to uniquely colour the edges of a graph such that no two edges of the same colour terminate at the same vertex). The skilled person will recognise that this is a well-studied problem in graph theory, and consequently the use of graph colouring in this context allows the findings of graph theory to be applied to this situation.

Next we will obtain analytical upper and lower bounds for each type of strategy in the case where arbitrary quartic terms are allowed in the Hamiltonian. These bounds highlight the differences between the strategies and show their worst-case behaviour. The bounds are presented in Table 3.

**Table 3: Summary of the lower and upper bounds on the number of measurement rounds required.**

| Strategy | Lower bound | Upper bound |
|---|---|---|
| QWC | $\frac{{M}^{4}}{16}$ | $\frac{{M}^{4}}{3}$ |
| NC | $\frac{2 {M}^{2}}{3}$ | $\frac{7 {M}^{2}}{3}$ |
| COM | $\frac{2 {M}^{2}}{3}$ | $\frac{5 {M}^{2}}{3}$ |

### 5.4.2 Analytical lower bounds

(QWC) We produce a set of *Ω*(*M*⁴) quartic terms, each pair of which are not qubitwise commuting. Assume for simplicity that *M* is a multiple of 4. We consider the set of quartic interactions acting on modes (*i*,*j*,*k*,*l*) such that $1 \leq M / 4 , M / 4 + 1 \leq j < k \leq 3 M / 4 , 3 M / 4 + 1 \leq l \leq M$

There are $\frac{M}{4} \left(\begin{matrix}M / 2 \\ 2\end{matrix}\right) \frac{M}{4} = {M}^{4} / {2}^{7} - O \left({M}^{3}\right)$ quadruples of this form, and so there are at least 8 × *M*⁴/2⁷ = *M*⁴/16 corresponding quartic interactions.

We claim that any pair of interactions *P*₁,*P*₂ from this set are not qubitwise commuting. Consider a pair of interactions *P*₁, *P*₂ from this set acting on (*i*₁,*j*₁,*k*₁,*l*₁) and (*i*₂,*j*₂,*k*₂,*l*₂) respectively. If (*i*₁,*j*₁,*k*₁,*l*₁) = (*i*₂,*j*₂,*k*₂,*l*₂), then they must act differently at one of *i*₁,*j*₁,*k*₁,*l*₁ in order to be distinct. So instead consider the case where (*i*₁,*j*₁,*k*₁,*l*₁) ≠ (*i*₂,*j*₂,*k*₂,*l*₂). Suppose *i*₁ < *i*₂, then at qubit *i*₂, *P*₁ acts as *Z* but *P*₂ acts as *X* or *Y.* The same argument applies if *k*₁ < *k*₂. And similarly, if *j*₁ < *j*₂ (or *l*₁ < *l*₂), then at qubit *j*₁ (*l*₁), *P*₁ acts as *X* or *Y*, but *P*₂ acts as *Z.*

(COM) It is known that a maximal set of commuting quartic terms is of size at most $\left(\begin{matrix}M \\ 2\end{matrix}\right)$ (in the large *M* limit). Since we wish to measure $8 \left(\begin{matrix}M \\ 4\end{matrix}\right)$ terms in total, any strategy will require at least $8 \left(\begin{matrix}M \\ 4\end{matrix}\right) / \left(\begin{matrix}M \\ 2\end{matrix}\right) = \frac{2 \left(M-3\right) \left(M-2\right)}{3} = \frac{2 {M}^{2}}{3} - O \left(M\right)$ measurement rounds.

### 5.4.3 Analytical upper bounds

(QWC) There is a trivial upper bound of $8 \left(\begin{matrix}M \\ 4\end{matrix}\right) = \frac{{M}^{4}}{3} + O \left({M}^{3}\right)$ from the strategy of measuring each term in turn.

We can do marginally better by splitting {1, ...,M} in half and doing the measurements that act only on {1, ... , *M*/2} in parallel with the ones that act only on {M/2 + 1, ... , *M*}. There are $8 \left(\begin{matrix}M / 2 \\ 4\end{matrix}\right) \approx \frac{1}{16} \frac{{M}^{4}}{3}$ terms that act only on {1, ..., *M*/2}, so the total number of measurements is $\frac{15}{16} \frac{{M}^{4}}{3}$.

We can iterate this procedure, by first measuring the $\frac{14}{16}$ fraction of the terms that act on both sides of *M*/2. Then, of the $\frac{1}{16}$ fraction of terms that act within the first half, do the $\frac{14}{16}$ fraction of terms acting across *M*/4 and so on. This gives a total number of measurements that asymptotically approaches: $\left[\frac{14}{16}+\frac{1}{16}\left(\frac{14}{16}+\frac{1}{16}…\right)\right] \frac{{M}^{4}}{3} = \frac{14}{16} \frac{1}{1 - \frac{1}{16}} \frac{{M}^{4}}{3} = \frac{14}{15} \frac{{M}^{4}}{3}$

(COM) An upper bound has been provided by Bonet-Monroig et al for measuring all quartic interactions, including those that do not respect time reversal symmetry. Here we describe how the same method can be used to measure all the interactions we are interested in. Then we will show how to adapt this method into a NC strategy.

The abstract combinatorial problem that needs to be solved is the following. We say a list of disjoint pairs of a set is a matching. We need to construct a list of matchings of {1, ... , *M*} such that each quadruple {*a, b, c,d*} appears in a matching as the union of two pairs (i.e. there is a matching that contains either {*a, b*}, {*c, d*} or {*a, c*}, {*b, d*} or {*a, d*}, {*b, c*}). Let *mq*(*M*) be the number of matchings required to get all quadruples in the set {1, ... , *M*}.

To get all quartic fermionic terms, we can work in the Majorana basis and measure any product of two distinct Majoranas simultaneously. A measurement of this form corresponds to a matching of {1, ... 2*M*}, and the total number of measurements required to get all quartic terms is *mq*(2*M*)*.* If we are interested only in terms that respect time symmetry, we can instead measure all quadratic terms of *XX*/*YY* type and then all terms of *XY*/*YX* type leading to a total of 2*mq*(*M*) measurements.

Each matching contains $\left⌊M/2\right⌋$ pairs and so $\left(\begin{matrix}\left⌊M/2\right⌋ \\ 2\end{matrix}\right)$ quadruples are covered by each matching. Since there are $\left(\begin{matrix}M \\ 4\end{matrix}\right)$ quadruples in total, we have a lower bound of $mq \left(M\right) \geq \left(\begin{matrix}M \\ 4\end{matrix}\right) / \left(\begin{matrix}\left⌊M/2\right⌋ \\ 2\end{matrix}\right) \approx {M}^{2} / 3$. It is shown in that, when *M* is a power of 2, *mq*(*M*) ≤ 5*M*²/6. This therefore corresponds to an upper bound of $2 mq \left(M\right) \leq \frac{5 {M}^{2}}{3} .$

Before moving on to discuss non-crossing strategies, we will first discuss the algorithm of Bonet-Monroig et al in more detail so that we can later adapt it into a non-crossing strategy. There are two important subroutines for creating matchings that contain certain pairs (which can be thought of as methods for measuring quadratic interactions). The first is a list of matchings to get all pairs of a set {1, ... , *M*} which is equivalent to finding an edge colouring of the complete graph. Baranyai's theorem says that this takes *M* - 1 colours if *M* is even and *M* colours if *M* is odd. The second subroutine is a list of matchings to get all pairs of the form {*x*,*y*} where *x* ∈ {1, ... , *M*/2}, *y* ∈ {M/2 + 1, ... , *M*}. This can be done in *M*/2 matchings and corresponds to an edge colouring of the complete bipartite graph.

We now describe the algorithm when *M* is a power of 2. Split the set {1, ... , *M*} into blocks of size 2*ⁿ* labelled ${B}_{m}^{n} = \left\{m{2}^{n}<i\leq \left(m+1\right){2}^{n}\right\}$. For each *n* ∈ {1, ... , log(*M*)} do the following:
Divide the set ${B}_{m}^{n}$ in half (using the same notation, ${B}_{m}^{n}$ splits into ${B}_{m}^{n} = {B}_{2 m}^{n - 1} ∪ {B}_{2 m + 1}^{n - 1}$). Generate a list of 2^{*n*-1} - 1 matchings of ${B}_{2 m}^{n - 1}$ to get all pairs in ${B}_{2 m}^{n - 1}$. Extend each of these matchings to a matching of ${B}_{m}^{n}$ in 2^{*n*-1} - 1 different ways to get all pairs in ${B}_{2 m + 1}^{n - 1}$. This gives a total of < 4^{*n*-1} matchings that covers all quadruples in ${B}_{m}^{n}$ that consist of a pair in ${B}_{2 m}^{n - 1}$ and a pair in ${B}_{2 m + 1}^{n - 1}$. Do this in parallel for all *m*.

For each *n* ∈ {1, ... , log(*M*) - 1} do the following:
Generate a list of *M*2^{-*n*} - 1 matchings of {1, ..., *M*2^{-*n*}} that covers all pairs. For each of these matchings {{*a*₁,*b*₁}, {*a*₂,*b*₂}, ... }, pair up ${B}_{{a}_{i}}^{n}$ and ${B}_{{b}_{i}}^{n}$.

Split ${B}_{a}^{n}$ and ${B}_{b}^{n}$ into half again and for *c, d* ∈ {0,1} do the following: Generate a list of 2^{*n*-1} matchings that gets all pairs with one element of ${B}_{2 a + c}^{n - 1}$ and one element of ${B}_{2 b + d}^{n - 1}$. Extend each of these matchings to a matching on ${B}_{a}^{n} ∪ {B}_{b}^{n}$ in 2^{*n*-1} - 1 ways so that each pair in ${B}_{2 a + 1 - c}^{n - 1}$ and each pair in ${B}_{2 b + 1 - d}^{n - 1}$ is covered.

This gives a total of ≤ 4 × 4^{*n*-1} matchings that cover all quadruples of the form (*w*,*x*,*y*,*z*) with $w ∈ {B}_{a}^{n}$, $x , y , z ∈ {B}_{b}^{n}$ and at least one element in both ${B}_{2 b}^{n - 1}$ and ${B}_{2 b + 1}^{n - 1}$ (or similarly for *a* ↔ *b*).

The total number of matchings is therefore ${\sum }_{n = 1}^{log M} {4}^{n - 1} + {\sum }_{n = 1}^{log M - 1} M {2}^{- n} \times 4 \times {4}^{n - 1} \leq \frac{5 {M}^{2}}{6}$ as claimed.

(NC) We want to adapt the method of the previous section so that all matchings are non-crossing. We first describe how to get all pairs in {1, ... , *M*} using *M* matchings. The *j* th matching pairs up (*i,j* - *i* mod *M*) for all *i*. Note that if *j* - i mod *M* = 0, the *i*'th mode is not paired. These matchings can be visualized as parallel lines on circles as shown in Figure 15.

We can use this method in all the places in the previous algorithm where we need to generate all pairs within a subset ${B}_{2 m}^{n - 1}$. This takes 2^{*n*-1} non-crossing matchings, compared to 2^{*n*-1} - 1 matchings previously, making minimal difference to the total. We can also use this method when pairing up blocks ${B}_{a}^{n}$ and ${B}_{b}^{n}$.

However, we don't have an alternative non-crossing strategy to get all pairs with one element in ${B}_{2 a + c}^{n - 1}$ and one element in ${B}_{2 b + d}^{n - 1}$, which we were able to do with 2^{*n*-1} - 1 matchings. Instead we can just use our non-crossing strategy to get all pairs in ${B}_{2 a + c}^{n - 1} ∪ {B}_{2 b + d}^{n - 1}$ using 2*ⁿ* matchings.

If we do this, the total number of non-crossing matchings is ${\sum }_{n = 1}^{log M} {4}^{n - 1} + {\sum }_{n = 1}^{log M - 1} M {2}^{- n} \times 4 \times {2}^{n - 1} \times {2}^{n} \leq \frac{{M}^{2}}{3} + {M}^{2} = \frac{7 {M}^{2}}{6}$ giving an upper bound of 7*M*²/3 non-crossing measurements.

### 5.4.4 Quartic terms that act on three modes

The strategy in the previous section allows all quartic fermionic terms to be measured. However, we can get a more efficient protocol if we only want to measure terms that act non-trivially on only 3 modes. After the JW transformation, these are of the form ${X}_{i} \left({\prod }_{i < j < k} {Z}_{j}\right) {Y}_{k} {Z}_{l} or {Y}_{i} \left({\prod }_{i < j < k} {Z}_{j}\right) {X}_{k} {Z}_{l}$ where i < *k* and *l* ∉ {*i*, *k*}, and in which {*i, j, k, l*} are indices denoting qubits in the qubit array and wherein the non-crossing protocol is used to identify a set of non-crossing matchings in which all possible pairs in the set of size M' occur in at least one matching.

There are $2 \left(\begin{matrix}M \\ 2\end{matrix}\right) \left(M-2\right) = {M}^{3} - O \left(M\right)$ terms of this form, and we can measure all of them in 2*M*log(*M*) non-crossing measurements as follows.

Assume for simplicity that *M* is a power of 2, *M* = 2*^{m}*. We can construct M non-crossing matchings such that all pairs occur in at least one matching, as shown in Figure 15 and discussed in the upper bound for non-crossing strategies to measure all quartic terms. For each of these matchings, we choose 2log(*M*/2) measurement settings, where for each measurement setting we measure each pair in the matching in either the {*XY,YX,ZZ*} basis or the the {*ZI,IZ*} basis. For the *j*th measurement setting we measure the ith pair in the matching in the {*XY, YX, ZZ*} basis if the *j*th bit of the binary representation of i is 0 and in the {*ZI, IZ*} basis if the jth bit of the binary representation of *i* is 1. We want to do this such that for any two pairs in a matching, say {*a, b*} and {*c*,*d*}, there is a measurement setting such that {*a*, *b*} is measured in the {*XY*,*YX*, *ZZ*} basis and {*c*,*d*} is measured in the {*ZI*,*IZ*} basis.

This can be done with a binary partitioning scheme. Explicitly, label each pair in the matching with a binary string *x* ∈ {0,1}^{*m*-1}. For *j* ∈ {1, ... , *m* - 1}, we have two measurement settings: one where the pair with label *x* is measured in the {*XY*, *YX*, *ZZ*} basis if *xⱼ* = 0 and in the {*ZI*, *IZ*} basis if *xⱼ* = 1; and another where we do the opposite - measure in the {*XY*, *YX*, *ZZ*} basis if *xⱼ* = 1 and in the {*ZI*,*IZ*} basis if *xⱼ* = 0. If we have two pairs with labels *x* and *y*, then if *x* and *y* are distinct, they must differ in at least one bit, and so there is a measurement setting where they are measured in different bases. This is equivalent to, for each matching providing a set of log₂(M'/2) measurement settings such that the v^{th} measurement setting measures the u^{th} pair in the matching in: the {XY, YX, ZZ} basis if the v^{th} bit of the binary representation of u is 0; or the {ZI, IZ} basis if the v^{th} bit of the binary representation of u is 1. This procedure allows the identification of a special class of operators, those which operate non-trivially on only three qubits. Having identified these operators, the non-crossing criteria described herein are applied in the usual manner discussed elsewhere to identify a set of matchings which covers all pairs in the set. It is important to perform the measurements of each pair in a couplet of pairs in a different basis. This is achieved in the procedure set out above by selecting a measurement basis for each pair in each matching (referred to generally as a measurement setting) in a logical and consistent manner. Note that the actual ordering of the pairs within a matching is arbitrary - so long as the same ordering is used throughout, the above method will result in a logical route to stepping through each pair in turn. Likewise, the use of a binary representation for the pair number to determine the measurement basis results in each pair in a couplet of pairs being measured in a different measurement basis, thereby satisfying the conditions above. The ordering of the measurement settings is also arbitrary so long as the same ordering is used throughout. The skilled person will note that there are other protocols which achieve this in different, but equivalent ways. For example, the protocol above would work equally well by swapping 0 and 1 (so that the {XY, YX, ZZ} basis is used if the v^{th} bit of the binary representation of u is 1; or the {ZI, IZ} basis is used if the v^{th} bit of the binary representation of u is 0).

### Circuit compiler design

Here we outline the structure of the compiling algorithm which we use to compute the circuit depth of applying either TDS or VQE to a given material. The compiler computes the circuit depth of a trotter step in TDS, or an ansatz layer in VQE, both of which have similar structure.

Precompilation step: The precompiling step prepares the requisite data for the circuit compiler. It takes as input a fermionic Hamiltonian, a specification of which modes are associated with which sites, and a specification of the spatial layout of the sites. Depending on user specification, the compiler builds the appropriately sized 3d or 2d hybrid encoding and assigns modes in the encoding so that all modes on the same site are grouped together on the same Jordan-Wigner chain in the hybrid encoding, or if one is representing a 3d system on a 2d encoding, it collapses one axis down into a single site before assigning modes.

Compiling step: In the compiling step the terms in the Hamiltonian are organized into a sequence of groupings via a series of decomposition subroutines. Starting with a single grouping, every decomposition subroutine decomposes each grouping into smaller groupings. Next the terms are translated into Pauli operators and undergo a final decomposition. Finally the circuit cost for each grouping is totalled.

The decomposition subroutines are:
Common sites: Groups together terms which act on exactly the same set of sites.

Mutually commuting terms: Groups together mutually commuting terms, optimizing for the smallest number of groups using a pre-supplied graph colouring algorithm.

Swap network: Finds an optimized sequence of fermionic swaps on the modes of the encoding. Groups together any terms with sufficiently low weight Pauli representation at every step of the swap sequence. Optionally all modes are put back in their original location at the end of each sequence of swaps. See subsection 6.1 for more details.

Disjoint qubits: Groups together terms which act on different sets of qubits, optimizing for the smallest number of groups using a pre-supplied graph colouring algorithm.

The choice of ordering and inclusion of particular decomposition routines will depend on a number of considerations:
The decomposition into common sites is primarily useful when compiling the unit cell of a translationally invariant system (see subsection 6.2) and may be excluded otherwise.

The inclusion of a decomposition into mutually commuting terms is important for evaluating the Trotter error of a particular TDS circuit and may be excluded when considering VQE. Depending on the importance of minimizing Trotter error, it may appear either before or after the swap network routine.

Generally it is useful to include the swap network routine, but in some cases the density of long range terms may be sufficiently small that the swap network does not improve circuit depths, so it may be worth checking the compilation with and without the swap network.

### 6.1 Swap network implementation details

With respect to circuit depth, when implementing an interaction between two modes, it is preferable that they are adjacent within the fermionic encoding, as outlined in Section 5.3. By swapping modes through the graph of encoding, we can ensure that modes which share an interaction will become adjacent at some point, in almost all cases. Swap operations can be performed efficiently on modes which are adjacent, i.e. share an edge in the encoding (see Section 5.3), and swaps can be performed in parallel provided no mode is involved in more than one swap. We therefore design a swap network, i.e. a series of swap layers interspersed with layers of interactions which are facilitated by the intermediate mode configurations.

We seek the swap network that enables implementation of all terms using the smallest number of swap layers. After each swap layer we implement all allowed terms (those on adjacent modes) before proceeding to the next swap layer. This does not necessarily give the lowest quantum circuit depth overall but is a reasonable heuristic. The compiler is equipped with two routines for determining the swap layers required to facilitate interactions, which we now introduce.

Similarly to the other threads discussed in some detail above, the use of swap networks allows the simulation to optimise for circuit depth, and thereby to address some of the shortcomings of current and near term quantum computation systems. This in turn allows the simulations to be carried out at all, or indeed in greater detail or to greater accuracy than is possible in taking a simple, naïve approach.

In general it may be helpful to think of the concept of swap networks used herein as being a method of compiling a quantum circuit comprising swap layers and interaction layers for performing quantum operations on a quantum information processor. The method starts by receiving a graph comprising vertices and edges, the vertices of the graph being associated with quantum systems wherein the edges define a set of available vertex swaps. Next, a plurality of interactions of the quantum systems are received, each interaction comprising at least two vertices of the graph. A swap layer for the quantum circuit is determined by:
(i) determining a graph cost of the graph, wherein the graph cost is based on distances between vertices in the interactions on the graph;
(ii) determining, for each available vertex swap, a swapped graph cost of a swapped graph, wherein the swapped graph is the graph modified according to the each available vertex swap;
(iii) adding a best available vertex swap to the swap layer, the best available vertex swap being the available vertex swap associated with a lowest swapped graph cost; and
(iv) updating the graph according to the best available vertex swap and updating the set of available vertex swaps to remove available vertex swaps containing vertices in the best available vertex swap.

The step of determining a swap layer in this way is iterated until at least one of the following is true:
there are no more available vertex swaps; and/or
the swapped graph costs associated with the available vertex swaps are not less than the swapped graph cost of the updated graph following the last vertex swap added to the swap layer; and/or
none of the available swaps reduce the distance of at least one interaction.

An interaction layer is determined for the quantum circuit by adding interactions whose vertices can be split into one or more pairs of vertices that are connected by edges after the swap layer to the interaction layer. A layer of quantum swap operations is added to the quantum circuit for swapping qubits or swapping labels of qubits of the quantum information processor corresponding to the vertex swaps in the swap layer. Finally a subsequent layer of quantum operations is added to the quantum circuit for interacting qubits of the quantum information processor corresponding to the interactions in the interaction layer. Advantageously, constructing a swap layer in this way may allow as many interactions as possible to be performed on the subsequent interaction layer and may reduce the overall number of swaps required thereby to allow for a quantum circuit of low depth to be compiled. The distances may be examples of internal distance functions of the interactions. The graph cost may be an example of a total distance function, based on the internal distance functions. In an example, the graph costs may be an *Lₚ* norm.

In order to identify the list of interactions to be received, the method can include, for example, determining a vertex list of all vertices involved in the plurality of interactions and determining a Steiner tree, wherein the Steiner tree is a tree in the graph that connects the vertices in the vertex list. If it is determined that the Steiner tree has fewer vertices than the graph the graph is replaced by the Steiner tree. This may further improve the efficiency of the method by reducing the size of the graph for which the graph cost is determined.

Preferably, the vertices are associated with modes of a fermionic Hamiltonian and the plurality of interactions are interactions of modes in the fermionic Hamiltonian, preferably wherein the edges of the graph connect fermionic modes which are efficiently swappable by a fermionic swap operation. Advantageously, this allows building up of a quantum circuit to simulate the interaction in a fermionic Hamiltonian which has a low depth, this may allow such simulations to be performed, for example, on small and/or noisy quantum information processors or to improve the performance of such simulations on quantum information processors in general.

The graph may be an encoding graph of a fermion to qubit encoding. Encoding fermionic operators as qubit operators may lead to qubit operators which are high weight, by swapping modes of an encoding graph of a fermion-to-qubit encoding such that modes which are interacting are made closer (or, for example, adjacent) in the encoding graph the weight of the qubit operators for simulating that interaction may be reduced.

Preferably, the vertices are associated with qubits and the edges connect qubits which are swappable by a qubit swap operation or a fermionic swap operation. Advantageously, the method may be used to reduce the circuit depth for simulating fermionic interactions on qubits and/or for simulating or compiling any quantum circuit with or to another quantum circuit comprising swap layers and interaction layers.

The steps of determining a swap layer, iterating, and determining an interaction layer can advantageously be iterated to determine a plurality of interleaved swap layers and interaction layers until each of the plurality of interactions has been included in at least one interaction layer. This may provide for a quantum circuit to simulate all of the interactions which is optimised for low circuit depth.

The quantum operations may be native quantum operations of the quantum information processor. This may be particularly advantageous in providing a circuit to simulate the interactions which can be implemented directly on the quantum information processor. As an example, the quantum operations may be two-qubit quantum gates. This may provide a simple circuit suitable for implementing on a wide range of quantum information processors. As a further example, the quantum swap operations can include fermionic swap operations and/or qubit swap operations. This may be particularly suitable for simulating fermionic quantum systems on qubits. As yet a further example of the relationship between the graph and the quantum information processor, the vertices of the graph can be associated with qubits of the quantum information processor, and the edges of the graph can be associated with qubits of the quantum information processor which are configured to interact with each other. This may be particularly advantageous for compiling a quantum circuit suitable for implementing on a particular layout of qubits in a quantum information processor. The end result of this is of course that the method can be performed as a quantum circuit on a quantum information processor. Advantageously, the low depth quantum circuit compiled by the above method may then provide faster and more reliable results of calculation run on the quantum information processor.

### 6.1.1 Chain swap network

The chain swap network is applicable in the case where all relevant modes are arranged linearly, i.e. in a JW string of length n modes/qubits. Swap layers iteratively perform swaps on even-indexed edges, followed by odd-indexed edges. This mechanism ensures that every mode-pair is achieved within n swap layers.

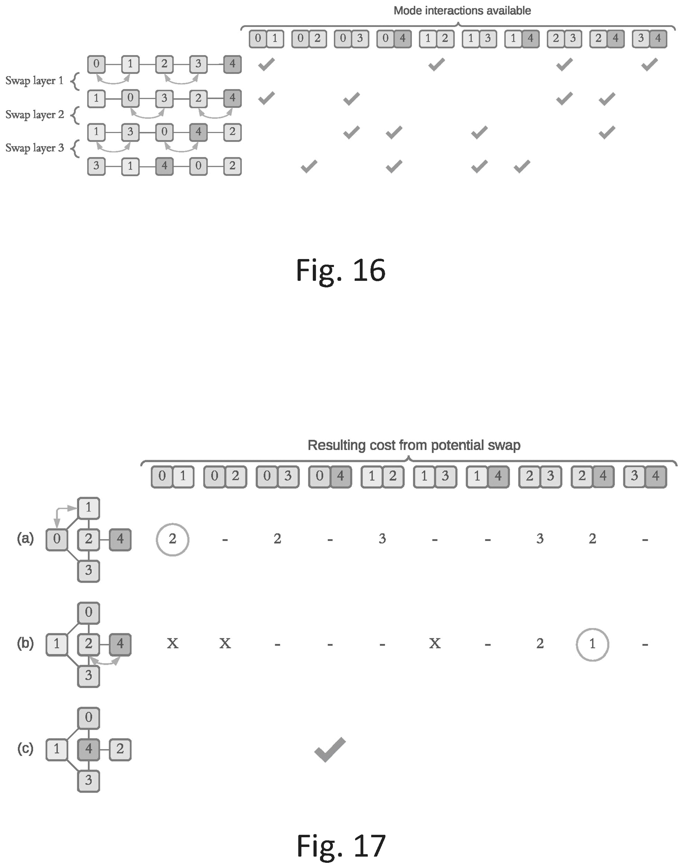

For example, the swap network in Fig. 16 aims to implement a set of all-to-all interactions, where each mode interacts with every other mode in the system. This can be described as the set of layers in Table 4, which must then be translated into circuit gates.

Figure 16 shows an example swap network for a five-mode linear system where we require all-to-all interactions, i.e. that each mode should be adjacent to all other modes at least once. The chain on the left represents the configuration of the system, and the table on the right indicates whether a given interaction (between a pair of modes) is available at that configuration. Ticks indicate that the pair is available on the present configuration; by the end of the third layer, all required interactions have been implementable at least once. Swap layers on the mode configuration (left) are ordered: the first layer swaps even-indexed edges, i.e. the 0*^{th}* and 2*^{nd}* of the chain; the second layer odd-indexed edges (1^{st}, 3^{rd}, etc.), in a repeating pattern until either (i) all required interactions have been implemented or (ii) the chain has completely reversed after n swap layers;

**Table 4: Circuit layers corresponding to the swap network in Fig. 16.**

| Layer type | Modes to interact/swap |
|---|---|
| Interaction | (0,1), (1,2), (2,3), (3,4) |
| Swap | (0,1), (2,3) |
| Interaction | (0,3), (2,4) |
| Swap | (0,3), (2,4) |
| Interaction | (0,4), (1,3) |
| Swap | (1,3), (0,4) |
| Interaction | (0,2), (1,4) |

### 6.1.2 Distance minimising swap network

For a more general mode graph, we do not have such a straightforward strategy. Moreover, the chain swap network does not guarantee that quartic terms will all be facilitated: quartic terms consist of four Majorana indices, and therefore require that two mode-pairs are adjacent simultaneously, even if the two pairs are distant from each other. The chain swap network ensures that every pair will be adjacent, but not that every set of two pairs will be simultaneously adjacent, as required. Instead, given a set of required interactions, we devise a swap network which seeks to find the optimal set of swaps at each swap layer, in order to facilitate as many interactions as possible on the subsequent interaction layer. That is, a mode graph G can be evaluated with respect to the set of interaction terms required, T, $D \left(G\right) = {\sum }_{t ∈ T} {\left[d{\left(t\left|G\right.\right)}^{p}\right]}^{\frac{1}{p}} ,$ (112) where *d*(*t*) is the cost of a single term *t*, and *p >* 0 is a hyperparameter (see Section 5.3). The cost of each term is evaluated as the graph distance between the involved modes, $d \left(t\left|G\right.\right) = G . path _ length \left(t\right) .$ (113)

Then, a proposed swap s will result in a modified graph G(s), yielding $d \left(t\left|G, s\right.\right) = G \left(s\right) . path _ length \left(t\right) .$ (114)

The edgelist of G - labelled *ε* - defines the set of permitted swaps for G; we can evaluate the cost of each available swap independently, giving {*D*(*G*(*s*))}_{*s*∈*ε*}. The edge which results in the lowest cost, *s*₁, is added to the present swap layer, 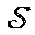 = {*s*₁}. However, we can perform numerous swaps in the same layer, provided no mode is involved in more than one swap operation. We therefore evaluate the effect of swapping the remaining edges, i.e. compute the set {*D*(*G*(*s*))}_{*s*∈*ε\s*₁}, and add the best swap from this set to 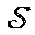 . This process is repeated until there are no remaining available swaps, or it is no longer advantageous to include more swaps, i.e. the cost of the proposed graph would increase from any available swap. Fig. 17 shows the calculation of *d*(*t*|*G, s*) for each *s* ∈ *ε* for a small graph which requires a single interaction 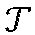 = {(0,4)}. Here the swap network is seeking an interaction between modes (0,4), and finds that a single swap layer 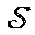 = {(0,1), (2,4)} facilitates the sole required interaction. Figure 17 shows a distance minimising swap network; determining the set of swaps to apply in order to facilitate an interaction between modes (0,4) on a small mode graph. Mode graphs, left, represent modes as squares, lines between modes indicate an edge, i.e. a connection in the fermionic encoding. In the initial configuration (a), the shortest distance between modes (0,4) is 3, e.g. via edges {(0,1), (1,2), (2,4)}. Iteratively, (i) available swaps *s* ∈ *ε* are evaluated i.e. *d*(*t*|*G*(*s*) is computed ∀*s* ∈ *ε*.; (ii) the swap yielding the lowest cost within the round (circled) is added to the swap layer 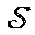 . Dashes indicate that such an edge is not present in the graph; an X indicates that the corresponding mode in the proposed swap has already been used and is therefore unavailable. (c), *G*( 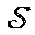 ), the mode graph after the swap layer has been applied, showing the interaction *t* = (0,4) is available.

This graph swap network mechanism can be varied by defining an alternative total distance function, Eq. (112), or internal distance function, Eq. (133). Furthermore, in realistic use cases (see e.g. Section 7.1), the distance function will be based on Majorana indices, of which two reside on each mode. Such terms are implementable if both Majoranas are on the same mode, or their corresponding modes are adjacent. Such considerations can be built into the design of *d*(*t*|*G*). In particular, the swap network can be designed to handle quartic interaction terms by specifying an internal distance function which is minimised when the graph permits the implementation of the quartic term.

The distances may be computed based on a minimum path length between vertices, more preferably between pairs of vertices within interactions. Advantageously, the distances are thus closely related to the number of swaps required to make vertices in an interaction adjacent and so minimising a graph cost based on such distances is a good heuristic for minimising the number of swaps which need be implemented. The graph cost may then be based on a sum of a function of the distances, preferably the sum being of the distances of all the interactions. This may provide a graph cost which characterises the overall cost of performing the interactions on the graph.

Optionally, distances are computed based on a function of indices of the quantum systems associated with the vertices, preferably wherein the indices are Majorana indices. This is particularly useful in realistic use cases of simulating quantum systems, such as systems where two indices reside on each (fermionic) mode associated with the vertices of the graph. The distance may then account for quartic interactions of modes consisting, for example, of four Majorana indices which may require, for example that two mode-pairs are adjacent simultaneously for an interaction to be performed.

At least one of the plurality of interactions may be a quadratic interaction comprising a pair of vertices of the graph. Quadratic interactions are common features of interacting quantum systems, so this provides a method applicable to a wide range of systems which may be usefully simulated. In addition, the method is applicable to situations in which at least one of the plurality of interactions is a quartic interaction comprising a pair of vertices of the graph. Quartic interactions are common features of interacting quantum systems, so this provides a method applicable to a wide range of systems which may be usefully simulated. In the present example, the quartic interaction comprises four vertices and may be split into two pairs of vertices. Quartic interactions may be dealt with simply in an analogous way to quadratic interactions.

In such an example, the distance of a quartic interaction is based on the sum of the distance of each pair of vertices. This simple method of calculating the distance of a quartic interaction may be sufficient in many cases, and thus quadratic and quartic interactions may be dealt with in a simple and similar way. The distance between certain pairs in the quartic interaction may not be important in many useful scenarios, for example, fermionic quartic interactions encoded as qubit operations on qubits may benefit from strings of Pauli operators cancelling which obviates the need to consider the distance between certain pairs.

### 6.1.3 Compose swap network

The method described in Section 6.1.2 ought to produce a shorter swap network overall, and is applicable for all mode graphs including chains, however it is much more expensive to compute, owing to the requirement to evaluate the cost of all remaining *t* ∈ 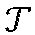 for each *s* ∈ *ε*, on potentially large graphs *G*. It is therefore preferable to rely on the chain swap network of Section 6.1.1 when possible, which guarantees that all quadratic (and some quartic) interactions will be implementable within n swap layers (for a chain of length *n* modes). The cases in which the chain method do not suffice are:
- the mode graph of the system is not linear;
- some quartic interactions are not made implementable, i.e. when multiple edges are required to implement a single term, the chain method does not guarantee they will occur concurrently.

In practice then, we compose a swap network from one or both of the above methods, depending on the required interactions and graph structure. Also note that the swap networks we wish to construct will likely exist in a larger mode graph than they require. For instance, the entire system under study contains N modes across several sites, but we are interested in simulating only a subset of *n* < *N* modes, such as the interactions contained on single physical site. In these cases, it is sensible first to reduce to the minimal graph which supports the *n* modes we require to implement the interactions in 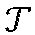 . This can be done by finding the Steiner tree which holds all the modes involved in any interaction: this can include some modes which are not involved directly, but which reside in between modes of interest. We can compute the swap network only on this subgraph, but in practice the swaps will be applied in the space of the full graph.

We employ the following strategy for a given mode graph G and interactions 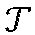 :
1) Isolate the modes, *M* which are involved in any interaction in 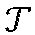
   a) Construct a Steiner tree consisting only of 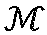 , i.e. a subgraph of *G*;
   b) If the Steiner tree has fewer modes than *G*, it will require fewer swaps to traverse, so replace *G* with the Steiner tree.
2) If *G* is semi-Eulerian, i.e. there is a path containing each edge once (equivalently, a chain encompassing all modes)
   a) Form a new graph from the Euler path edges of *G*, and replace *G*;
   b) Run the chain swap network on *G* for 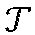 , resulting in the swap network *S*₁;
   c) Throughout *S*₁, the terms 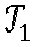 ⊆ 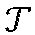 were implementable
      i) If the initial 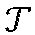 contains only quadratic terms, 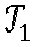 = 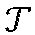 , and the swap network composition can terminate;
      ii) In general, some terms remain, so replace T with 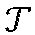 *\* 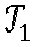 .
3) Again, attempt to reduce *G* to a Steiner tree based on the required interactions 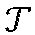
4) Pass *G,* 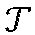 to the distance-minimising swap network to produce *S*₂.
5) Combine the generated swap networks into a single swap network, *S* ← {*S*₁,*S*₂}.
6) Restore the initial mode graph *G*
   a) After all swap and interaction layers of *S* are implemented, reverse all swaps in *S* so that the final configuration matches the initial configuration.

In other words, the method, which is unclaimed, may further comprise determining whether the graph is semi-Eulerian, and if the graph is semi-Eulerian proceeding to determine further swap and interaction layers of the quantum circuit. This is achieved by:
(i) forming a new graph from the Euler path edges of the graph;
(ii) adding vertex swaps corresponding to odd-indexed edges of the new graph to an odd swap layer;
(iii) adding the ones of the plurality of interactions whose vertices are connected by edges after the swap layer to an odd interaction layer;
(iv) updating the new graph according to the further vertex swaps of step added above (step (ii);
(iv) adding vertex swaps corresponding to even-indexed edges of the new graph to an even swap layer;
(v) adding the ones of the plurality of interactions whose vertices are connected by edges after the swap layer to an even interaction layer;
(vi) updating the new graph according to the vertex swaps of step (v);
(vii) iterating steps (ii)-(vi) until each of the plurality of interactions has been included in at least one odd or even interaction layer;

Further layers of quantum swap operations are added to the quantum circuit for swapping qubits or swapping labels of qubits of the quantum information processor corresponding to the vertex swaps in the odd and even swap layers. These further layers of quantum swap operations are interleaved in the quantum circuit with further layers of quantum operations for interacting qubits of the quantum information processor corresponding to the interactions in the corresponding odd and even interaction layers. Advantageously, this may permit a chain swap network protocol to be used where appropriate to reduce the computational cost of determining the swap and interaction layers.

A development of this is that the plurality of interactions comprise quadratic interactions involving two vertices of the graph and quartic interactions involving four vertices of the graph. These are approached in this method by, prior to the step in which a quantum swap layer is determined (in the general method described herein), determining whether the graph is semi-Eulerian. If the graph is semi-Eulerian swap and interaction layers are determined for the quantum circuit by:
(i) forming a new graph from the Euler path edges of the graph;
(ii) adding vertex swaps corresponding to odd-indexed edges of the new graph to an odd swap layer;
(iii) adding the ones of the plurality of interactions whose vertices are connected by edges after the odd swap layer to an odd interaction layer;
(iv) updating the graph according to the vertex swaps of step(ii);
(v) adding vertex swaps corresponding to even-indexed edges of the new graph to an even swap layer;
(vi) adding the ones of the plurality of interactions whose vertices are connected by edges after the swap layer to an even interaction layer;
(vii) updating the graph according to the vertex swaps of step (v);
(viii) iterating steps (ii)-(vii) until each of the plurality of quadratic interactions has been included in at least one odd or even interaction layer,

The step in which a quantum swap layer is determined follows this process for those quartic interactions not present in at least one odd or even interaction layer. Layers of quantum swap operations are added to the quantum circuit for swapping qubits or swapping labels of qubits of the quantum information processor corresponding to the vertex swaps in the odd and even swap layers. Finally, the layers of quantum swap operations are interleaved in the quantum circuit with layers of quantum operations for interacting qubits of the quantum information processor corresponding to the interactions in the corresponding odd and even interaction layers. Advantageously, the chain swap network may thus be used to determine the swap and interactions layers to perform the quadratic interactions at low computation cost, while the quartic interactions may be handled by consideration of the graph cost, thereby to determine with lower computational cost a set of interleaved swap and interactions layers for compiling the quantum circuit.

### 6.2 Compiling unit cells of translationally invariant Hamiltonians

Although the compiler is capable of handling a fully populated multi-site material Hamiltonian, it is usually more efficient to perform the compilation on a unit cell and its neighbours. This introduces a few subtleties which are worth explaining.

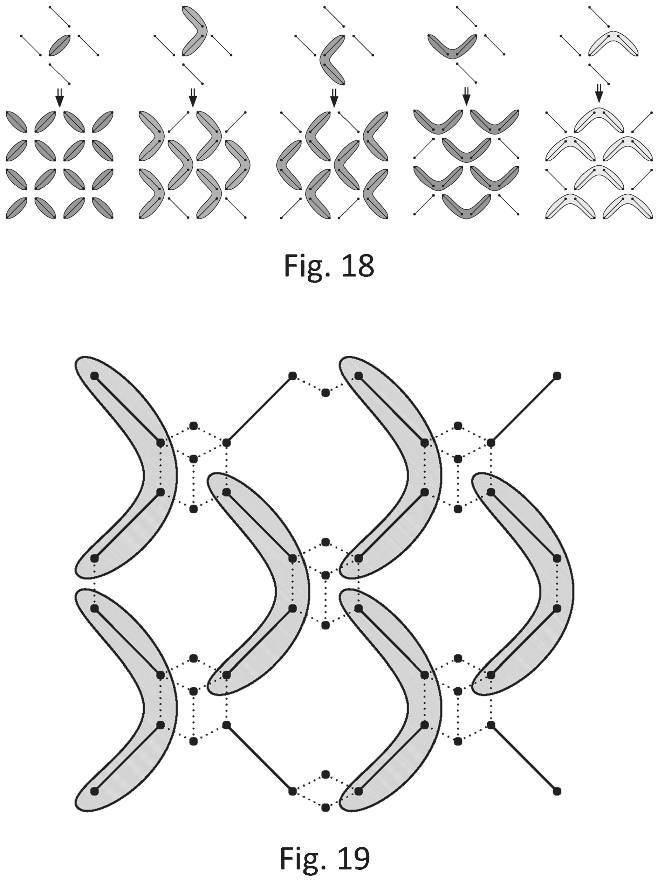

The premise behind performing the compilation on a unit cell is that a judicious choice of groupings of terms onto common sites will yield a circuit depth that reflects the circuit depth of the fully populated system. This holds when each grouping of terms onto common sites can by uniformly tiled onto the full system in a parallelizable fashion, so that the circuit depth of each grouping is the circuit depth of the full tiling. This is illustrated in figures 18 and 19 for nearest neighbour terms. These Figures show respectively an illustration of how the common site decomposition on a unit cell translates to the full system for nearest neighbour interactions on the 2D hybrid encoding; and an illustration of how the common site decomposition on a unit cell translates to the full system for nearest neighbour interactions on the 3D hybrid encoding. Here the tiling is done in the orthographic plane.

Because the fermionic encoding does not have exactly the same translational symmetry as the material some care needs to be taken in how the groupings are ultimately tiled, and how the modes are ordered in the encoding. In particular, the choice of tiling needs to ensure that two parallelized groupings are not using the same ancillary face qubits at the same time. Furthermore, the modes in the encoding of the unit cell need to be ordered in such a way that their relative positions within a grouping are consistent throughout the tiling of that grouping.

In the case of next nearest neighbour terms, one can always consider a larger cell which includes more sites, however again care should be taken in the precompiling stage to remove any terms that would be double counted under tiling, to ensure that mode ordering is consistent, and to ensure the terms are grouped in a way that can be uniformly tiled.

### 6.3 Circuit costing

After applying the decomposition routines each grouping is given a circuit cost according to the terms it contains. The depth cost of an individual grouping is given be the largest circuit depth of an individual term in the group, which may depend on the gate set available in hardware. Assuming access to arbitrary two qubit rotations yields a depth of 2log₂(*w*) - 1 where *w* is the weight of the Pauli term. Summing this cost over all groups gives the total depth.

### 6.4 Trotter error

In the case of TDS we may also compute an estimate on the Trotter error. This is done using an upper bound estimate given by: $ϵ \leq {C}_{1} \frac{{Tδ}^{p}}{\left(p+1\right) !} + {C}_{2} \frac{T}{δ} I \left(N\right)$ (115) ${C}_{1} : = {npB}_{p}^{2} {Λ}^{p - 1} N {\left({MH}_{p}-{B}_{p}+{B}_{p}\left(\frac{N}{Λ}\right)\right)}^{p - 1}$ (116) ${C}_{2} : = {nB}_{p}^{2} {\left({MH}_{p}Λ\right)}^{p} N \left({\left({S}_{p}M\right)}^{2}-{S}_{p}M\right)$ (117)

Where: *T* is the target time; *p* is the Trotter order; N is the largest number of terms in a given mutually commuting grouping; *M* is the number of mutually commuting groupings; *Λ* is a bound on the largest norm of any mutually commuting grouping; *δ* is the Trotter step size; *n* is the maximum number of terms from a single grouping that do not commute with a given term in another grouping, and *Bₚ*, *Hₚ*, *Sₚ* and *I* are defined in the original work. This equation may be inverted to compute the required circuit depth of a TDS simulation for a given target time *T* and Trotter error *ε*.

### Results

In this section we present several results about the circuit costs of different materials. To familiarise the reader with our approach, in section 7.1 we walk through a system simple enough that all the components can be understood easily. This system consists of a 2D lattice of unit cells with 2 orbitals per unit cell. We include this discussion as an aid to grasp the algorithmic concepts developed in this work. This simple system allows one to detach the analysis of the circuit complexity from the physics, but it does not answer satisfactorily how to generate a Hamiltonian instance related to a particular material. In section 7.2 we describe in full detail the whole construction developed in this work, from a DFT analysis all the way to the circuit decomposition, for the strongly correlated material Strontium Vanadate SrVO₃. The results for different materials and assumptions are shown in section 7.3.

### 7.1 Circuit analysis of a simple example

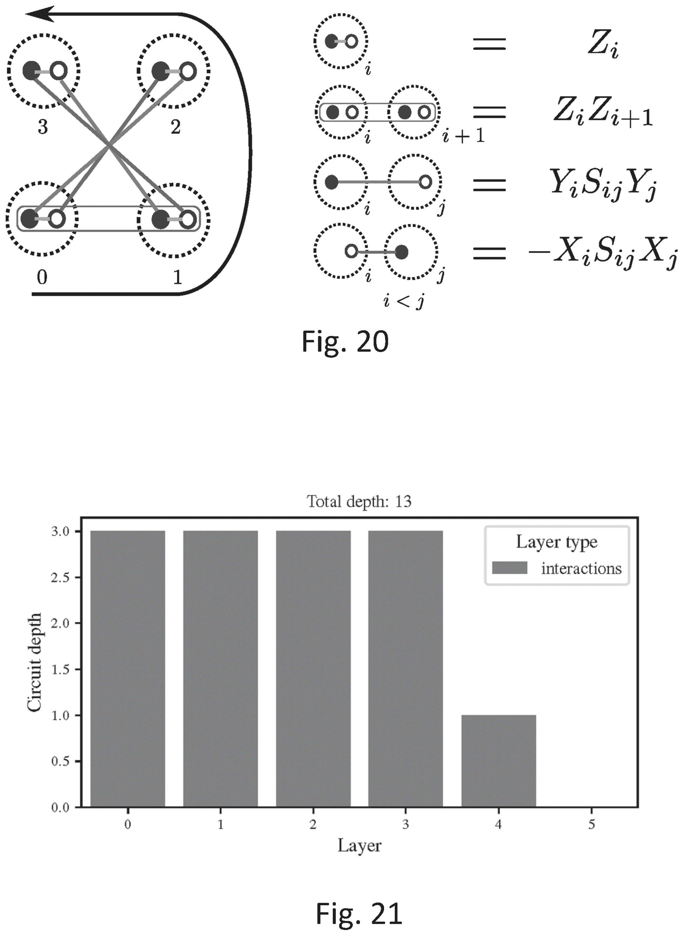

Here we discuss a simple model of immobile impurity levels coupled to mobile electrons (the bath) in 2D. The unit cell contains one impurity level and one bath mode, and the bath modes can hop to neighbouring sites (see Figure 20).

Figure 20 shows (left) connectivity graph of a single unit cell. Each mode is represented by dashed circles. Filled (open) circles inside represent the even (odd) Majorana at that site. Quadratic interactions are depicted as lines between Majorana modes. The quartic interaction is represented by the rectangle containing four modes. The black arrow denotes the JW ordering. (Right) Four different types of interactions in the Hamiltonian and their map into Pauli monomials. *Sᵢⱼ* is a string of Pauli Z between i and*j*.

We first concentrate on a single unit cell, where we discuss in detail the procedure of mapping a fermionic model into a Pauli Hamiltonian, and the use of the JW string and swap networks. In section 7.1.3 we discuss tiling this unit cell across the lattice, and the advantages of the hybrid encoding. Each disconnected unit cell is easily diagonalisable on a classical computer.

### 7.1.1 One unit cell

A system with a single unit cell consists of two electrons, one being the impurity electron of spin *σ* (created by ${d}_{σ}^{†}$) and the other being the bath electron of spin *σ* (created by ${c}_{σ}^{†}$). This corresponds to the simple Hamiltonian in complex fermion form ${H}_{cell} = {\sum }_{σ = ↑ , ↓} \left({ϵ}_{σ}{c}_{σ}^{†}{c}_{σ}+Δ\left({c}_{σ}^{†}{d}_{σ}+{d}_{σ}^{†}{c}_{σ}\right)+{ϵ}_{σ}^{d}{d}_{σ}^{†}{d}_{σ}\right) + U {c}_{↑}^{†} {c}_{↓}^{†} {c}_{↓} {c}_{↑} ,$ (118) where *ε_{σ}*, ${ϵ}_{σ}^{d}$, *Δ* and *U* are real parameters. This system can be represented by 4 modes. Relabelling (*d*_{↑}, *d*_{↓}, *c*_{↑}, *c*_{↓}) = (*a*₀, *a*₁, *a*₂, *a*₃) and introducing the Majorana fermion representation *aⱼ* = (*γ*_{2*j*} + *iγ*_{2*j+*1})/2 the Hamiltonian (up to an overall constant) Eq. (18) becomes ${H}_{cell} = {\sum }_{j = 0}^{3} i \frac{{ϵ}_{j}}{2} {γ}_{2 j} {γ}_{2 j + 1} + {\sum }_{j = 0 , 1} i \frac{Δ}{2} \left({γ}_{2 j}{γ}_{2 j + 5}-{γ}_{2 j + 1}{γ}_{2 j + 4}\right) - \frac{U}{4} {γ}_{0} {γ}_{1} {γ}_{2} {γ}_{3} ,$ (119) with parameters $\left({ϵ}_{0}, {ϵ}_{1}, {ϵ}_{2}, {ϵ}_{3}\right) = \left({ϵ}_{↑}^{d}+\frac{U}{2},{ϵ}_{↓}^{d}+\frac{U}{2},{ϵ}_{↑},{ϵ}_{↓}\right)$. The particular connectivity structure in this example maps straightforwardly to the fermionic encoding given by a single JW line. As we will see, in more complex situations, this encoding can be hybridized with the compact encoding to generate a more efficient mapping, i.e. one that reduces the operator weight in term of the Pauli operators.

In what follows, we will use the JW string depicted in Fig. 20. The reader may note that for the particular connectivity graph of this problem, a better JW ordering would be produced by relabelling 2→0 and 0→2, as there all the interactions would be between nearest neighbours. We intentionally choose the ordering shown above, as it motivates the introduction of larger weight operators, which are needed in generic situations where the connectivity graph does not consist of a simple line.

In this system we have two types of fundamental interactions: *γ*₂*ₘγ*_{2*l+*1} or *γ*_{2*m+*1}*γ*_{2*l*} (with m ≤ *l*). The quartic interaction is a product of these fundamental ones. Interaction terms like *γ*₂*ᵢγ*_{2*j*} or *γ*_{2*i*-1}*γ*_{2*j*+1} are not present because the original Hamiltonian is hermitian and invariant under complex conjugation 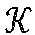 (i.e., 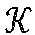 *H* 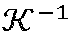 *= H* and 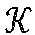 *i* 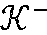 1 = -*i*, where *i* is the imaginary number). This antiunitary symmetry acts like usual time reversal symmetry on spinless fermions. We find ${Ka}_{j} {K}^{- 1} = {a}_{j} \to {Kγ}_{2 j} {K}^{- 1} = {γ}_{2 j} , {Kγ}_{2 j + 1} {K}^{- 1} = - {γ}_{2 j + 1} .$ (120)

The Hermitian quadratic operators have the form *iγₐγ_{b}*. For these terms to be invariant under 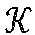 , they have to contain an odd number of majoranas with odd index, according to Eq. (120). This shows the role of symmetry in restricting the type of operators present in the Hamiltonian. Interactions are uniquely specified by the structure of the Majorana monomial and can be mapped directly to the Pauli algebra under the JW encoding. There are three possibilities; *iγ*₂*ₘγ*_{2*m+*1} is mapped into *Zₘ*, *-iγ*₂*ₘγ*_{2*l+*1} to *YₘSₘₗYₗ*, and *-iγ*_{2*m*-1}*γ*_{2*l*} to *XₘSₘₗXₗ* (with *m* ≤ *l*). Here *Sᵢⱼ =* Π*_{i<k<j}Zₖ* is a string of Pauli Zs between the mode *i* + 1 and the mode *j* - 1. For further details see Section 5.

The Hamiltonian *H*_{cell} in the Pauli representation is ${H}_{cell} = {\sum }_{j = 0}^{3} \frac{{ϵ}_{j}}{2} {Z}_{j} - {\sum }_{j = 0 , 1} \frac{Δ}{2} \left({Y}_{j}{S}_{j , j + 2}{Y}_{j + 2}+{X}_{j}{S}_{j , j + 2}{X}_{j + 2}\right) + \frac{U}{4} {Z}_{0} {Z}_{1} .$ (121)

For quantum algorithms like VQE or TDS, we need to create the unitary *U = e*^{*iθH*_{cell}}, where *θ* is some parameter. In a quantum computer, the accessible operations form a fixed subset of gates, from which any possible unitary on the whole system can be approximated. Usually these consist of single and two qubit gates. Using the Suzuki-Trotter formula, we can approximate the unitary *U* by a series of simpler unitaries that can be implemented in the quantum computer. This decomposition has to be done in a way that minimizes the depth of the circuit constructed.

We wish to know the circuit depth of the unitary generated by the Pauli string for a given interaction. Our circuit depth will reflect the number of layers of 2-qubit gates required to run a given algorithm for the specified Hamiltonian. If only a single qubit is involved, i.e. the weight is *w* = 1, we only require one-qubit gates, which we assume access to at no cost. In general, for Pauli strings with weight w, we saw above that such a circuit can be performed with cost $c \left(w\right) = 2 \left⌈{log}_{2} w\right⌉ - 1$ (122) sublayers of 2-qubit gates. However, we cannot concurrently perform operations which involve the same qubits: that is, we must separate the interactions into lists, each of which contains terms with disjoint support. We therefore separate the terms in Eq. (121) into a number of layers, where each layer can consist of several terms that can be implemented simultaneously. The cost of any layer is the depth, *d*, of the most expensive term in that layer. The overall depth is therefore $d = {\sum }_{l} {max}_{w} {\left\{c\left(w\right)\right\}}_{l}$ (123)

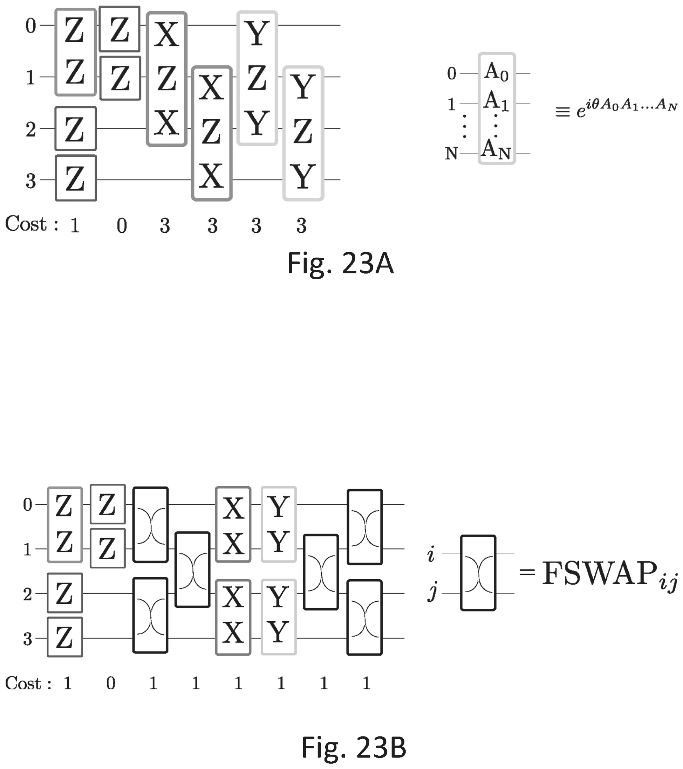

We break down the set of interactions in Eq. (121) into layers and show the resulting circuit depth of each layer in Fig. 23A. The overall circuit depth for implementing all the terms of this Hamiltonian once is therefore *d* = 13 rounds of 2-qubit gates.

### 7.1.2 Fermionic swap networks

Many terms in the circuit in Fig. 23A have cost 3, since their Pauli string crosses a third qubit, whereas monomials involving only adjacent qubits have depth 1. It may therefore be advantageous to rearrange the modes before implementing interactions: fermionic swap operations can be used to move modes through the graph. Although they also incur a cost (as described in Section 6.1), here we assume they have uniform cost *d* = 1 . However, if they successfully enable low-weight operations for all other interactions, they can prove beneficial overall.

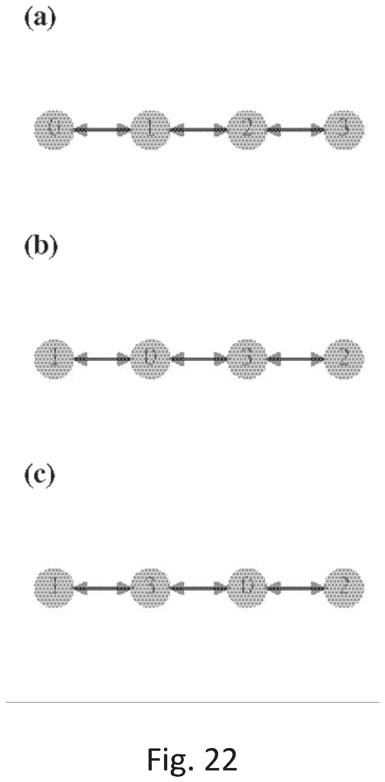

The initial mode configuration can allow implementation of the terms {*Z*₀*Z*₁,*Zᵢ*}, but as above, we must split these into sublayers whose constituents have disjoint support, i.e. we create two layers {*Z*₀*Z*₁,*Z*₂,*Z*₃}; {*Z*₀,*Z*₁}. Thereafter, we run two swap layers. Denoting the swap between modes *a* and *b* as FSWAP*_{ab}*, we apply the layers {FSWAP₀₁,FSWAP₂₃}; [FSWAP₁₂}, which maps the original JW ordering (0,1,2,3) into the ordering (1,3,0,2). This process is illustrated in Figure 22, in which a swap network rearranging the mode configurations is shown. In part (a) a starting configuration is shown, part (b) shows the configuration after swaps {(0,1), (2,3)}, and part (c) shows the configuration after a further swap (0,3), to achieve the desired output.

In this new ordering the operators *γ*₀*γ*₅, *γ*₂*γ*₇, *γ*₁*γ*₄, and *γ*₃*γ*₆ all represent interactions between majoranas in nearest neighbor modes and as such, they do not have strings of Z operators attached. This allows (after splitting into disjoint-support sublayers) the interactions

{*Y*₀*Y*₂, *Y*₁*Y*₃}; {*X*₀*X*₂,*X*₁*X*₃}.

We also must reverse the swaps in order to recover the starting mode configuration, so after the final interaction layer, there are two further swap layers. These terms and their associated cost are depicted in fig. 23B, which shows (Left) a circuit implementing the unitaries generated by all the terms in the Hamiltonian. In this approach we use fermionic swap networks to decompose high weight operators into two qubit gates. If the cost of doing fermionic swap gates is small, this strategy can be advantageous. Further gains can be achieved by merging two qubit gates, which is preferred in a cost model where any 2-qubit gate has the same cost d = 1. (Right) Diagram for the fermionic-swap gate. We include the cost of the swap layers since it contributes to the overall circuit depth. The total depth using this method is then *d* = 7, verifying that using swap networks is justified here as this decreases the circuit depth, compared with the default method which gave *d* = 13 in Fig. 23A, which shows (left) a circuit decomposition to implement all the terms of the Hamiltonian Eq. (121) once. (Right) Circuit notation used. Each box in the left represents a unitary. The parameters *θ* used may vary depending on the particular algorithm.

### 7.1.3 Many unit cells

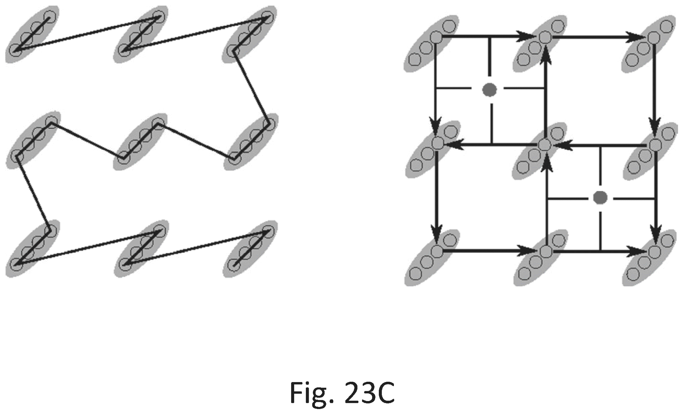

We are now in a position to discuss the whole model of impurity levels coupled to mobile electrons. We consider the Hamiltonian $H = {\sum }_{k ∈ cells} {H}_{cell}^{\left(k\right)} + t {\sum }_{\left〈i, j\right〉} \left({c}_{i , σ}^{†}{c}_{j , σ}+{c}_{j , σ}^{†}{c}_{i , σ}\right)$ where ${H}_{cell}^{\left(k\right)}$ is the Hamiltonian of cell *k*, and the second sum represents the intercell coupling, produced by the hopping of bath modes between nearest neighbour cells in 2D. Following the procedure outlined above has some drawbacks in this larger system. Although the fermions hop locally in the 2D system, after including a JW ordering that maps the system into a line, some local interactions become very non-local. See for example Figure 23C, which shows (Left) JW ordering across a 2D lattice. Neighbouring unit cells (ellipses) can end very far away in the JW chain, leading to a large operator weight for physical processes that happen locally. (Right) Using extra ancilla qubits (circles at centre of square grids in the right hand figure), the hybrid encoding can generate low weight Pauli operators for the intracell processes. For the intercell processes, JW ordering and swap networks can implement all the required terms; This ultimately increases the circuit depth by a factor that depends on the whole size of the system.

To keep the operator weight of Pauli strings independent of the system size, we exploit the hybrid encoding introduced in Section 4. In this encoding, we add extra ancilla qubits that allow to represent the fermion algebra with low weight Pauli operators. The price to pay is that more qubits are needed. In materials the interactions (understood generically as electron-electron interactions or hopping) between the modes in the unit cell are expected to be more dense than the intercell interactions, meaning that inside the cell the swap protocol could be very beneficial to bring modes together (as discussed in Section 6.1). The hybrid encoding can minimise the use of the extra qubits by using them to implement the interactions between different cells, which are expected to be sparse.

### 7.2 Full-stack analysis: strontium vanadate

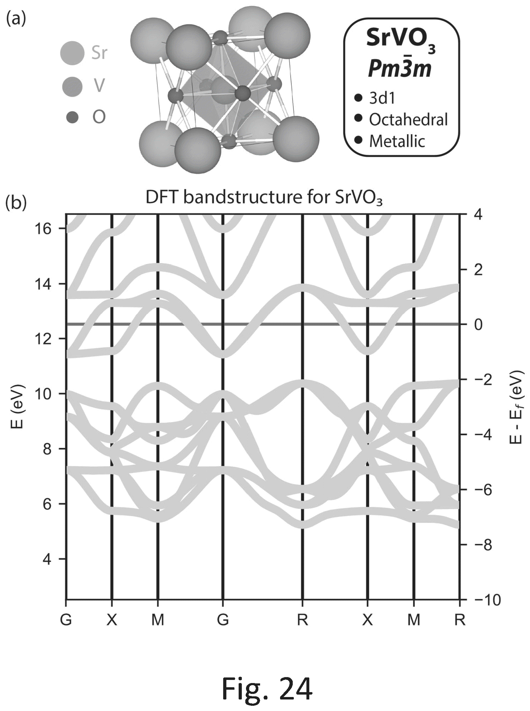

In this section we present a full-stack analysis of the transition metal perovskite oxide SrVO₃. Figure 24(a) shows the structural unit cell of SrVO₃ with space group Pm3m, 3d1 nominal electronic valence configuration, and octahedral coordination environment. In this configuration, the compound is a metal. Materials in the perovskite oxide family with chemical formula ABO3 form basic components of the Earth's mantle, are central to many technological applications and pioneer current research efforts to design bespoke materials with multifunctional properties. They can exhibit a wide range of physical properties, spanning insulating, semiconducting and metallic characteristics as well as a superconducting, correlated, multiferroic and ferroelectric phases, and highly controllable transitions between them. For example, synthetic perovskite oxides are used in batteries, qubits, spin switches, high temperature superconductors, solar cells, semiconductors, multiferroics and ferroelectrics. In particular, SrVO₃ has been used as components in both the anode and cathode of Li-ion batteries. Their widespread usage is a result of the remarkable stability of the ABO3 chemical structure and allows for highly tuneable functional properties as a result of being able to control and couple the many electronic degrees of freedom, such as orbital, charge and lattice in a large phase space of chemical species.

We start by presenting the DFT results and their subsequent mapping to maximally localised Wannier functions, followed by the computation of the single-body and two-body matrix elements that parametrise the periodic complex fermionic Hamiltonian, and end with a discussion on the calculation of the quantum complexity for this Hamiltonian by calculating its circuit depth.

We first describe the results as obtained from DFT and the subsequent Wannierisation procedure. All DFT calculations were performed using the plane wave code Quantum Espresso, version 6.8, together with the GGA-PBE exchange correlation functional. Atomic cores were treated using the standard solid-state pseudopotentials (ONCVPSP) library with valence configuration Sr(4s4p4d5s5s5p), V(3s3p3d4s), and O(2s2p). The plane-wave basis representation is used for the wavefunctions, with a cut-off of *E*_{cut} *=* 400 eV. We use a 4 × 4 × 4 Γ-centered k-point mesh in the Brillouin zone for k-point sampling. Structural degrees of freedom are relaxed until all forces are smaller than 1 mRyd/a.u. Subsequently, the generation of maximally localised Wannier functions is performed with Wannier90.

Figure 24(b) presents the electronic band structure of SrVO₃ along the high symmetry Brillouin zone path. The Fermi level is indicated by the horizontal red line, which intersects a triply degenerate band with bandwidth ~2 eV and is thus representative of a metallic system. We also note the set of 9 nondegenerate bands in the range [-8, -2] eV (where *E_{f}* is zeroed).

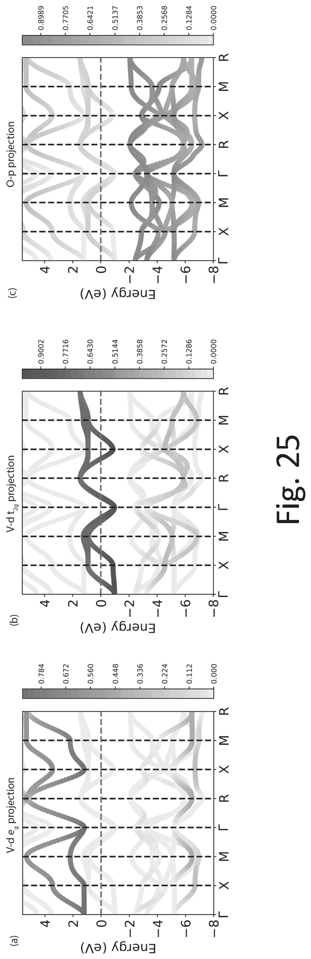

To identify the orbital character of the electronic structure in Fig. 24 we perform a fatbands projection analysis according to Eq. (45) using d-orbital projections for the Vanadium ions and p-orbital projections for the Oxygen ions. These results are presented in Fig. 25, where we see that the states of the triply degenerate band at the Fermi level belong to the d-states of Vanadium. Furthermore, we see from Fig. 25(a) and (b) that the full d-manifold of states splits into the e*_{g}* and t_{2*g*} crystal field subgroups of the overall full d group, where the t_{2*g*} states are responsible for the conduction electrons. Moreover, the states below the Fermi-level in the range [-8, -2] eV are primarily O-p type. Knowing the orbital character of the electronic states is a crucial step in determining the necessary initial projectors used for generating MLWFs, which affects the numerical stability of the Wannierisation procedure. Additionally, it is an essential component in determining the physical interpretation of these electronic states, required for comparing against experimental results.

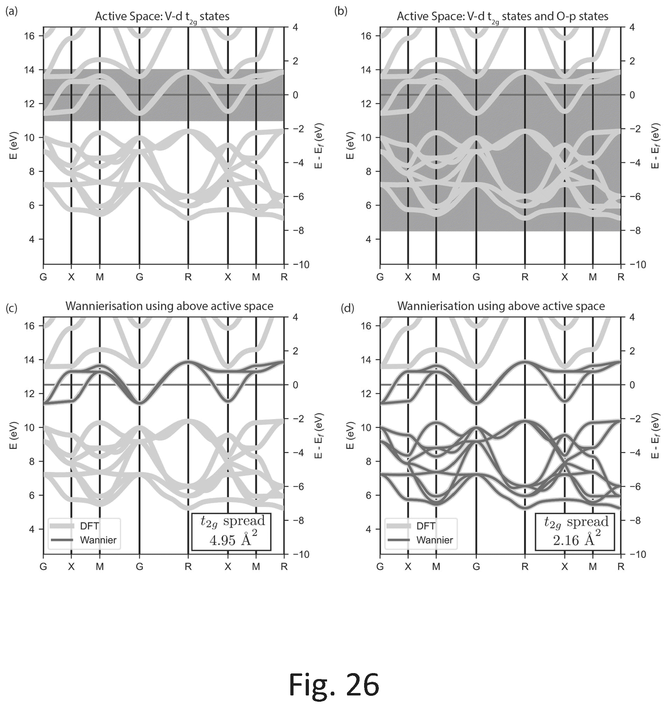

Knowing the orbital character of the electronic bands near the Fermi level allows us to reliably choose regions of the band structure over which an active space can be chosen, that can be used to parametrise fermionic Hamiltonians. The upper panel of Fig. 26 presents two possible choices of active space for SrVO₃. In Fig. 26(a) we illustrate the active space containing the 3 V-t_{2*g*} orbitals, while in Fig. 26(b) we show the active space that contains the 3 V-t_{2*g*} and 9 O-p orbitals. Accounting for spin degeneracy, the t_{2*g*} active space contains 6 modes, while the t_{2*g*}+p active space contains 24 modes. Choosing a larger window over which the Wannier functions can be generated allows for their maximal localisation, but at the price of including additional modes, while Wannierising over smaller active spaces results a larger total spread of the resultant Wannier functions. In Fig. 26(c)-(d) we show the corresponding MLWFs, highlighting a larger total spread for the t_{2*g*} active space compared to the t_{2*g*}+p active space. The resultant Fourier Transform of the maximally localised Wannier functions highlighting spreads for the t_{2*g*} levels of (c) 4.95Å and (d) 2.16Å.

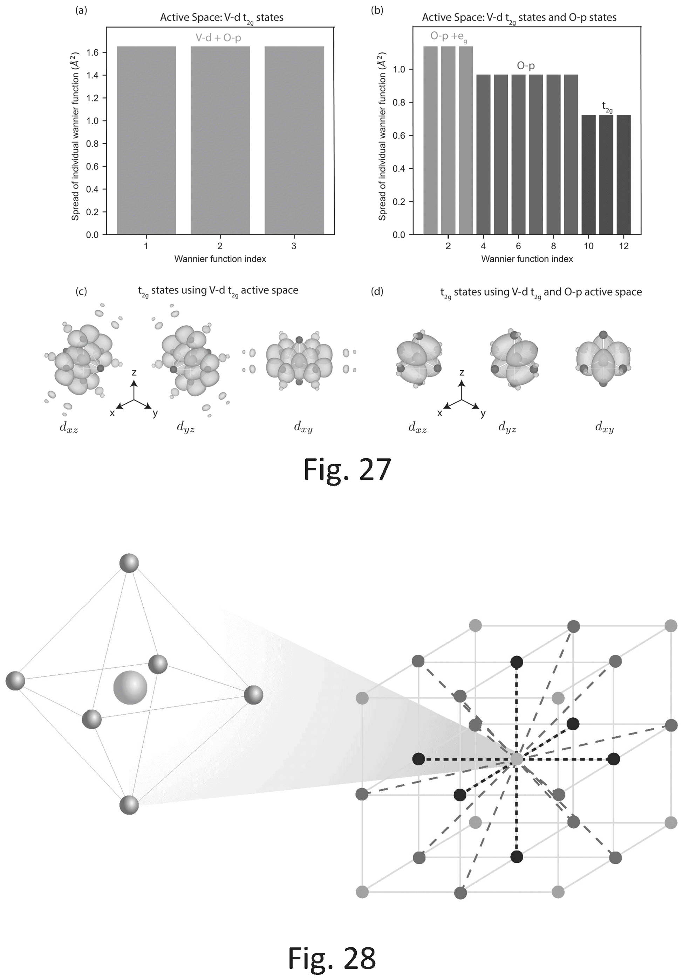

Furthermore, Fig. 27(a)-(b) illustrates the individual spreads of the generated Wannier functions. Specifically, (a) shows the spread of each Wannier function for the subspaces consisting of 3 V-d t_{2*g*} states and (b) 3 V-d t_{2*g*} states with an additional 9 O-p states, as illustrated in Fig. 26. By Wannierising over the large energy window, we see that the smallest spreads belong to the V-t_{2*g*} orbitals and increase for the O-p states. Fig. 27(c)-(d) presents the corresponding t_{2*g*} Wannier functions on a real space grid, highlighting the clear differences in their locality depending on the size of the active space considered. See for example the corresponding MLWFs for the (c) small and (d) large subspaces, which use an isosurface value of 0.325; Using the t_{2*g*} active space only results in Wannier functions which extend into neighbour and nearest-neighbour cells, thus resulting in significant overlap with the Wannier functions in those cells. Whereas the larger active space results in localised Wannier functions that do not extend into neighbouring cells.

### 7.2.1 Computation of hopping matrix and Coulomb tensor coefficients

Once selected the active space and built the corresponding MLWFs, we can proceed with the calculation of the hopping matrix and Coulomb coefficients entering Eq. (23). As explained in Section 3.4, in the usual DFT procedure the ionic potential *Ũ*(**r**) for the electrons in the active space is replaced by the effective Kohn-Sham potential *Ũ*_{eff}(**r**). The latter contains the entangled contributions arising from the original ionic potential, the screening effects of core electrons, and part of the electron-electron interactions. Therefore, it is convenient to rewrite the hopping matrix and Coulomb tensor for the electrons in the active space as $T {\left(R\right)}_{mn} = \int d r {W}_{m , σ}^{R} \left(r\right) \left[-\frac{{ℏ}^{2} {∇}^{2}}{2 m}+{{U}^{˜}}_{eff}\left(r\right)\right] {W}_{n , σ}^{0} \left(r\right) ,$ (124a) ${{V}^{˜}}_{slmn}^{\left(0, {R}_{2}, {R}_{3}, {R}_{4}\right)} = \frac{1}{2} \int dr \int dr ′ {W}_{s , σ}^{0} \left(r\right) {W}_{l , σ ′}^{{R}_{2}} \left(r′\right) V \left(\left|r-r′\right|\right) {W}_{m , σ ′}^{{R}_{3}} \left(r′\right) {W}_{n , σ}^{{R}_{4}} \left(r\right) .$ (124b) where we exploited the translational invariance of the lattice to set **R** = **R**₁ - **R**₂ in the hopping matrix and **R**₁ = **0** in the Coulomb tensor. Here, *V*(|**r** - **r**'|) represents the part of the electron-electron Coulomb potential which is not captured by the DFT procedure. One simple way to mitigate potential double-counting issues is to use a screened interaction potential of the form *V*(|**r** - **r**'|) = *qₑ*/(4*πε*₀)*e*^{-*µ*|**r**-**r**'|}/|**r** - **r'**|, with *µ* a material dependent inverse screening length. For the sake of simplicity, in what follows we will set *µ* = 0 and note that this corresponds to evaluate an upper bound for the quantum circuit complexities.

All the steps to calculate the hopping matrix and Coulomb tensor coefficients are described in detail in the "Hamiltonian coefficients pipeline" section above. Here, we will give a brief description of the most important steps and analyse the outputs in the case of SrVO₃. Importantly, we will work within the following assumptions:
we will consider non-magnetic materials only, so that the two spin sectors are degenerate,
hopping matrix and Coulomb tensor coefficients involving unit cells which are not nearest neighbours of order *n*₀ and *n*ᵢₙₜ, respectively, are negligible,
hopping matrix and Coulomb tensor coefficients whose absolute value is smaller than a pre-determined threshold are negligible.

As a consequence of the second assumption, we do not need to evaluate the hopping matrix and the Coulomb tensor over the whole lattice but we can focus on a minimal set of lattice sites identified by the nearest neighbours of order *n*, with n being the largest between *n*₀ and *n*ᵢₙₜ, from which all the other coefficients can be obtained by exploiting the translational invariance. We will name such a minimal set of lattice sites a motif of order *n*. For the case of SrVO₃, the latter is shown in Fig. 28.

Figure 28 shows the unit cell and the motif of order *n* = 1 for SrVO₃. In the unit cell, on the left, only the atoms whose orbitals contribute significantly to the bands in the selected active space are shown. For SrVO₃ it consists of a central V atom surrounded by 6 O atoms (see Fig. 24). The full SrVO₃ lattice, a portion of which is shown on the right hand side, can be obtained by translating the active unit cell by multiple integers of the lattice vectors. The motif corresponding to nearest neighbour order *n* = 1 is formed by the central cell and the 6 nearest neighbours (black dots), while the nearest neighbour order *n* = 2 motif is obtained by including also the 12 next-to-nearest neighbours;

Hopping Matrix. The hopping matrix ***T***(**R**) can be directly obtained from the output of the wannierization procedure described in the previous section. For instance, the hopping of electrons from the central unit cell at **R** = **0** to the cells at **R** = **R**₁ and R = **R**₁ + **R**₂ (with **R** = *n*₁**R**₁ + *n*₂**R**₂ + *n*₃**R**₃; see Eq. (11)) is described by the two matrices ${T}_{\left(100\right)} \left[eV\right] = \left(\begin{matrix}- 0.26 & 0 & 0 \\ 0 & - 0.26 & 0 \\ 0 & 0 & - 0.26\end{matrix}\right) {T}_{\left(110\right)} \left[eV\right] = \left(\begin{matrix}0.006 & 0.009 & 0 \\ 0.009 & 0.006 & 0 \\ 0 & 0 & - 0.082\end{matrix}\right) ,$ (125) respectively. Here, we introduced the notation *T*_{(*n*₁*n*₂*n*₃)} ≡ *T*(**R**)*.* Noting that in SrVO₃ we have |**R**₁| < |**R**₂|, the equation above also shows that, in general, the values of the hopping matrix coefficients decrease as function of the distance between the cells and therefore a nearest neighbour approximation is well justified.

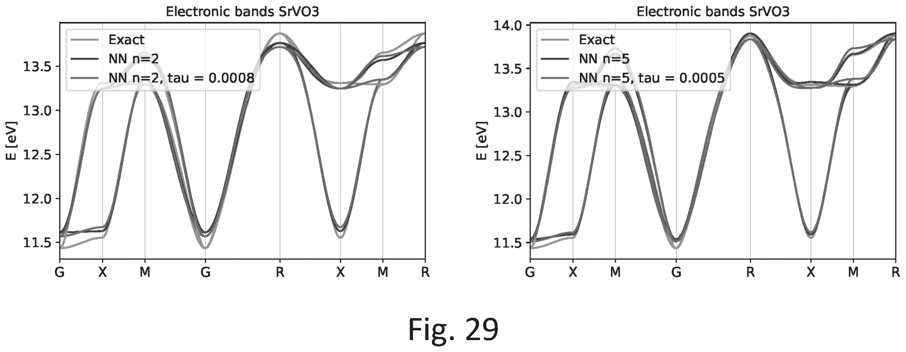

In the next step we determine the nearest neighbour order *n*₀ to be used in the truncation of the hopping matrix. We do that by comparing the band structure obtained from the truncated hopping matrix with the original one. By denoting with ${N}_{0}^{{n}_{0}}$ the set of lattice vectors corresponding to unit cells which are nearest neighbors of order *n*₀ with respect to the central one, the truncated band structure is given by the eigenvalues of the matrices $h {\left(k\right)}_{mn} = {\sum }_{R ∈ {N}_{0}^{{n}_{0}}} {e}^{i k ⋅ R} T {\left(R\right)}_{mn}$ (126) for values of **k** along the high symmetry path in the Brillouin zone. For SrVO₃, the bands obtained from this approximation are shown in Fig. 29 for (a) *n*₀ = 2 and (b) *n*₀ = 5 . To obtain a consistent approximation, we then filter the truncated hopping matrix by setting to zero all the coefficients *T*(***R***)*ₘₙ* such that |*T*(**R**)*ₘₙ*| < *t*₀, with threshold *t*₀ = *τ*₀ × max|*T*(**R**)*ₘₙ*|, $∀ R ∉ {N}_{0}^{{n}_{0}}$. For SrVO₃ this further step results in the red bands in Fig. 29 which represent a good approximation of the truncated bands for both values of *n*₀. In this case, as shown in Table 5, the two approximations combined allow us to reduce the number of non-zero hopping matrix coefficients *T*(**R**)*ₘₙ* from 81 to 33 for *n*₀ = 2 and from 296 to 93 for *n*₀ = 5.

Figure 29 shows a comparison between the exact electronic band structure of SrVO₃, *εᵢ*(**k**) (grey lines), the one obtained by truncating the hopping matrix *T*(**R**)*ₘₙ* to a motif of order *n*₀, ${ε}_{i}^{{n}_{0}} \left(k\right)$, and the one obtained after filtering the truncated hopping matrix according to the threshold *t*₀, ${{ε}^{˜}}_{i}^{{n}_{0}} \left(k\right)$, for (left) *n*₀ = 2 and (right) *n*₀ = 5. Here, *τ*₀ is determined in such a way that *t*₀ coincides with the largest absolute value of *T*(**R**)*ₘₙ* , $∀ R ∉ {N}_{0}^{{n}_{0}}$;

**Table 5: Number of total, non-zero, and filtered hopping matrix coefficients for SrVO₃ for different values of the nearest neighbour order, respectively.**

| *n*₀ | All | Non-zero | \|*T*(**R**)*ₘₙ*\| > *t*₀ |
|---|---|---|---|
| 1 | 63 | 21 | 15 |
| 2 | 171 | 81 | 33 |
| 5 | 513 | 296 | 93 |

In order to determine *n*₀ in a systematic way, we look for the minimum value of *n*₀ such that the distance between the exact bands *εᵢ*(**k**) and the ones obtained from the filtered truncated hopping matrix, *ε̃*^{(*n*₀)}(**k**), is smaller than a pre-determined tolerance. In our case, we choose to measure the distance between the bands according to $d \left({n}_{0}\right) = {max}_{i , k} \left|{ε}_{i}\left(k\right)-{{ε}^{˜}}_{i}^{\left({n}_{0}\right)}\left(k\right)\right| ,$ (127) where i is the band index and **k** is sampled from a regular grid on the Brillouin zone. In what follows, for each material we will use values of *n*₀ such that *d*(*n*₀) ≤ 0.5 eV.

### Coulomb Tensor.

To obtain the Coulomb tensor coefficients ${{V}^{˜}}_{slmn}^{\left(0, {R}_{2}, {R}_{3}, {R}_{4}\right)}$ one has to compute numerically the 6 -dimensional integral in Eq. (124b) using the Wannier functions generated by Wannier90 for each value of the orbital and site indices. For a standard material this would result in an extremely large number of integrals and, consequently, long computational time. However, as a consequence of the localization properties of the MLWFs, only a few of these integrals are important in determining the properties of a material. Therefore, as stated above, we only consider coefficients involving sites which are reciprocal nearest neighbours of order *n*ᵢₙₜ and set to zero all the others. In general, we denote the set of sites which are nearest neighbours of order n with respect to sites at **R**₁, **R**₂, ... as ${N}_{\left\{{R}_{1},{R}_{2},…\right\}}^{n}$. As described elsewhere, the symmetry properties of the Coulomb tensor given in Eq. (51) make it possible to identify a minimal set of unique site configurations from which all of the other can be reconstructed at a later stage. For instance, since ${{V}^{˜}}_{slmn}^{\left(0,0, R, 0\right)} = {{V}^{˜}}_{lsnm}^{\left(0, 0,0, R\right)}$ it is sufficient to compute only coefficients with site structure (**0**, **0**, **0, R**)**.** For each unique site configuration, exploiting again Eq. (51), we then determine all the non-equivalent orbital configurations required to obtain the full Coulomb tensor. For instance, for a coefficient with site structure (**0**, **0**, **R**, **R**) the orbital configurations (*s*, *l*, *m*, *n*) and (*l*, *s*, *n*, *m*) are equivalent and, therefore, ${{V}^{˜}}_{slmn}^{\left(0,0, R, R\right)} = {{V}^{˜}}_{lsnm}^{\left(0,0, R, R\right)}$. This procedure based just on fundamental symmetry considerations allows us to reduce the number of integrals to be computed for SrVO₃ from 5913 to 831 for *n*ᵢₙₜ = 1 and from 101169 to 3180 for *n*ᵢₙₜ = 2. See the "Unique" column of Table 6.

As stated above, we assume that the physical properties of the system are determined exclusively by those Coulomb tensor coefficients with the largest absolute value. We fix a threshold as ${t}_{int} = {τ}_{int} \times max \left|{{V}^{˜}}_{slmn}^{\left(0, {R}_{2}, {R}_{3}, {R}_{4}\right)}\right|$ , with ${R}_{2} , {R}_{3} , {R}_{4} ∈ {N}_{\left\{0, {R}_{2}, {R}_{3}, {R}_{4}\right\}}^{{n}_{int}}$ and *s*, *l*, *m*, *n* ∈ {1, ... , *M*} and set to zero all the coefficients such that $\left|{{V}^{˜}}_{slmn}^{\left(0, {R}_{2}, {R}_{3}, {R}_{4}\right)}\right| < {t}_{int}$. This can be conveniently combined with the Cauchy-Schwarz inequality introduced in Section 3.1.2 to further reduce the number of integrals which one needs to compute. Indeed, Eq. (8) implies that ${\left|{{V}^{˜}}_{slmn}^{\left({R}_{1}, {R}_{2}, {R}_{3}, {R}_{4}\right)}\right|}^{2} \leq {{V}^{˜}}_{ssnn}^{\left({R}_{1}, {R}_{1}, {R}_{4}, {R}_{4}\right)} {{V}^{˜}}_{mmll}^{\left({R}_{3}, {R}_{3}, {R}_{2}, {R}_{2}\right)} .$ (128)

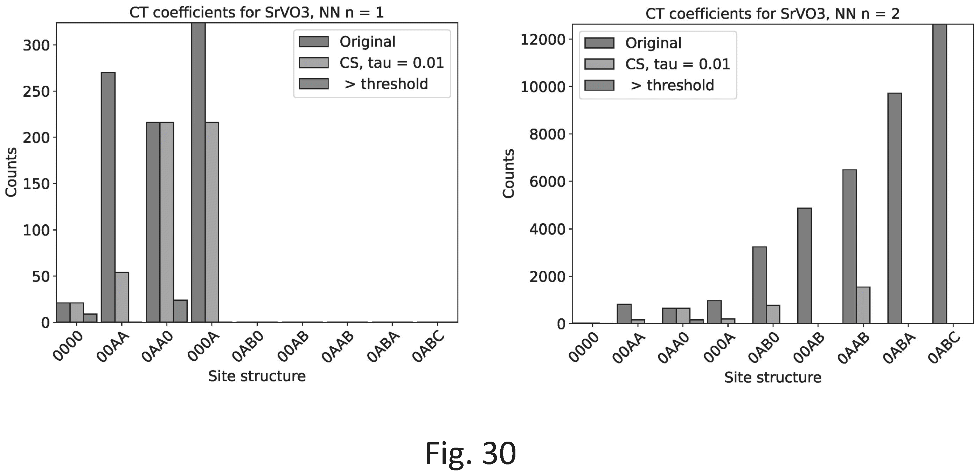

Hence, if all the coefficients with site structure (**0**, **0**, R, R) are known one can a priori exclude from the computation all those coefficients with site structure (**R**₁, **R**₂, **R**₃, **R**₄) and orbital configuration (*s*,*l*, *m*, *n*) such that ${{V}^{˜}}_{ssnn}^{\left({R}_{1}, {R}_{1}, {R}_{4}, {R}_{4}\right)} {{V}^{˜}}_{mmll}^{\left({R}_{3}, {R}_{3}, {R}_{2}, {R}_{2}\right)} < {t}_{int}$, since Eq. (128) guarantees that they are going to be smaller than the threshold. The advantages deriving by using this procedure are shown in Fig. 30 for SrVO₃ with *τ*ᵢₙₜ = 0.01, *n*ᵢₙₜ = 1 and *n*ᵢₙₜ = 2. In this case, the Cauchy-Schwarz inequality allows us to reduce the number of integrals to be computed from a total of 831 to 444 (of which 60 have absolute value greater than the threshold *t*ᵢₙₜ) for *n*ᵢₙₜ = 1 and from 39387 to 3180 (of which 168 have absolute value greater than the threshold *t*ᵢₙₜ) for *n*ᵢₙₜ = 2. See the "Unique+Cauchy-Schwarz" and the last columns in Table 6. Figure 30 shows the number of unique Coulomb tensor coefficients with site structure *ABCD* (i.e., ${{V}^{˜}}_{slmn}^{\left({R}_{A}, {R}_{B}, {R}_{C}, {R}_{D}\right)}$ with *s*, *l*, *m*, *n* being unique orbital configurations for the site structure (**R***_{A},* **R***_{B},* **R***_{C}*, **R***_{D}*)) to be computed under various conditions specifically without (leftmost bars) and with (central bars) the Cauchy-Schwarz inequality for (left) *n*ᵢₙₜ = 1 and (right) *n*ᵢₙₜ = 2. In both panels, the rightmost bars denote the number of coefficients per site structure whose absolute value is actually greater than the threshold, with τᵢₙₜ = 0.01;
Finally, to obtain a consistent approximation for the Coulomb tensor, we look for the element of the tensor with *n*ᵢₙₜ = 2 not included in the tensor with *n*ᵢₙₜ = 1 (i.e., ${{V}^{˜}}_{slmn}^{\left({R}_{1}, {R}_{2}, {R}_{3}, {R}_{4}\right)}$ such that at least one of **R**₁, **R**₂, **R**₃, **R**₄ is not in ${N}_{\left\{0, {R}_{2}, {R}_{3}, {R}_{4}\right\}}^{{n}_{int}}$ with the largest absolute value and we use the latter as a new threshold ${t}_{int}^{′}$ to filter once more the Coulomb tensor with *n*ᵢₙₜ = 1.

**Table 6: Number of Coulomb tensor coefficients to be computed for SrVO₃ using the various procedures described in the main text: total number of coefficients, number of unique coefficients, number of unique coefficients after employing the Cauchy-Schwarz inequality, and number of unique coefficients above the threshold.**

| *n*ᵢₙₜ | All | Unique | Unique+Cauchy-Schwarz | Unique $\left\|{V}_{slmn}^{\left({R}_{1}, {R}_{2}, {R}_{3}, {R}_{4}\right)}\right\| > {t}_{int}$ |
|---|---|---|---|---|
| 1 | 5913 | 831 | 444 | 60 |
| 2 | 101169 | 39387 | 3180 | 168 |

Single-index Hamiltonian. Starting from the hopping matrix and the Coulomb tensor evaluated as described above it is straightforward to construct the motif Hamiltonian in the Wannier basis (see Eq. (29)). To proceed, it is convenient to make the (trivial) spin structure of the coefficients explicit and to build a completely anti-symmetric Hamiltonian. This can be done by introducing the following spinful Hopping matrix and Coulomb tensor coefficients, ${T}_{\left({R}_{1}, m, {σ}_{1}\right) , \left({R}_{2}, n, {σ}_{2}\right)} = \left\{\begin{matrix}T {\left({R}_{1}-{R}_{2}\right)}_{mn} & if {σ}_{1} = {σ}_{2} \\ 0 & otherwise\end{matrix}\right.$ (129) and ${V}_{\left({R}_{1}, s, {σ}_{1}\right) , \left({R}_{2}, l, {σ}_{2}\right) , \left({R}_{3}, m, {σ}_{3}\right) , \left({R}_{4}, n, {σ}_{4}\right)} = \left\{\begin{matrix}{{V}^{˜}}_{slmn}^{s , \left({R}_{1}, {R}_{2}, {R}_{3}, {R}_{4}\right)} & if {σ}_{1} = {σ}_{2} = {σ}_{3} = {σ}_{4} \\ \frac{1}{2} {{V}^{˜}}_{slmn}^{\left({R}_{1}, {R}_{2}, {R}_{3}, {R}_{4}\right)} & if {σ}_{1} = {σ}_{3} and {σ}_{2} = {σ}_{4} \left({σ}_{1}\neq {σ}_{2}\right) \\ - \frac{1}{2} {{V}^{˜}}_{lsmn}^{\left({R}_{2}, {R}_{1}, {R}_{3}, {R}_{4}\right)} & if {σ}_{1} = {σ}_{4} and {σ}_{2} = {σ}_{3} \left({σ}_{1}\neq {σ}_{2}\right) \\ 0 & otherwise\end{matrix}\right. ,$ (130) respectively. Here, ${{V}^{˜}}_{slmn}^{s , \left({R}_{1}, {R}_{2}, {R}_{3}, {R}_{4}\right)} = \left[{{V}^{˜}}_{slmn}^{\left({R}_{1}, {R}_{2}, {R}_{3}, {R}_{4}\right)}-{{V}^{˜}}_{lsmn}^{\left({R}_{2}, {R}_{1}, {R}_{3}, {R}_{4}\right)}\right] / 2$. Each site-mode-spin triplet (**R***ᵢ*, *i, σᵢ*) is then mapped to a single-index *αᵢ* ∈ {1,...,2*MN*}, with *M* the number of orbitals per motif and $N = max \left(dim\left({N}_{0}^{{n}_{0}}\right),dim\left({N}_{0}^{{n}_{int}}\right)\right)$ , so that the motif Hamiltonian can be written as $H = {\sum }_{α , β} {t}_{αβ} {w}_{α}^{†} {w}_{β} + {\sum }_{α , β , γ , δ} {V}_{αβγδ} {w}_{α}^{†} {w}_{β}^{†} {w}_{γ} {w}_{δ} .$ (131)

Finally, we introduce the Majorana basis operators as *w_{α}* = (*γ_{α}* + *iγ̅_{α}*)/2 and ${w}_{α}^{†} = \left({γ}_{α}-i{\overline{γ}}_{α}\right) / 2$, in terms of which the full Hamiltonian reads ${H}_{M} = {\sum }_{k ∈ {\left\{0, 1\right\}}^{4 MN}} {α}_{k} {\prod }_{j} {γ}_{j}^{{k}_{2 j}} {\overline{γ}}_{j}^{{k}_{2 j + 1}} , \left|k\right| ∈ \left\{2, 4\right\} .$ (132)

This can then be used as an input for the VQE and TDS algorithm described in Sections 5 and 6. As discussed in Section 6.2, Eq. (132) can be used to tile a system of any size, without increasing the depth of the layer of quantum gates that implements these interactions.

### 7.2.2 Circuit analysis

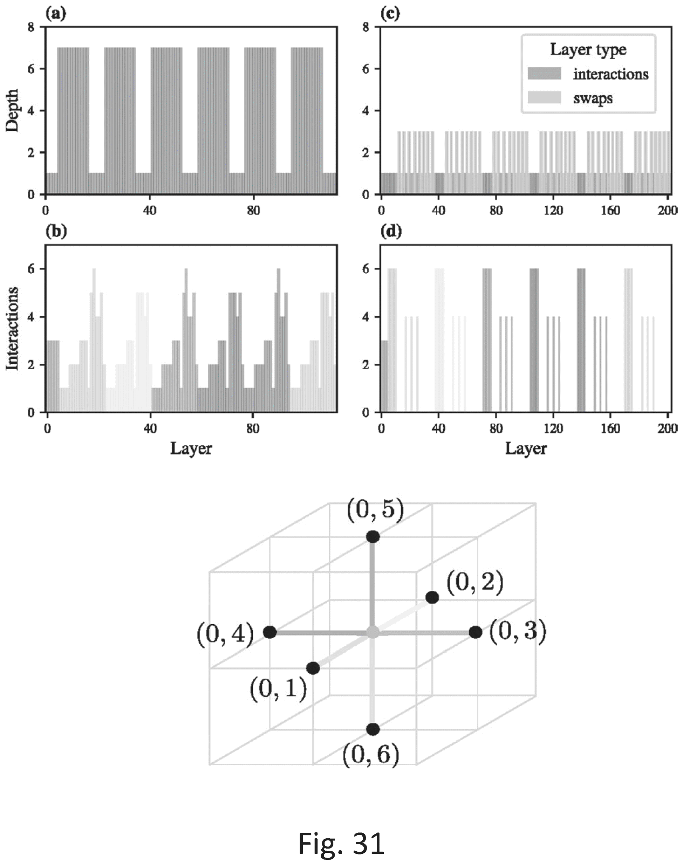

Having the Hamiltonian of SrVO₃ in Majorana form as above, we map it to Pauli operators, following the hybrid encoding. After that the circuit is compiled with respect to the algorithm of interest. For instance, let us assume we wish to write the circuit for a single layer of VQE. As outlined in Section 6, a series of compilation routines are applied to the set of interactions to derive the final circuit, including the fswap network described in Section 7.1.2. As explained there, it is important to separate the interactions based on the sites upon which they act, where the site index relates to the physical coordinates of the system. This can be seen in the final layer decomposition of Fig. 31.

Figure 31 shows an analysis of a circuit breakdown for SrVO₃. Top: (a) Circuit depth cost per layer in an approach without fswaps. (b) The number of interactions implemented on each layer. (c) Circuit depth cost per layer using fswaps. (d) Breakdown of the number of interactions per layer. Layer with zero interactions implement fswaps. The colour code in (b) and (d) is the same and denotes the pair of sites (0,*x*) involved in an interaction, as shown in the bottom diagrams, with x increasing to the right (note that the shading code repeats after seven colours). Bottom: Neighbourhood of a central cell in SrVO₃ and the shading code of the interactions. This approximation for SrVO₃ contains 6 nearest neighbour sites, denoted by the black dots. The compiler groups terms by their sites in advance, so the final circuit layering will have sections dedicated to each site grouping;

In Fig. 31(a) we show the circuit depth breakdown (for onsite and nearest neighbour terms for simplicity) by layer, similar to the analysis in Section 7.1. In Fig. 31(b) we can see how the circuit layers are distributed among terms acting on various sites. In this material, all interactions involve at most two sites: the central site and one neighbour. In this case, the majority of circuit depth is spent on implementing swap operations; it is difficult to know a-priori whether the swap network will be beneficial to the depth. We run the circuit compiler both with and without the swap network to determine the shortest circuit which should simulate the same process. Likewise, we can employ the circuit compiler to evaluate different algorithms; in particular, we consider VQE and TDS. We cost several representative algorithms with and without the aid of an fswap network for SrVO₃. Results are reported in Table 7.

**Table 7: Data for various algorithms running on the Hamiltonian for SrVO₃**

| Algorithm | Interactions depth | Swaps depth | Circuit depth |
|---|---|---|---|
| VQE w/o swap network | 881 | 0 | 881 |
| VQE w/ swap network | 395 | 336 | 731 |
| TDS (prioritising circuit depth w/ swap network) | 545 | 336 | 881 |

### 7.3 Further materials analysed

Following the same procedure outlined for SrVO₃, we can construct circuits for the simulation of a number of materials. We summarise the findings in Table 8. In Fig. 32 we report the circuit depth required for each material, against the number of qubits resulting from the encoding of the motif of that material. We recall that a motif represents the minimal arrangement of interactions that can be tiled to produce a Hamiltonian of arbitrary size. By performing the same type of layers on disjoint set of qubits across the lattice, it is possible to implement the needed quantum gates on the whole system without increasing the circuit depth.

Figure 32 shows circuit costings for materials' simulations. Each material's circuitry involves the interactions with those nearest neighbours which allow for threshold precision in the approximation, as described in Section 7.2.1.

**Table 8: Materials Analysed. For each material, the number of bands retained in the Wannier basis are listed. We list the number of qubits and circuit depth required for VQE and TDS in each case; asterisks denote that the circuit was compiled without the use of a swap network. The circuit depths reported refer to a single VQE or Trotter layer, without accounting for state preparation.**

| Material | Bands | Qubits | Algorithm | Depth |
|---|---|---|---|---|
| GaAs | 4 | 1120 | TDS | 6567 |
| | | | TDS* | 7180 |
| | | | VQE | 4935 |
| | | | VQE* | 5530 |
| H₃S | 7 | 1870 | TDS | 31203 |
| | | | TDS* | 37288 |
| | | | VQE | 28244 |
| | | | VQE^{*} | 34311 |
| Li₂CuO₂ | 11 | 1024 | TDS | 8261 |
| | | | TDS* | 10843 |
| | | | VQE | 7994 |
| | | | VQE* | 10438 |
| Si | 4 | 1120 | TDS | 6853 |
| | | | TDS* | 8128 |
| | | | VQE | 5244 |
| | | | VQE* | 6489 |
| SrVO₃ | 3 | 180 | TDS | 881 |
| | | | TDS* | 1031 |
| | | | VQE | 731 |
| | | | VQE* | 881 |

Although not discussed herein in great detail, the disclosure extends to an unclaimed control apparatus for a quantum information processor, the apparatus configured to improve the efficiency of a quantum computational measurement of a set of Majorana operators describing a Hamiltonian encoded on an array of qubits, the apparatus comprising: a processor configured to perform the steps of any one of the methods discussed above. It will be appreciated that the methods discussed above have a wide applicability, irrespective of the specific hardware on which they have been implemented. The apparatus may further comprise a quantum information processor including the array of qubits. The apparatus may be further configured to compile a quantum circuit for performing quantum operations on a quantum information processor,

Finally, the disclosure, also extends to an unclaimed non-transient computer readable medium comprising instructions which cause a computer to enact the method steps set out above.

## Claims

1. A computer-implemented method of compiling a quantum circuit comprising swap layers and interaction layers for performing quantum operations on a quantum information processor, the method comprising:
(a) receiving a graph comprising vertices and edges, the vertices of the graph being associated with quantum systems wherein the edges define a set of available vertex swaps;
(b) receiving a plurality of interactions of the quantum systems, each interaction comprising at least two vertices of the graph;
(c) determining a swap layer for the quantum circuit by:
(i) determining a graph cost of the graph, wherein the graph cost is based on distances between vertices in the interactions on the graph;
(ii) determining, for each available vertex swap, a swapped graph cost of a swapped graph, wherein the swapped graph is the graph modified according to the each available vertex swap;
(iii) adding a best available vertex swap to the swap layer, the best available vertex swap being the available vertex swap associated with a lowest swapped graph cost; and
(iv) updating the graph according to the best available vertex swap and updating the set of available vertex swaps to remove available vertex swaps containing vertices in the best available vertex swap;
(d) iterating step (c) until there are no more available vertex swaps and/or until the swapped graph costs associated with the available vertex swaps are not less than the swapped graph cost of the updated graph following the last vertex swap added to the swap layer and/or none of the available swaps reduce the distance of at least one interaction;
(e) determining an interaction layer for the quantum circuit by adding interactions whose vertices can be split into one or more pairs of vertices that are connected by edges after the swap layer to the interaction layer;
(f) adding a layer of quantum swap operations to the quantum circuit for swapping qubits or swapping labels of qubits of the quantum information processor corresponding to the vertex swaps in the swap layer; and
(g) adding a subsequent layer of quantum operations to the quantum circuit for interacting qubits of the quantum information processor corresponding to the interactions in the interaction layer.

2. The method of Claim 1, wherein the vertices are associated with modes of a fermionic Hamiltonian and the plurality of interactions are interactions of modes in the fermionic Hamiltonian, preferably wherein the edges of the graph connect fermionic modes which are efficiently swappable by a fermionic swap operation.

3. The method of Claim 1 or Claim 2, wherein the graph is an encoding graph of a fermion to qubit encoding.

4. The method of any preceding claim, wherein the vertices are associated with qubits and the edges connect qubits which are swappable by a qubit swap operation or a fermionic swap operation.

5. The method of any preceding claim, wherein step (b) further comprises:
determining a vertex list of all vertices involved in the plurality of interactions;
determining a Steiner tree, wherein the Steiner tree is a tree in the graph that connects the vertices in the vertex list; and
determining whether the Steiner tree has fewer vertices than the graph and, if so, replacing the graph with the Steiner tree.

6. The method of any preceding claim, wherein the distances are computed based on a minimum path length between vertices.

7. The method of any preceding claim wherein the graph cost is based on a sum of a function of the distances of the interactions, preferably the sum being of the distances of all the interactions.

8. The method of any preceding claim wherein determining the graph cost comprises calculating:
(∑*_{T}d*(*T*)*^{p}*)^{1/*p*}, wherein *T* is the interaction, *d*(*T*) is the distance of the interaction on the graph, the sum is over all of the interactions and 0 < *p* ≤ 1, preferably wherein 0.25 < *p* < 0.75, more preferably wherein *p* = 0.5; and/or wherein distances are computed based on a function of indices of the quantum systems associated with the vertices, preferably wherein the indices are Majorana indices; and/or wherein at least one of the plurality of interactions is a quadratic interaction comprising a pair of vertices of the graph.

9. The method of any preceding claim, wherein at least one of the plurality of interactions is a quartic interaction comprising four vertices of the graph; optionally wherein the quartic interaction comprising four vertices is split into two pairs of vertices; optionally wherein the distance of a quartic interaction is based on the sum of the distance of each pair of vertices.

10. The method of any preceding claim, wherein steps (c)-(e) are iterated to determine a plurality of interleaved swap layers and interaction layers until each of the plurality of interactions has been included in at least one interaction layer; and/or wherein the quantum operations are native quantum operations of the quantum information processor; and/or wherein the quantum operations are two-qubit quantum gates; and/or wherein the quantum swap operations comprise fermionic swap operations and/or qubit swap operations; and/or wherein the vertices of the graph are associated with qubits of the quantum information processor, and the edges of the graph are associated with qubits of the quantum information processor which are configured to interact with each other.

11. The method of any preceding claim, comprising:
determining after step (e) whether the graph is semi-Eulerian, and if the graph is semi-Eulerian:
(m) determining further swap and interaction layers of the quantum circuit by:
(i) forming a new graph from the Euler path edges of the graph;
(ii) adding vertex swaps corresponding to odd-indexed edges of the new graph to an odd swap layer;
(iii) adding the ones of the plurality of interactions whose vertices are connected by edges after the swap layer to an odd interaction layer;
(iv) updating the new graph according to the vertex swaps of step (m)(ii);
(v) adding vertex swaps corresponding to even-indexed edges of the new graph to an even swap layer;
(vi) adding the ones of the plurality of interactions whose vertices are connected by edges after the swap layer to an even interaction layer;
(vii) updating the new graph according to the vertex swaps of step (m)(v);
(viii) iterating steps (m)(ii)-(vii) until each of the plurality of interactions has been included in at least one odd or even interaction layer;
(n) adding further layers of quantum swap operations to the quantum circuit for swapping qubits or swapping labels of qubits of the quantum information processor corresponding to the vertex swaps in the odd and even swap layers; and
(o) interleaving the further layers of quantum swap operations in the quantum circuit with further layers of quantum operations for interacting qubits of the quantum information processor corresponding to the interactions in the corresponding odd and even interaction layers.

12. The method of any preceding claim, wherein the plurality of interactions comprise quadratic interactions involving two vertices of the graph and quartic interactions involving four vertices of the graph, further comprising:
before step (c), determining whether the graph is semi-Eulerian, and if the graph is semi-Eulerian:
(x) determining swap and interaction layers for the quantum circuit by:
(i) forming a new graph from the Euler path edges of the graph;
(ii) adding vertex swaps corresponding to odd-indexed edges of the new graph to an odd swap layer;
(iii) adding the ones of the plurality of interactions whose vertices are connected by edges after the odd swap layer to an odd interaction layer;
(iv) updating the graph according to the vertex swaps of step (x)(ii);
(v) adding vertex swaps corresponding to even-indexed edges of the new graph to an even swap layer;
(vi) adding the ones of the plurality of interactions whose vertices are connected by edges after the swap layer to an even interaction layer;
(vii) updating the graph according to the vertex swaps of step (x)(v);
(viii) iterating steps (x)(ii)-(vii) until each of the plurality of quadratic interactions has been included in at least one odd or even interaction layer,
wherein, step (c) follows step (x) for those quartic interactions not present in at least one odd or even interaction layer;
(y) adding layers of quantum swap operations to the quantum circuit for swapping qubits or swapping labels of qubits of the quantum information processor corresponding to the vertex swaps in the odd and even swap layers; and
(z) interleaving the layers of quantum swap operations in the quantum circuit with layers of quantum operations for interacting qubits of the quantum information processor corresponding to the interactions in the corresponding odd and even interaction layers.

13. The method of any preceding claim further comprising:
performing the quantum circuit on the quantum information processor.

14. A control apparatus for a quantum information processor, the apparatus configured to compile a quantum circuit for performing quantum operations on a quantum information processor, the apparatus comprising:
a processor configured to perform the steps of any one of the preceding claims.

15. A non-transient computer readable medium comprising instructions which, when executed by a computer, cause the computer to carry out the method steps of any one of claims 1 to 13.

## Patentansprüche

1. Computerimplementiertes Verfahren zum Kompilieren einer Quantenschaltung, die Swap-Schichten und Wechselwirkungsschichten zum Durchführen von Quantenoperationen auf einem Quanteninformationsprozessor umfasst, wobei das Verfahren Folgendes umfasst:
(a) Empfangen eines Graphen, der Knoten und Kanten umfasst, wobei die Knoten des Graphen Quantensystemen zugeordnet sind, wobei die Kanten einen Satz verfügbarer Vertex-Swaps definieren;
(b) Empfangen einer Vielzahl von Wechselwirkungen der Quantensysteme, wobei jede Wechselwirkung mindestens zwei Knoten des Graphen umfasst;
(c) Bestimmen einer Swap-Schicht für die Quantenschaltung durch:
(i) Bestimmen von Kosten eines Graphen für den Graphen, wobei die Kosten des Graphen auf Abständen zwischen Knoten in den Wechselwirkungen auf dem Graphen basieren;
(ii) Bestimmen, für jeden verfügbaren Vertex-Swap, Kosten des ausgetauschten Graphen eines ausgetauschten Graphen, wobei der ausgetauschte Graph der Graph ist, der gemäß dem jeweils verfügbaren Vertex-Swap modifiziert ist;
(iii) Hinzufügen eines besten verfügbaren Vertex-Swaps zur Swap-Schicht, wobei der beste verfügbare Vertex-Swap der verfügbare Vertex-Swap ist, der mit den niedrigsten Kosten des ausgetauschten Graphen verbunden ist; und
(iv) Aktualisieren des Graphen gemäß dem besten verfügbaren Vertex-Swap und Aktualisieren des Satzes verfügbarer Vertex-Swaps, um verfügbare Vertex-Swaps zu entfernen, die Knoten des besten verfügbaren Vertex-Swaps enthalten;
(d) Iterieren des Schritts (c), bis keine weiteren verfügbaren Vertex-Swaps vorhanden sind und/oder bis die mit den verfügbaren Vertex-Swaps verbundenen Kosten des ausgetauschten Graphen nicht geringer als die Kosten des ausgetauschten Graphen des aktualisierten Graphen nach dem letzten der Swap-Schicht hinzugefügten Vertex-Swap sind und/oder keiner der verfügbaren Swaps den Abstand mindestens einer Wechselwirkung reduziert;
(e) Bestimmen einer Wechselwirkungsschicht für die Quantenschaltung durch Hinzufügen von Wechselwirkungen, deren Knoten in ein oder mehrere Paare von Knoten aufgeteilt werden können, die nach der Swap-Schicht durch Kanten verbunden sind, zu der Wechselwirkungsschicht;
(f) Hinzufügen einer Schicht von Quanten-Swap-Operationen zu der Quantenschaltung zum Austauschen von Qubits oder Austauschen von Labels von Qubits des Quanteninformationsprozessors, die den Vertex-Swaps in der Swap-Schicht entsprechen; und
(g) Hinzufügen einer nachfolgenden Schicht von Quantenoperationen zu der Quantenschaltung für interaktive Qubits des Quanteninformationsprozessors, die den Wechselwirkungen in der Wechselwirkungsschicht entsprechen.

2. Verfahren nach Anspruch 1, wobei die Knoten Moden eines fermionischen Hamiltonoperators zugeordnet sind und die Vielzahl von Wechselwirkungen Wechselwirkungen von Moden in dem fermionischen Hamiltonoperator sind, vorzugsweise wobei die Kanten des Graphen fermionische Moden verbinden, die durch eine fermionische Swap-Operation effizient austauschbar sind.

3. Verfahren nach Anspruch 1 oder Anspruch 2, wobei der Graph ein Codierungsgraph einer Fermion-zu-Qubit-Codierung ist.

4. Verfahren nach einem der vorhergehenden Ansprüche, wobei die Knoten Qubits zugeordnet sind und die Kanten Qubits verbinden, die durch eine Qubit-Swap-Operation oder eine fermionische Swap-Operation austauschbar sind.

5. Verfahren nach einem der vorhergehenden Ansprüche, wobei Schritt (b) ferner Folgendes umfasst:
Bestimmen einer Knotenliste aller Knoten, die an der Vielzahl von Wechselwirkungen beteiligt sind;
Bestimmen eines Steiner-Baums, wobei der Steiner-Baum ein Baum in dem Graphen ist, der die Knoten in der Knotenliste verbindet; und
Bestimmen, ob der Steiner-Baum weniger Knoten als der Graph aufweist, und, falls dies der Fall ist, Ersetzen des Graphen durch den Steiner-Baum.

6. Verfahren nach einem der vorhergehenden Ansprüche, wobei die Abstände basierend auf einer minimalen Pfadlänge zwischen Knoten berechnet werden.

7. Verfahren nach einem der vorhergehenden Ansprüche, wobei die Kosten eines Graphen auf einer Summe einer Funktion der Abstände der Wechselwirkungen basieren, wobei die Summe vorzugsweise die Abstände aller Wechselwirkungen ist.

8. Verfahren nach einem der vorhergehenden Ansprüche, wobei das Bestimmen der Kosten eines Graphen das Berechnen von Folgendem umfasst:
(Σ*_{T} d*(*T*)*^{p}*)^{1/*p*}, wobei *T* die Wechselwirkung ist, *d*(*T*) der Abstand der Wechselwirkung auf dem Graphen ist, die Summe über alle Wechselwirkungen gebildet wird und 0 < *p* ≤ 1 gilt, vorzugsweise wobei 0,25 < *p* < 0,75 gilt, besonders bevorzugt wobei *p* = 0,5 gilt; und/oder wobei Abstände basierend auf einer Funktion von Indizes der den Knoten zugeordneten Quantensysteme berechnet werden, vorzugsweise wobei die Indizes Majorana-Indizes sind; und/oder wobei mindestens eine der Vielzahl von Wechselwirkungen eine quadratische Wechselwirkung ist, die ein Knotenpaar des Graphen umfasst.

9. Verfahren nach einem der vorhergehenden Ansprüche, wobei mindestens eine der Vielzahl von Wechselwirkungen eine quartische Wechselwirkung ist, die vier Knoten des Graphen umfasst; wobei optional die quartische Wechselwirkung, die vier Knoten umfasst, in zwei Knotenpaare aufgeteilt wird; wobei optional der Abstand einer quartischen Wechselwirkung auf der Summe des Abstands jedes Knotenpaares basiert.

10. Verfahren nach einem der vorhergehenden Ansprüche, wobei die Schritte (c)-(e) iteriert werden, um eine Vielzahl von verschachtelten Swap-Schichten und Wechselwirkungsschichten zu bestimmen, bis jede der Vielzahl von Wechselwirkungen in mindestens eine Wechselwirkungsschicht aufgenommen wurde; und/oder wobei die Quantenoperationen native Quantenoperationen des Quanteninformationsprozessors sind; und/oder wobei die Quantenoperationen Zwei-Qubit-Quantengatter sind; und/oder wobei die Quanten-Swap-Operationen fermionische Swap-Operationen und/oder Qubit-Swap-Operationen umfassen; und/oder wobei die Knoten des Graphen Qubits des Quanteninformationsprozessors zugeordnet sind und die Kanten des Graphen Qubits des Quanteninformationsprozessors zugeordnet sind, die dazu konfiguriert sind, miteinander zu wechselwirken.

11. Verfahren nach einem der vorhergehenden Ansprüche, umfassend:
Bestimmen nach Schritt (e), ob der Graph semi-eulerisch ist, und, wenn der Graph semi-eulerisch ist:
(m) Bestimmen weiterer Swap-Schichten und Wechselwirkungsschichten der Quantenschaltung durch:
(i) Bilden eines neuen Graphen aus den Eulerpfad-Kanten des Graphen;
(ii) Hinzufügen von Vertex-Swaps, die Kanten mit ungeraden Indizes des neuen Graphen entsprechen, zu einer ungeraden Swap-Schicht;
(iii) Hinzufügen derjenigen der Vielzahl von Wechselwirkungen, deren Knoten nach der Swap-Schicht durch Kanten verbunden sind, zu einer ungeraden Wechselwirkungsschicht;
(iv) Aktualisieren des neuen Graphen gemäß den Vertex-Swaps von Schritt (m) (ii);
(v) Hinzufügen von Vertex-Swaps, die Kanten mit geraden Indizes des neuen Graphen entsprechen, zu einer geraden Swap-Schicht;
(vi) Hinzufügen derjenigen der Vielzahl von Wechselwirkungen, deren Knoten nach der Swap-Schicht durch Kanten verbunden sind, zu einer geraden Wechselwirkungsschicht;
(vii)Aktualisieren des neuen Graphen gemäß den Vertex-Swaps von Schritt (m) (v);
(viii) Iterieren der Schritte (m) (ii) - (vii), bis jede der Vielzahl von Wechselwirkungen in mindestens eine ungerade oder gerade Wechselwirkungsschicht aufgenommen wurde;
(n) Hinzufügen weiterer Schichten von Quanten-Swap-Operationen zu der Quantenschaltung zum Austauschen von Qubits oder Austauschen von Labels von Qubits des Quanteninformationsprozessors, die den Vertex-Swaps in den ungeraden und geraden Swap-Schichten entsprechen; und
(o) Verschachteln der weiteren Schichten von Quanten-Swap-Operationen in der Quantenschaltung mit weiteren Schichten von Quantenoperationen für interaktive Qubits des Quanteninformationsprozessors, die den Wechselwirkungen in den entsprechenden ungeraden und geraden Wechselwirkungsschichten entsprechen.

12. Verfahren nach einem der vorhergehenden Ansprüche, wobei die Vielzahl von Wechselwirkungen quadratische Wechselwirkungen, die zwei Knoten des Graphen betreffen, und quartische Wechselwirkungen, die vier Knoten des Graphen betreffen, umfasst, ferner umfassend:
vor Schritt (c) Bestimmen, ob der Graph semi-eulerisch ist, und, wenn der Graph semi-eulerisch ist:
(x) Bestimmen von Swap-Schichten und Wechselwirkungsschichten für die Quantenschaltung durch:
(i) Bilden eines neuen Graphen aus den Eulerpfad-Kanten des Graphen;
(ii) Hinzufügen von Vertex-Swaps, die Kanten mit ungeraden Indizes des neuen Graphen entsprechen, zu einer ungeraden Swap-Schicht;
(iii) Hinzufügen derjenigen der Vielzahl von Wechselwirkungen, deren Knoten nach der ungeraden Swap-Schicht durch Kanten verbunden sind, zu einer ungeraden Wechselwirkungsschicht;
(iv) Aktualisieren des Graphen gemäß den Vertex-Swaps von Schritt (x)(ii);
(v) Hinzufügen von Vertex-Swaps, die Kanten mit geraden Indizes des neuen Graphen entsprechen, zu einer geraden Swap-Schicht;
(vi) Hinzufügen derjenigen der Vielzahl von Wechselwirkungen, deren Knoten nach der Swap-Schicht durch Kanten verbunden sind, zu einer geraden Wechselwirkungsschicht;
(vii) Aktualisieren des Graphen gemäß den Vertex-Swaps von Schritt (x)(v);
(viii) Iterieren der Schritte (x)(ii)-(vii), bis jede der Vielzahl von quadratischen Wechselwirkungen in mindestens eine ungerade oder gerade Wechselwirkungsschicht aufgenommen wurde,
wobei Schritt (c) für diejenigen quartischen Wechselwirkungen, die nicht in mindestens einer ungeraden oder geraden Wechselwirkungsschicht vorhanden sind, auf Schritt (x) folgt;
(y) Hinzufügen von Schichten von Quanten-Swap-Operationen zu der Quantenschaltung zum Austauschen von Qubits oder Austauschen von Labels von Qubits des Quanteninformationsprozessors, die den Vertex-Swaps in den ungeraden und geraden Swap-Schichten entsprechen; und
(z) Verschachteln der Schichten von Quanten-Swap-Operationen in der Quantenschaltung mit Schichten von Quantenoperationen für interaktive Qubits des Quanteninformationsprozessors, die den Wechselwirkungen in den entsprechenden ungeraden und geraden Wechselwirkungsschichten entsprechen.

13. Verfahren nach einem der vorhergehenden Ansprüche, ferner umfassend:
Ausführen der Quantenschaltung auf dem Quanteninformationsprozessor.

14. Steuervorrichtung für einen Quanteninformationsprozessor, wobei die Vorrichtung dazu konfiguriert ist, eine Quantenschaltung zum Durchführen von Quantenoperationen auf einem Quanteninformationsprozessor zu kompilieren, wobei die Vorrichtung Folgendes umfasst:
einen Prozessor, der dazu konfiguriert ist, die Schritte nach einem der vorhergehenden Ansprüche durchzuführen.

15. Nicht-transientes computerlesbares Medium, das Anweisungen umfasst, die, wenn sie von einem Computer ausgeführt werden, den Computer veranlassen, die Verfahrensschritte nach einem der Ansprüche 1 bis 13 durchzuführen.

## Revendications

1. Procédé mis en œuvre par ordinateur de compilation d'un circuit quantique comprenant des couches d'échange et des couches d'interaction pour réaliser des opérations quantiques sur un processeur d'informations quantiques, le procédé consistant à :
(a) recevoir un graphe comprenant des sommets et des arêtes, les sommets du graphe étant associés à des systèmes quantiques où les arêtes définissent un ensemble d'échanges de sommets disponibles ;
(b) recevoir une pluralité d'interactions des systèmes quantiques, chaque interaction comprenant au moins deux sommets du graphe ;
(c) déterminer une couche d'échange pour le circuit quantique en effectuant les étapes consistant à :
(i) déterminer un coût de graphe du graphe, le coût de graphe étant basé sur des distances entre des sommets dans les interactions sur le graphe ;
(ii) déterminer, pour chacun des échanges de sommet disponibles, un coût de graphe échangé d'un graphe échangé, le graphe échangé étant le graphe modifié selon chacun desdits échanges de sommet disponibles ;
(iii) ajouter un meilleur échange de sommet disponible à la couche d'échange, le meilleur échange de sommet disponible étant l'échange de sommet disponible associé à un coût de graphe échangé le plus bas ; et
(iv) mettre à jour le graphe selon le meilleur échange de sommet disponible et mettre à jour l'ensemble d'échanges de sommets disponibles afin de supprimer les échanges de sommets disponibles contenant des sommets dans le meilleur échange de sommet disponible ;
(d) itérer l'étape (c) jusqu'à ce qu'il n'y ait plus d'échanges de sommets disponibles et/ou jusqu'à ce que les coûts de graphe échangé associés aux échanges de sommets disponibles ne soient pas inférieurs au coût de graphe échangé du graphe mis à jour après le dernier échange de sommet ajouté à la couche d'échange et/ou qu'aucun des échanges disponibles ne réduise la distance d'au moins une interaction ;
(e) déterminer une couche d'interaction pour le circuit quantique en ajoutant à la couche d'interaction des interactions dont les sommets peuvent être divisés en une ou plusieurs paires de sommets qui sont reliés par des arêtes après la couche d'échange ;
(f) ajouter une couche d'opérations d'échange quantique au circuit quantique pour échanger des bits quantiques ou échanger des étiquettes de bits quantiques du processeur d'informations quantiques correspondant aux échanges de sommets dans la couche d'échange ; et
(g) ajouter une couche supplémentaire d'opérations quantiques au circuit quantique pour faire interagir des bits quantiques du processeur d'informations quantiques correspondant aux interactions dans la couche d'interaction.

2. Procédé selon la revendication 1, les sommets étant associés à des modes d'un hamiltonien fermionique et la pluralité d'interactions étant des interactions de modes dans l'hamiltonien fermionique, de préférence les arêtes du graphe reliant des modes fermioniques qui peuvent être échangés de manière efficace par une opération d'échange fermionique.

3. Procédé selon la revendication 1 ou 2, le graphe étant un graphe de codage d'un codage de fermion en bit quantique.

4. Procédé selon l'une quelconque des revendications précédentes, les sommets étant associés à des bits quantiques et les arêtes reliant des bits quantiques qui peuvent être échangés par une opération d'échange de bits quantiques ou une opération d'échange fermionique.

5. Procédé selon l'une quelconque des revendications précédentes, l'étape (b) consistant en outre à :
déterminer une liste de sommets de tous les sommets impliqués dans la pluralité d'interactions ;
déterminer un arbre de Steiner, l'arbre de Steiner étant un arbre dans le graphe qui relie les sommets dans la liste de sommets ; et
déterminer si l'arbre de Steiner possède moins de sommets que le graphe et, si c'est le cas, remplacer le graphe par l'arbre de Steiner.

6. Procédé selon l'une quelconque des revendications précédentes, les distances étant calculées sur la base d'une longueur de chemin minimale entre des sommets.

7. Procédé selon l'une quelconque des revendications précédentes, le coût de graphe étant basé sur une somme d'une fonction des distances des interactions, de préférence la somme étant celle des distances de toutes les interactions.

8. Procédé selon l'une quelconque des revendications précédentes, la détermination du coût de graphe consistant à calculer :
(Σ*_{T} d*(*T*)*^{p}*)^{1/*p*}, où *T* est l'interaction, *d*(*T*) est la distance de l'interaction sur le graphe, la somme portant sur la totalité des interactions et 0 < *p* ≤ 1, de préférence où 0,25 < *p* < 0,75, plus préférablement où *p* = 0,5 ; et/ou les distances étant calculées sur la base d'une fonction d'indices des systèmes quantiques associés aux sommets, de préférence les indices étant des indices de Majorana ;
et/ou au moins une interaction parmi la pluralité d'interactions étant une interaction quadratique comprenant une paire de sommets du graphe.

9. Procédé selon l'une quelconque des revendications précédentes, au moins une interaction parmi la pluralité d'interactions étant une interaction quartique comprenant quatre sommets du graphe ; éventuellement l'interaction quartique comprenant quatre sommets étant divisée en deux paires de sommets ; éventuellement la distance d'une interaction quartique étant basée sur la somme de la distance de chaque paire de sommets.

10. Procédé selon l'une quelconque des revendications précédentes, les étapes (c) à (e) étant itérées pour déterminer une pluralité de couches d'échange et de couches d'interaction entrelacées jusqu'à ce que chaque interaction parmi la pluralité d'interactions ait été incluse dans au moins une couche d'interaction ; et/ou les opérations quantiques étant des opérations quantiques natives du processeur d'informations quantiques ; et/ou les opérations quantiques étant des portes quantiques à deux bits quantiques ; et/ou les opérations d'échange quantique comprenant des opérations d'échange fermionique et/ou des opérations d'échange de bits quantiques ; et/ou les sommets du graphe étant associés à des bits quantiques du processeur d'informations quantiques, et les arêtes du graphe étant associées à des bits quantiques du processeur d'informations quantiques qui sont configurés pour interagir les uns avec les autres.

11. Procédé selon une quelconque revendication précédente, consistant à :
déterminer après l'étape (e) si le graphe est semi-eulérien, et si le graphe est semi-eulérien :
(m) déterminer des couches d'échange et d'interaction supplémentaires du circuit quantique en effectuant les étapes consistant à :
(i) former un nouveau graphe à partir des arêtes de chemin eulérien du graphe ;
(ii) ajouter des échanges de sommets correspondant à des arêtes d'indice impair du nouveau graphe à une couche d'échange impaire ;
(iii) ajouter les interactions, parmi la pluralité d'interactions, dont les sommets sont reliés par des arêtes après la couche d'échange à une couche d'interaction impaire ;
(iv) mettre à jour le nouveau graphe selon les échanges de sommets de l'étape (m)(ii) ;
(v) ajouter des échanges de sommets correspondant à des arêtes d'indice pair du nouveau graphe à une couche d'échange paire ;
(vi) ajouter les interactions, parmi la pluralité d'interactions, dont les sommets sont reliés par des arêtes après la couche d'échange à une couche d'interaction paire ;
(vii) mettre à jour le nouveau graphe selon les échanges de sommets de l'étape (m)(v) ;
(viii) itérer les étapes (m)(ii) à (vii) jusqu'à ce que chaque interaction parmi la pluralité d'interactions ait été incluse dans au moins une couche d'interaction impaire ou paire ;
(n) ajouter des couches supplémentaires d'opérations d'échange quantique au circuit quantique pour échanger des bits quantiques ou échanger des étiquettes de bits quantiques du processeur d'informations quantiques correspondant aux échanges de sommets dans les couches d'échange impaires et paires ; et
(o) entrelacer les couches supplémentaires d'opérations d'échange quantique dans le circuit quantique avec des couches supplémentaires d'opérations quantiques pour faire interagir des bits quantiques du processeur d'informations quantiques correspondant aux interactions dans les couches d'interaction impaires et paires correspondantes.

12. Procédé selon l'une quelconque des revendications précédentes, la pluralité d'interactions comprenant des interactions quadratiques impliquant deux sommets du graphe et des interactions quartiques impliquant quatre sommets du graphe, le procédé consistant en outre à :
avant l'étape (c), déterminer si le graphe est semi-eulérien, et si le graphe est semi-eulérien :
(x) déterminer des couches d'échange et d'interaction pour le circuit quantique en effectuant les étapes consistant à :
(i) former un nouveau graphe à partir des arêtes de chemin eulérien du graphe ;
(ii) ajouter des échanges de sommets correspondant à des arêtes d'indice impair du nouveau graphe à une couche d'échange impaire ;
(iii) ajouter les interactions, parmi la pluralité d'interactions, dont les sommets sont reliés par des arêtes après la couche d'échange impaire à une couche d'interaction impaire ;
(iv) mettre à jour le graphe selon les échanges de sommets de l'étape (x)(ii) ;
(v) ajouter des échanges de sommets correspondant à des arêtes d'indice pair du nouveau graphe à une couche d'échange paire ;
(vi) ajouter les interactions, parmi la pluralité d'interactions, dont les sommets sont reliés par des arêtes après la couche d'échange à une couche d'interaction paire ;
(vii) mettre à jour le graphe selon les échanges de sommets de l'étape (x)(v) ;
(viii) itérer les étapes (x)(ii) à (vii) jusqu'à ce que chaque interaction quadratique parmi la pluralité d'interactions quadratiques ait été incluse dans au moins une couche d'interaction impaire ou paire,
l'étape (c) suivant l'étape (x) pour les interactions quartiques qui ne sont pas présentes dans au moins une couche d'interaction impaire ou paire ;
(y) ajouter des couches d'opérations d'échange quantique au circuit quantique pour échanger des bits quantiques ou échanger des étiquettes de bits quantiques du processeur d'informations quantiques correspondant aux échanges de sommets dans les couches d'échange impaires et paires ; et
(z) entrelacer les couches d'opérations d'échange quantique dans le circuit quantique avec des couches d'opérations quantiques pour faire interagir des bits quantiques du processeur d'informations quantiques correspondant aux interactions dans les couches d'interaction impaires et paires correspondantes.

13. Procédé selon l'une quelconque des revendications précédentes, consistant en outre à :
réaliser le circuit quantique sur le processeur d'informations quantiques.

14. Appareil de commande pour un processeur d'informations quantiques, l'appareil étant configuré pour compiler un circuit quantique pour réaliser des opérations quantiques sur un processeur d'informations quantiques, l'appareil comprenant :
un processeur configuré pour réaliser les étapes selon l'une quelconque des revendications précédentes.

15. Support non transitoire lisible par ordinateur, comprenant des instructions qui, lorsqu'elles sont exécutées par un ordinateur, amènent l'ordinateur à réaliser les étapes de procédé selon l'une quelconque des revendications 1 à 13.
